# EUROPEAN PATENT APPLICATION

(11) **EP 4 671 865 A1**
(43) Date of publication of application: **31.12.2025**
(21) Application number: 25185194.5
(22) Date of filing: 25.06.2025
(51) Int. Cl.: G03F 7/004, G03F 7/038

(54) **CHEMICALLY AMPLIFIED NEGATIVE RESIST COMPOSITION AND RESIST PATTERN FORMING PROCESS**

(30) Priority: 28.06.2024 JP 2024105510
(71) Applicant: Shin-Etsu Chemical Co., Ltd., Tokyo 100-0005 (JP)
(72) Inventor: FUKUSHIMA, Masahiro, Joetsu-shi 9428601 (JP); WATANABE, Satoshi, Joetsu-shi 9428601 (JP); FUNATSU, Kenji, Joetsu-shi 9428601 (JP); MASUNAGA, Keiichi, Joetsu-shi 9428601 (JP); KOTAKE, Masaaki, Joetsu-shi 9428601 (JP); MATSUZAWA, Yuta, Joetsu-shi 9428601 (JP)
(74) Representative: Ter Meer Steinmeister & Partner

(57) **Abstract**

A chemically amplified negative resist composition containing (A) a base polymer containing a polymer which contains a repeat unit having formula (A1) and a repeat unit having formula (A2), the polymer being adapted to decrease its solubility in an aqueous alkaline solution under an action of an acid.

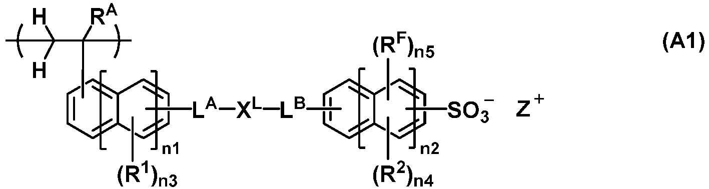

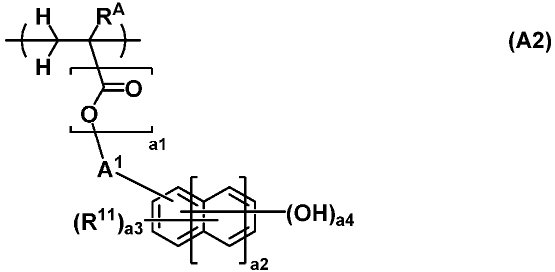

## Description

### TECHNICAL FIELD

The present invention relates to a chemically amplified negative resist composition and a resist pattern forming process.

### BACKGROUND ART

In recent years, to meet the demand for higher integration density and higher operating speed of LSIs, the effort to reduce the pattern rule is in rapid progress. In forming resist patterns with a feature size of 0.2 µm or less, acid-catalyzed chemically amplified resist compositions are most often used. High-energy radiation such as UV, deep-UV, or an electron beam (EB) is used as the light source for exposure of these resist compositions. In particular, while EB lithography is utilized as the ultra-fine microfabrication technique, it is also indispensable in processing photomask blanks to form photomasks for use in semiconductor device fabrication.

Polymers containing a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

Resist compositions for photolithography include positive ones in which exposed areas are dissolved away and negative ones in which exposed areas are left as a pattern. A viable composition is selected among them depending on the desired resist pattern. In general, the chemically amplified negative resist composition contains a polymer which is normally soluble in an aqueous alkaline developer, an acid generator which is decomposed to generate an acid upon exposure to light, and a crosslinker which causes the polymer to crosslink in the presence of the acid serving as a catalyst, thus rendering the polymer insoluble in the developer (sometimes, the crosslinker is incorporated in the polymer). Most often a quencher is added for controlling the diffusion of the acid generated upon light exposure.

Typical of the alkali-soluble units to constitute the polymer which is soluble in an aqueous alkaline developer are units derived from phenols. A number of negative resist compositions of such type were developed, especially as adapted for exposure to KrF excimer laser. These compositions have not been used in the ArF excimer laser lithography because the phenolic units are not transmissive to exposure radiation having a wavelength of 150 to 220 nm. Recently, these compositions are recognized attractive again as the negative resist composition for EB or EUV lithography capable of forming smaller size patterns. As a resist composition which provides very high resolution even when used as a thin film, for example, those described in Patent Documents 1, 2, and 3 have been proposed.

In addition to those described above, many materials have been developed as materials for chemically amplified negative resist compositions. For example, as a material that insolubilizes an alkali-soluble polymer which provides a negative mechanism used in a resist composition by the action of an acid generated when the composition is irradiated with high-energy radiation, a crosslinker as used in Patent Documents 1 to 3 is used, and many crosslinkers have been developed. In addition, many attempts have been made to impart the function of the crosslinker to a polymer, and a method of introducing a styrene unit substituted with an alkoxymethoxy group (Patent Document 4), a method of introducing a repeat unit having an alkoxymethylamino group (Patent Document 5), a method of introducing a repeat unit having an epoxy group (Patent Document 6), a method of introducing a styrene-based repeat unit having an acid-releasable group (Patent Document 7), a method of introducing an adamantyl-based repeat unit having an acid-releasable hydroxy group (Patent Document 8), a method of introducing an aliphatic hydrocarbon group having an acid-releasable hydroxy group and an alicyclic hydrocarbon-based repeat unit (Patent Documents 9, 10, and 11), and the like have been proposed. A material having an acid-releasable hydroxy group has been proposed in Patent Document 12 and the like.

In order to reduce acid diffusion, a polymer containing a repeat unit derived from an onium salt of a sulfonic acid having a polymerizable unsaturated bond has been proposed (Patent Document 13). Such a so-called polymer-bound acid generator has a feature that the distance of acid diffusion is very short because a polymeric sulfonic acid is generated by exposure. It is also possible to increase the sensitivity by increasing the percentage of the acid generator. The sensitivity is also increased in the case where a large amount of an acid generator of addition type is added, but in this case, the acid diffusion distance is also increased. Since the acid diffuses non-uniformly, line edge roughness (LER) and dimensional uniformity (CDU) deteriorate as the acid diffusion increases. In the balance of sensitivity, LER, and CDU, the polymer-bound acid generator has high ability, and development of an acid generator which generates an acid with more suitable strength is desired.

Patent Documents 14 and 15 disclose, as for an acid generator which generates an acid having a more suitable strength, examples in which acid diffusion is controlled by bonding a sulfonic acid generated by exposure to a polymer used in a resist composition to reduce diffusion. Such a method of incorporating a repeat unit which generates an acid by exposure into a base polymer to reduce acid diffusion is effective for obtaining a pattern with small LER. However, depending on the structure and introduction rate of such a repeat unit, the base polymer to which the repeat unit that generates an acid by exposure is bonded may have a problem in solubility in an organic solvent.

As the feature size of a resist pattern is reduced in recent years, collapse of the resist pattern during development and poor resistance during the subsequent etching step have become outstanding problems. Introduction of the repeat unit derived from an onium salt of a sulfonic acid having a polymerizable unsaturated bond is effective for reducing the diffusion of the generated acid to some extent. There is left room for improvement in lithography performance, resist pattern collapse, and etching resistance. To meet the future demand for further miniaturization, it is quite important to have a polymer-bound acid generator capable of meeting the desired lithography performance, especially resist pattern collapse and etching resistance.

### Citation List

| | |
|---|---|
| Patent Document 1: | JP-A 2010-276910 |
| Patent Document 2: | JP-A 2010-164933 |
| Patent Document 3: | JP-A 2008-249762 |
| Patent Document 4: | JP-A H05-232702 |
| Patent Document 5: | JP-A H08-202037 |
| Patent Document 6: | JP-A 2001-226430 |
| Patent Document 7: | JP-A 2003-337414 |
| Patent Document 8: | JP-A 2001-154357 |
| Patent Document 9: | USP 7300739 |
| Patent Document 10: | USP 7393624 |
| Patent Document 11: | USP 7563558 |
| Patent Document 12: | JP-A 2013-164588 |
| Patent Document 13: | JP-A 2012-177834 |
| Patent Document 14: | JP-A 2011-22564 |
| Patent Document 15: | WO 2015/194330 |

### SUMMARY OF THE INVENTION

The present invention has been made in view of the above circumstances. An object of the present invention is to provide a chemically amplified negative resist composition containing a polymer-bound acid generator which has excellent etching resistance and organic solvent solubility, and can generate an acid having an appropriate acid strength with reduced diffusion, and a resist pattern forming process using the chemically amplified resist composition.

As a result of intensive studies to achieve the above object, the present inventors have found that, as for a polymer-bound acid generator, a polymer containing a repeat unit derived from an onium salt containing an aromatic sulfonate anion having an aromatic ring substituted with a vinyl group and a repeat unit having a phenolic hydroxy group has good solvent solubility. The present inventors have also found that by using the polymer as a material of a chemically amplified negative resist composition, the polymer-bound acid generator is excellent in lithography performance such as resolution, LER, and pattern profile particularly in EB lithography and EUV lithography, is resistant to pattern collapse even in fine pattern formation, and is also excellent in pattern profile, and have completed the present invention.

That is, the present invention provides the following chemically amplified negative resist composition and resist pattern forming process.
1. A chemically amplified negative resist composition containing (A) a base polymer containing a polymer which contains a repeat unit having formula (A1) and a repeat unit having formula (A2), the polymer being adapted to decrease its solubility in an aqueous alkaline solution under an action of an acid: 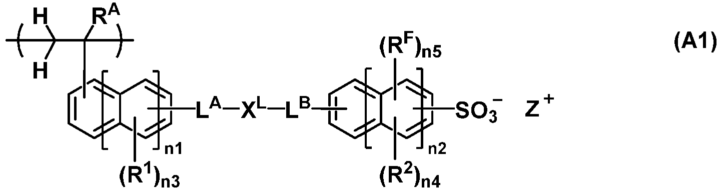
   wherein n1 is 0 or 1, n2 is 0 or 1, n3 is 0, 1, 2, 3, or 4, n4 is 0, 1, 2, 3, or 4, n5 is 0, 1, 2, 3, or 4, provided that when n2 is 0, 0 ≤ n4 + n5 ≤ 4, and when n2 is 1, 0 ≤ n4 + n5 ≤ 6, and
   a case where n1 to n5 are all 0 is excluded,
      R^{A} is a hydrogen atom, a fluorine atom, a methyl group, or a trifluoromethyl group,
      R¹ is a halogen atom, a nitro group, a cyano group, or a C₁-C₂₀ hydrocarbyl group which may contain a heteroatom, and when n3 is 2 or more, groups R¹ may be identical or different from each other, and a plurality of groups R¹ may bond together to form a ring with a carbon atom to which they are bonded,
      R² is a C₁-C₂₀ hydrocarbyl group which may contain a heteroatom, and when n4 is 2 or more, groups R² may be identical or different from each other, and a plurality of groups R² may bond together to form a ring with a carbon atom to which they are bonded,
      R^{F} is a fluorine atom, a C₁-C₆ fluorinated alkyl group, a C₁-C₆ fluorinated alkoxy group, or a C₁-C₆ fluorinated alkylthio group, and when n5 is 2 or more, groups R^{F} may be identical or different from each other,
      L^{A} and L^{B} are each independently a single bond, an ether bond, an ester bond, a sulfonic ester bond, a sulfonic amide bond, a carbonate bond, or a carbamate bond,
      X^{L} is a C₁-C₄₀ hydrocarbylene group which may contain a heteroatom, and
      Z⁺ is an onium cation, 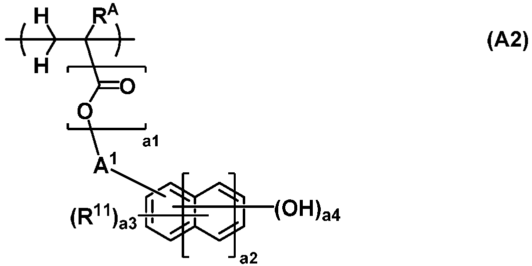
         wherein a1 is 0 or 1, a2 is 0, 1, or 2, a3 is an integer satisfying 0 ≤ a3 ≤ 5 + 2(a2) - a4, and
         a4 is 1, 2, or 3,
            R^{A} is a hydrogen atom, a fluorine atom, a methyl group, or a trifluoromethyl group,
            R¹¹ is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom, and when a3 is 2 or more, groups R¹¹ may be identical or different from each other, and
            A¹ is a single bond or a C₁-C₁₀ saturated hydrocarbylene group in which some constituent -CH₂- may be replaced by -O-.
2. The chemically amplified negative resist composition according to item 1, wherein the repeat unit having formula (A1) has formula (A1-1): 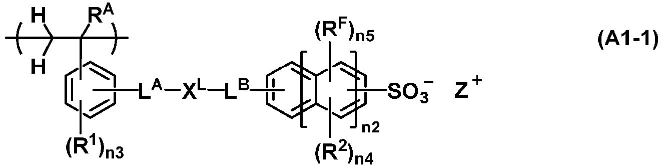 wherein n2 to n5, R^{A}, R¹, R², R^{F}, L^{A}, L^{B}, X^{L}, and Z⁺ are as defined above.
3. The chemically amplified negative resist composition according to item 2, wherein the repeat unit having formula (A1-1) has formula (A1-2): 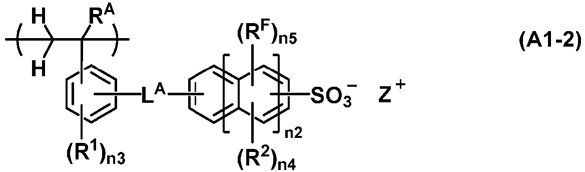 wherein n2 to n5, R^{A}, R¹, R², R^{F}, L^{A}, and Z⁺ are as defined above.
4. The chemically amplified negative resist composition according to any one of items 1 to 3, wherein Z⁺ is a sulfonium cation having formula (cation-1) or an iodonium cation having formula (cation-2): 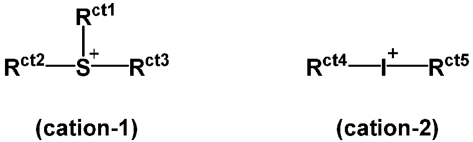 wherein R^{ct1} to R^{ct5} are each independently a halogen atom or a C₁-C₃₀ hydrocarbyl group which may contain a heteroatom, and R^{ct1} and R^{ct2} may bond together to form a ring with a sulfur atom to which they are bonded.
5. The chemically amplified negative resist composition according to any one of items 1 to 4, wherein the polymer further contains at least one moiety selected from a repeat unit having formula (A3) and a repeat unit having formula (A4): 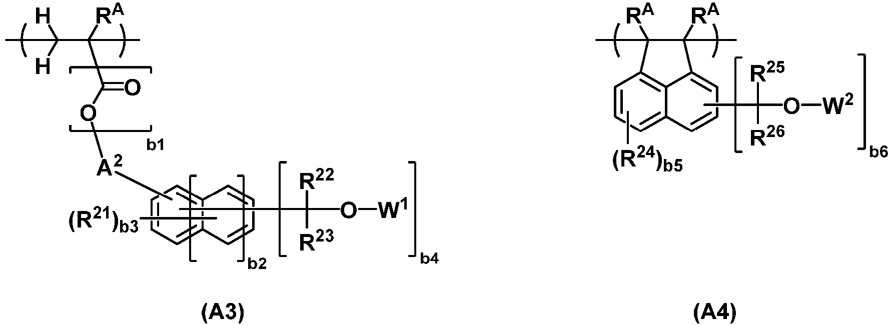 wherein b1 is 0 or 1, b2 is 0, 1, or 2, b3 is an integer satisfying 0 ≤ b3 ≤ 5 + 2(b2) - b4, b4 is 1, 2, or 3, b5 is 0, 1, or 2, and b6 is 1 or 2,
   groups R^{A} are each independently a hydrogen atom, a fluorine atom, a methyl group, or a trifluoromethyl group,
   R²¹ is a halogen atom or a C₁-C₂₀ hydrocarbyl group which may contain a heteroatom, and when b3 is 2 or more, groups R²¹ may be identical or different from each other,
   R²² and R²³ are each independently a hydrogen atom, a C₁-C₁₅ saturated hydrocarbyl group which may be substituted with a hydroxy moiety or a C₁-C₆ saturated hydrocarbyloxy moiety, or a C₆-C₁₅ aryl group which may have a substituent, a case where R²² and R²³ are both hydrogen atoms simultaneously is excluded, R²² and R²³ may bond together to form a ring with a carbon atom to which they are bonded, and some -CH₂- in the ring may be replaced by -O- or -S-,
   R²⁴ is a halogen atom or a C₁-C₂₀ hydrocarbyl group which may contain a heteroatom, and when b5 is 2 or more, groups R²⁴ may be identical or different from each other,
   R²⁵ and R²⁶ are each independently a hydrogen atom, a C₁-C₁₅ saturated hydrocarbyl group which may be substituted with a hydroxy moiety or a C₁-C₆ saturated hydrocarbyloxy moiety, or a C₆-C₁₅ aryl group which may have a substituent, a case where R²⁵ and R²⁶ are both hydrogen atoms simultaneously is excluded, R²⁵ and R²⁶ may bond together to form a ring with a carbon atom to which they are bonded, and some -CH₂- in the ring may be replaced by -O- or -S-,
   A² is a single bond or a C₁-C₁₀ saturated hydrocarbylene group in which some constituent -CH₂- may be replaced by -O-, and
   W¹ and W² are each independently a hydrogen atom, a C₁-C₁₀ aliphatic hydrocarbyl group, a C₂-C₁₀ aliphatic hydrocarbylcarbonyl group, or a C₆-C₁₅ aryl group which may have a substituent.
6. The chemically amplified negative resist composition according to any one of items 1 to 5, wherein the polymer further contains at least one moiety selected from a repeat unit having formula (A5), a repeat unit having formula (A6), and a repeat unit having formula (A7): 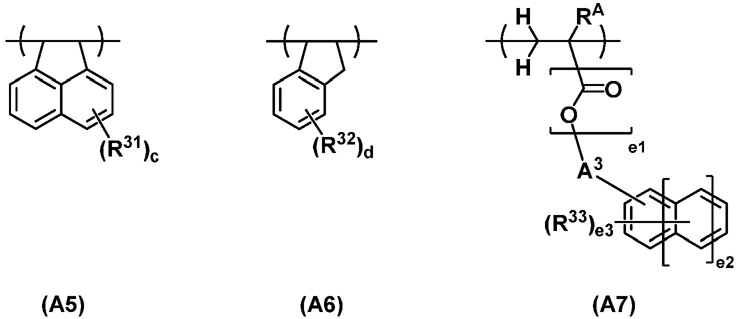
   wherein c and d are each independently 0, 1, 2, 3, or 4, e1 is 0 or 1, e2 is 0, 1, or 2, and
   e3 is 0, 1, 2, 3, 4, or 5,
      R^{A} is a hydrogen atom, a fluorine atom, a methyl group, or a trifluoromethyl group,
      R³¹ and R³² are each independently a hydroxy group, a halogen atom, a C₁-C₈ saturated hydrocarbyl group which may be substituted with a halogen atom, a C₁-C₈ saturated hydrocarbyloxy group which may be substituted with a halogen atom, or a C₂-C₈ saturated hydrocarbylcarbonyloxy group which may be substituted with a halogen atom, when c is 2 or more, groups R³¹ may be identical or different from each other, and when d is 2 or more, groups R³² may be identical or different from each other,
      R³³ is a C₁-C₂₀ saturated hydrocarbyl group, a C₁-C₂₀ saturated hydrocarbyloxy group, a C₂-C₂₀ saturated hydrocarbylcarbonyloxy group, a C₂-C₂₀ saturated hydrocarbyloxyhydrocarbyl group, a C₂-C₂₀ saturated hydrocarbylthiohydrocarbyl group, a halogen atom, a nitro group, a cyano group, a C₁-C₂₀ saturated hydrocarbylsulfinyl group, or a C₁-C₂₀ saturated hydrocarbylsulfonyl group, and when e3 is 2 or more, groups R³³ may be identical or different from each other, and
      A³ is a single bond or a C₁-C₁₀ saturated hydrocarbylene group in which some constituent -CH₂- may be replaced by -O-.
7. The chemically amplified negative resist composition according to item 5,
   wherein the polymer contains the repeat unit having formula (A1), a repeat unit having formula (A2-1), and a repeat unit having formula (A3-1), (A3-2), or (A4-1): 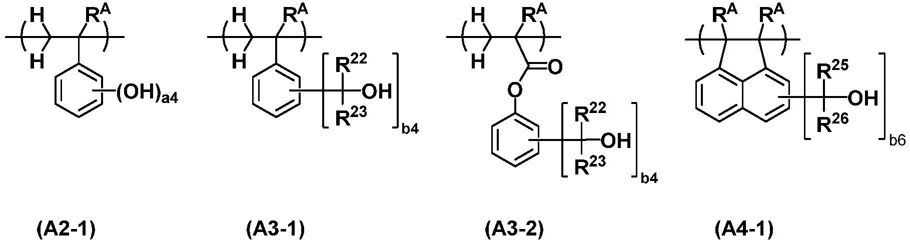 wherein a4, b4, b6, R^{A}, R²², R²³, R²⁵, and R²⁶ are as defined above.
8. The chemically amplified negative resist composition according to item 5,
   wherein the base polymer (A) further contains a polymer which contains the repeat unit having formula (A2) and the repeat unit having above formula (A3) or (A4) and is free of the repeat unit having formula (A1).
9. The chemically amplified negative resist composition according to item 1,
   wherein a content of a repeat unit having an aromatic ring structure in all repeat units of the polymer contained in the base polymer is 60 mol% or more.
10. The chemically amplified negative resist composition according to any one of items 1 to 9, further containing (B) a crosslinker.
11. The chemically amplified negative resist composition according to item 5, which is free of a crosslinker.
12. The chemically amplified negative resist composition according to any one of items 1 to 11, further containing (C) a fluorinated polymer which contains at least one moiety selected from a repeat unit having formula (C1), a repeat unit having formula (C2), a repeat unit having formula (C3), and a repeat unit having formula (C4), and may further contain at least one moiety selected from a repeat unit having formula (C5) and a repeat unit having formula (C6): 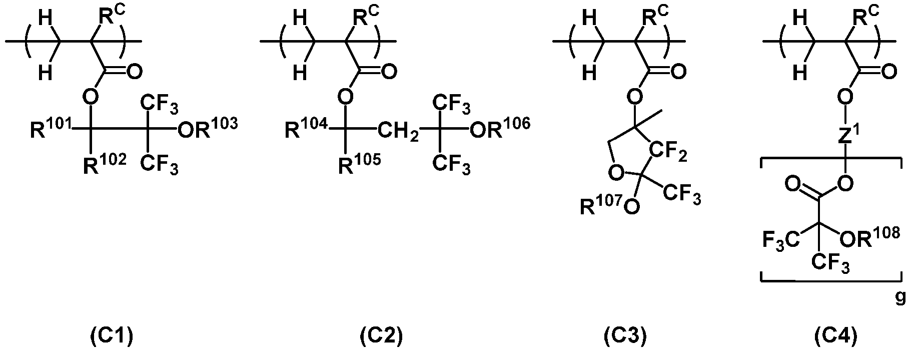 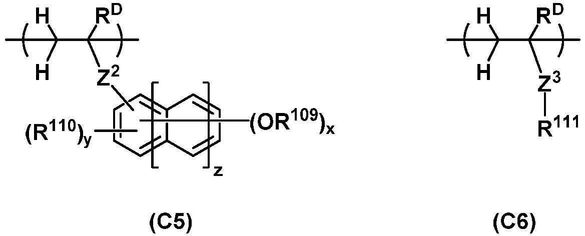 wherein x is 1, 2, or 3, y is an integer satisfying 0 ≤ y ≤ 5 + 2z - x, z is 0 or 1, and g is 1, 2, or 3,
   groups R^{C} are each independently a hydrogen atom, a fluorine atom, a methyl group, or a trifluoromethyl group,
   groups R^{D} are each independently a hydrogen atom or a methyl group,
   R¹⁰¹, R¹⁰², R¹⁰⁴, and R¹⁰⁵ are each independently a hydrogen atom or a C₁-C₁₀ saturated hydrocarbyl group,
   R¹⁰³, R¹⁰⁶, R¹⁰⁷, and R¹⁰⁸ are each independently a hydrogen atom, a C₁-C₁₅ hydrocarbyl group, a C₁-C₁₅ fluorinated hydrocarbyl group, or an acid labile group, and when R¹⁰³, R¹⁰⁶, R¹⁰⁷, and R¹⁰⁸ are each a hydrocarbyl group or a fluorinated hydrocarbyl group, an ether bond or a carbonyl group may intervene in a carbon-carbon bond,
   R¹⁰⁹ is a hydrogen atom or a C₁-C₅ linear or branched hydrocarbyl group in which a heteroatom-containing moiety may intervene in a carbon-carbon bond, and when x is 2 or more, groups R¹⁰⁹ may be identical or different from each other,
   R¹¹⁰ is a C₁-C₅ linear or branched hydrocarbyl group in which a heteroatom-containing moiety may intervene in a carbon-carbon bond, and when y is 2 or more, groups R¹¹⁰ may be identical or different from each other,
   R¹¹¹ is a C₁-C₂₀ saturated hydrocarbyl group in which at least one hydrogen atom is substituted with a fluorine atom, and some -CH₂- in the saturated hydrocarbyl group may be replaced by an ester bond or an ether bond,
   Z¹ is a C₁-C₂₀ (g+1)-valent hydrocarbon group or a C₁-C₂₀ (g+1)-valent fluorinated hydrocarbon group,
   Z² is a single bond, *-C(=O)-O-, or *-C(=O)-NH-, wherein the asterisk (*) designates a point of attachment to a carbon atom in a backbone,
   Z³ is a single bond, -O-, *-C(=O)-O-Z³¹-Z³²-, or *-C(=O)-NH-Z³¹-Z³²-, Z³¹ is a single bond or a C₁-C₁₀ saturated hydrocarbylene group, and Z³² is a single bond, an ester bond, an ether bond, or a sulfonamide bond, wherein the asterisk (*) designates a point of attachment to a carbon atom in a backbone.
13. The chemically amplified negative resist composition according to any one of items 1 to 12, further containing (D) a quencher.
14. The chemically amplified negative resist composition according to any one of items 1 to 13, further containing (E) an organic solvent.
15. The chemically amplified negative resist composition according to any one of items 1 to 14, further containing (F) a photoacid generator.
16. A resist pattern forming process including the steps of:
   applying the chemically amplified negative resist composition of any one of items 1 to 15 onto a substrate to form a resist film thereon,
   exposing the resist film patternwise to high-energy radiation, and
   developing the exposed resist film in an alkaline developer.
17. The resist pattern forming process according to item 16, wherein the high-energy radiation is an EUV having a wavelength of 3 to 15 nm or an EB.
18. The resist pattern forming process according to item 16 or 17, wherein the substrate has an outermost surface made of a material containing at least one element selected from chromium, silicon, tantalum, molybdenum, cobalt, nickel, tungsten, and tin.
19. The resist pattern forming process according to any one of items 16 to 18, wherein the substrate is a mask blank of transmission or reflection type.
20. A mask blank of transmission or reflection type which is coated with the chemically amplified negative resist composition according to any one of items 1 to 15.

### ADVANTAGEOUS EFFECTS OF THE INVENTION

Owing to the repeat unit having formula (A1), which is derived from an onium salt type monomer, the chemically amplified negative resist composition of the present invention is effective for controlling acid diffusion during the exposure in pattern formation. When a resist film is formed with use of the composition and processed to form a pattern, the resist film exhibits very high resolution, and provides a pattern with high fidelity and reduced LER. Owing to the repeat unit having formula (A2), when the resist composition is applied onto a substrate to form a resist film, the adhesion of the resist film to the substrate is improved, and solubility in an alkaline developer can be controlled.

### DESCRIPTION OF THE PREFERRED EMBODIMENT

### Chemically Amplified Negative Resist Composition

The chemically amplified negative resist composition of the present invention contains, as the component (A), a base polymer containing a polymer that is adapted to be decomposed under an action of an acid to decrease its solubility in an alkaline developer (hereinafter, the polymer is also referred to as a polymer A).

### (A) Base Polymer

The polymer A contains a repeat unit having formula (A1) (hereinafter, the repeat unit is also referred to as a repeat unit A1).

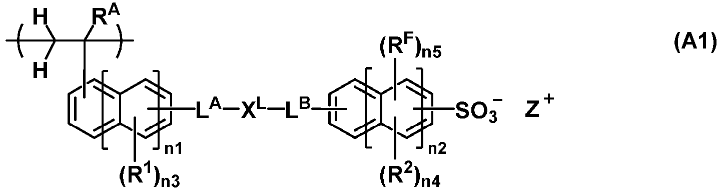

In formula (A1), n1 is 0 or 1. The relevant structure is a benzene ring when n1 is 0, and a naphthalene ring when n1 is 1. The benzene ring corresponding to n1 = 0 is preferable from the viewpoint of solvent solubility. n2 is 0 or 1. n3 is 0, 1, 2, 3, or 4, and is preferably 0, 1, or 2. n4 is 0, 1, 2, 3, or 4, and is preferably 0, 1, or 2. n5 is 0, 1, 2, 3, or 4, and is preferably 1, 2, 3, or 4, and more preferably 2, 3, or 4 from the viewpoint of the acid strength of the generated acid. When n2 is 0, 0 ≤ n4 + n5 ≤ 4, and when n2 is 1, 0 ≤ n4 + n5 ≤ 6. From the viewpoint of solvent solubility, a case where n1 to n5 are all 0 is excluded.

In formula (A1), R^{A} is a hydrogen atom, a fluorine atom, a methyl group, or a trifluoromethyl group. Among them, a hydrogen atom and a methyl group are preferable, and a hydrogen atom is more preferable.

In formula (A1), R¹ is a halogen atom, a nitro group, a cyano group, or a C₁-C₂₀ hydrocarbyl group which may contain a heteroatom. The halogen atom is preferably a fluorine atom, a chlorine atom, a bromine atom, or an iodine atom, and more preferably a fluorine atom or an iodine atom. The hydrocarbyl group may be saturated or unsaturated, and may be linear, branched, or cyclic. Specific examples thereof include C₁-C₂₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-octyl group, a n-nonyl group, a n-decyl group, an undecyl group, a dodecyl group, a tridecyl group, a tetradecyl group, a pentadecyl group, a heptadecyl group, an octadecyl group, a nonadecyl group, and an icosyl group; C₃-C₂₀ cyclic saturated hydrocarbyl groups such as a cyclopropyl group, a cyclopentyl group, a cyclohexyl group, a cyclopropylmethyl group, a 4-methylcyclohexyl group, a cyclohexylmethyl group, a norbornyl group, and an adamantyl group; C₂-C₂₀ alkenyl groups such as a vinyl group, an allyl group, a propenyl group, a butenyl group, and a hexenyl group; C₃-C₂₀ cyclic unsaturated hydrocarbyl groups such as a cyclohexenyl group; C₂-C₂₀ aryl groups such as a phenyl group and a naphthyl group; C₇-C₂₀ aralkyl groups such as a benzyl group, a 1-phenylethyl group, and a 2-phenylethyl group; and groups obtained by combining the foregoing. Among them, an aryl group is preferable. Some or all of hydrogen atoms of the hydrocarbyl group may be substituted with a heteroatom-containing moiety such as an oxygen atom, a sulfur atom, a nitrogen atom, or a halogen atom, and some -CH₂- in the hydrocarbyl group may be substituted with a heteroatom-containing moiety such as an oxygen atom, a sulfur atom, or a nitrogen atom, so that the group may contain a hydroxy group, a cyano group, a fluorine atom, a chlorine atom, a bromine atom, an iodine atom, a carbonyl group, an ether bond, an ester bond, a sulfonic ester bond, a carbonate bond, a lactone ring, a sultone ring, a carboxylic anhydride (-C(=O)-O-C(=O)-), or a haloalkyl group. When n3 is 2 or more, groups R¹ may be identical or different from each other.

When n3 is 2 or more, a plurality of groups R¹ may bond together to form a ring with a carbon atom to which they are bonded. Specific examples of the ring formed include a cyclopropane ring, a cyclobutane ring, a cyclopentane ring, a cyclohexane ring, a norbornane ring, and an adamantane ring. Some or all of hydrogen atoms in the ring may be substituted with a heteroatom-containing moiety such as an oxygen atom, a sulfur atom, a nitrogen atom, or a halogen atom, and some -CH₂- in the ring may be substituted with a heteroatom-containing moiety such as an oxygen atom, a sulfur atom, or a nitrogen atom, so that the group may contain a hydroxy group, a fluorine atom, a chlorine atom, a bromine atom, an iodine atom, a cyano group, a carbonyl group, an ether bond, an ester bond, a sulfonic ester bond, a carbonate bond, a lactone ring, a sultone ring, a carboxylic anhydride (-C(=O)-O-C(=O)-), or a haloalkyl group.

In formula (A1), R² is a C₁-C₂₀ hydrocarbyl group which may contain a heteroatom. The hydrocarbyl group may be saturated or unsaturated, and may be linear, branched, or cyclic. Specific examples thereof include those groups mentioned as the hydrocarbyl group represented by R¹, but are not limited thereto. When n4 is 2 or more, groups R² may be identical or different from each other. When n4 is 2 or more, a plurality of groups R² may bond together to form a ring with a carbon atom to which they are bonded. The ring is preferably a 5- to 8-membered ring.

In formula (A1), R^{F} is a fluorine atom, a C₁-C₆ fluorinated alkyl group, a C₁-C₆ fluorinated alkoxy group, or a C₁-C₆ fluorinated alkylthio group. R^{F} is preferably a fluorine atom, a trifluoromethyl group, a difluoromethyl group, a trifluoromethoxy group, a difluoromethoxy group, a trifluoromethylthio group, or a difluoromethylthio group, and more preferably a fluorine atom, a trifluoromethyl group, or a trifluoromethoxy group. When the polymer A contains a fluorine atom or a fluorine atom-containing substituent, the acid strength of the generated acid is enhanced due to the electron attractive effect, so that a deprotection reaction of acid labile groups such as tertiary ester or tertiary ether groups may smoothly take place. When n5 is 2 or more, groups R^{F} may be identical or different from each other.

In formula (A1), L^{A} and L^{B} are each independently a single bond, an ether bond, an ester bond, a sulfonic ester bond, a sulfonic amide bond, a carbonate bond, or a carbamate bond. Among them, a single bond, an ether bond, an ester bond, or a sulfonic ester bond is preferable, and an ester bond or a sulfonic ester bond is more preferable for L^{A}. A single bond, an ether bond, an ester bond, or a sulfonic ester bond is preferable, and a single bond, an ester bond, or a sulfonic ester bond is more preferable for L^{B}.

In formula (A1), X^{L} is a single bond or a C₁-C₄₀ hydrocarbylene group which may contain a heteroatom. The hydrocarbylene group may be linear, branched, or cyclic, and specific examples thereof include an alkanediyl group, a cyclic saturated hydrocarbylene group, and an arylene group. Specific examples of the heteroatom include an oxygen atom, a nitrogen atom, and a sulfur atom.

Specific examples of the C₁-C₄₀ hydrocarbylene group which may contain a heteroatom represented by X^{L} include those shown below, but are not limited thereto. In the following formulae, each of two asterisks (*) represents a point of attachment to L^{A} or L^{B}.

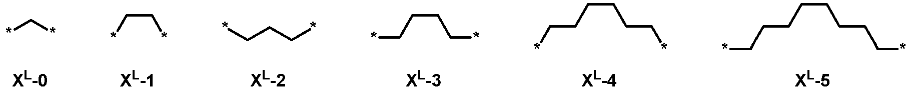

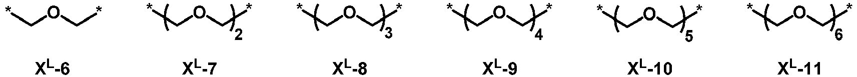

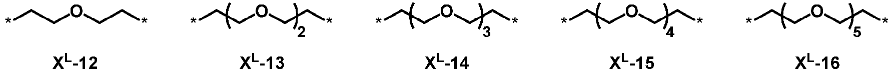

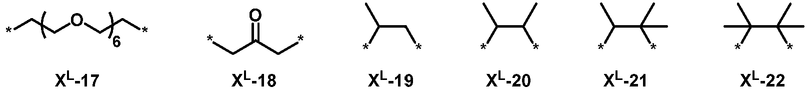

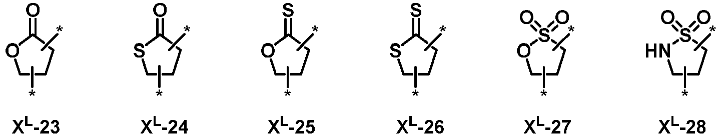

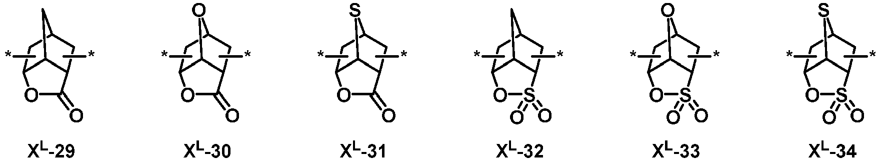

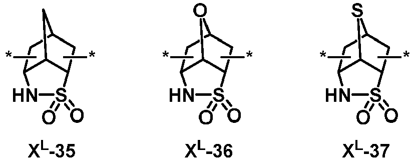

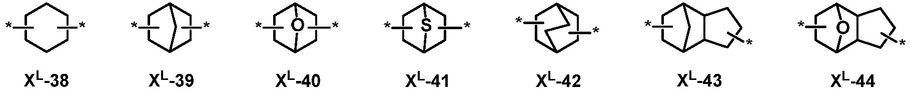

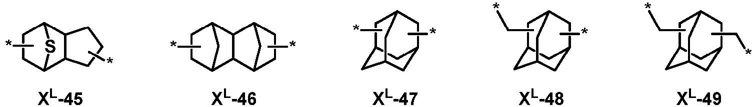

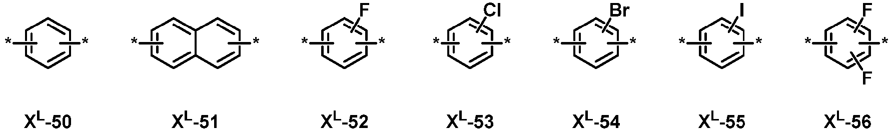

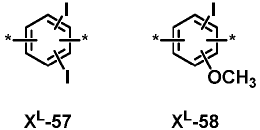

Among them, X^{L}-0 to X^{L}-22, X^{L}-29 to X^{L}-34, and X^{L}-47 to X^{L}-58 are preferable.

The repeat unit A¹ is preferably a repeat unit having formula (A1-1).

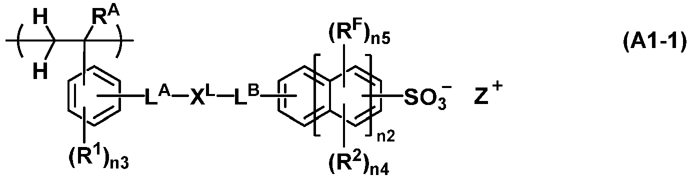

In the formula, n2 to n5, R^{A}, R¹, R², R^{F}, L^{A}, L^{B}, X^{L}, and Z⁺ are as defined above.

The repeat unit having formula (A1-1) is preferably a repeat unit having formula (A1-2).

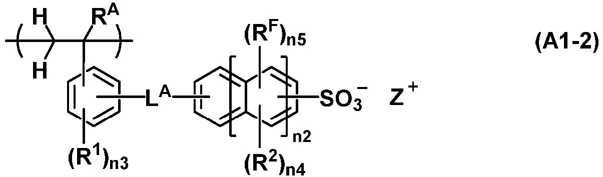

In the formula, n2 to n5, R^{A}, R¹, R², R^{F}, L^{A}, and Z⁺ are as defined above.

Specific examples of an anion in the monomer from which the repeat unit A¹ is derived include those shown below, but are not limited thereto. In the following formulae, Me is a methyl group. The bonding positions of various substituents on the aromatic ring may be interchanged with each other.

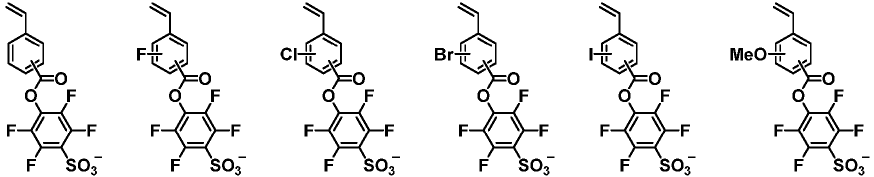

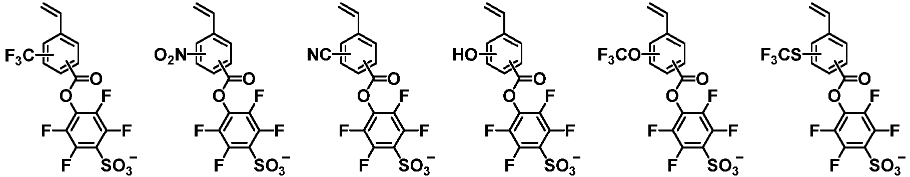

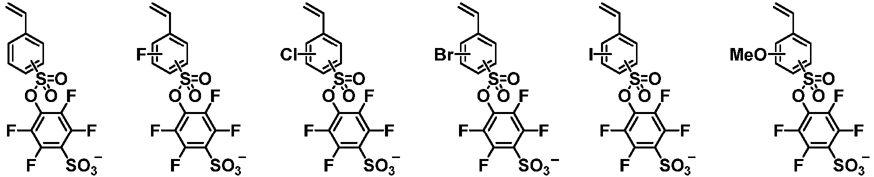

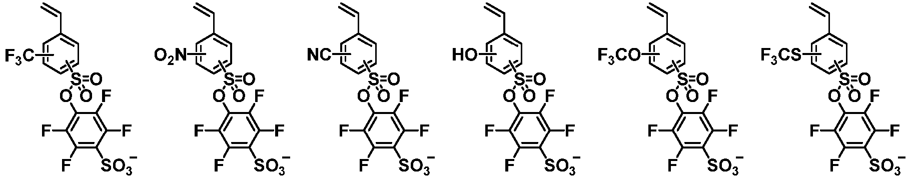

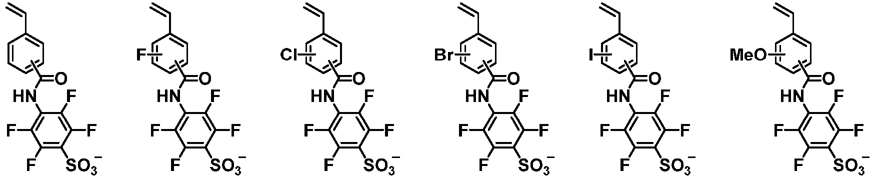

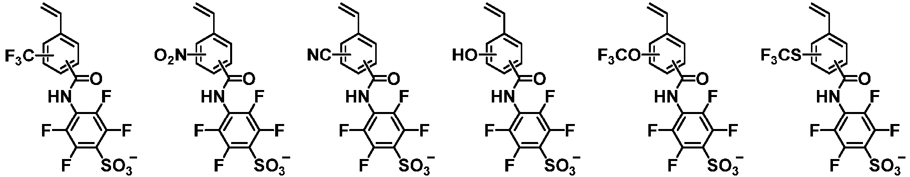

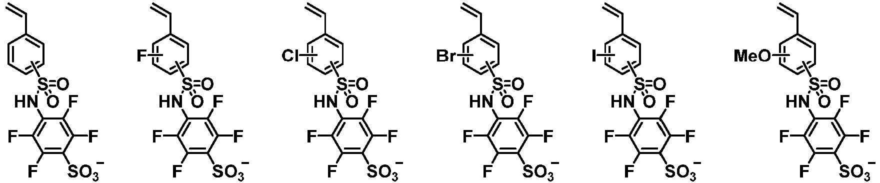

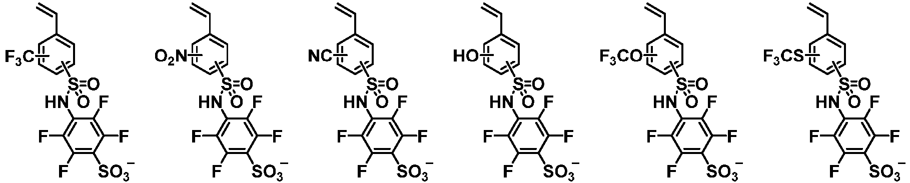

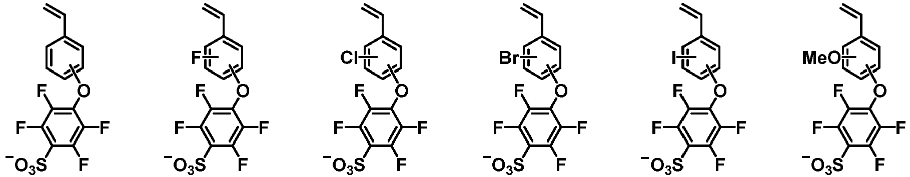

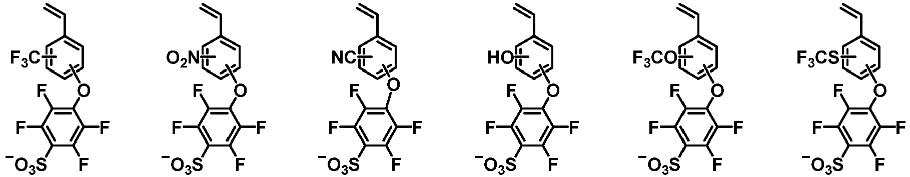

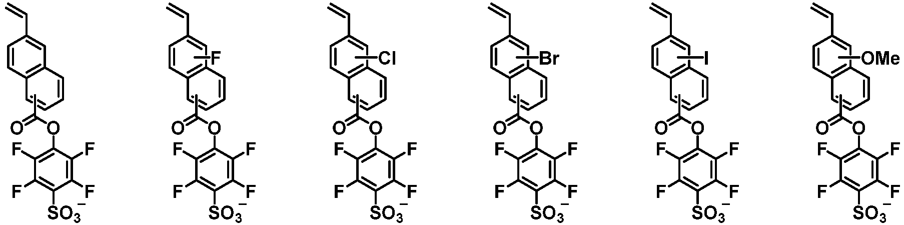

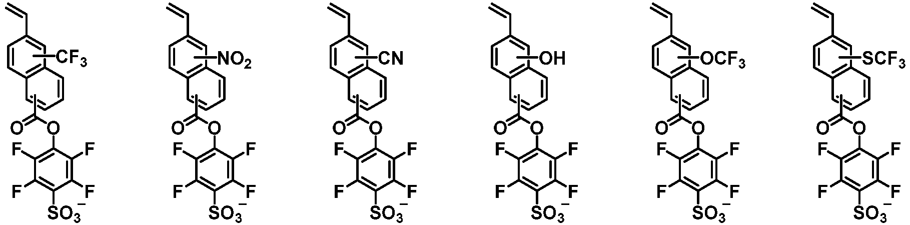

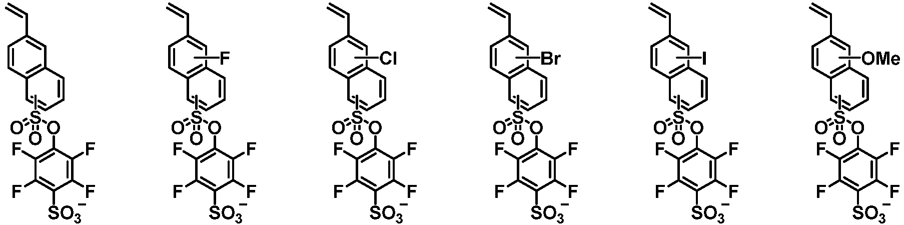

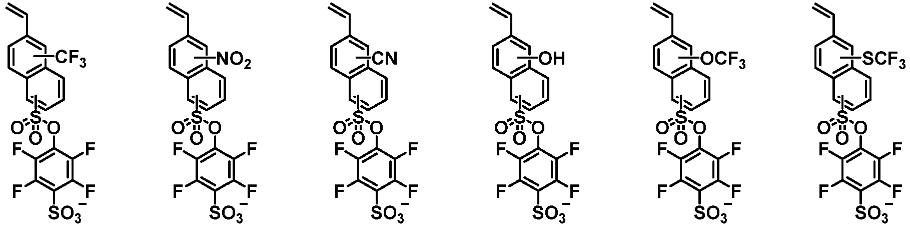

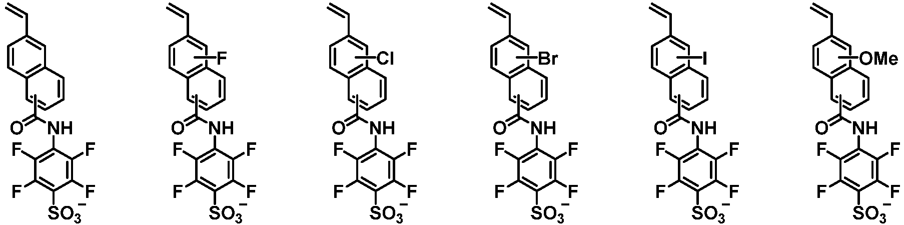

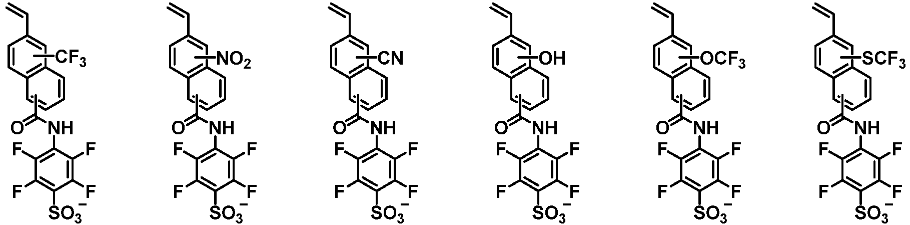

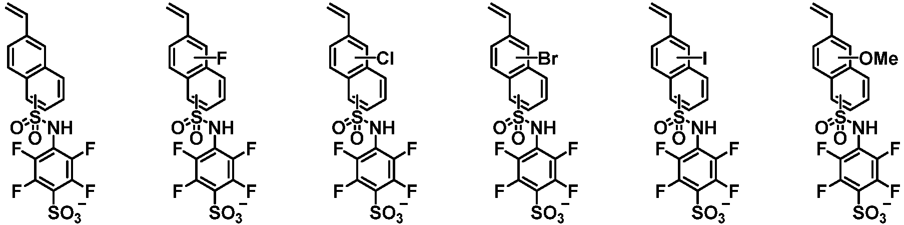

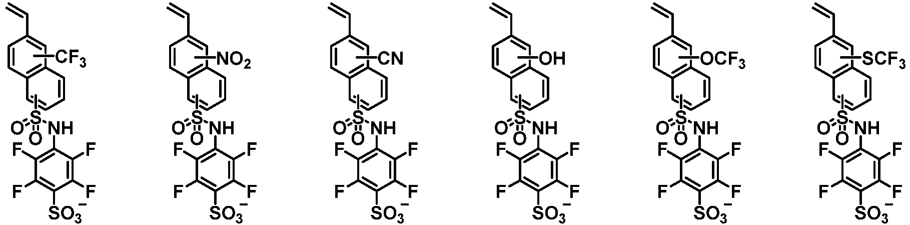

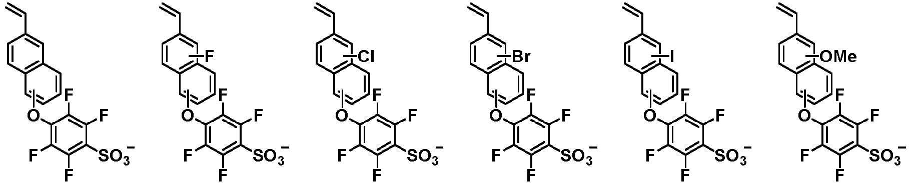

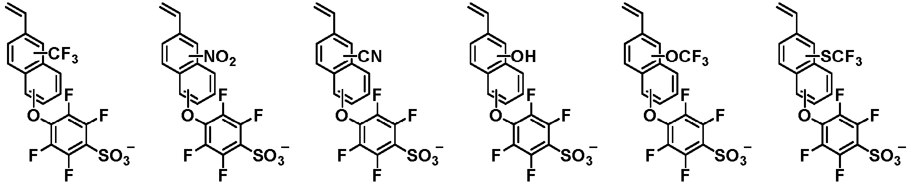

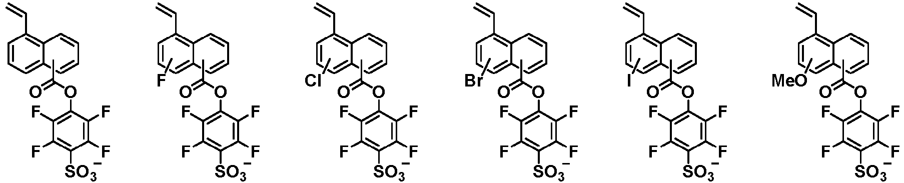

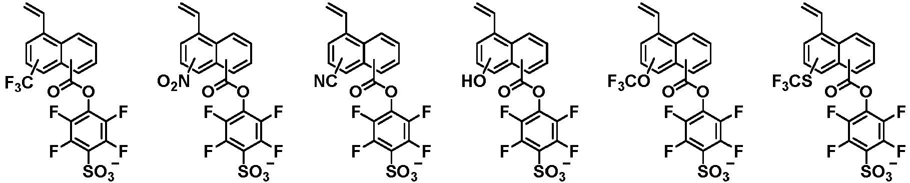

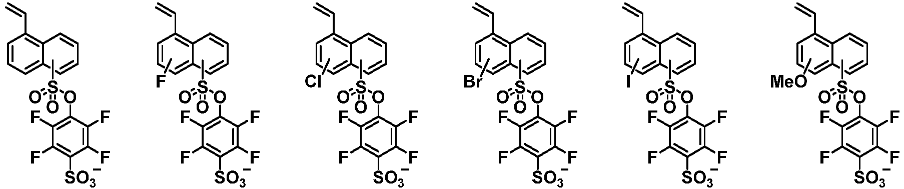

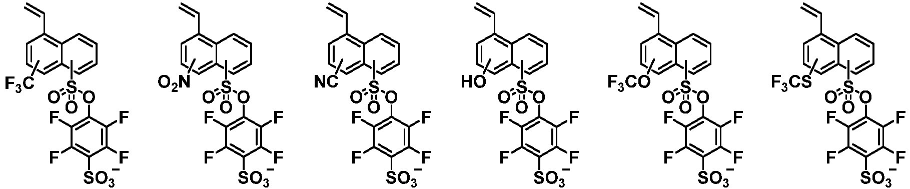

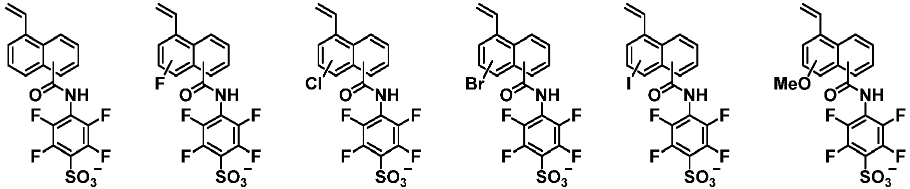

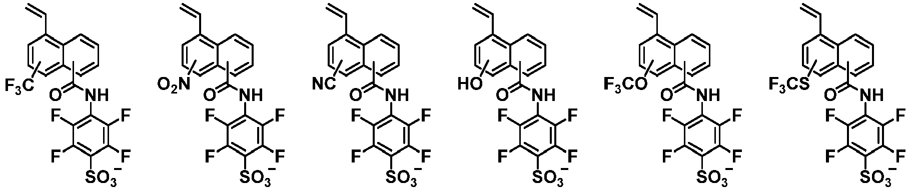

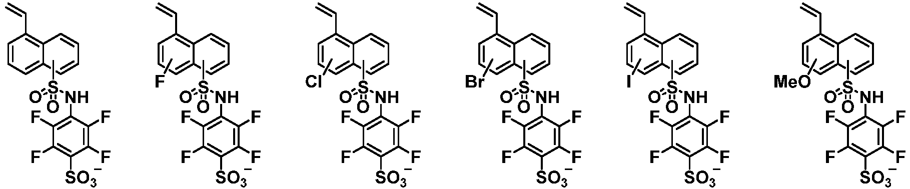

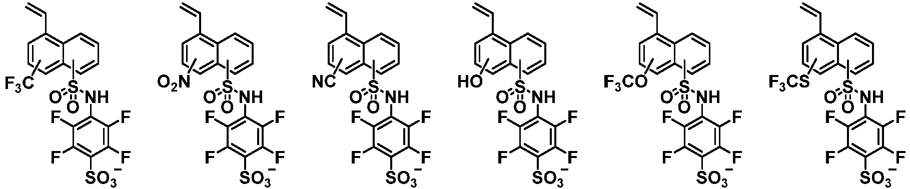

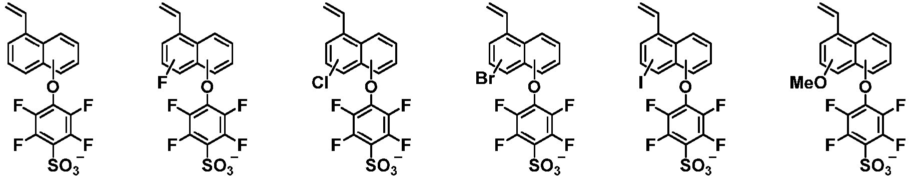

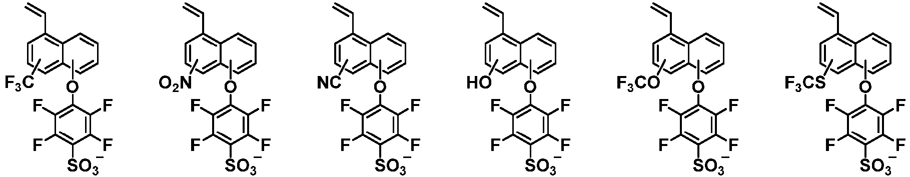

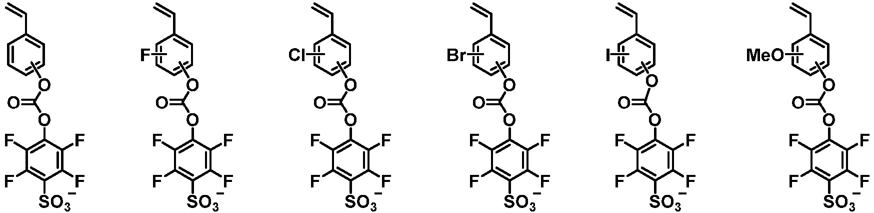

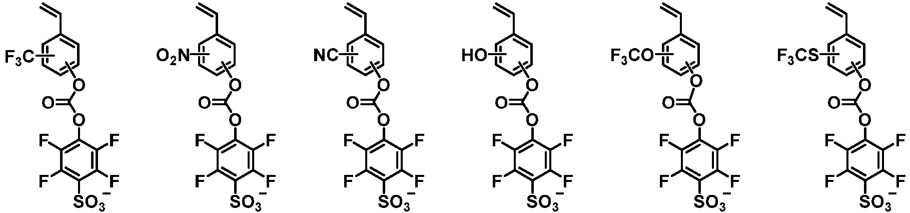

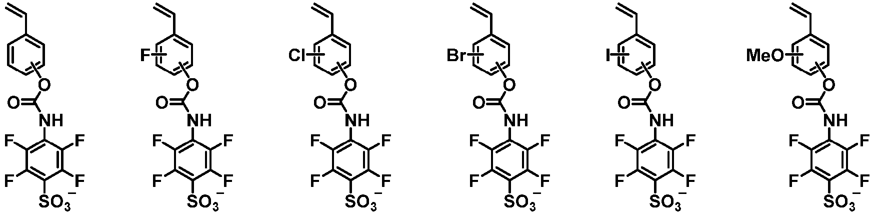

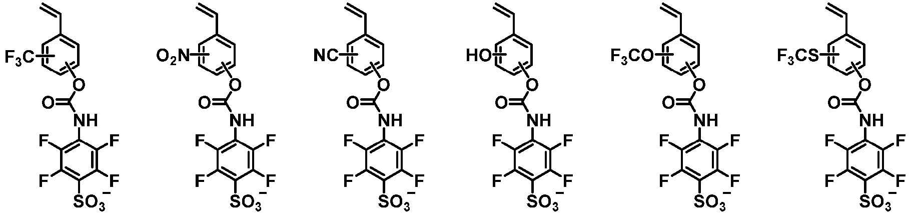

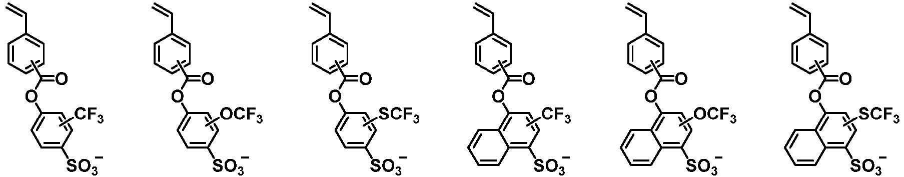

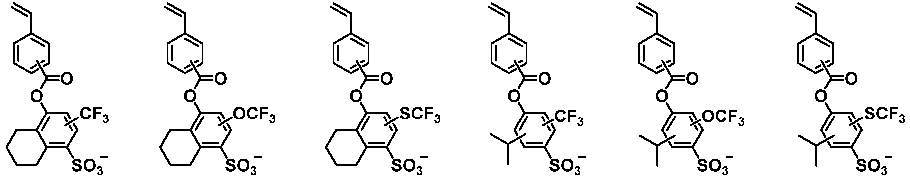

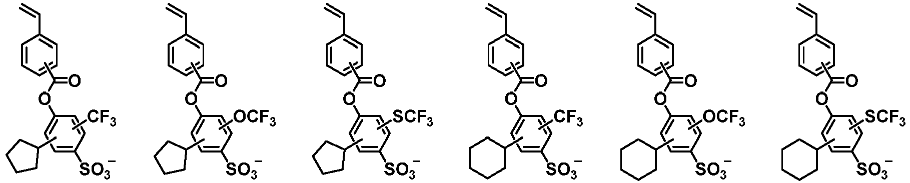

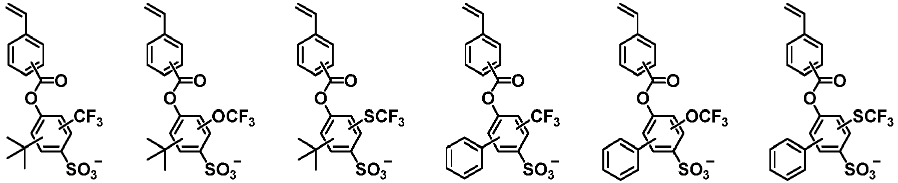

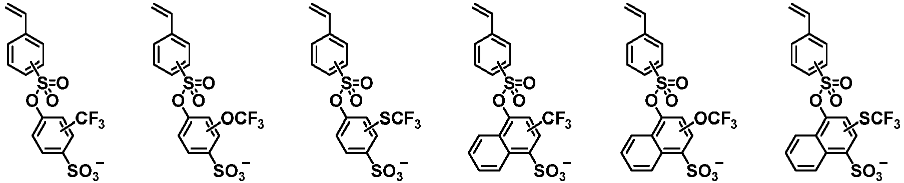

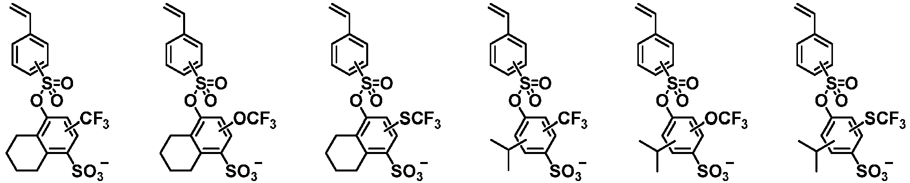

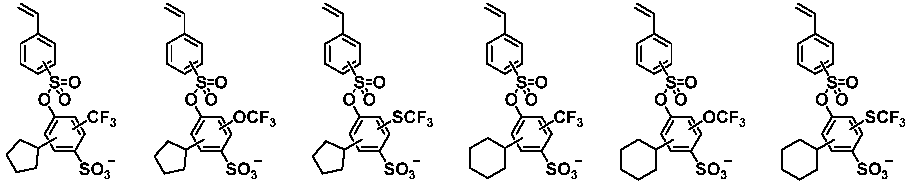

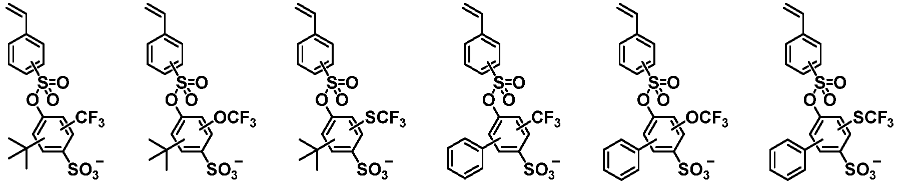

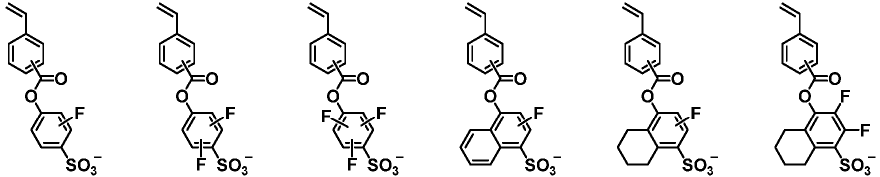

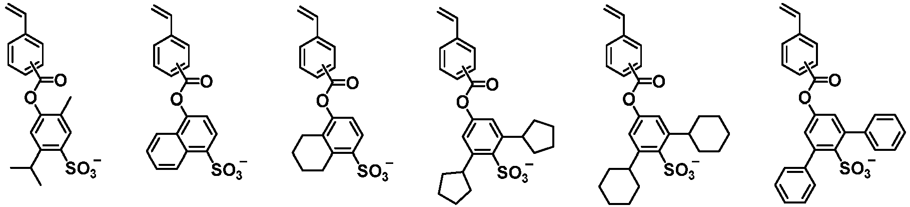

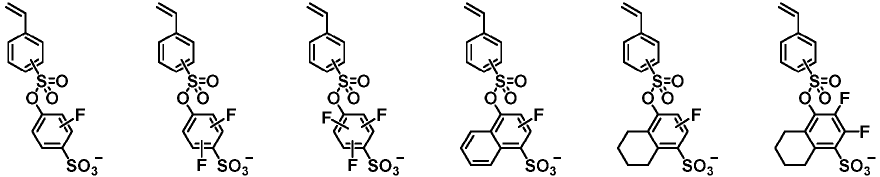

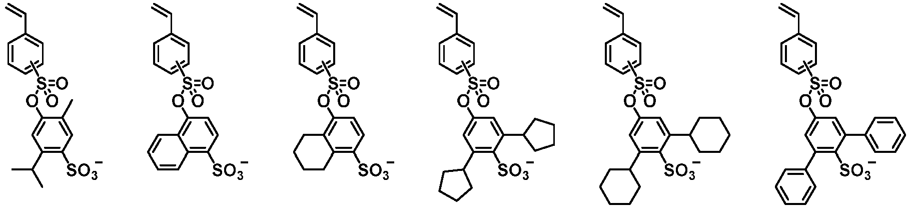

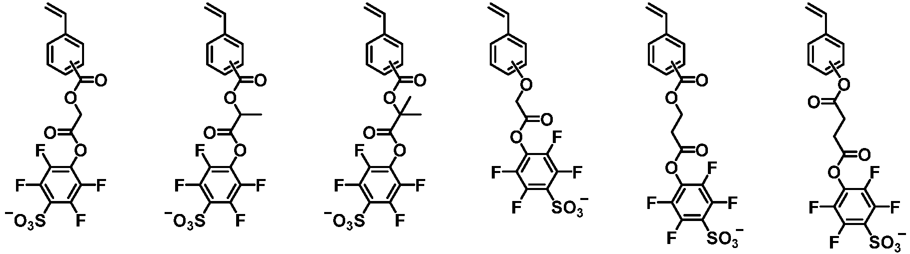

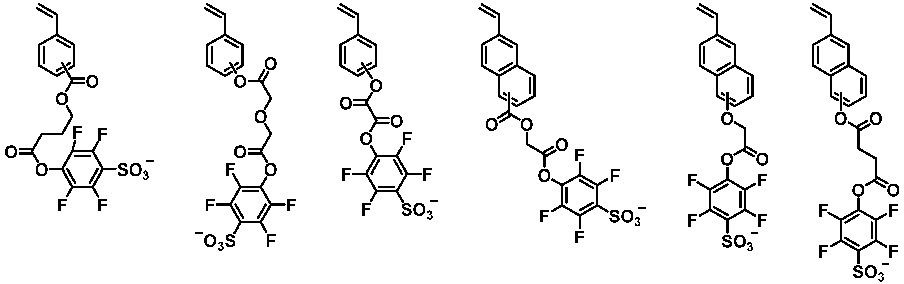

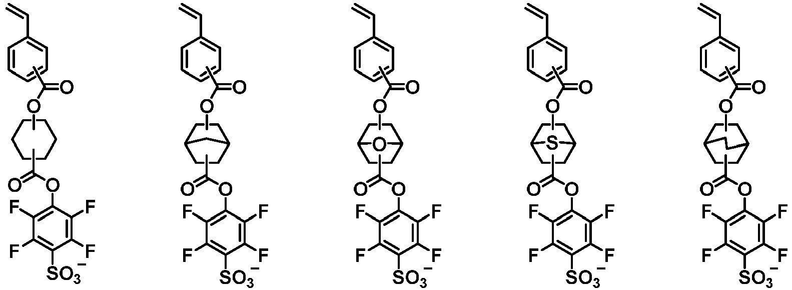

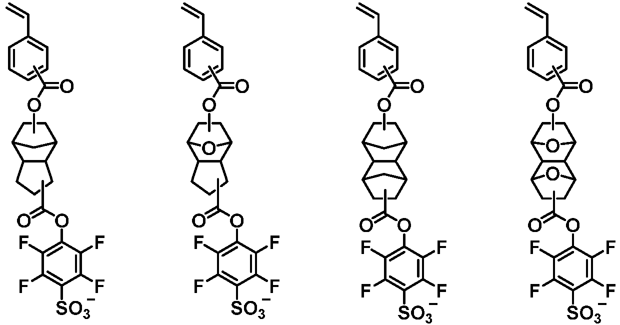

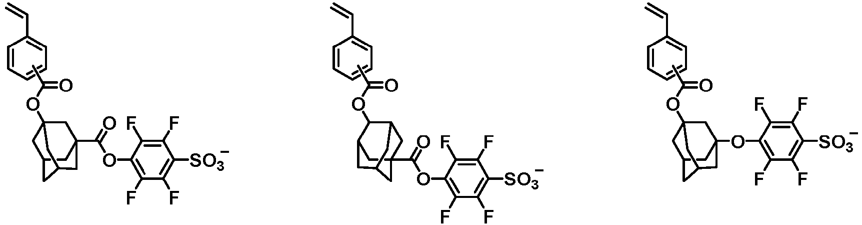

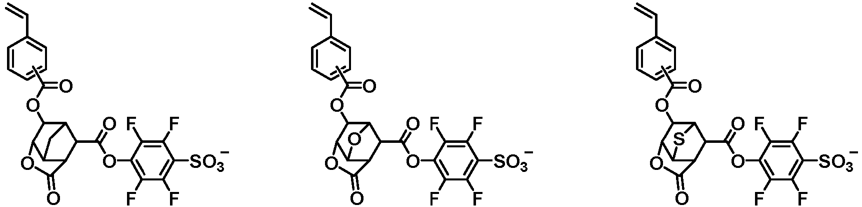

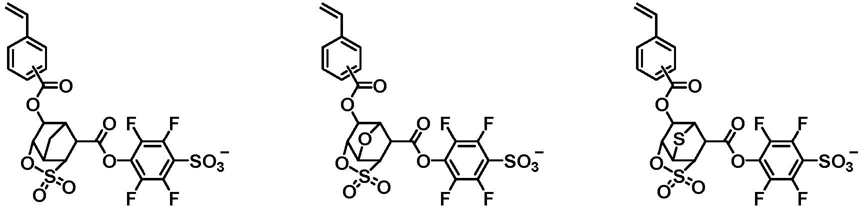

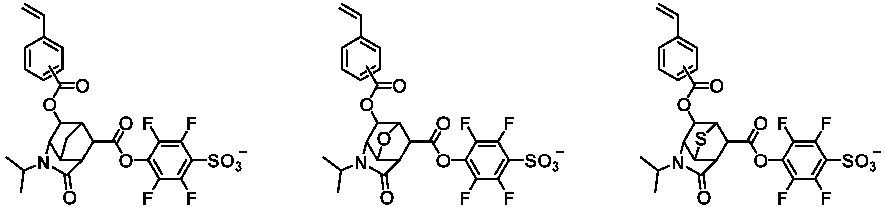

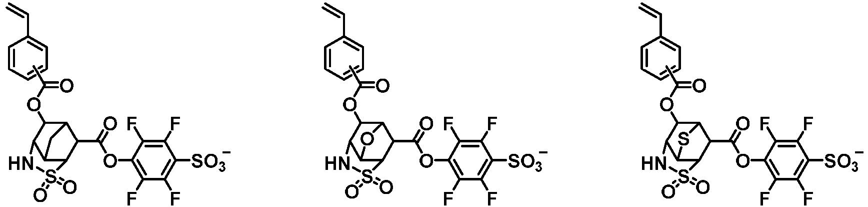

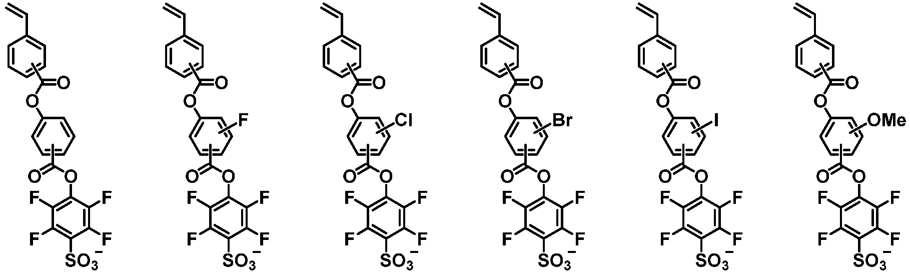

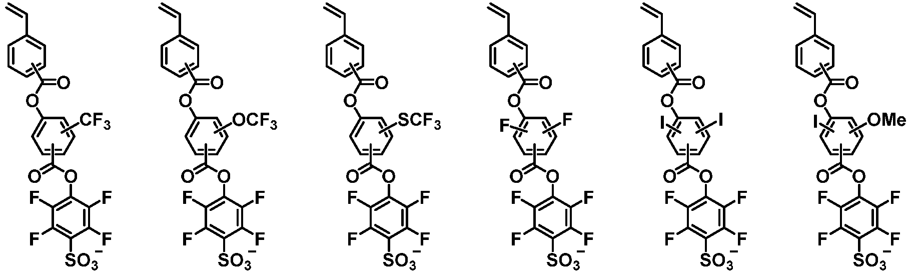

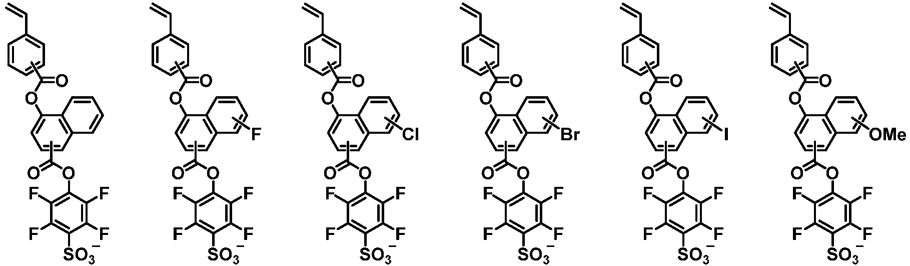

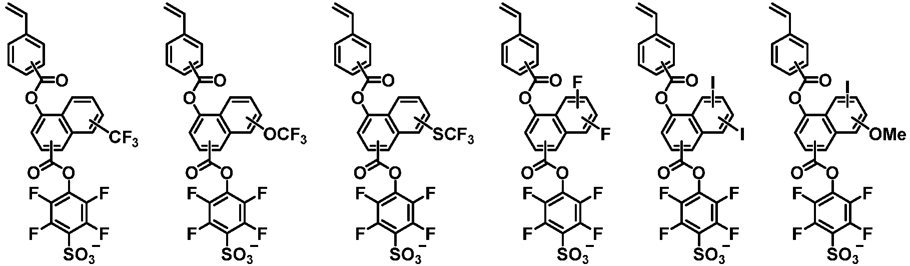

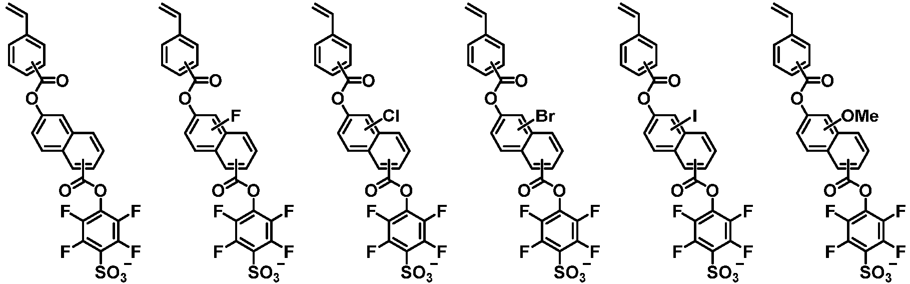

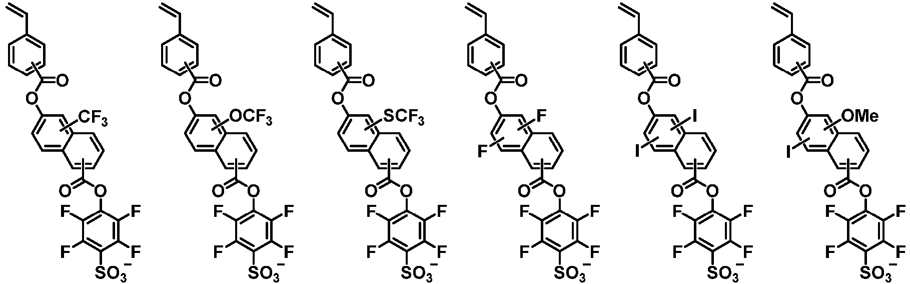

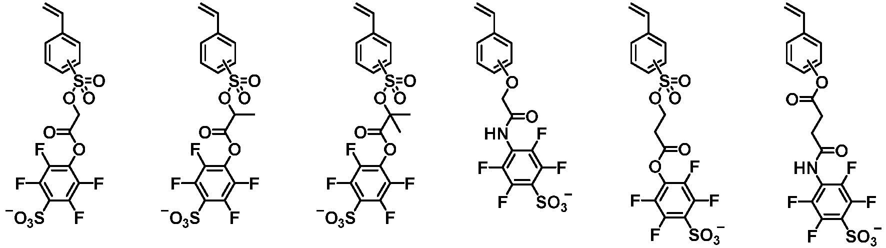

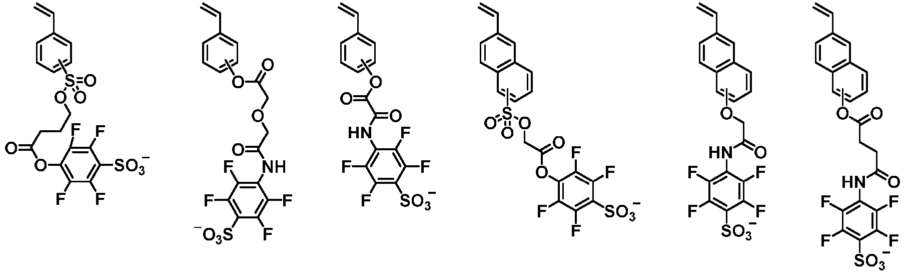

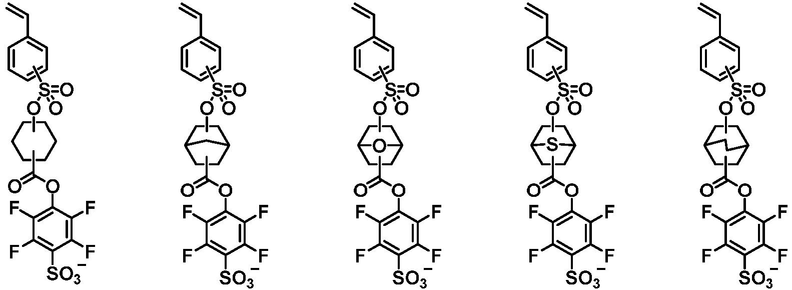

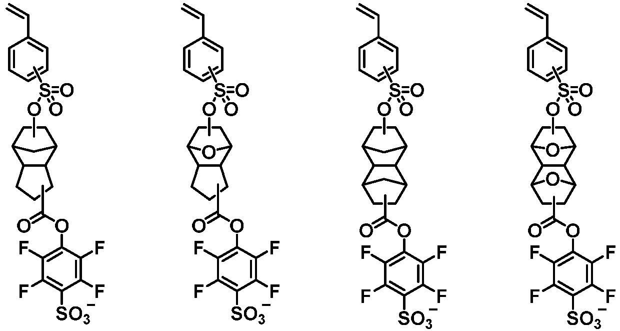

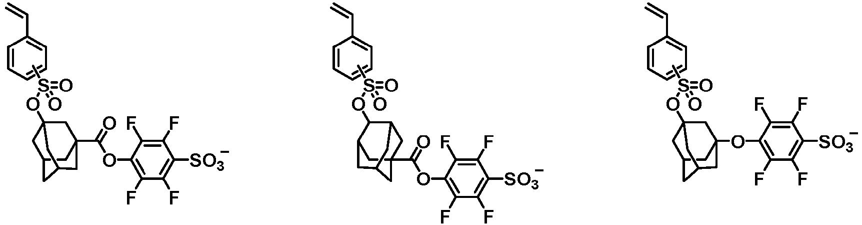

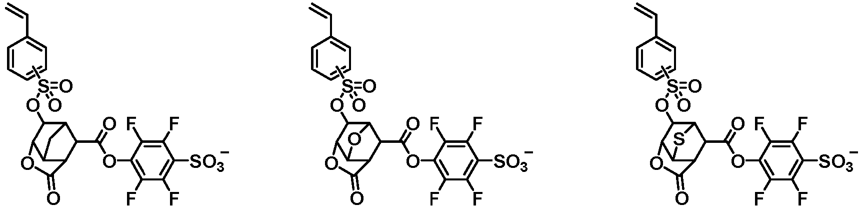

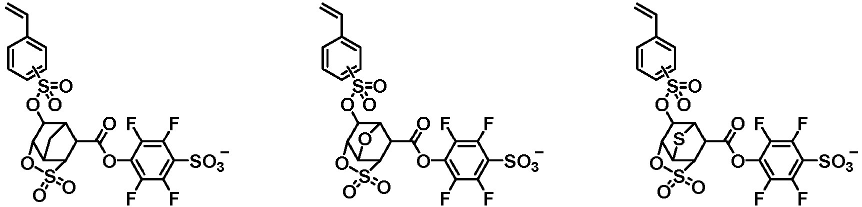

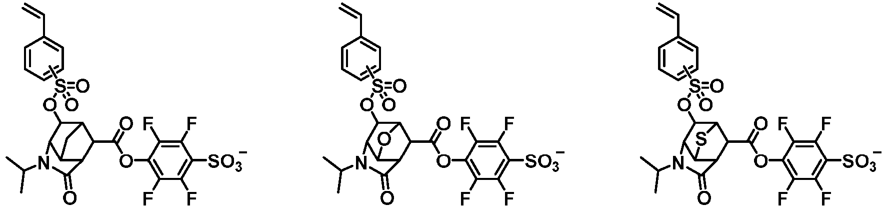

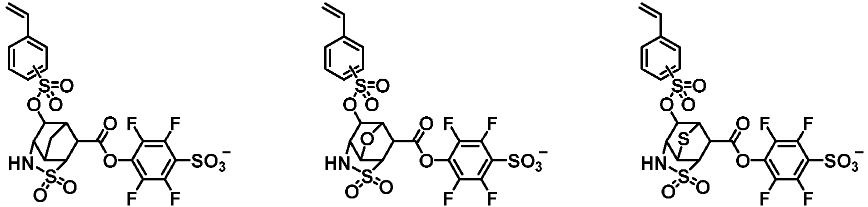

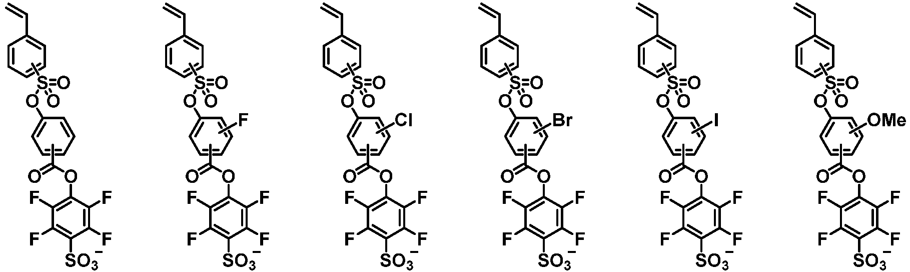

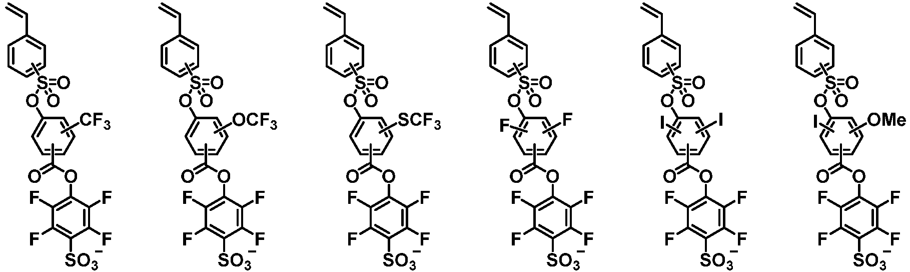

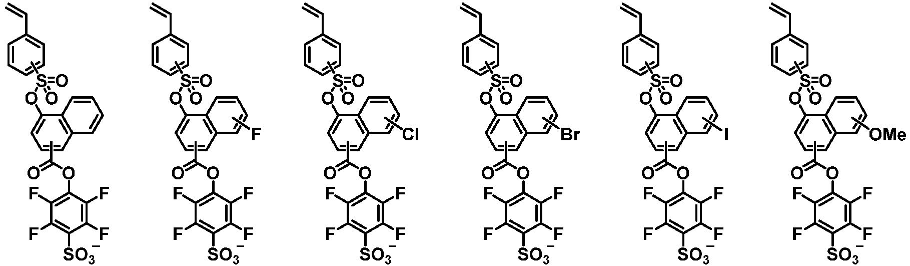

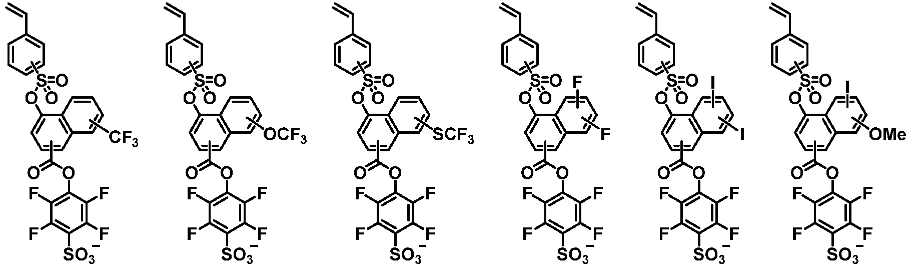

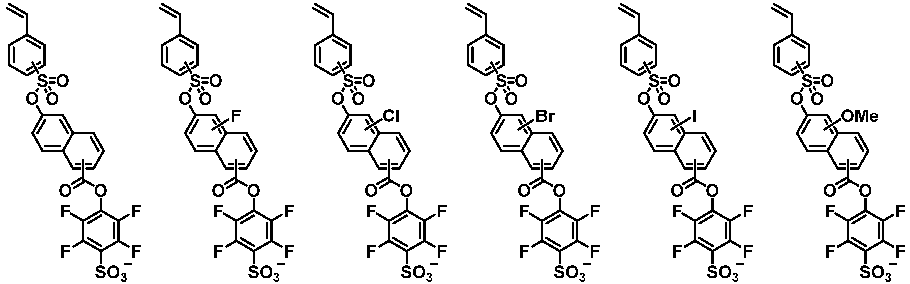

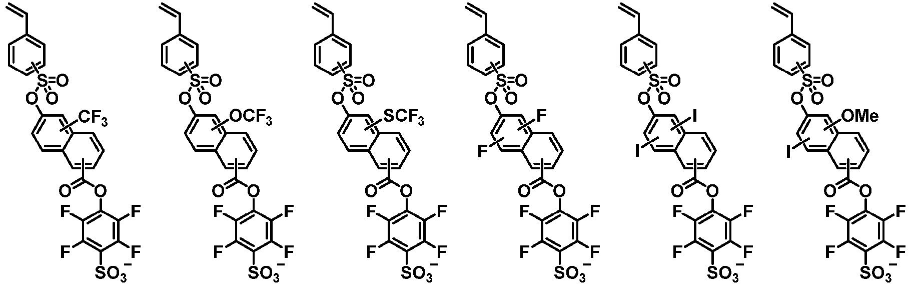

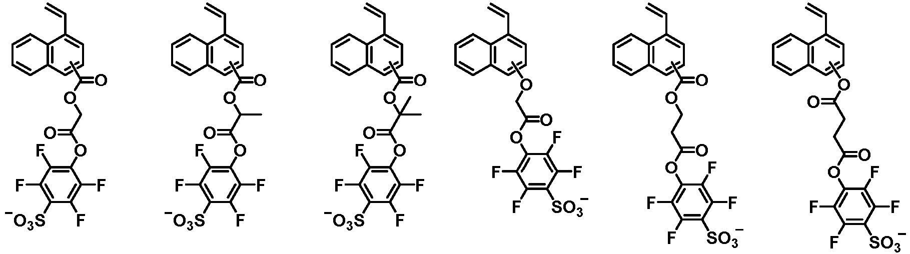

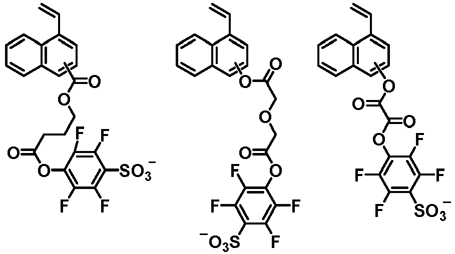

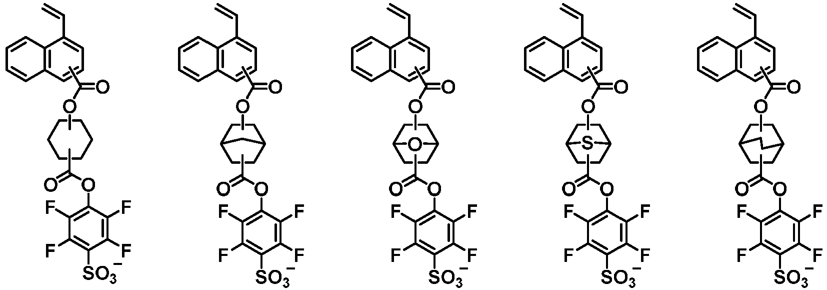

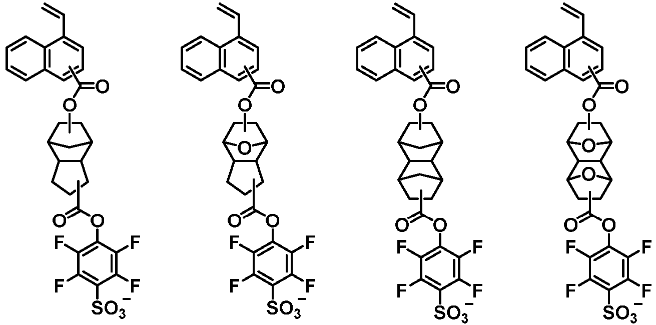

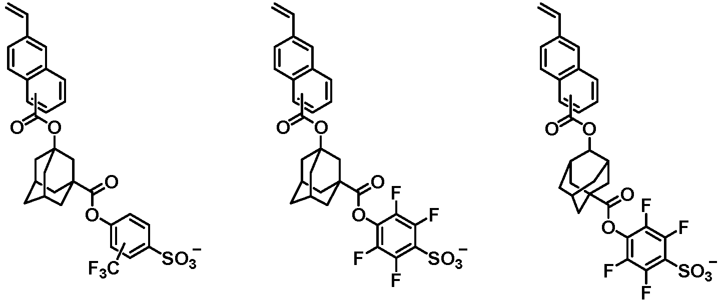

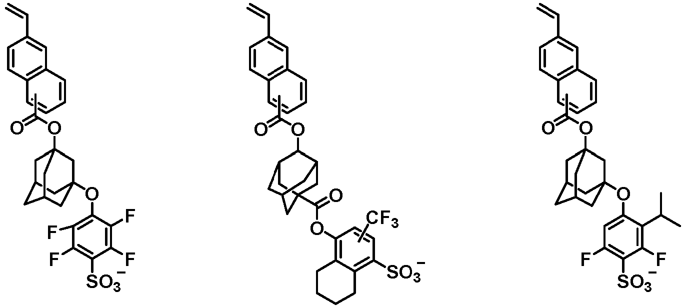

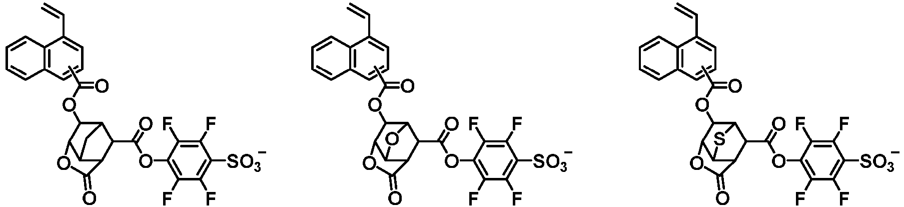

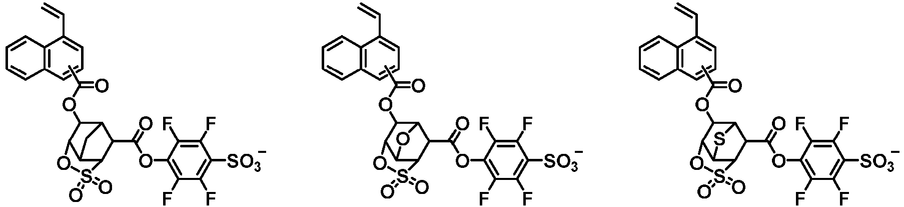

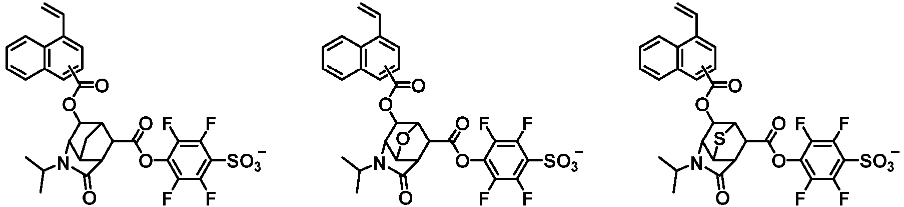

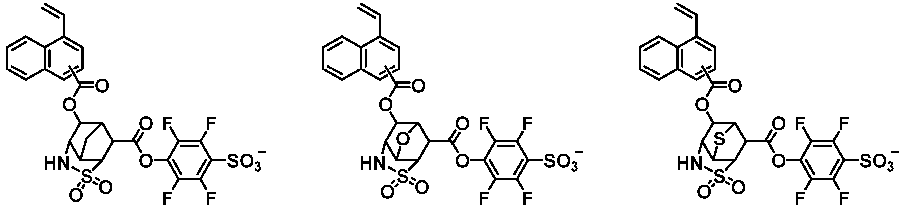

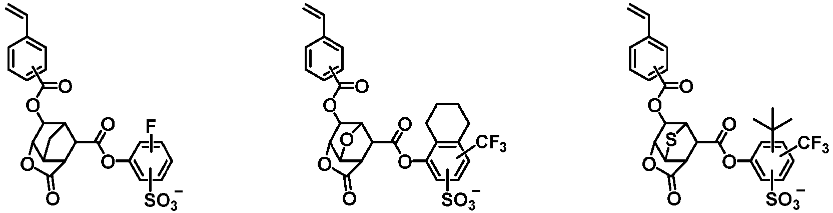

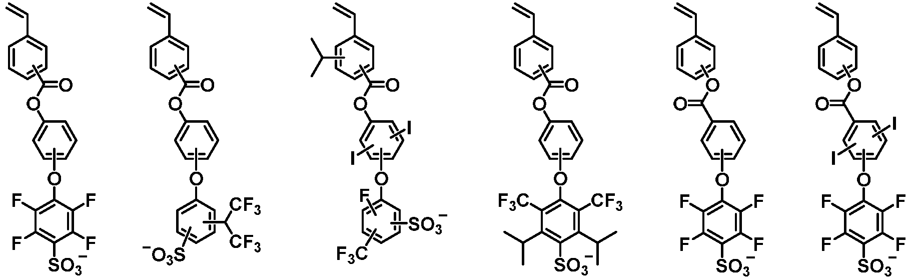

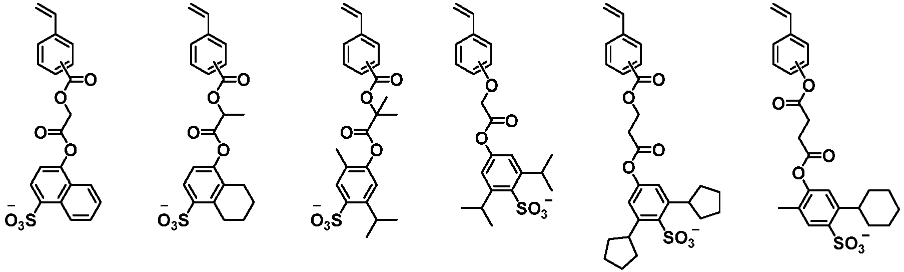

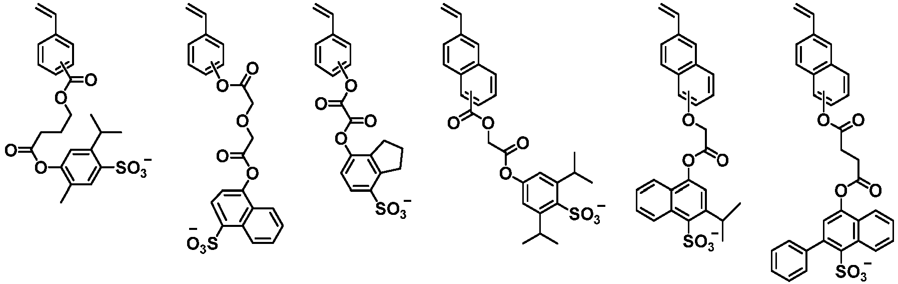

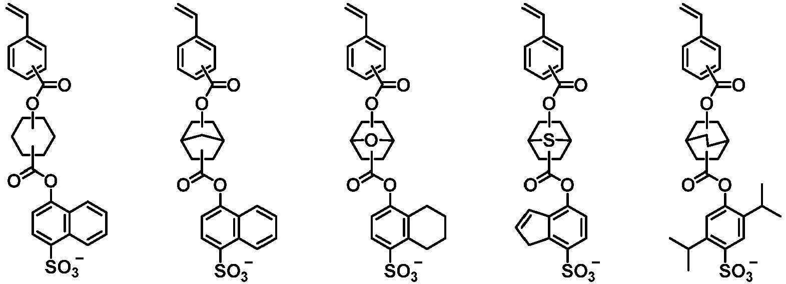

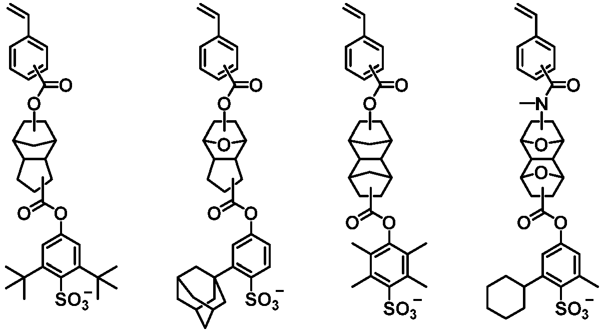

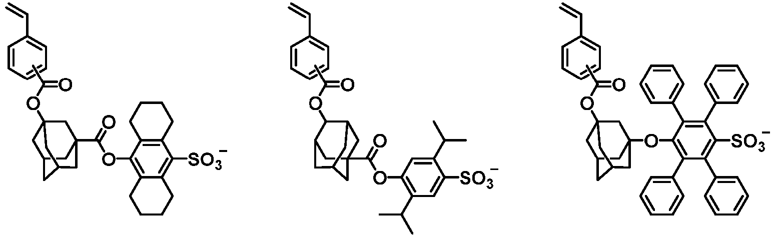

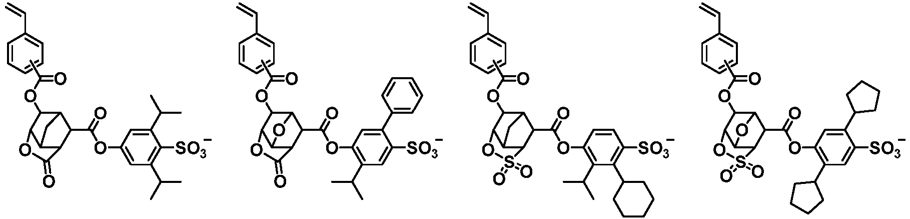

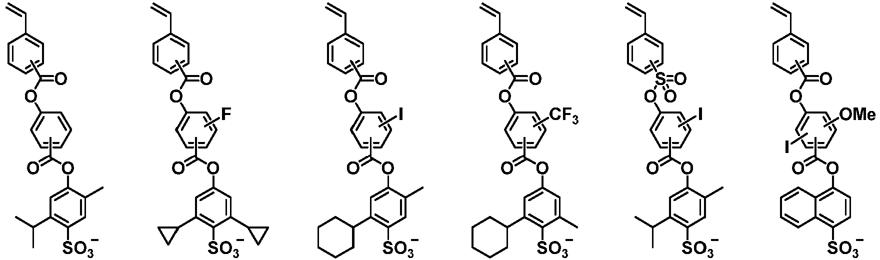

In formula (A1), Z⁺ is an onium cation. The onium cation is preferably a sulfonium cation having formula (cation-1) or an iodonium cation having formula (cation-2).

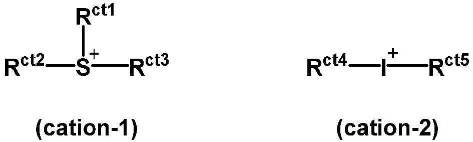

In formulae (cation-1) and (cation-2), R^{ct1} to R^{ct5} are each independently a halogen atom or a C₁-C₃₀ hydrocarbyl group which may contain a heteroatom.

Specific examples of the halogen atom represented by R^{ct1} to R^{ct5} include a fluorine atom, a chlorine atom, a bromine atom, and an iodine atom.

The hydrocarbyl group represented by R^{ct1} to R^{ct5} may be saturated or unsaturated, and may be linear, branched, or cyclic. Specific examples thereof include C₁-C₃₀ alkyl groups such as a methyl group, an ethyl group, a n-propyl group, an isopropyl group, a n-butyl group, an isobutyl group, a sec-butyl group, and a tert-butyl group; C₃-C₃₀ cyclic saturated hydrocarbyl groups such as a cyclopropyl group, a cyclopentyl group, a cyclohexyl group, a cyclopropylmethyl group, a 4-methylcyclohexyl group, a cyclohexylmethyl group, a norbornyl group, and an adamantyl group; C₂-C₃₀ alkenyl groups such as a vinyl group, an allyl group, a propenyl group, a butenyl group, and a hexenyl group; C₃-C₃₀ cyclic unsaturated hydrocarbyl groups such as a cyclohexenyl group; C₆-C₃₀ aryl groups such as a phenyl group, a naphthyl group, and a thienyl group; C₇-C₃₀ aralkyl groups such as a benzyl group, a 1-phenylethyl group, and a 2-phenylethyl group; and groups obtained by combining the foregoing. An aryl group is preferable. Some or all of hydrogen atoms of the hydrocarbyl group may be substituted with a heteroatom-containing moiety such as an oxygen atom, a sulfur atom, a nitrogen atom, or a halogen atom, and some -CH₂- in the hydrocarbyl group may be substituted with a heteroatom-containing moiety such as an oxygen atom, a sulfur atom, or a nitrogen atom, so that the group may contain a hydroxy group, a fluorine atom, a chlorine atom, a bromine atom, an iodine atom, a cyano group, a nitro group, a carbonyl group, an ether bond, an ester bond, a sulfonic ester bond, a carbonate bond, a lactone ring, a sultone ring, a carboxylic anhydride (-C(=O)-O-C(=O)-), or a haloalkyl group.

R^{ct1} and R^{ct2} may bond together to form a ring with a sulfur atom to which they are bonded. Examples of the structure of the ring include those having the following formulae.

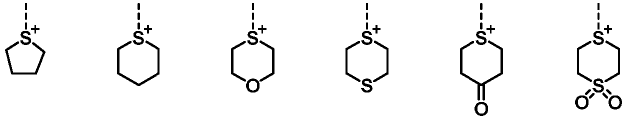

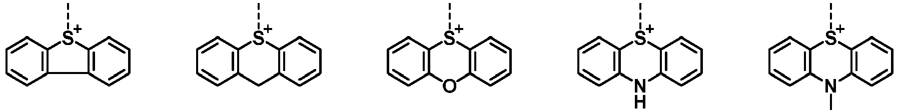

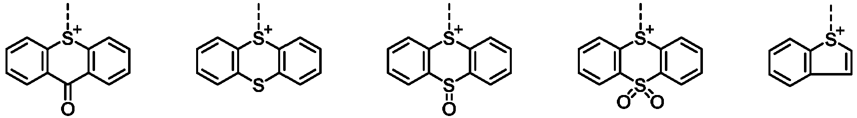

In the formulae, a broken line designates a point of attachment to R^{ct3}.

Specific examples of the sulfonium cation having formula (cation-1) include those shown below, but are not limited thereto.

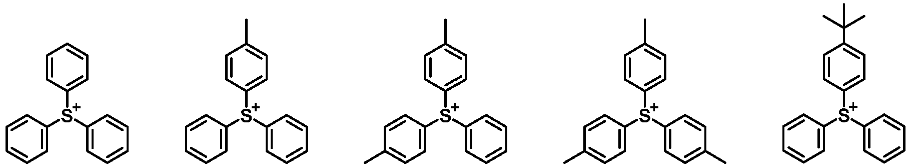

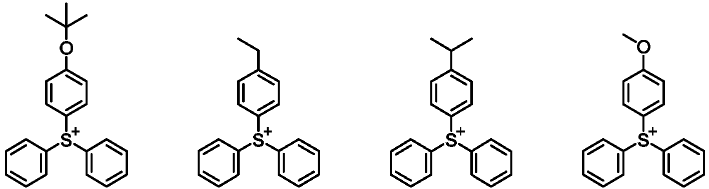

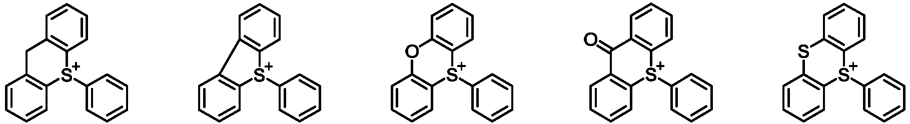

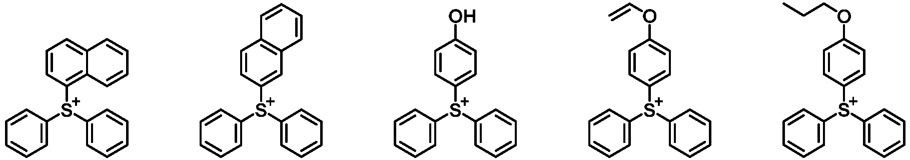

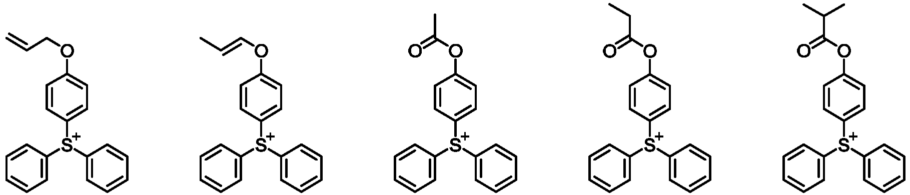

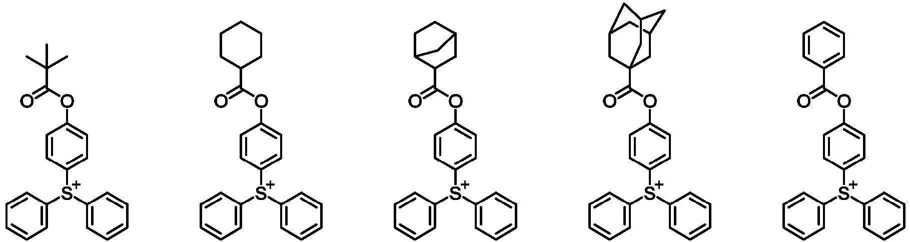

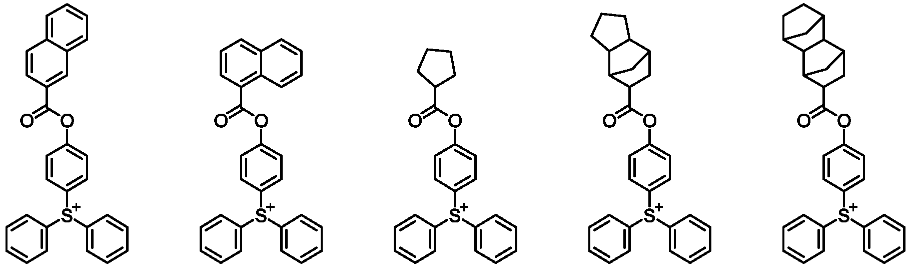

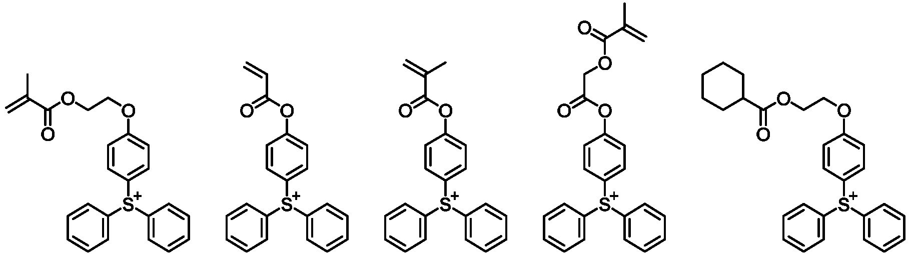

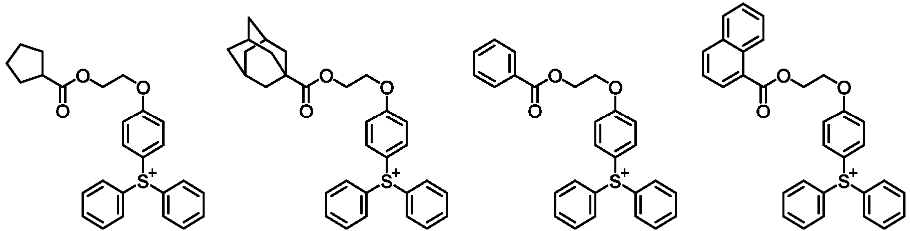

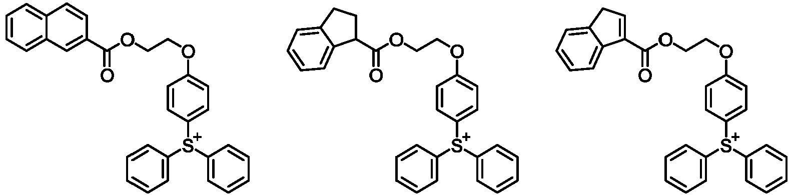

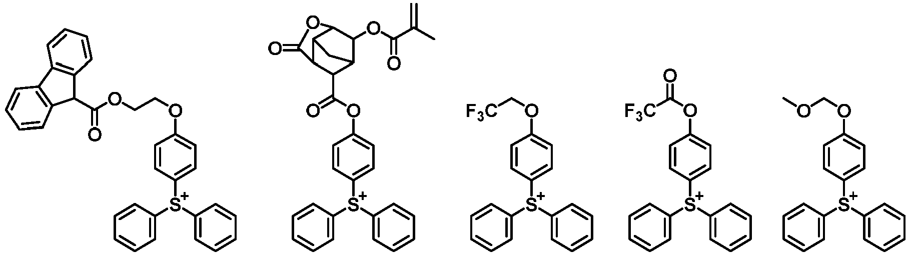

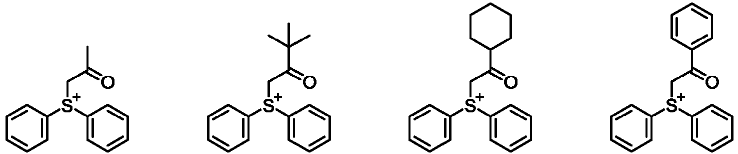

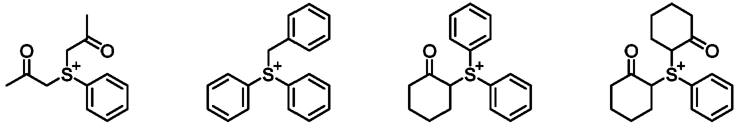

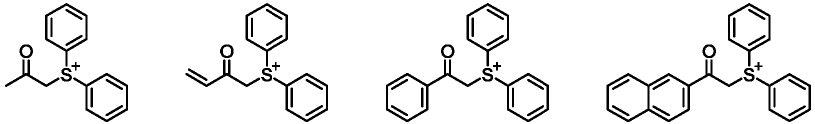

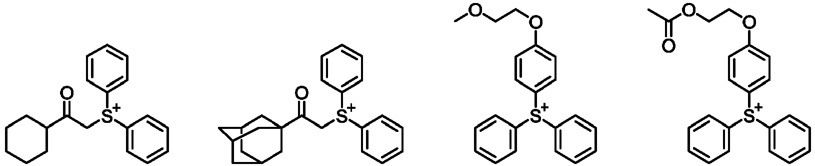

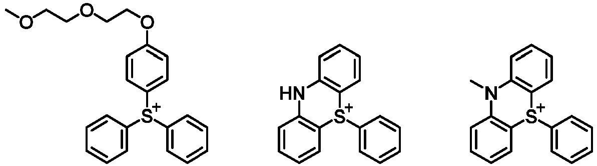

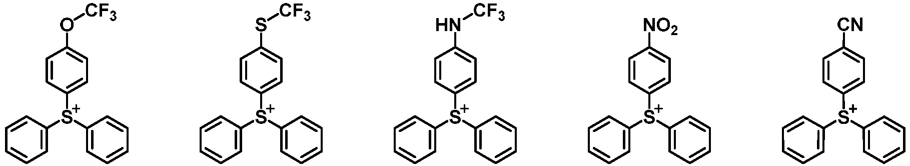

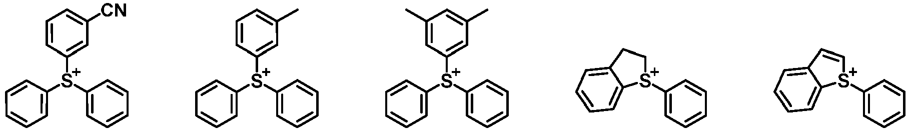

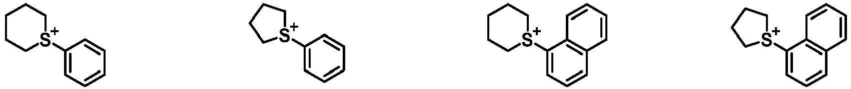

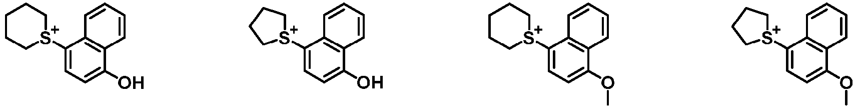

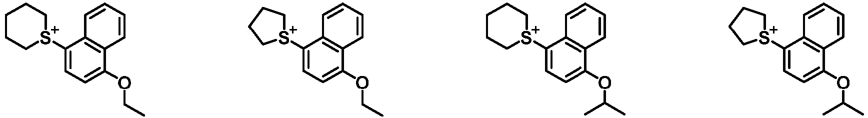

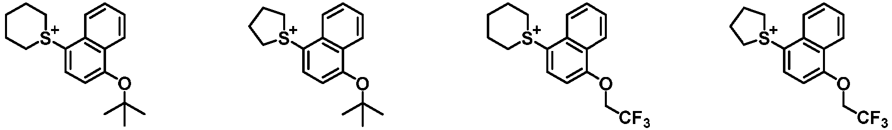

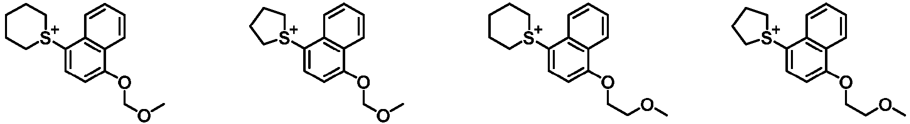

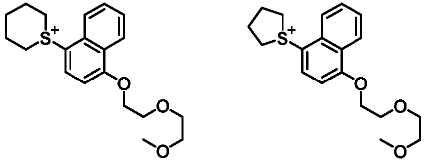

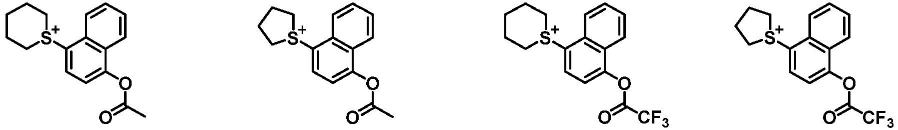

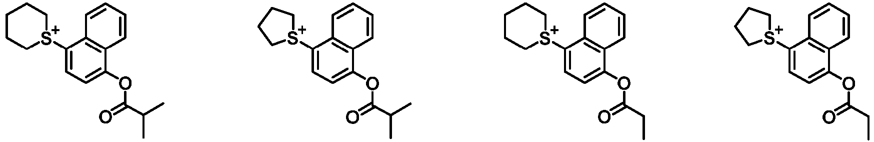

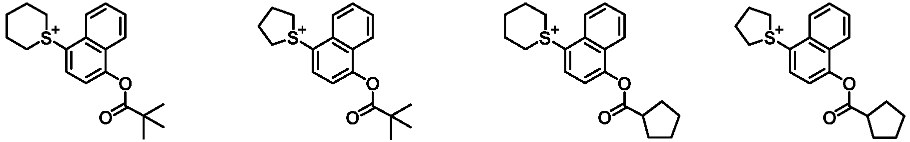

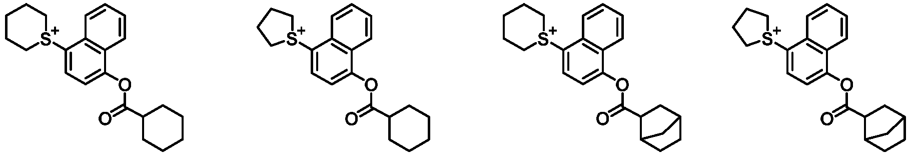

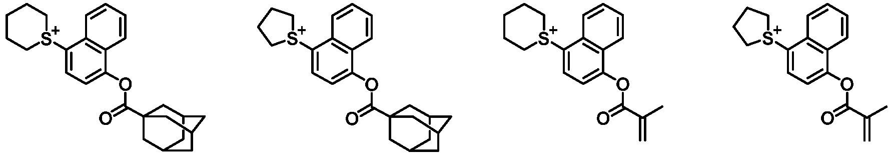

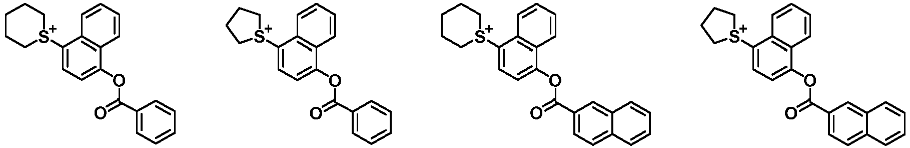

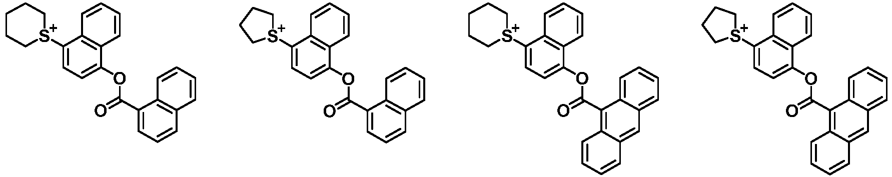

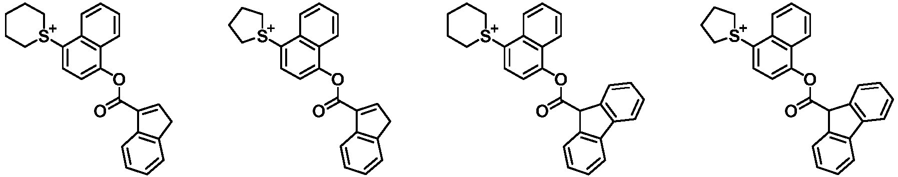

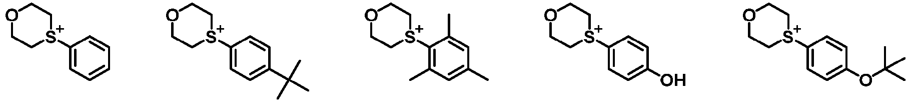

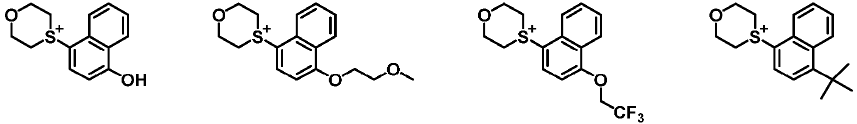

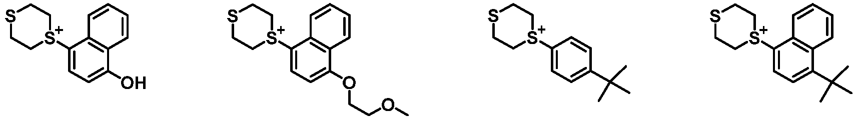

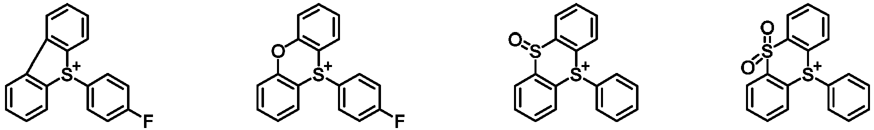

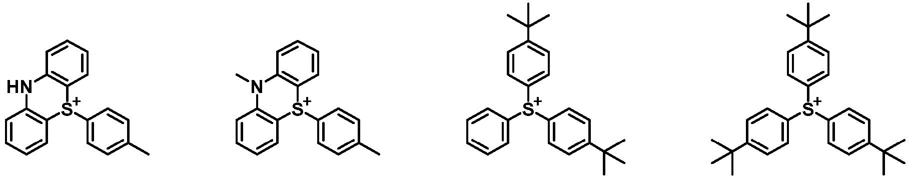

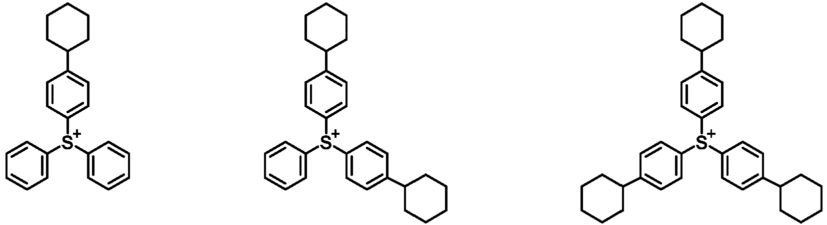

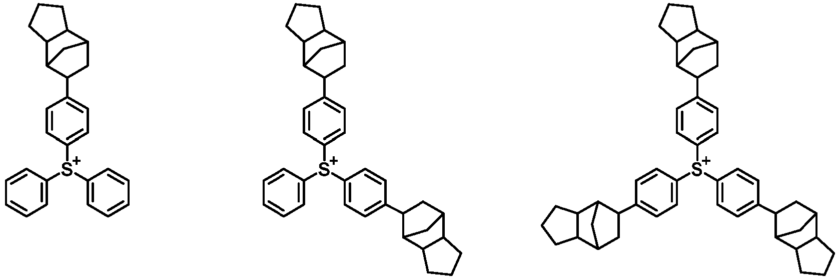

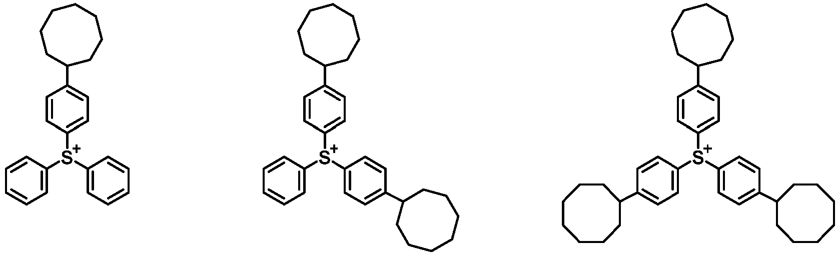

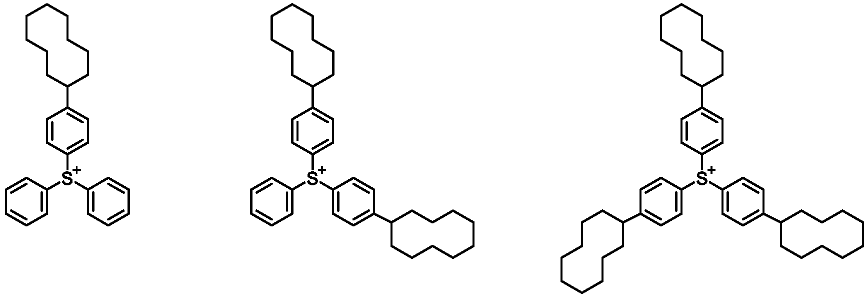

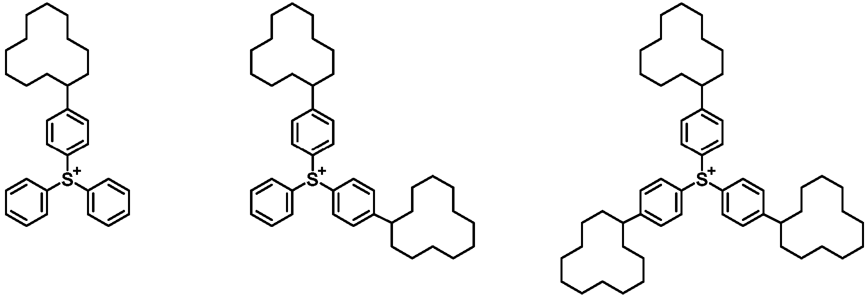

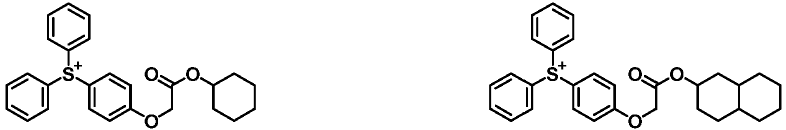

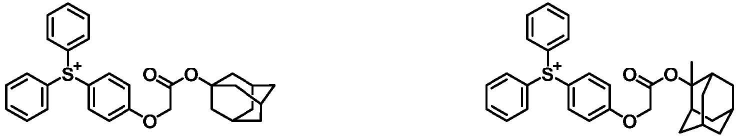

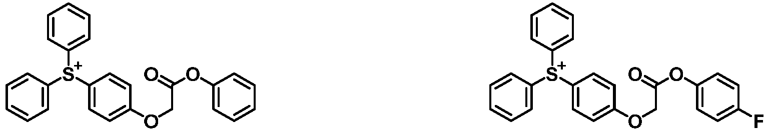

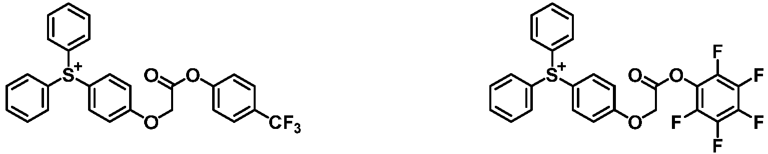

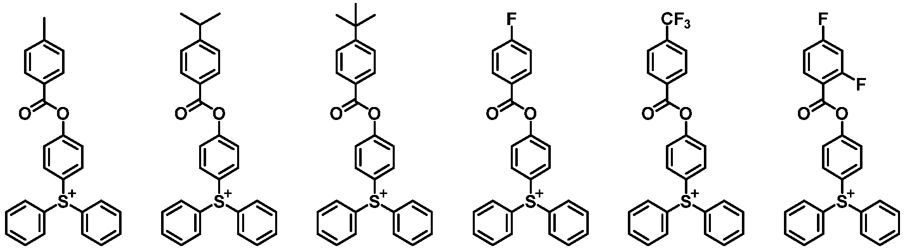

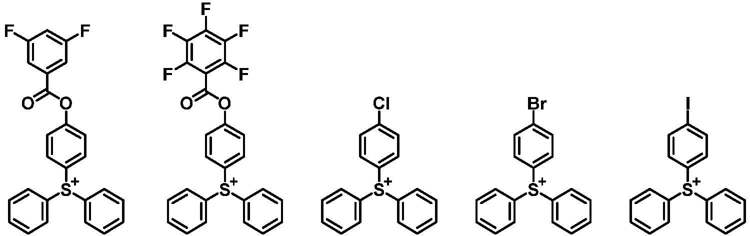

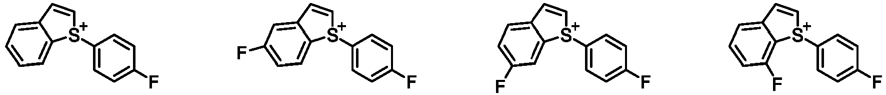

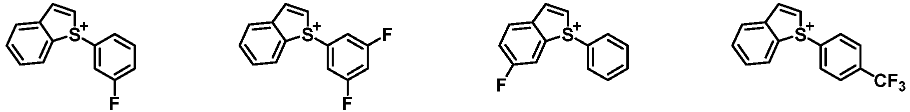

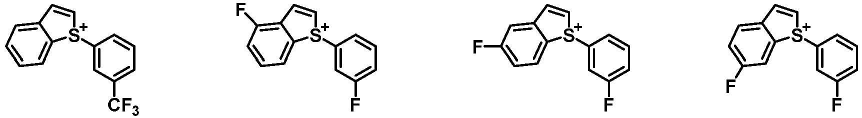

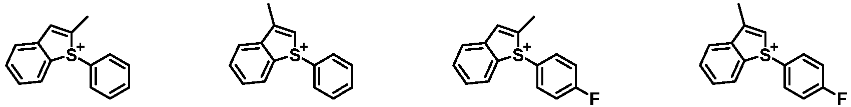

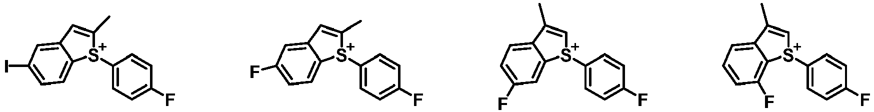

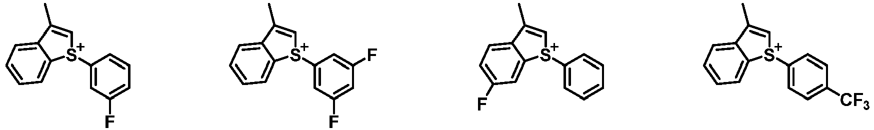

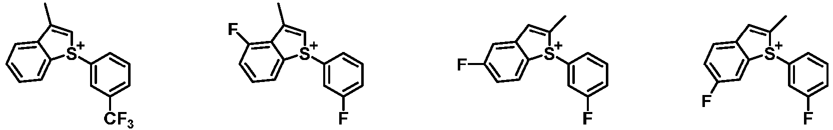

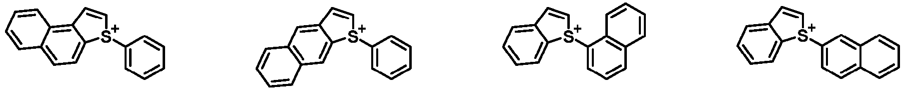

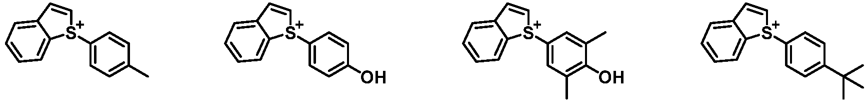

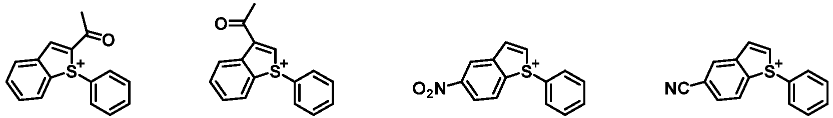

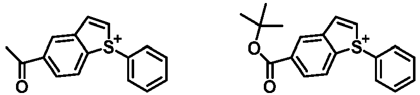

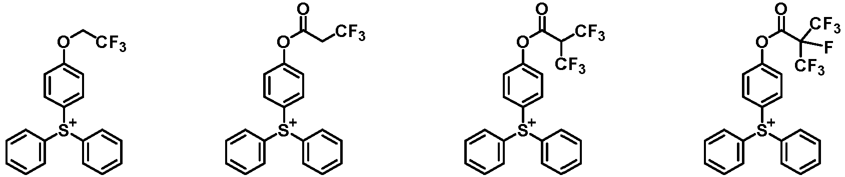

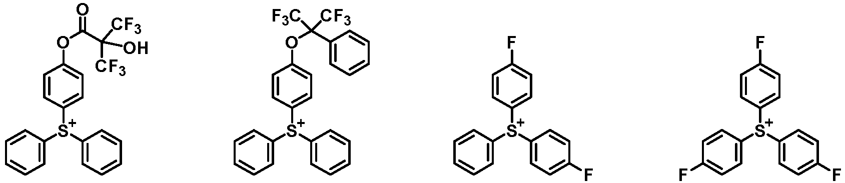

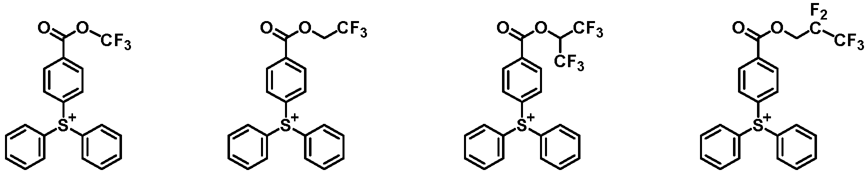

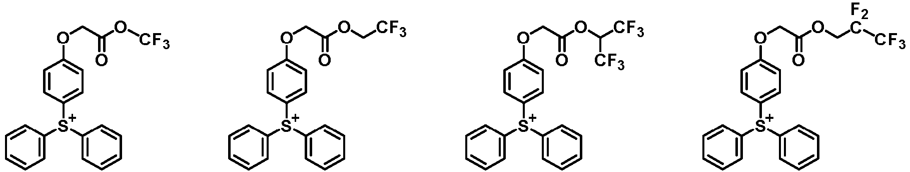

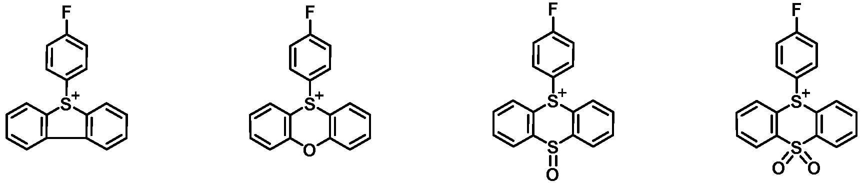

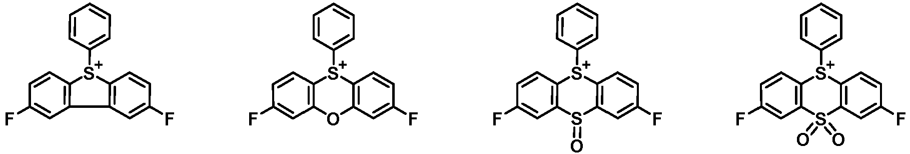

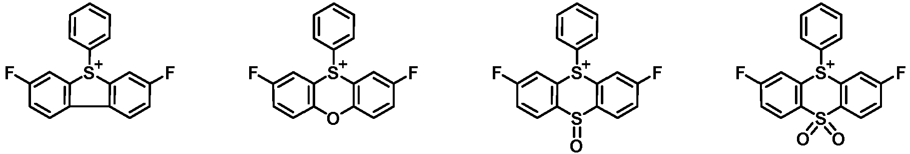

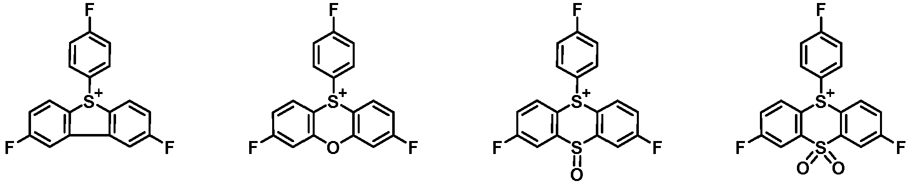

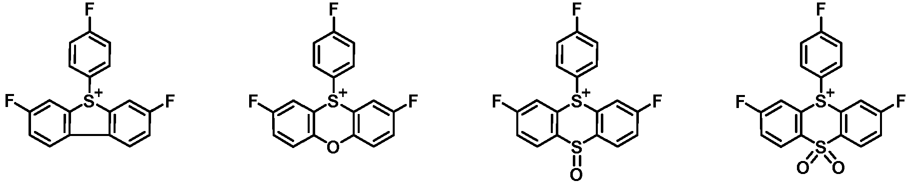

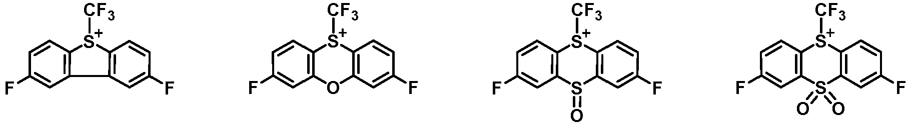

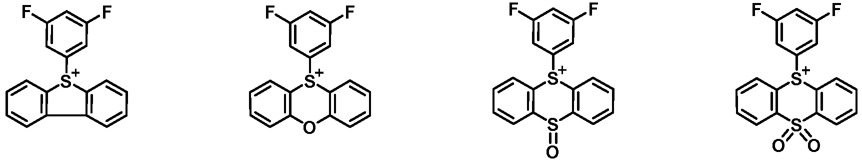

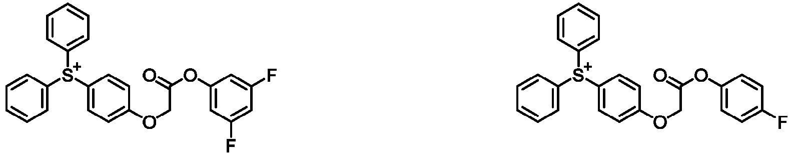

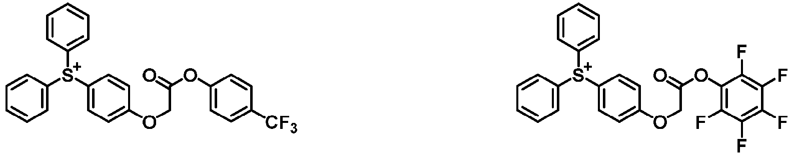

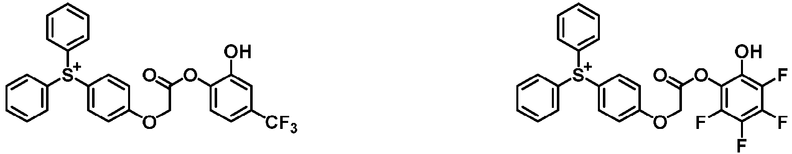

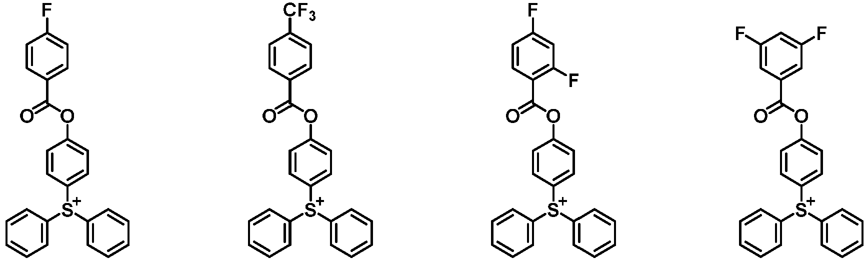

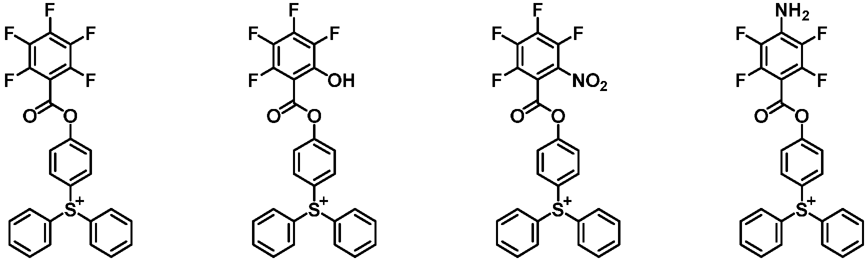

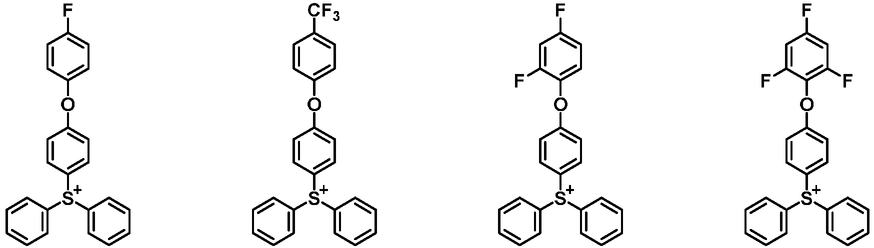

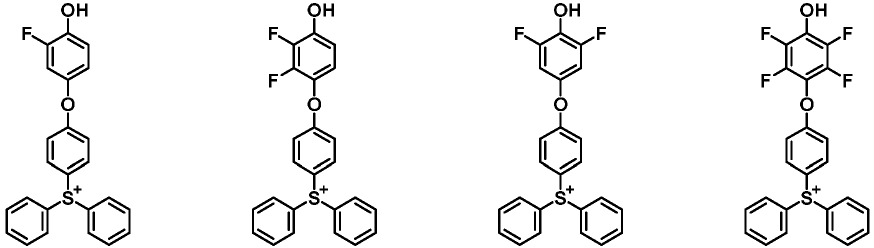

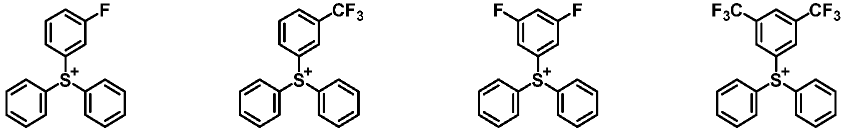

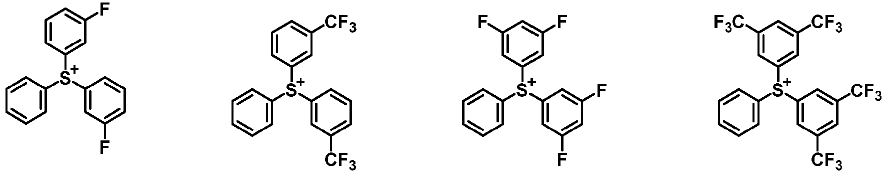

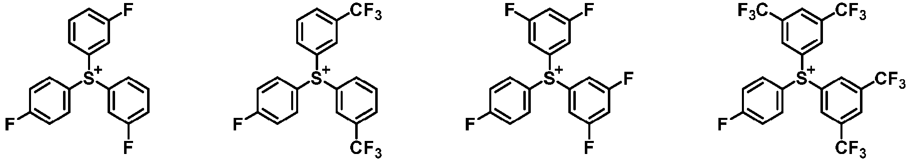

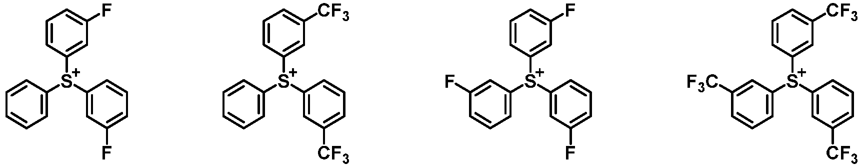

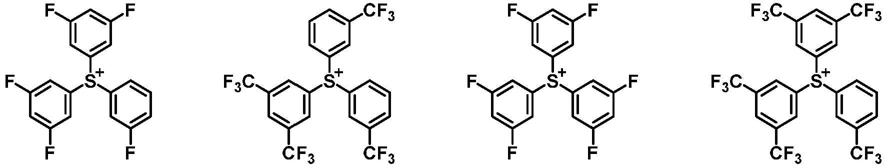

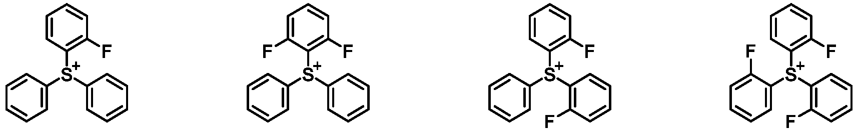

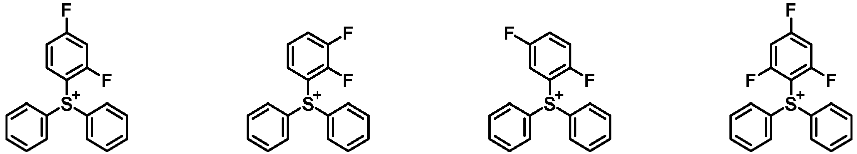

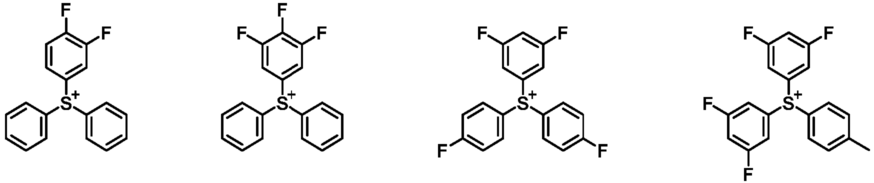

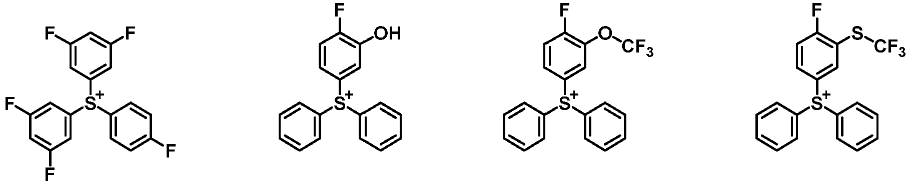

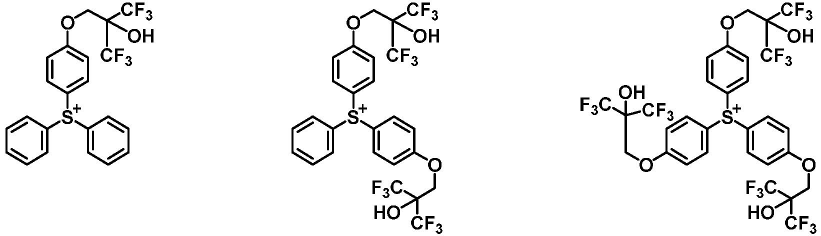

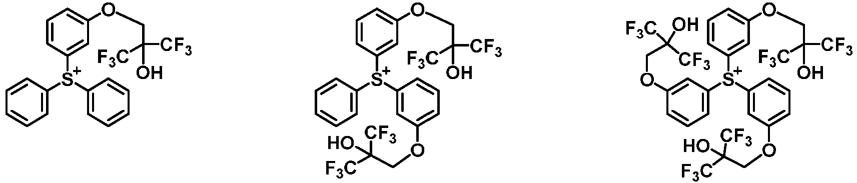

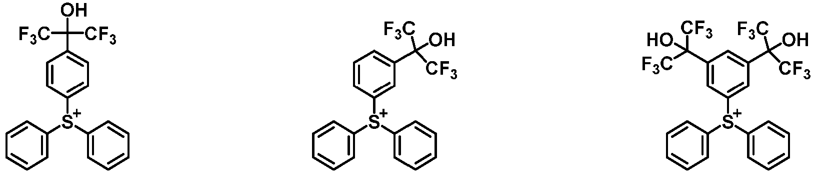

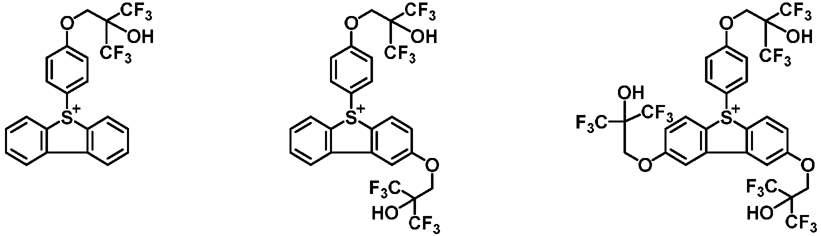

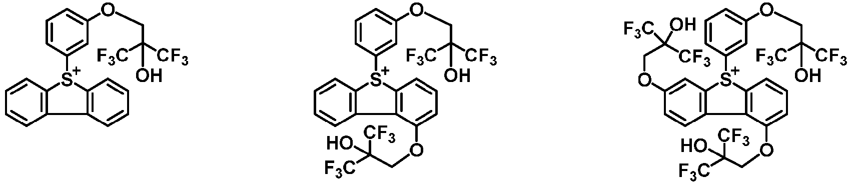

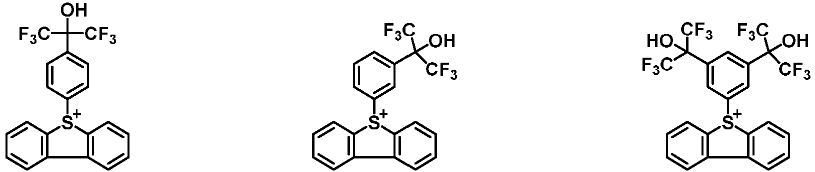

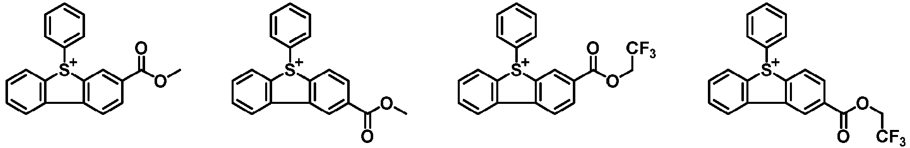

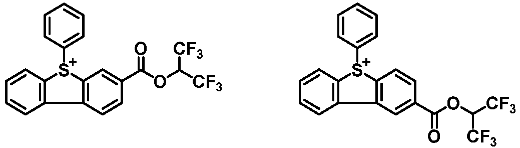

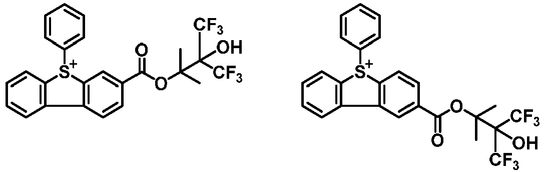

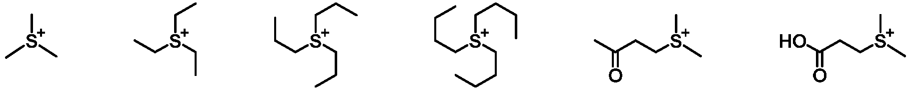

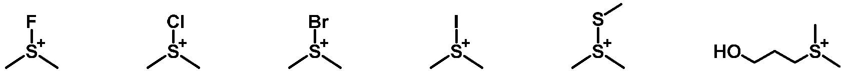

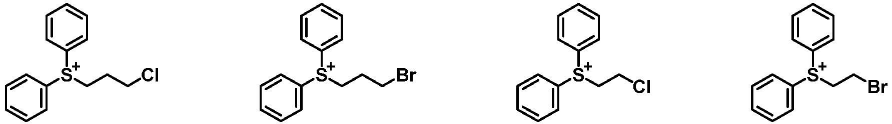

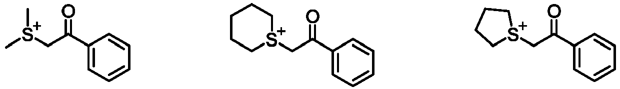

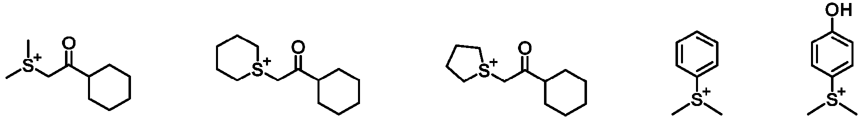

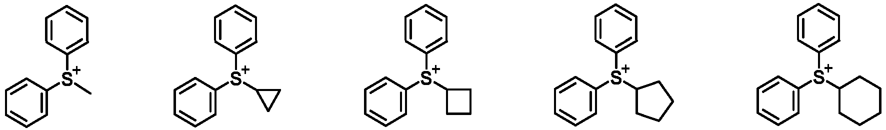

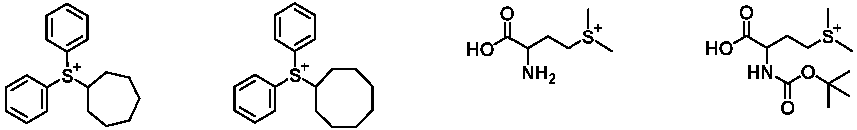

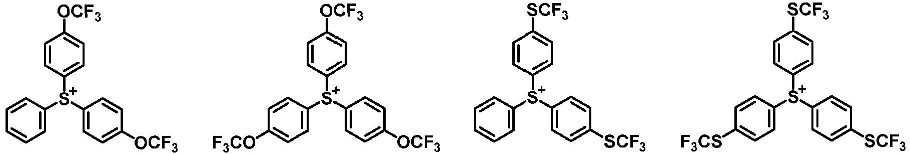

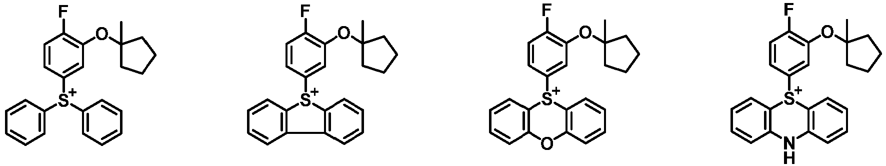

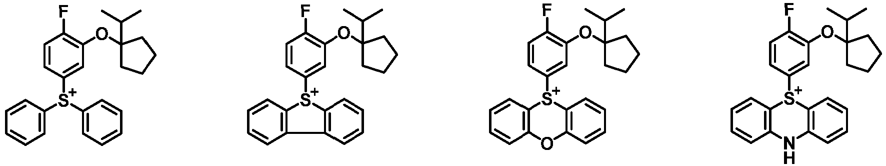

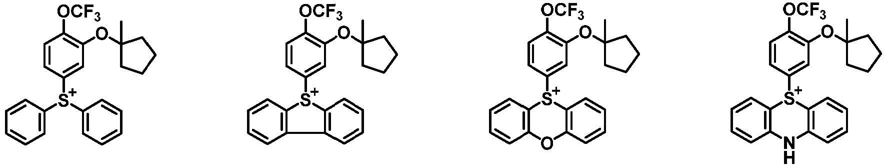

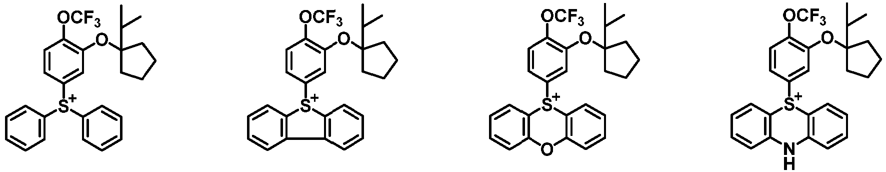

Specific examples of the iodonium cation having formula (cation-2) include those shown below, but are not limited thereto.

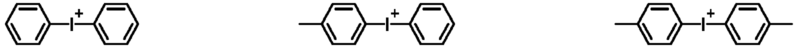

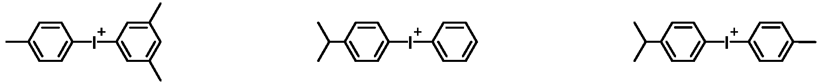

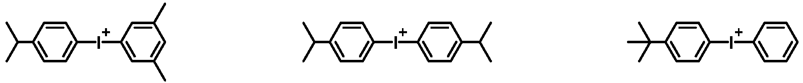

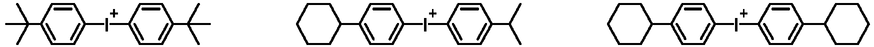

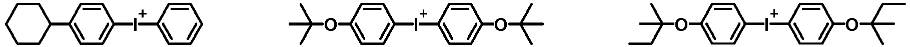

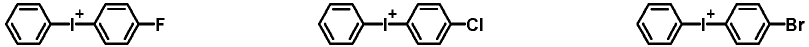

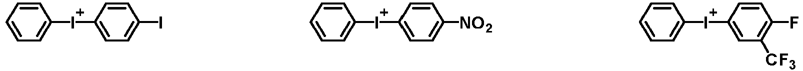

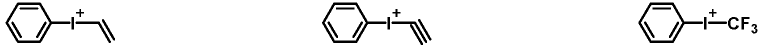

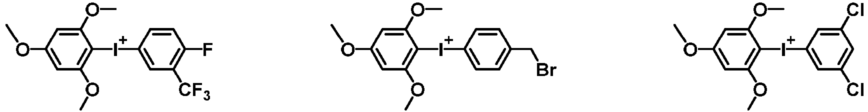

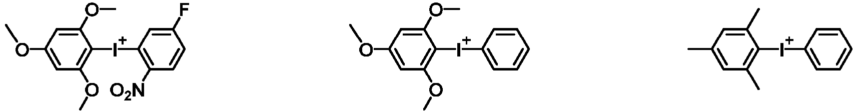

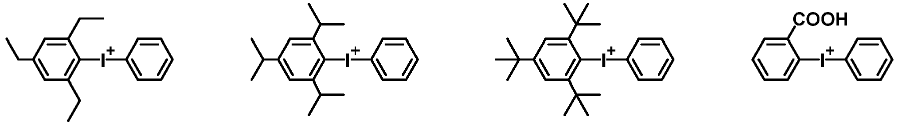

Specific examples of the monomer having formula (A1) include any combination of the anion and the cation described above.

The monomer having formula (A1) can be synthesized, for example, in the same manner as for the sulfonium salt having a polymerizable anion described in JP 5201363, but the synthesis method is not limited thereto.

The polymer A further contains a repeat unit A2 having formula (A2) and having a phenolic hydroxy group. The repeat unit A2 provides etching resistance and also provides adhesion to a substrate and solubility in an alkaline developer.

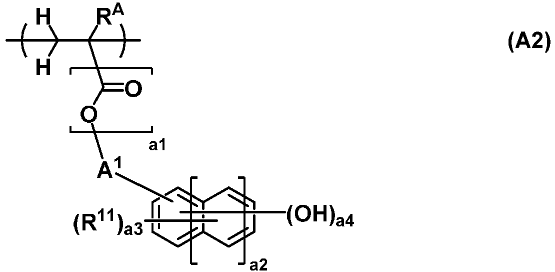

**In** formula (A2), a1 is 0 or 1. a2 is 0, 1, or 2, and the corresponding structure represents a benzene skeleton when a2 is 0, a naphthalene skeleton when a2 is 1, and an anthracene skeleton when a2 is 2. a3 is an integer satisfying 0 ≤ a3 ≤ 5 + 2(a2) - a4. a4 is 1, 2, or 3. When a2 is 0, a3 is preferably 0, 1, 2, or 3, and a4 is preferably 1, 2, or 3; and when a2 is 1 or 2, a3 is preferably 0, 1, 2, 3, or 4, and a4 is preferably 1, 2, or 3.

In formula (A2), R^{A} is a hydrogen atom, a fluorine atom, a methyl group, or a trifluoromethyl group.

In formula (A2), R¹¹ is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom. The saturated hydrocarbyl group, and the saturated hydrocarbyl moieties of the saturated hydrocarbyloxy group and the saturated hydrocarbylcarbonyloxy group may be linear, branched, or cyclic, and specific examples thereof include alkyl groups such as a methyl group, an ethyl group, a n-propyl group, an isopropyl group, a butyl group, a pentyl group, a hexyl group, and structural isomers thereof; cycloalkyl groups such as a cyclopropyl group, a cyclobutyl group, a cyclopentyl group, and a cyclohexyl group; and groups obtained by combining the foregoing. When the number of carbon atoms is equal to or less than the upper limit, solubility in an alkaline developer is satisfactory. When a3 is 2 or more, groups R¹¹ may be identical or different from each other.

In formula (A2), A¹ is a single bond or a C₁-C₁₀ saturated hydrocarbylene group in which some constituent -CH₂- may be replaced by -O-. The saturated hydrocarbylene group may be linear, branched, or cyclic, and specific examples thereof include C₁-C₁₀ alkanediyl groups such as a methylene group, an ethane-1,2-diyl group, a propane-1,3-diyl group, a butane-1,4-diyl group, a pentane-1,5-diyl group, a hexane-1,6-diyl group, and structural isomers thereof; C₃-C₁₀ cyclic saturated hydrocarbylene groups such as a cyclopropanediyl group, a cyclobutanediyl group, a cyclopentanediyl group, and a cyclohexanediyl group; and groups obtained by combining the foregoing. For the saturated hydrocarbylene group which contains an ether bond, when a1 in formula (A2) is 1, the ether bond may be incorporated at any position excluding the position between the α-carbon and the β-carbon relative to the ester oxygen atom. When a1 is 0, the atom that bonds with the backbone becomes an ethereal oxygen atom, and a second ether bond may be incorporated at any position excluding the position between the α-carbon and the β-carbon relative to the ethereal oxygen atom. The number of carbon atoms of the saturated hydrocarbylene group is preferably 10 or less because sufficient solubility in an alkaline developer can be obtained.

When a1 is 0 and A¹ is a single bond, in other words, when the aromatic ring is directly bonded to the backbone of the polymer (i.e., there is no linker (-C(=O)-O-A¹-)), preferable examples of the repeat unit A2 include units derived from 3-hydroxystyrene, 4-hydroxystyrene, 5-hydroxy-2-vinylnaphthalene, and 6-hydroxy-2-vinylnaphthalene. In particular, a repeat unit having formula (A2-1) is preferable.

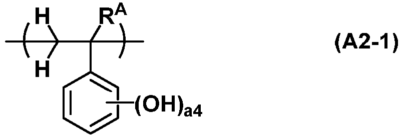

In the formula, R^{A} and a4 are as defined above.

When a1 is 1 (i.e., there is a linker (-C(=O)-O-A¹-)), preferable examples of the repeat unit A2 include those shown below, but are not limited thereto. In the following formulae, R^{A} is as defined above.

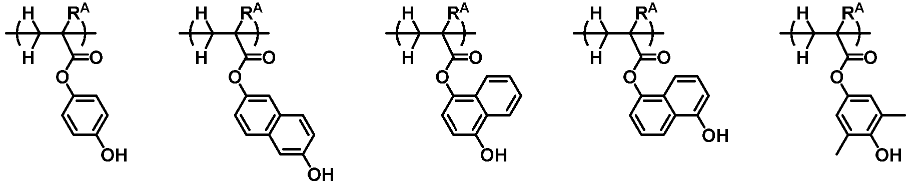

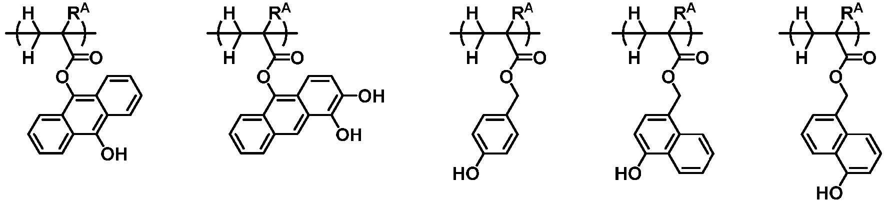

The repeat unit A2 may be used singly or in combination of two or more kinds thereof.

The polymer A may contain at least one moiety selected from a repeat unit having formula (A3) (hereinafter, the repeat unit is also referred to as a repeat unit A3) and a repeat unit having formula (A4) (hereinafter, the repeat unit is also referred to as a repeat unit A4) (in the following, the polymer A further containing at least one selected from the repeat unit A3 and the repeat unit A4 is also referred to as a polymer A').

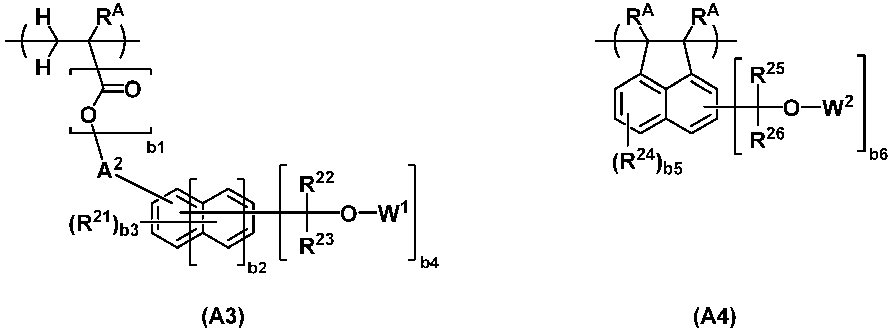

Upon exposure to high-energy radiation, the repeat unit A3 or A4 functions such that -O-W¹ or -O-W² undergoes an elimination reaction under the action of an acid which is generated by the acid generator. That is, the unit A3 or A4 induces insolubilization in an alkaline developer and a crosslinking reaction between polymer molecules. The repeat unit A3 or A4 provides for efficient progress of a negative-working reaction, leading to an improvement in resolution performance.

In formula (A3), b1 is 0 or 1. b2 is 0, 1, or 2. b3 is an integer satisfying 0 ≤ b3 ≤ 5 + 2(b2) - b4. b4 is 1, 2, or 3.

In formula (A3), b5 is 0, 1, or 2, and is preferably 0 or 1. b6 is 1 or 2, and is preferably 1.

In formulae (A3) and (A4), groups R^{A} are each independently a hydrogen atom, a fluorine atom, a methyl group, or a trifluoromethyl group. Among them, in formula (A4), a hydrogen atom or a methyl group is preferable, and a hydrogen atom is more preferable.

In formula (A3), R²¹ is a halogen atom or a C₁-C₂₀ hydrocarbyl group which may contain a heteroatom. Specific examples of the halogen atom represented by R²¹ include a fluorine atom, a chlorine atom, a bromine atom, and an iodine atom. The C₁-C₂₀ hydrocarbyl group represented by R²¹ may be saturated or unsaturated, and may be linear, branched, or cyclic. Specific examples thereof include those groups mentioned as the hydrocarbyl group represented by R¹ in the description of formula (A1). When b3 is 2 or more, groups R²¹ may be identical or different from each other.

**In** formula (A3), R²² and R²³ are each independently a hydrogen atom, a C₁-C₁₅ saturated hydrocarbyl group which may be substituted with a hydroxy moiety or a C₁-C₆ saturated hydrocarbyloxy moiety, or a C₆-C₁₅ aryl group which may have a substituent. A case where R²² and R²³ are both hydrogen atoms simultaneously is excluded. R²² and R²³ may bond together to form a ring with a carbon atom to which they are bonded, and some -CH₂- in the ring may be replaced by **-O-** or -S-. Preferable examples of R²² and R²³ include alkyl groups such as a methyl group, an ethyl group, a propyl group, a butyl group, and structural isomers thereof, and those in which some of hydrogen atoms are substituted with a hydroxy group or a saturated hydrocarbyloxy group.

In formula (A4), R²⁴ is a halogen atom or a C₁-C₂₀ hydrocarbyl group which may contain a heteroatom. Specific examples of the halogen atom represented by R²⁴ include a fluorine atom, a chlorine atom, a bromine atom, and an iodine atom. The C₁-C₂₀ hydrocarbyl group represented by R²⁴ may be saturated or unsaturated, and may be linear, branched, or cyclic. Specific examples thereof include those groups mentioned as the hydrocarbyl group represented by R¹ in the description of formula (A1). When b5 is 2 or more, groups R²⁴ may be identical or different from each other.

In formula (A4), R²⁵ and R²⁶ are each independently a hydrogen atom, a C₁-C₁₅ saturated hydrocarbyl group which may be substituted with a hydroxy moiety or a C₁-C₆ saturated hydrocarbyloxy moiety, or a C₆-C₁₅ aryl group which may have a substituent.

The C₁-C₁₅ saturated hydrocarbyl group represented by R²⁵ and R²⁶ may be linear, branched, or cyclic. Specific examples thereof include those groups mentioned as the saturated hydrocarbyl group represented by R²² and R²³.

Specific examples of the C₆-C₁₅ aryl group represented by R²⁵ and R²⁶ include a phenyl group, a naphthyl group, and an anthryl group, and among them, a phenyl group is preferable. The aryl group may have a substituent, and specific examples of the substituent include a halogen atom, a C₁-C₆ saturated hydrocarbyl group which may be substituted with a halogen atom, and a C₁-C₆ saturated hydrocarbyloxy group which may be substituted with a halogen atom.

A case where R²⁵ and R²⁶ are both hydrogen atoms simultaneously is excluded. When either of R²⁵ and R²⁶ is an aryl group which may have a substituent, the other substituent is preferably a hydrogen atom.

R²⁵ and R²⁶ are preferably the same group, and more preferably both a methyl group.

R²⁵ and R²⁶ may bond together to form a ring with a carbon atom to which they are bonded, and some -CH₂- in the ring may be replaced by -O- or -S-. Examples of the ring include a cyclopropane ring, a cyclobutane ring, a cyclopentane ring, a cyclohexane ring, a norbornane ring, an adamantane ring, a tricyclo[5.2.1.0^{2,6}]decane ring, a tetracyclo[6.2.1.1^{3,6}.0^{2,7}]dodecane ring, an oxanorbornane ring, and a thianorbornane ring, but are not limited thereto.

In formula (A3), A² is a single bond or a C₁-C₁₀ saturated hydrocarbylene group in which some constituent -CH₂- may be replaced by -O-. The saturated hydrocarbylene group may be linear, branched, or cyclic, and specific examples thereof include alkanediyl groups such as a methylene group, an ethane-1,2-diyl group, a propane-1,3-diyl group, a butane-1,4-diyl group, a pentane-1,5-diyl group, a hexane-1,6-diyl group, and structural isomers thereof; cyclic saturated hydrocarbylene groups such as a cyclopropanediyl group, a cyclobutanediyl group, a cyclopentanediyl group, and a cyclohexanediyl group; and groups obtained by combining the foregoing. For the saturated hydrocarbylene group which contains an ether bond, when b1 in formula (A3) is 1, the ether bond may be incorporated at any position excluding the position between the α-carbon and the β-carbon relative to the ester oxygen atom. When b1 is 0, the atom that bonds with the backbone becomes an ethereal oxygen atom, and a second ether bond may be incorporated at any position excluding the position between the α-carbon and the β-carbon relative to the ethereal oxygen atom.

In formulae (A3) and (A4), W¹ and W² are each independently a hydrogen atom, a C₁-C₁₀ aliphatic hydrocarbyl group, a C₂-C₁₀ aliphatic hydrocarbylcarbonyl group, or a C₆-C₁₅ aryl group which may have a substituent.

The C₁-C₁₀ aliphatic hydrocarbyl group represented by W¹ and W² may be saturated or unsaturated, and may be linear, branched, or cyclic. Specific examples thereof include C₁-C₁₀ alkyl groups such as a methyl group, an ethyl group, a n-propyl group, an isopropyl group, a n-butyl group, an isobutyl group, a sec-butyl group, a tert-butyl group, a n-pentyl group, a neopentyl group, a n-hexyl group, a n-heptyl group, a n-octyl group, a 2-ethylhexyl group, a n-nonyl group, and a n-decyl group; C₃-C₁₀ cyclic saturated hydrocarbyl groups such as a cyclopentyl group and a cyclohexyl group; C₂-C₁₀ alkenyl groups such as a vinyl group, a 1-propenyl group, a 2-propenyl group, a butenyl group, and a hexenyl group; and C₃-C₁₀ cyclic unsaturated hydrocarbyl groups such as a cyclohexenyl group. The hydrocarbyl moiety in the C₂-C₁₀ aliphatic hydrocarbylcarbonyl group represented by W¹ and W² may be saturated or unsaturated, and may be linear, branched, or cyclic. Specific examples thereof include C₁-C₉ aliphatic hydrocarbyl groups among the specific examples of the C₁-C₁₀ aliphatic hydrocarbyl group described above. Specific examples of the C₆-C₁₅ aryl group represented by W¹ and W² include a phenyl group, a naphthyl group, and an anthryl group, and among them, a phenyl group is preferable. The aryl group may have a substituent, and specific examples of the substituent include a halogen atom, a C₁-C₆ saturated hydrocarbyl group which may be substituted with a halogen atom, and a C₁-C₆ saturated hydrocarbyloxy group which may be substituted with a halogen atom.

The repeat unit A3 is preferably a repeat unit having formula (A3-1) or (A3-2).

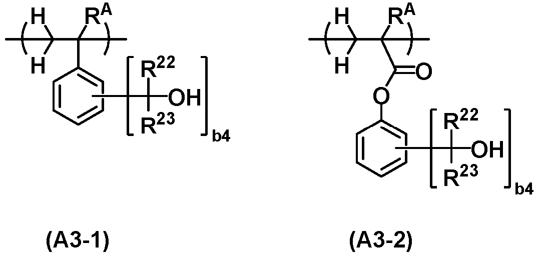

In the formulae, b4, R^{A}, R²², and R²³ are as defined above.

Preferable examples of the repeat unit A3 include those shown below, but are not limited thereto. In the following formulae, R^{A} is as defined above, Me is a methyl group, and Ac is an acetyl group.

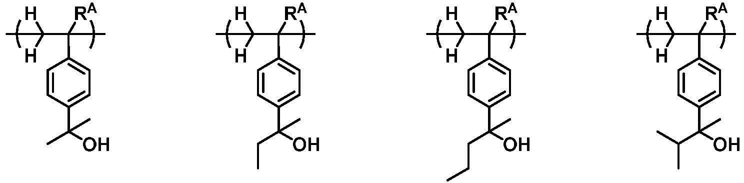

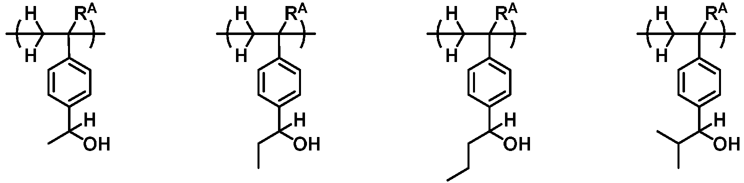

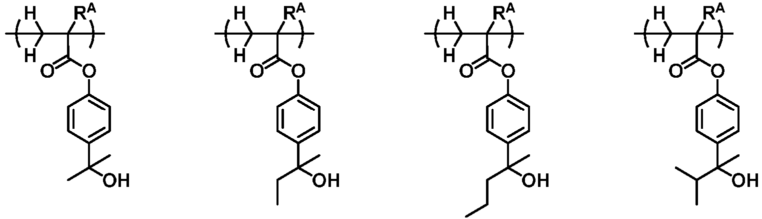

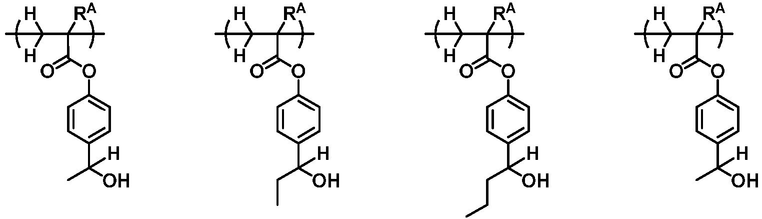

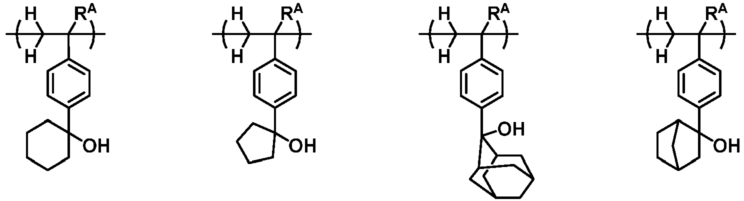

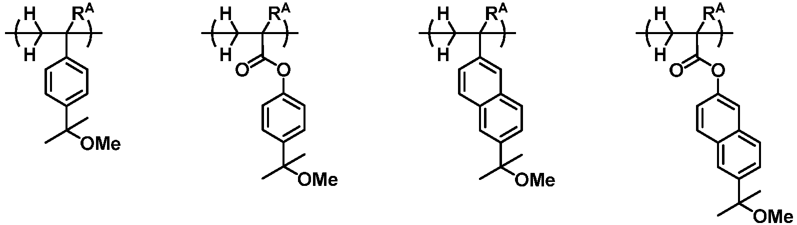

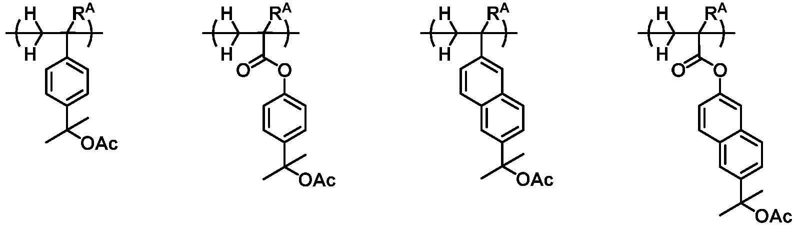

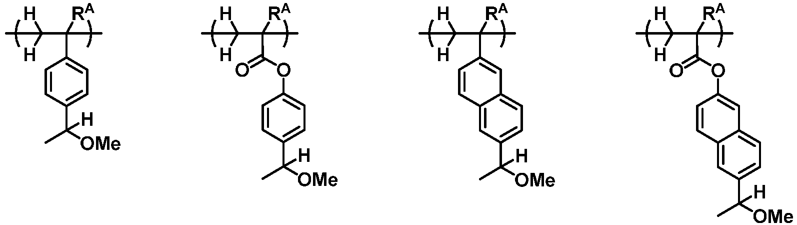

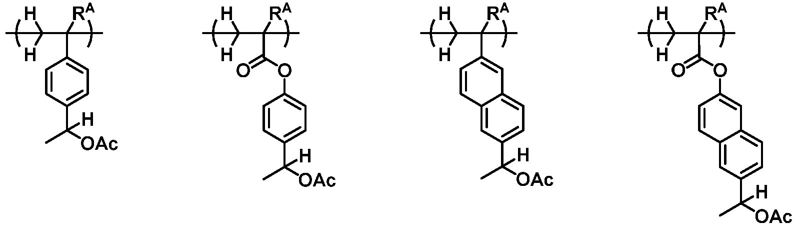

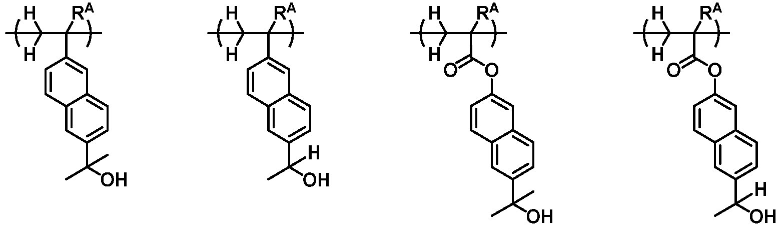

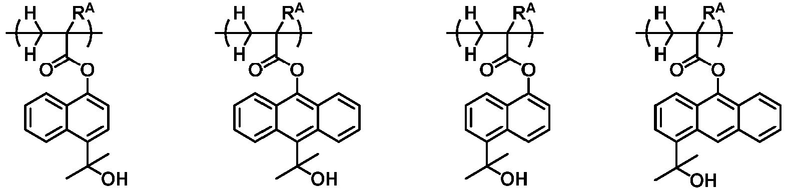

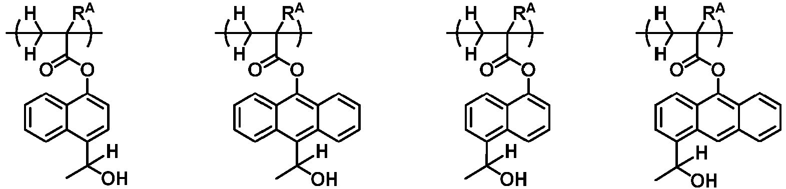

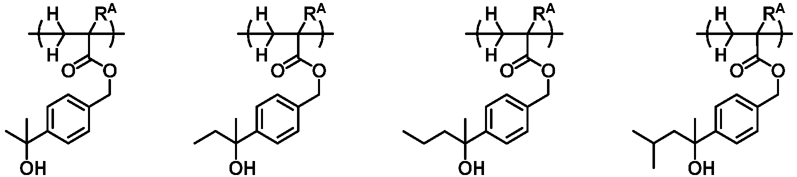

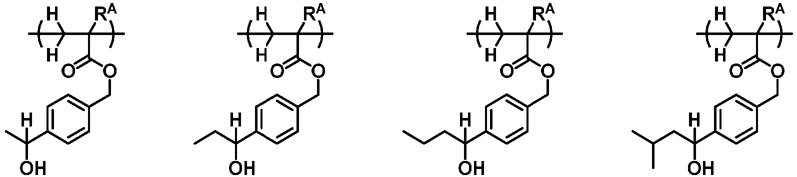

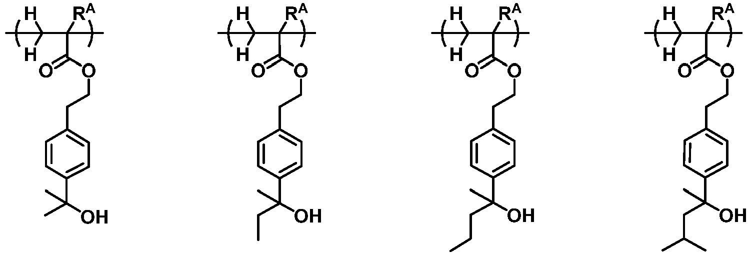

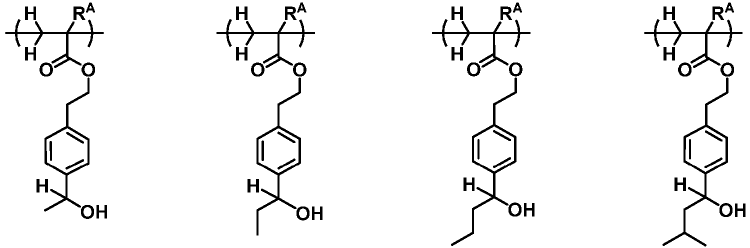

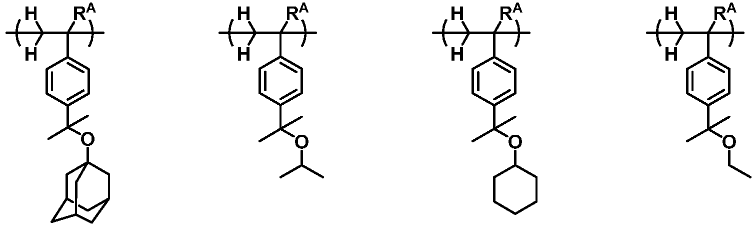

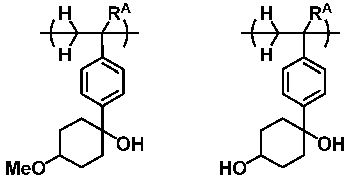

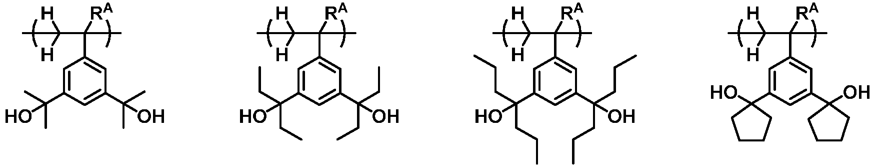

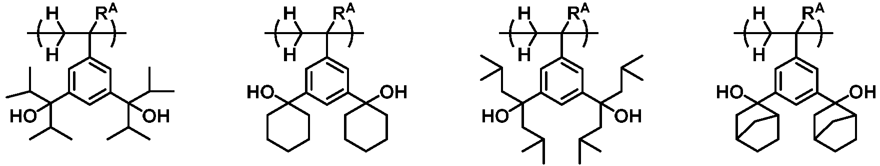

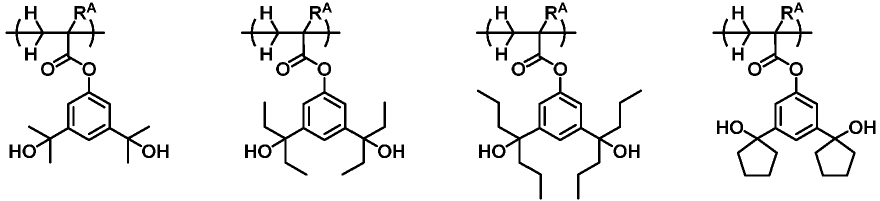

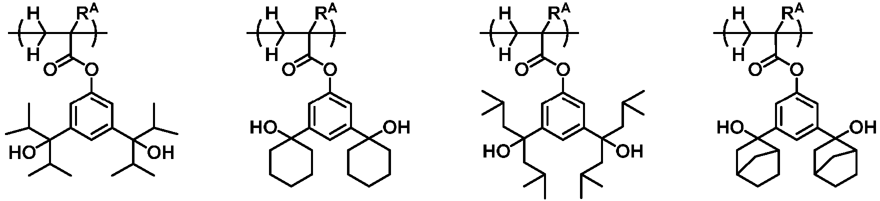

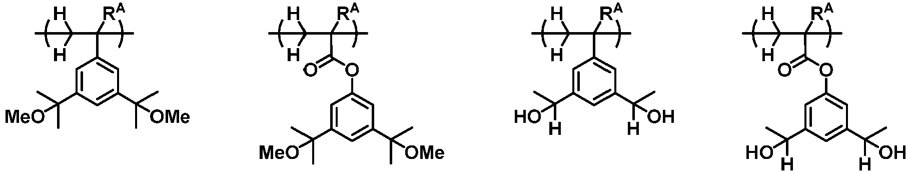

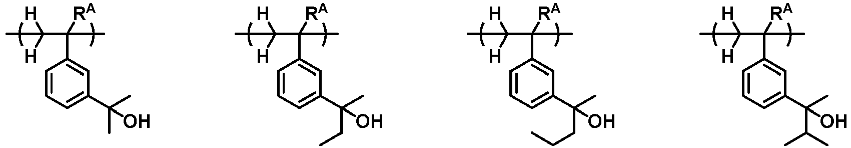

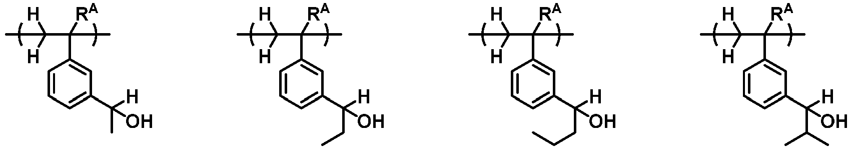

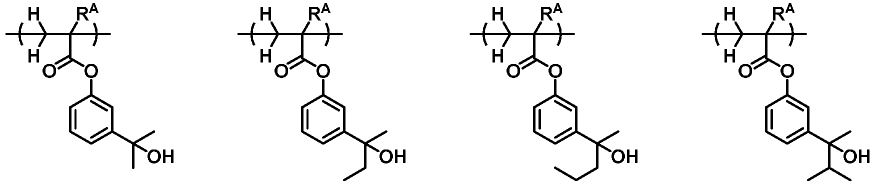

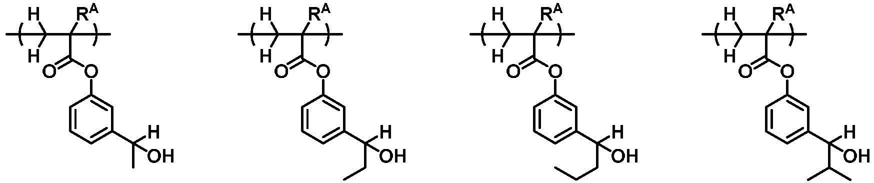

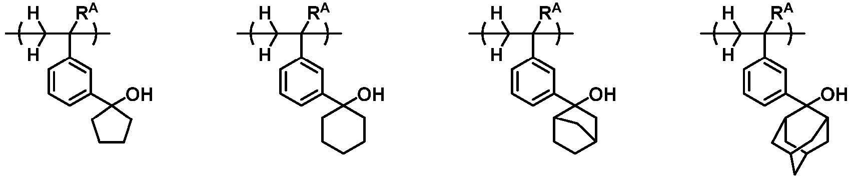

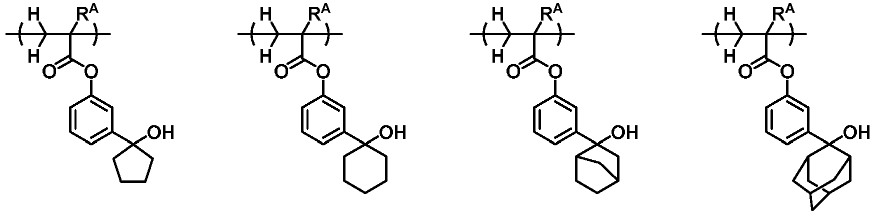

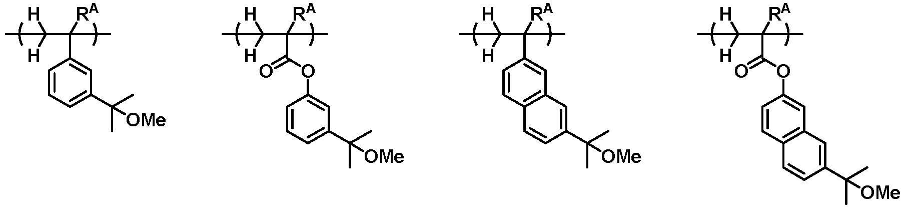

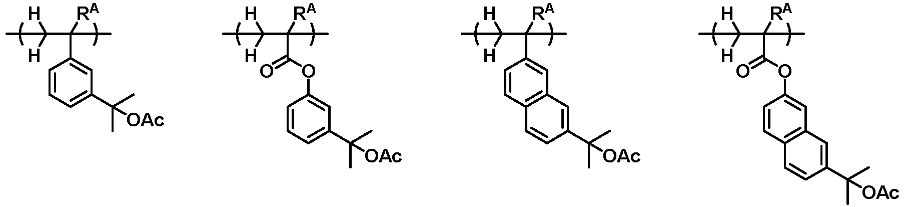

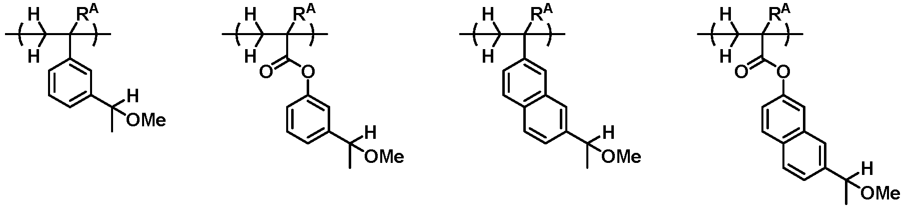

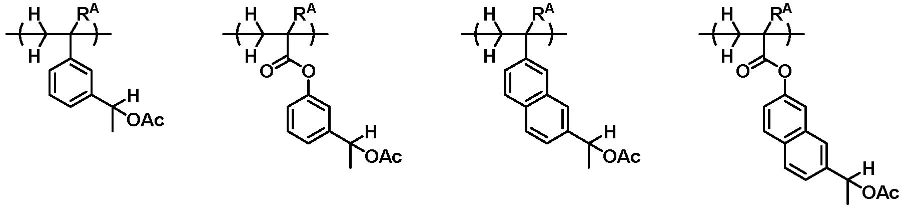

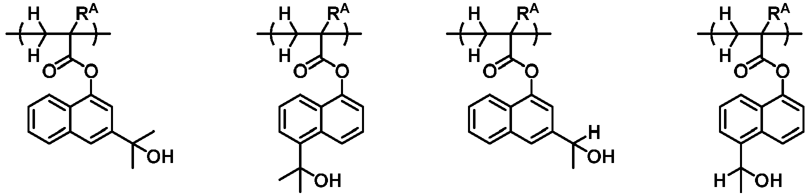

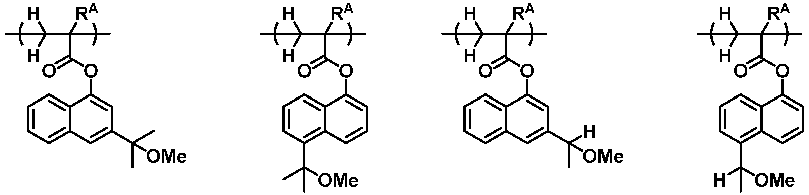

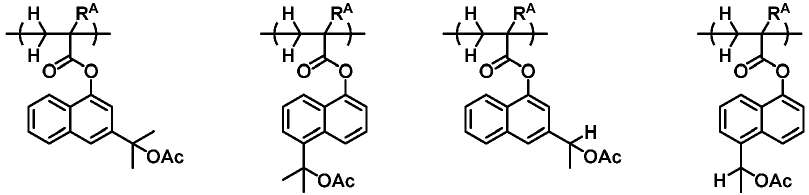

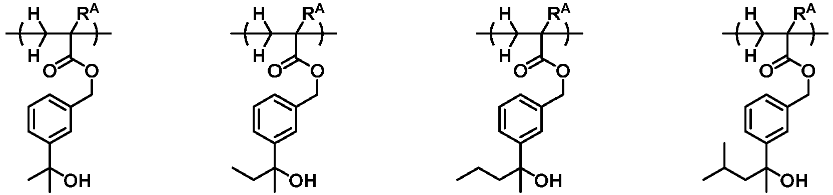

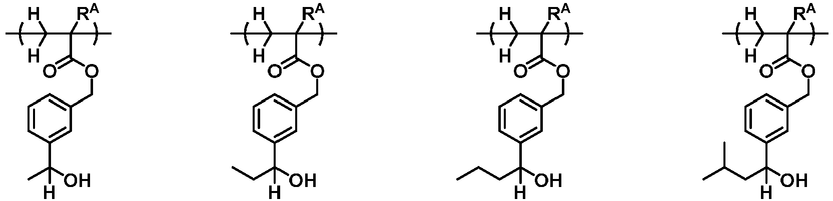

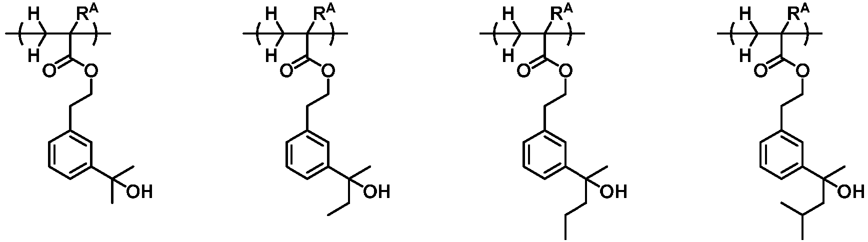

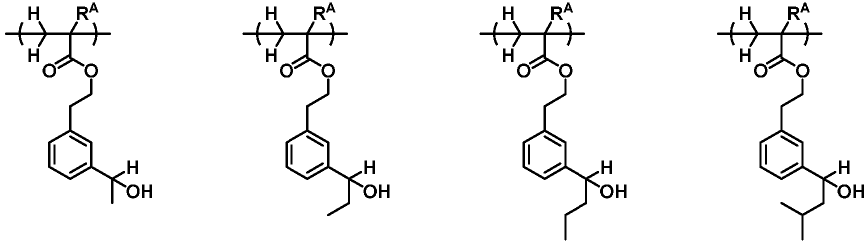

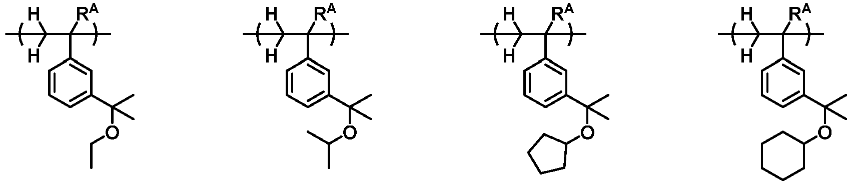

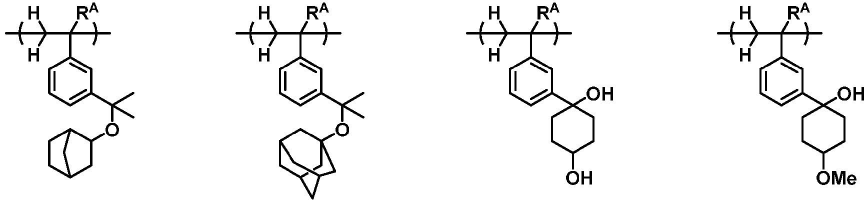

The repeat unit A3 may be used singly or in combination of two or more kinds thereof.

The repeat unit A4 is preferably a repeat unit having formula (A4-1).

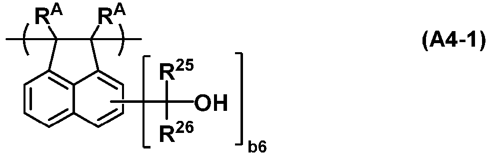

In the formula, b6, R^{A}, R²⁵, and R²⁶ are as defined above.

Preferable examples of the repeat unit A4 include those shown below, but are not limited thereto. In the following formulae, R^{A} is as defined above, Me is a methyl group, and Ac is an acetyl group.

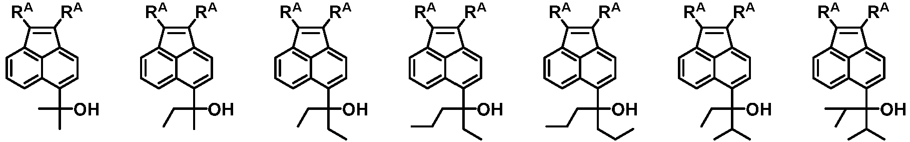

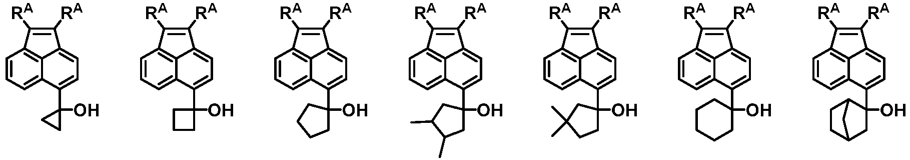

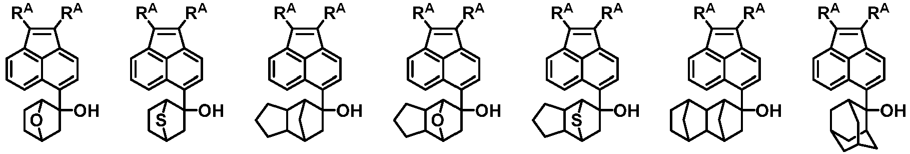

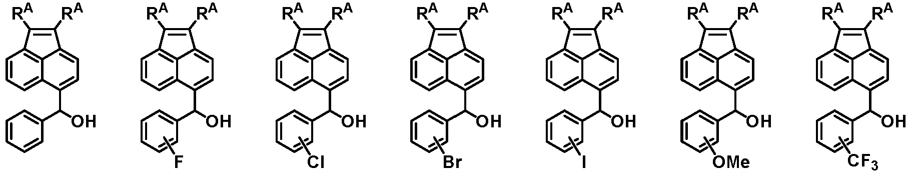

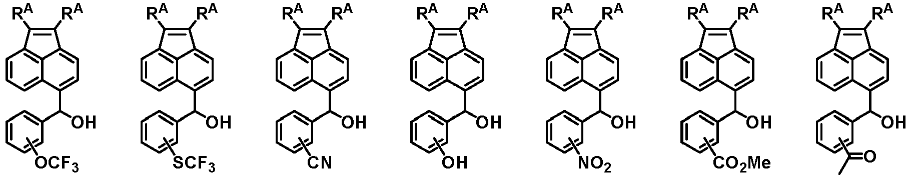

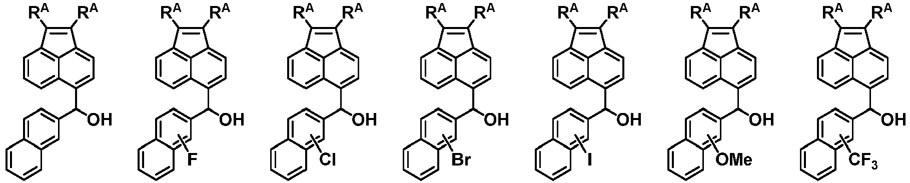

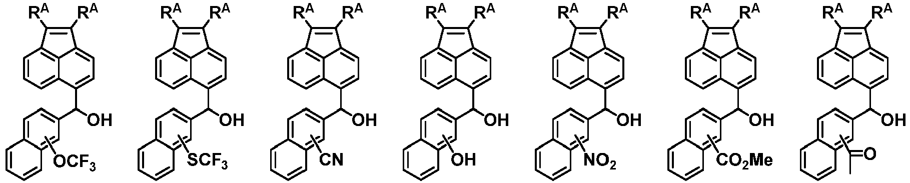

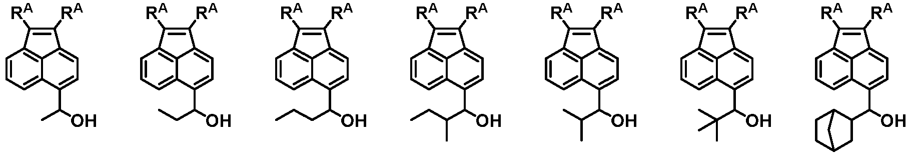

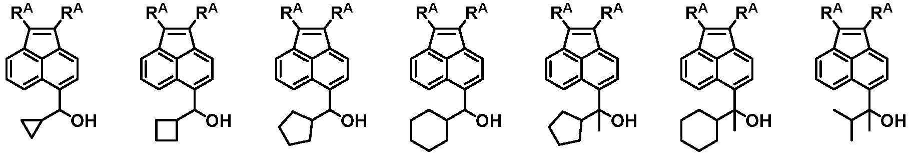

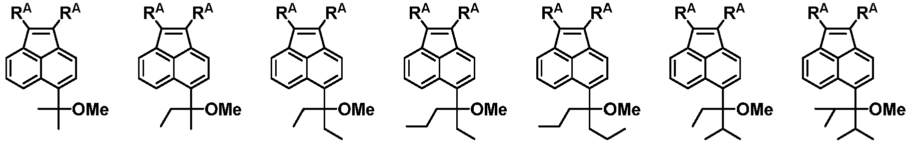

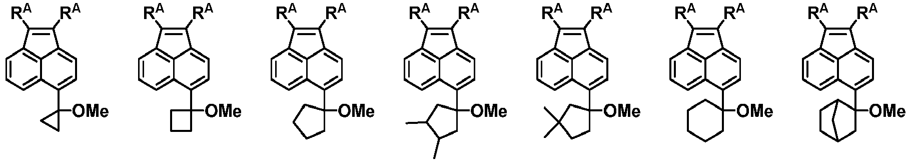

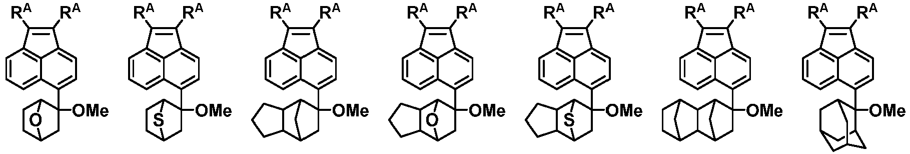

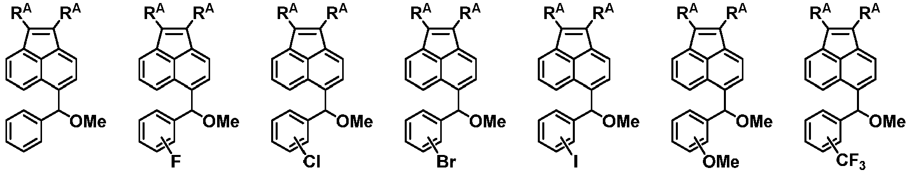

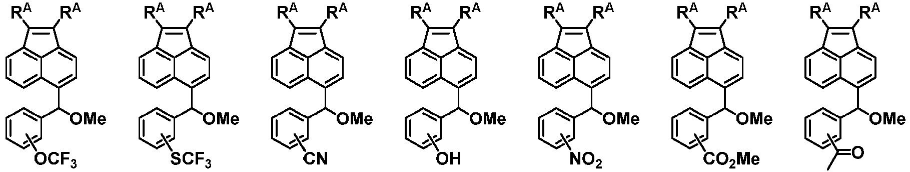

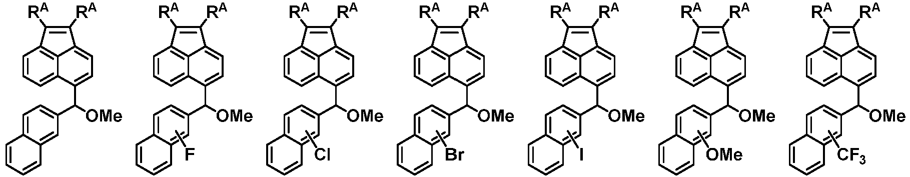

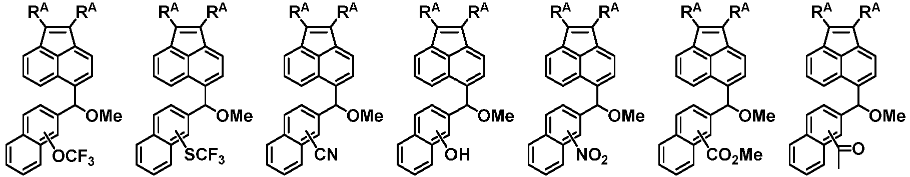

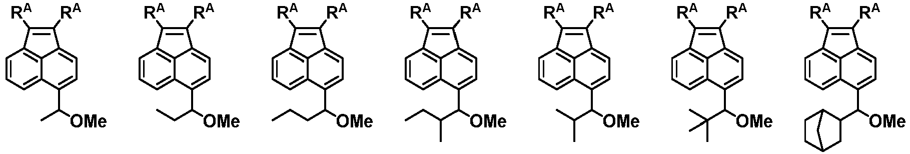

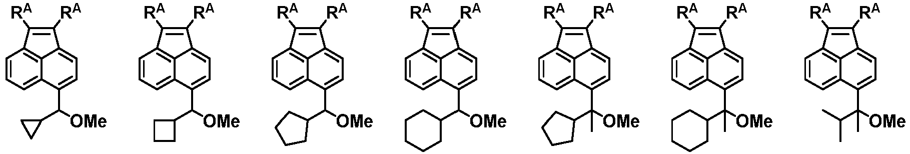

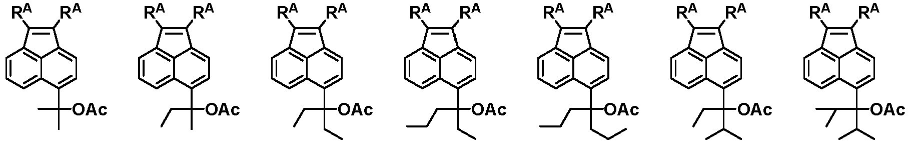

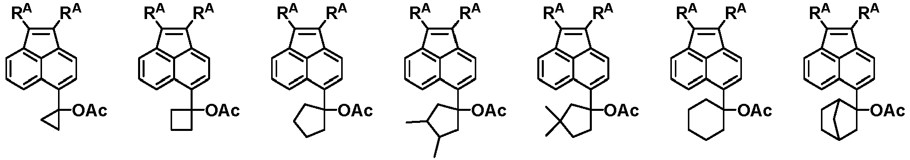

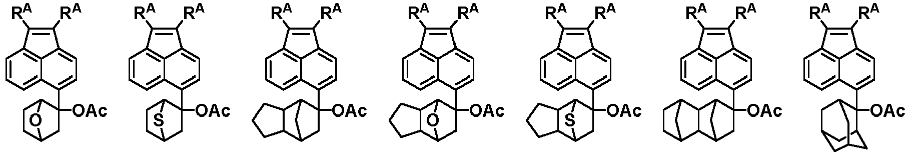

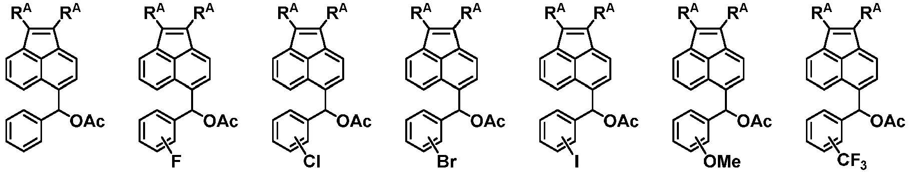

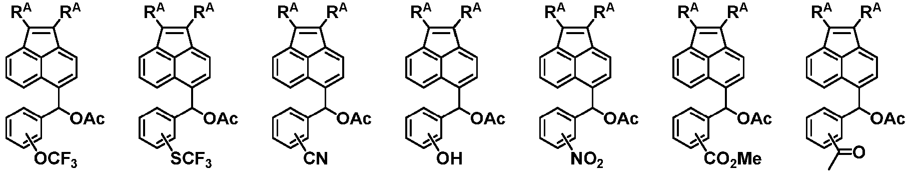

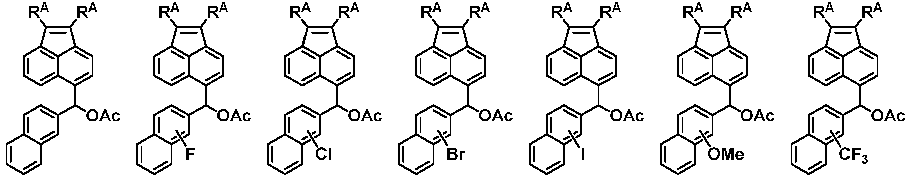

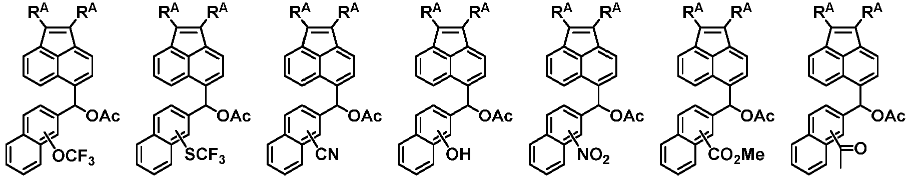

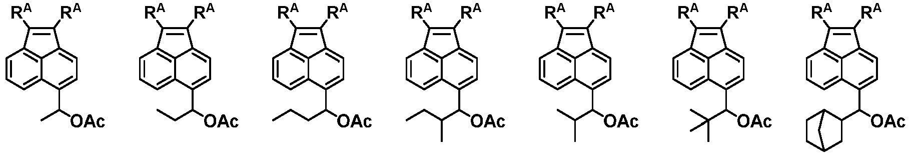

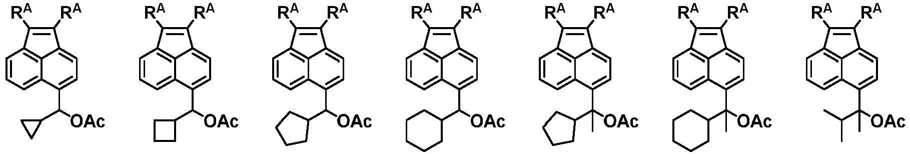

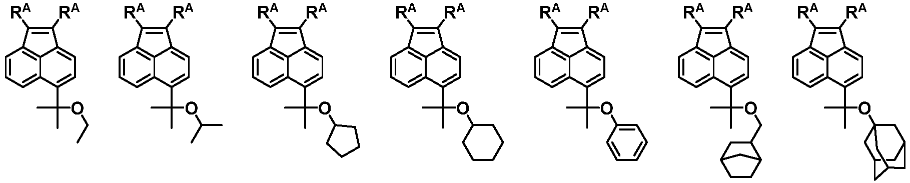

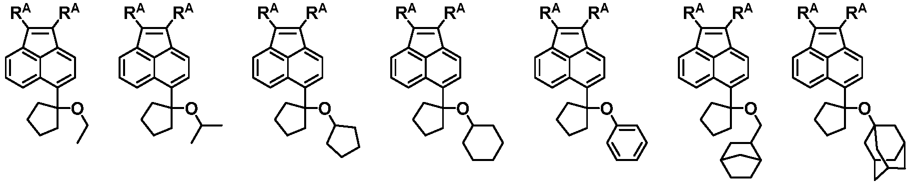

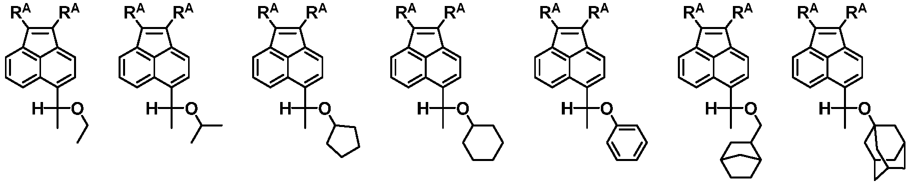

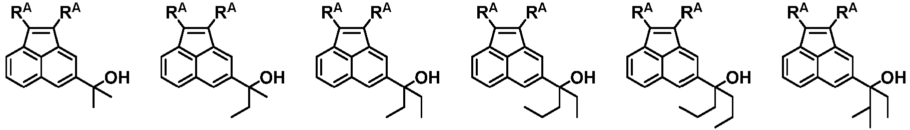

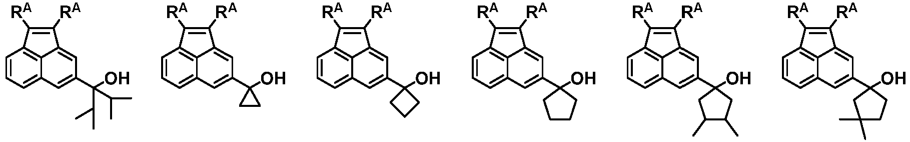

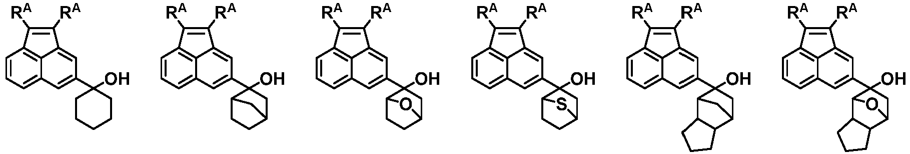

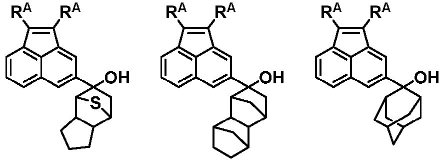

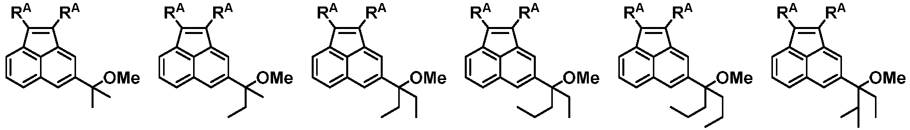

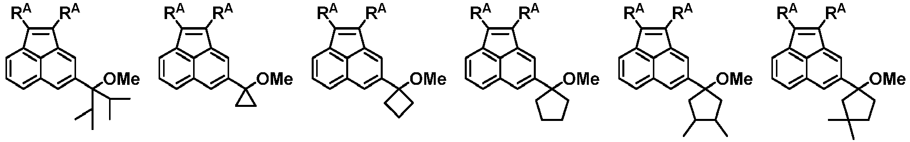

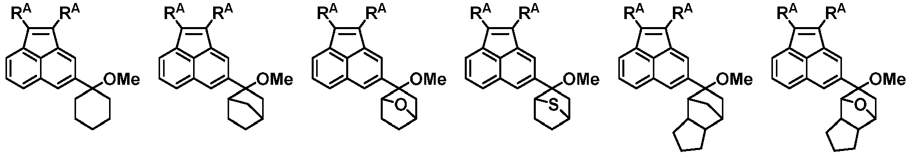

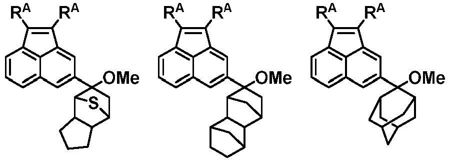

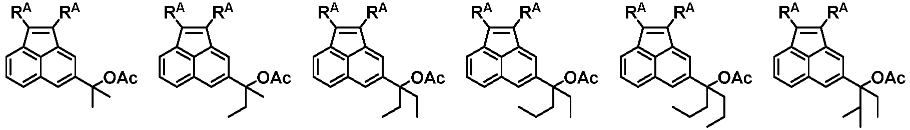

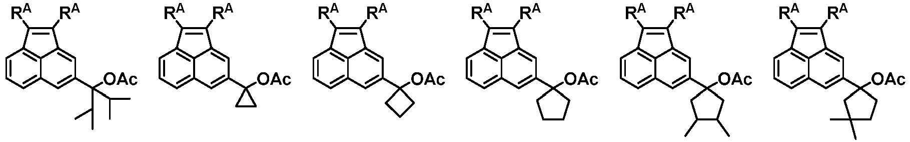

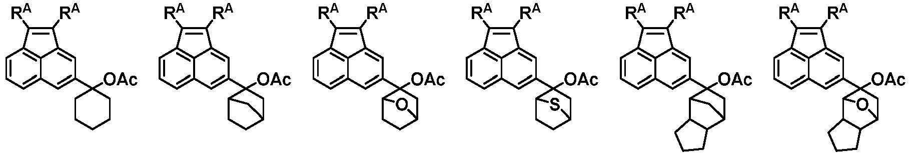

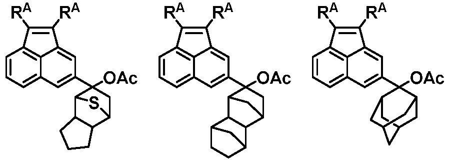

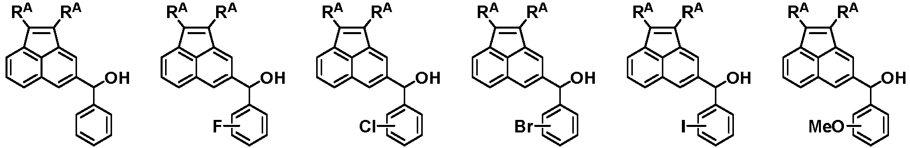

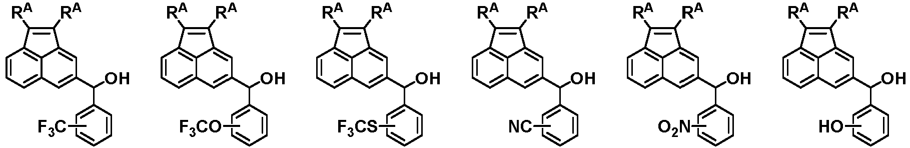

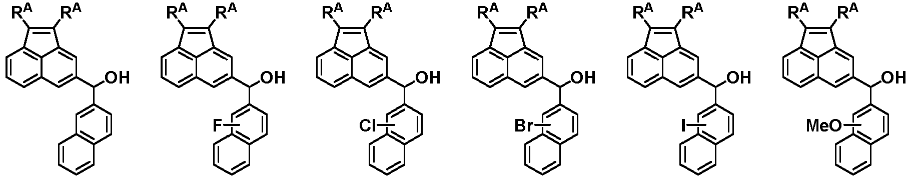

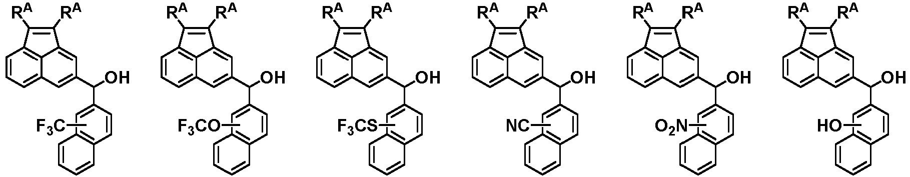

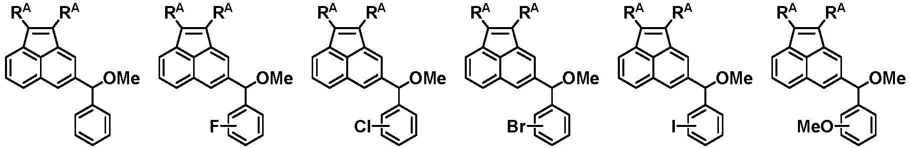

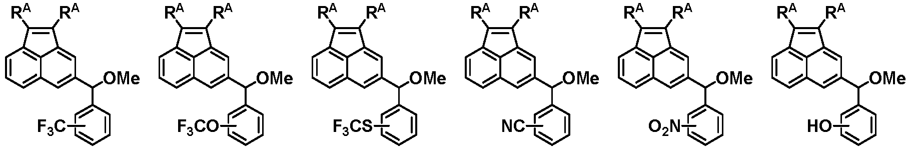

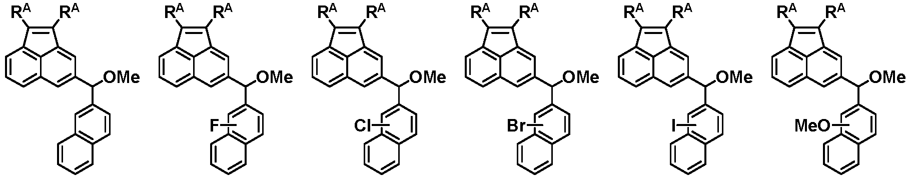

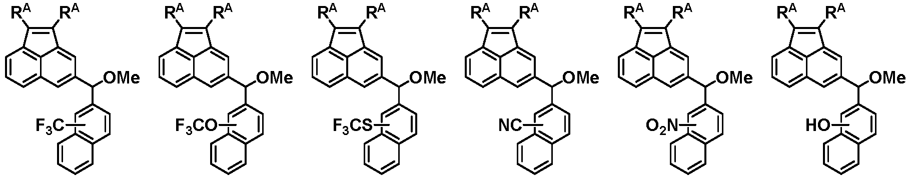

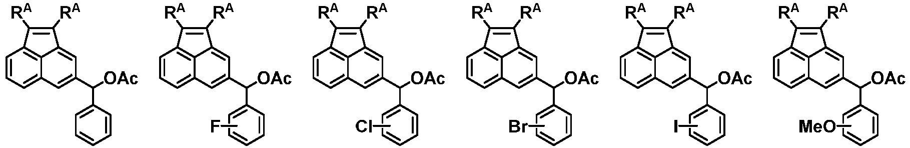

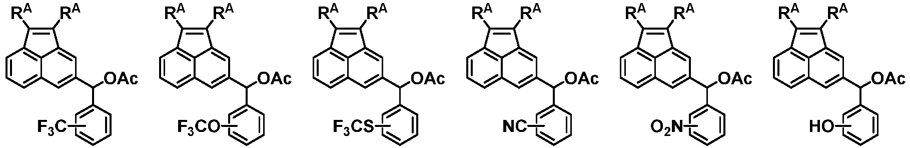

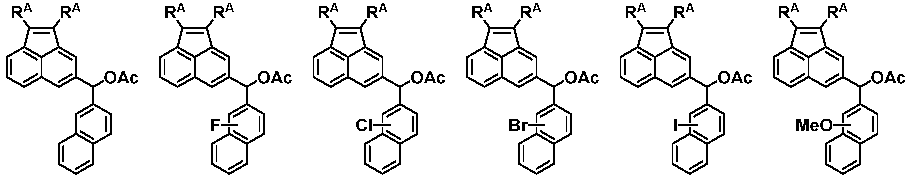

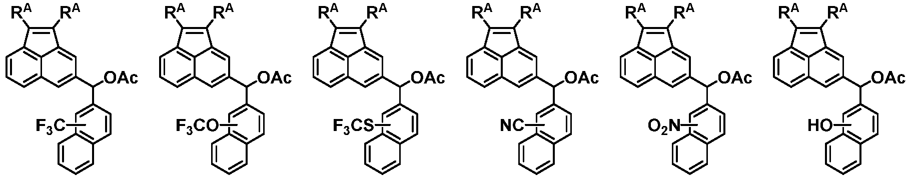

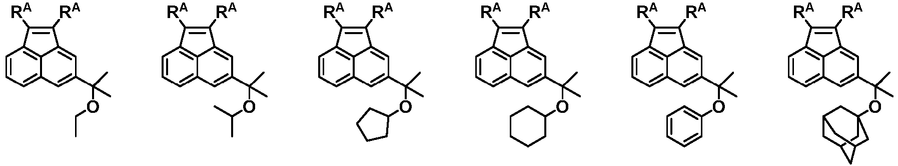

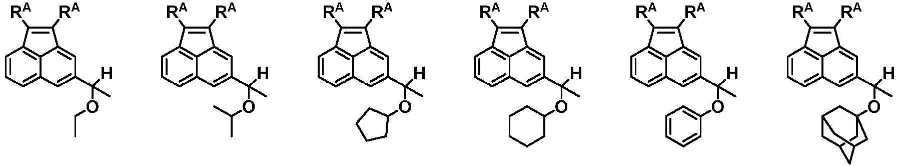

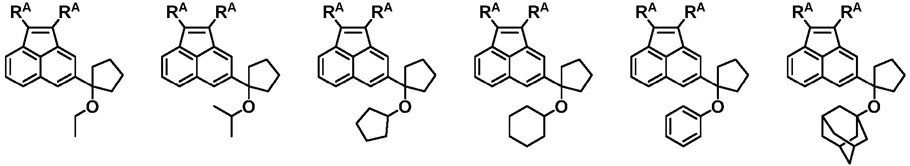

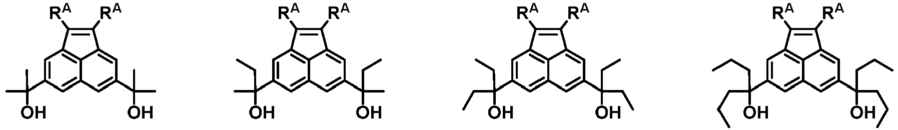

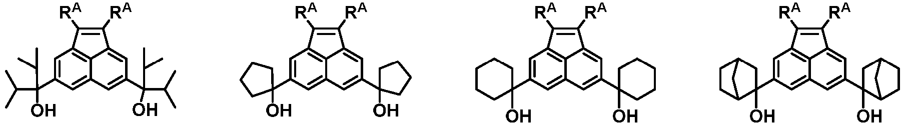

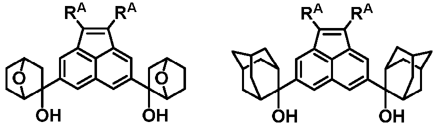

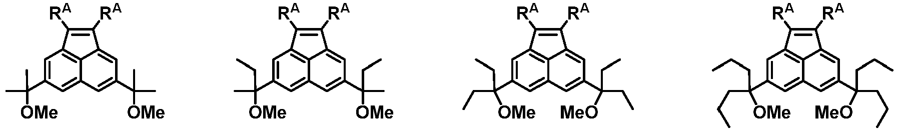

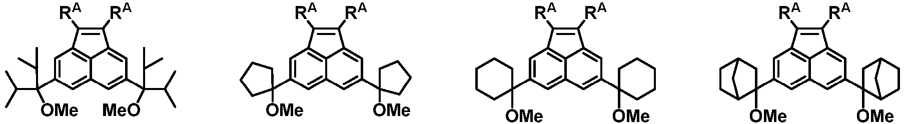

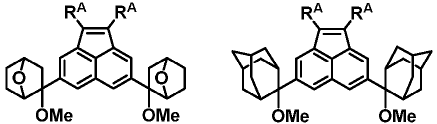

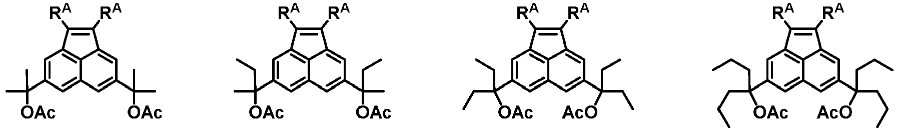

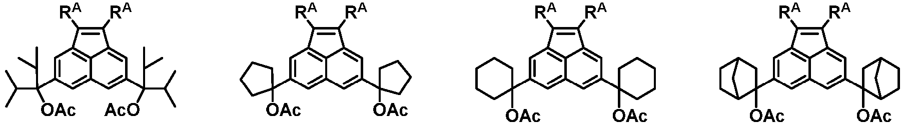

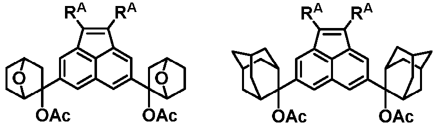

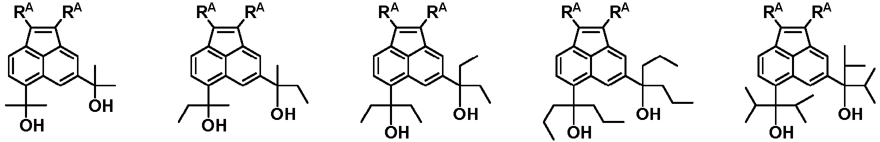

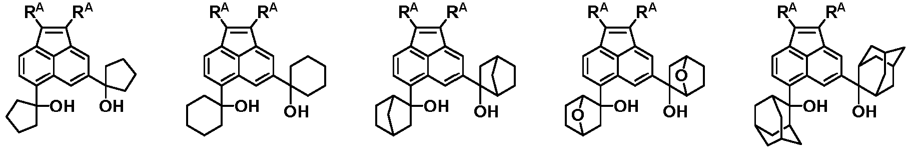

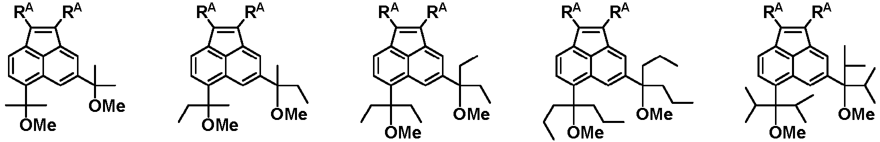

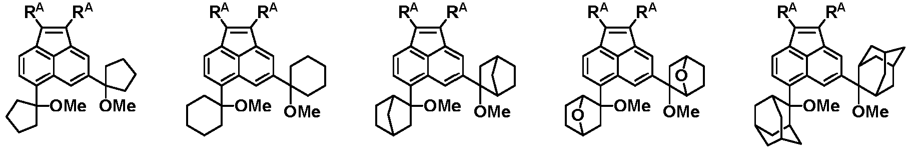

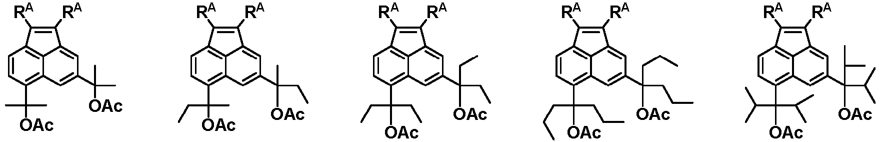

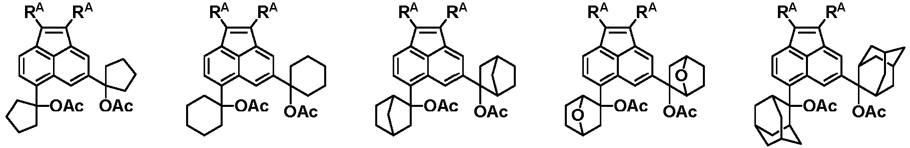

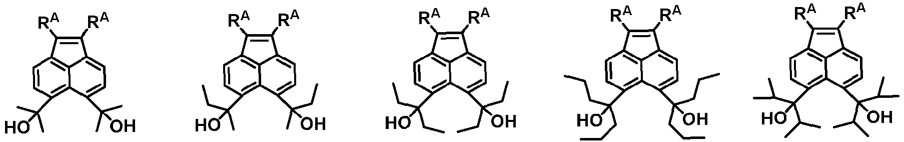

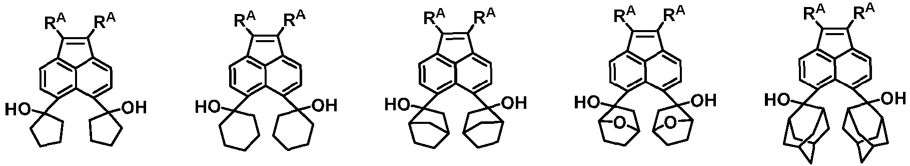

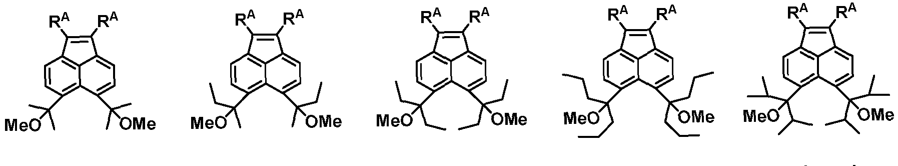

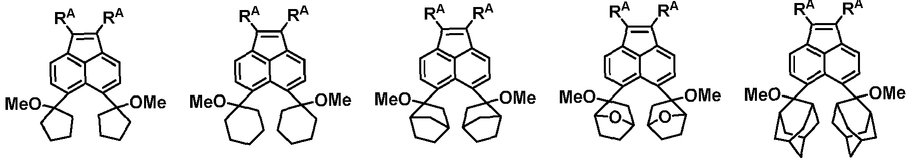

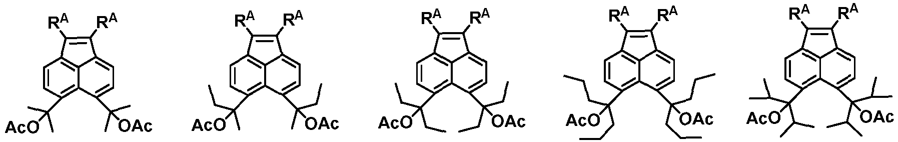

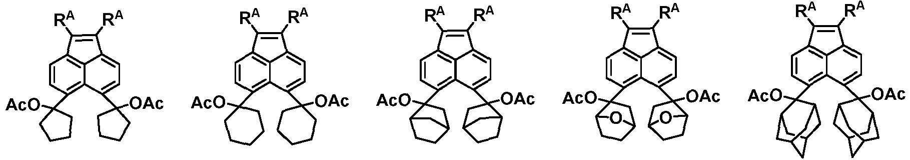

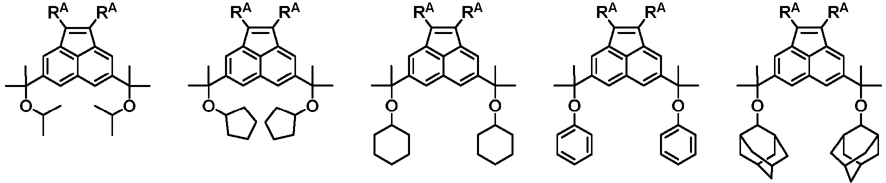

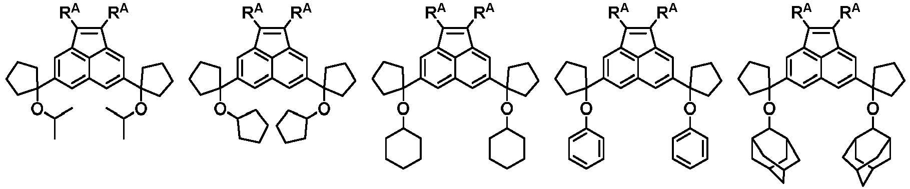

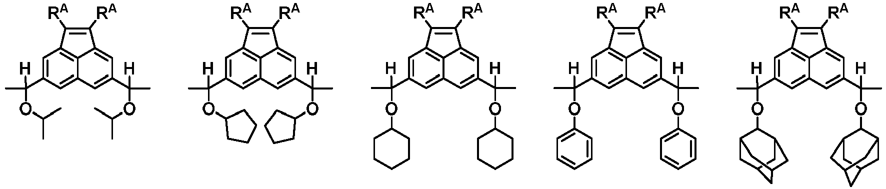

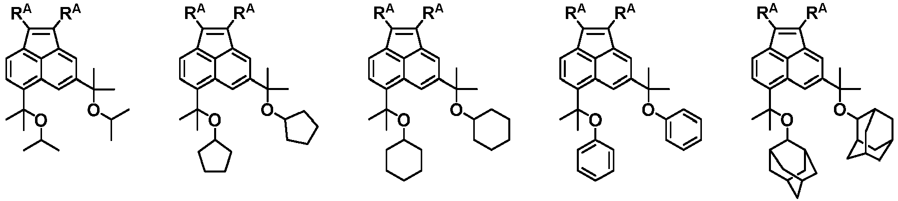

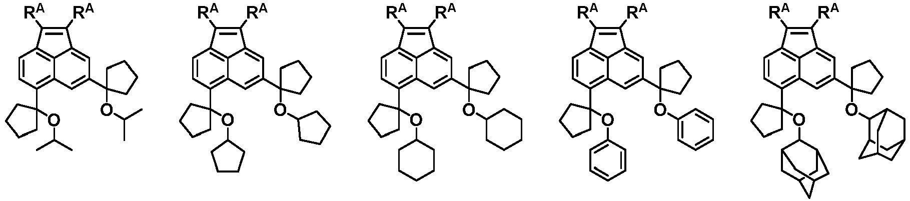

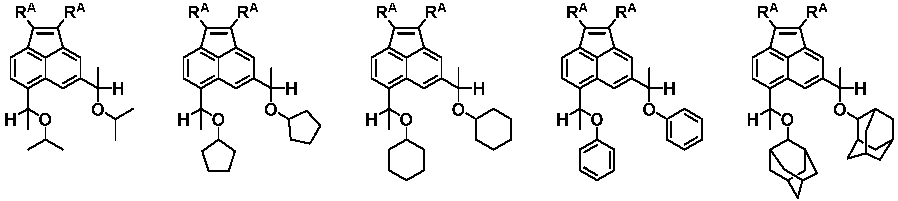

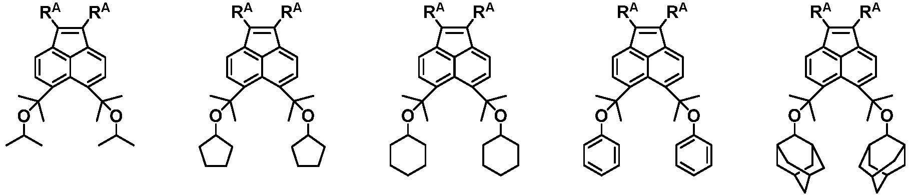

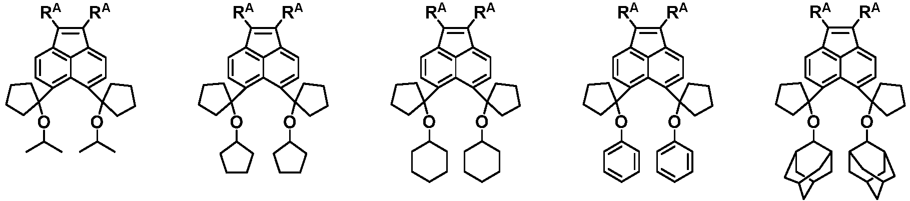

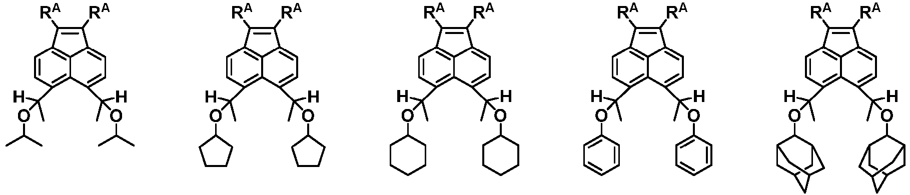

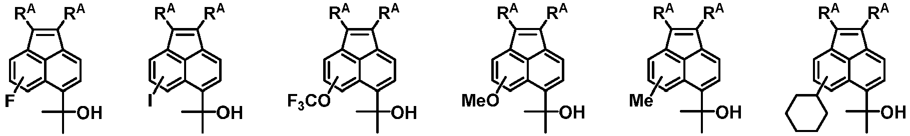

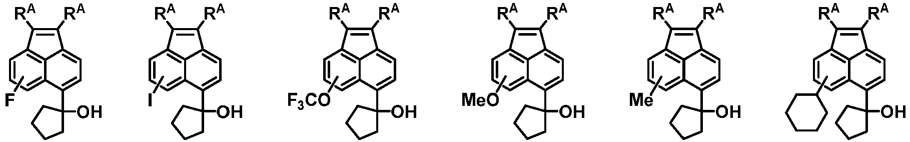

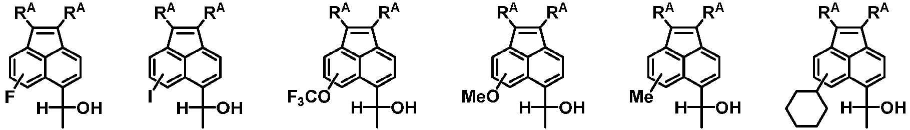

The repeat unit A4 may be used singly or in combination of two or more kinds thereof.

The polymer A and the polymer A' may contain at least one moiety selected from a repeat unit having formula (A5) (hereinafter, the repeat unit is also referred to as a repeat unit A5), a repeat unit having formula (A6) (hereinafter, the repeat unit is also referred to as a repeat unit A6), and a repeat unit having formula (A7) (hereinafter, the repeat unit is also referred to as a repeat unit A7) for the purpose of improving the etching resistance.

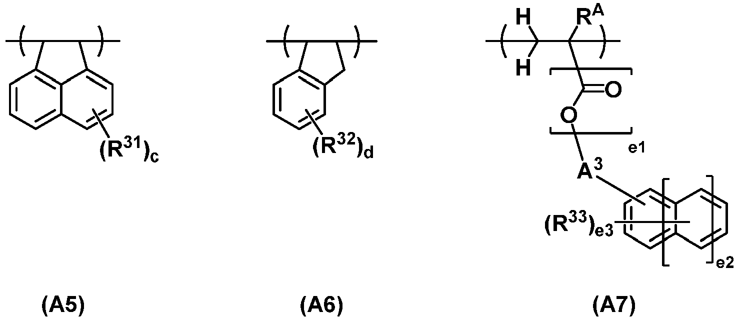

In formulae (A5) and (A6), c and d are each independently 0, 1, 2, 3, or 4.

In formulae (A5) and (A6), R³¹ and R³² are each independently a hydroxy group, a halogen atom, a C₁-C₈ saturated hydrocarbyl group which may be substituted with a halogen atom, a C₁-C₈ saturated hydrocarbyloxy group which may be substituted with a halogen atom, or a C₂-C₈ saturated hydrocarbylcarbonyloxy group which may be substituted with a halogen atom. The saturated hydrocarbyl group, the saturated hydrocarbyloxy group, and the saturated hydrocarbylcarbonyloxy group may be linear, branched, or cyclic. When c is 2 or more, groups R³¹ may be identical or different from each other. When d is 2 or more, groups R³² may be identical or different from each other.

In formula (A7), e1 is 0 or 1. e2 is 0, 1, or 2, and the corresponding structure represents a benzene skeleton when e2 is 0, a naphthalene skeleton when e2 is 1, and an anthracene skeleton when e2 is 2. e3 is 0, 1, 2, 3, 4, or 5. When e2 is 0, e3 is preferably 0, 1, 2, or 3, and when e2 is 1 or 2, e3 is preferably 0, 1, 2, 3, or 4.

In formula (A7), R^{A} is a hydrogen atom, a fluorine atom, a methyl group, or a trifluoromethyl group.

In formula (A7), R³³ is a C₁-C₂₀ saturated hydrocarbyl group, a C₁-C₂₀ saturated hydrocarbyloxy group, a C₂-C₂₀ saturated hydrocarbylcarbonyloxy group, a C₂-C₂₀ saturated hydrocarbyloxyhydrocarbyl group, a C₂-C₂₀ saturated hydrocarbylthiohydrocarbyl group, a halogen atom, a nitro group, a cyano group, a C₁-C₂₀ saturated hydrocarbylsulfinyl group, or a C₁-C₂₀ saturated hydrocarbylsulfonyl group. The saturated hydrocarbyl group, the saturated hydrocarbyloxy group, the saturated hydrocarbylcarbonyloxy group, the saturated hydrocarbyloxyhydrocarbyl group, the saturated hydrocarbylthiohydrocarbyl group, the saturated hydrocarbylsulfinyl group, and the saturated hydrocarbylsulfonyl group may be linear, branched, or cyclic. When e3 is 2 or more, groups R³³ may be identical or different from each other.

R³³ is preferably a halogen atom such as a chlorine atom, a bromine atom, or an iodine atom; a saturated hydrocarbyl group such as a methyl group, an ethyl group, a propyl group, a butyl group, a pentyl group, a hexyl group, a cyclopentyl group, a cyclohexyl group, or a structural isomer thereof; or a saturated hydrocarbyloxy group such as a methoxy group, an ethoxy group, a propoxy group, a butoxy group, a pentyloxy group, a hexyloxy group, a cyclopentyloxy group, a cyclohexyloxy group, or a structural isomer of a hydrocarbon moiety of these groups. Among them, a methoxy group and an ethoxy group are particularly useful.

The saturated hydrocarbylcarbonyloxy group can be easily introduced into a polymer by a chemical modification method even after polymerization, and can be used for fine adjustment of solubility of the base polymer in an alkaline developer. Examples of the saturated hydrocarbylcarbonyloxy group include a methylcarbonyloxy group, an ethylcarbonyloxy group, a propylcarbonyloxy group, a butylcarbonyloxy group, a pentylcarbonyloxy group, a hexylcarbonyloxy group, a cyclopentylcarbonyloxy group, a cyclohexylcarbonyloxy group, a benzoyloxy group, and structural isomers of hydrocarbon moieties of these groups. As long as the number of carbon atoms is 20 or less, an appropriate effect of controlling and adjusting (typically reducing) the solubility of the base polymer in an alkaline developer can be obtained, and generation of scum (or development defects) can be reduced.

Among the preferable substituents described above, substituents which are particularly easily prepared as monomers and are useful include a chlorine atom, a bromine atom, an iodine atom, a methyl group, an ethyl group, and a methoxy group.

In formula (A7), A³ is a single bond or a C₁-C₁₀ saturated hydrocarbylene group in which some constituent -CH₂- may be replaced by -O-. The saturated hydrocarbylene group may be linear, branched, or cyclic, and specific examples thereof include C₁-C₁₀ alkanediyl groups such as a methylene group, an ethane-1,2-diyl group, a propane-1,3-diyl group, a butane-1,4-diyl group, a pentane-1,5-diyl group, a hexane-1,6-diyl group, and structural isomers thereof; C₃-C₁₀ cyclic saturated hydrocarbylene groups such as a cyclopropanediyl group, a cyclobutanediyl group, a cyclopentanediyl group, and a cyclohexanediyl group; and groups obtained by combining the foregoing. For the saturated hydrocarbylene group which contains an ether bond, when e1 in formula (A7) is 1, the ether bond may be incorporated at any position excluding the position between the α-carbon and the β-carbon relative to the ester oxygen atom. When e1 is 0, the atom that bonds with the backbone becomes an ethereal oxygen atom, and a second ether bond may be incorporated at any position excluding the position between the α-carbon and the β-carbon relative to the ethereal oxygen atom. The number of carbon atoms of the saturated hydrocarbylene group is preferably 10 or less because sufficient solubility in an alkaline developer can be obtained.

When e1 is 0 and A³ is a single bond, in other words, when the aromatic ring is directly bonded to the backbone of the polymer (i.e., there is no linker (-C(=O)-O-A³-)), preferable examples of the repeat unit A7 include units derived from styrene, 4-chlorostyrene, 4-methylstyrene, 4-methoxystyrene, 4-bromostyrene, 4-acetoxystyrene, 2-hydroxypropylstyrene, 2-vinylnaphthalene, and 3-vinylnaphthalene.

When e1 is 1 (i.e., there is a linker (-C(=O)-O-A³-)), preferable examples of the repeat unit A7 include those shown below, but are not limited thereto. In the following formulae, R^{A} is as defined above.

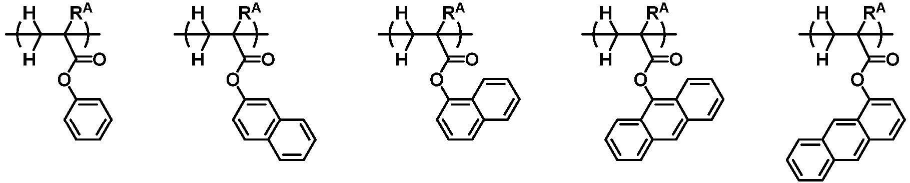

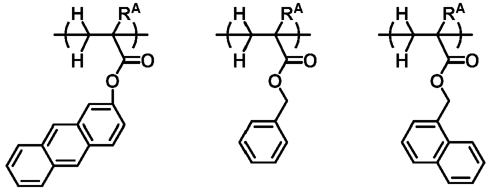

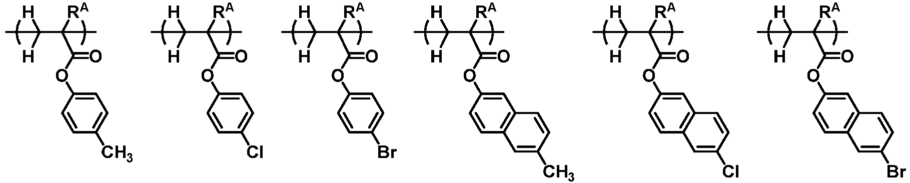

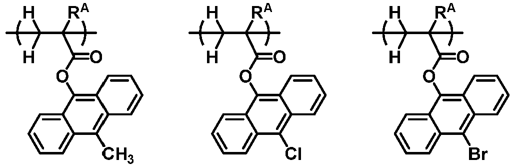

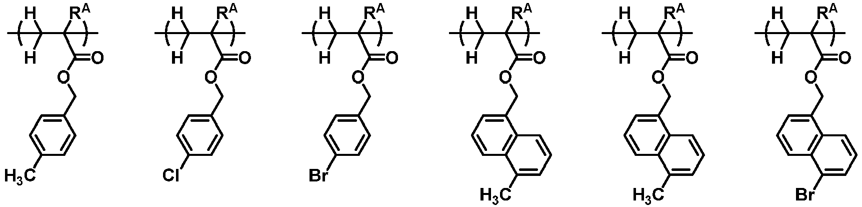

When at least one of the repeat units A5 to A7 is incorporated as a constituent unit of the polymer, in addition to the etching resistance of the aromatic ring, the ring structure incorporated into the backbone also exerts the effect of improving resistance to etching and EB irradiation during pattern inspection.

Each of the repeat units A5 to A7 may be used singly or in combination of two or more kinds thereof.

The polymers A and A' may contain a (meth)acrylate unit and other repeat units having an adhesive group such as a lactone structure or a hydroxy group other than a phenolic hydroxy group for fine adjustment of the properties of the resist film.

Examples of the (meth)acrylate unit having an adhesive group include a repeat unit having formula (A8) (hereinafter, the repeat unit is also referred to as a repeat unit A8), a repeat unit having formula (A9) (hereinafter, the repeat unit is also referred to as a repeat unit A9), and a repeat unit having formula (A10) (hereinafter, the repeat unit is also referred to as a repeat unit A10). These units do not exhibit acidity, and can be used as auxiliary units for providing adhesion to a substrate or for adjusting solubility.

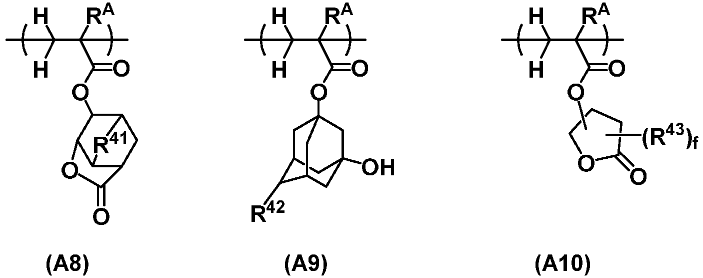

In formulae (A8) to (A10), groups R^{A} are each independently a hydrogen atom, a fluorine atom, a methyl group, or a trifluoromethyl group. R⁴¹ is -O- or a methylene group. R⁴² is a hydrogen atom or a hydroxy group. R⁴³ is a C₁-C₄ saturated hydrocarbyl group. f is 0, 1, 2, or 3.

The content of the repeat unit A¹ in the polymer A is preferably 1 to 20 mol%, and more preferably 2 to 15 mol% in order to obtain an effect of promoting the negative-working reaction. The content of the repeat unit A2 is preferably 30 to 95 mol%, and more preferably 50 to 85 mol% for establishing a high contrast between a region which is exposed to high-energy radiation and turns negative and the unexposed region (which does not turn negative) for the purpose of achieving high resolution. Each of the contents of the repeat unit A3 and the repeat unit A4 is preferably 5 to 70 mol%, and more preferably 10 to 60 mol% in order to obtain an effect of promoting the negative-working reaction. Each of the contents of the repeat units A5 to A7 is preferably 0 to 30 mol%, and more preferably 3 to 20 mol% in order to obtain an effect of improving etching resistance. The polymer A may contain other repeat units in an amount of 0 to 30 mol%, preferably 0 to 20 mol%.

The content of the repeat unit A¹ in the polymer A' is preferably 1 to 20 mol%, and more preferably 2 to 15 mol% in order to obtain an effect of promoting the negative-working reaction. The content of the repeat unit A2 is preferably 25 to 94.5 mol%, and more preferably 36 to 85 mol%. Each of the contents of the repeat units A5 to A7 is preferably 0 to 30 mol%, and more preferably 3 to 20 mol%. Each of the contents of the repeat units A3 and A4 is preferably 5 to 70 mol%, and more preferably 10 to 60 mol%. The total content of the repeat units A2 to A7 is preferably 60 to 99.5 mol%. The content of the repeat unit A¹ is preferably 0.5 to 20 mol%, and more preferably 1 to 10 mol%. The polymer A' may contain other repeat units in an amount of 0 to 30 mol%, preferably 0 to 20 mol%.

The repeat units A2 to A7 preferably account for 60 mol% or more, more preferably account for 70 mol% or more, and still more preferably account for 80 mol% or more of all the repeat units which constitute the polymer. As a result, properties required of the chemically amplified negative resist composition of the present invention are reliably obtained.

As the polymer A', a polymer containing a repeat unit having formula (A1), a repeat unit having formula (A2-1), and a repeat unit having formula (A3-1), (A3-2), or (A4-1) is preferable.

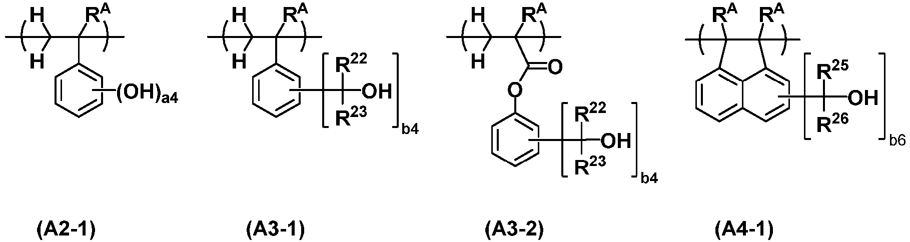

**In** the formulae, a4, b4, b6, R^{A}, R²², R²³, R²⁵, and R²⁶ are as defined above.

When the polymer A' is used as the base polymer (A), the polymer A' may be used in combination with a polymer which contains the repeat unit A2 and the repeat unit A3 or A4 and is free of the repeat unit A¹ (hereinafter, the polymer is also referred to as a polymer A"). **In** this case, the content of the repeat unit A2 in the polymer A" is preferably 25 to 95 mol%, and more preferably 40 to 85 mol%. Each of the contents of the repeat units A5 to A7 is preferably 0 to 30 mol%, and more preferably 3 to 20 mol%. Each of the contents of the repeat units A3 and A4 is preferably 5 to 70 mol%, and more preferably 10 to 60 mol%. The polymer A" may contain other repeat units in an amount of 0 to 30 mol%, preferably 0 to 20 mol%. When the polymer A' and the polymer A" are used in combination, the content of the polymer A" in the chemically amplified negative resist composition of the present invention is preferably 2 to 5000 parts by weight, and more preferably 10 to 1000 parts by weight per 100 parts by weight of the polymer containing the repeat unit A1.

When the chemically amplified negative resist composition is used for mask production, a coating film employed in the lithography of the advanced generation has a thickness of 150 nm or less, and preferably 100 nm or less. Since an intense development process is often employed to minimize defects resulting from resist residues, the base polymer that constitutes the chemically amplified negative resist composition should preferably have a dissolution rate in an alkaline developer (typically a 2.38 wt% aqueous tetramethylammonium hydroxide (TMAH) solution) of 80 nm/sec or less, and more preferably 50 nm/sec or less in order to form a fine pattern. When the chemically amplified negative resist composition of the present invention is used in the EUV lithography process for fabricating an LSI chip from a wafer, for example, the coating film often has a thickness of 100 nm or less in view of the necessity of patterning narrow lines of 50 nm or less. In consideration of the possibility that the pattern of such a thin film can be deteriorated by development, the polymer used preferably has a dissolution rate of 80 nm/sec or less, and more preferably 50 nm/sec or less.

The polymer can be synthesized by copolymerizing monomers optionally protected with a protecting group by a known method, and then performing a deprotection reaction as necessary. The copolymerization reaction is not particularly limited, and is preferably radical polymerization or anionic polymerization. For the polymerization reaction, reference may be made to WO 2006/121096, JP-A 2008-102383, JP-A 2008-304590, and JP-A 2004-115630.

The polymer preferably has a weight average molecular weight (Mw) of 1,000 to 50,000, and more preferably 2,000 to 20,000. As conventionally known, a Mw of 1,000 or more eliminates the possibility that pattern features are rounded at their top and the resolution is deteriorated, inviting deterioration of LER. On the other hand, a Mw of 50,000 or less eliminates the possibility that LER is increased when a pattern with a line width of 100 nm or less is formed. In the present invention, the Mw is a value measured in terms of polystyrene by gel permeation chromatography (GPC) using tetrahydrofuran (THF) or dimethylformamide (DMF) as a solvent.

The polymer preferably has a narrow molecular weight distribution (Mw/Mn) of 1.0 to 2.0, particularly 1.0 to 1.8. When the polymer has such a narrow molecular weight distribution, foreign matters are not generated on the pattern or the shape of the pattern is not deteriorated after development.

### (B) Crosslinker

When the base polymer (A) is free of the polymer A', the chemically amplified negative resist composition of the present invention preferably contains a crosslinker as the component (B). On the other hand, when the base polymer (A) contains the polymer A', the base polymer does not have to contain a crosslinker.

Specific examples of the crosslinker usable in the present invention include epoxy compounds, melamine compounds, guanamine compounds, glycoluril compounds, and urea compounds having substituted thereon at least one group selected from a methylol group, an alkoxymethyl group, and an acyloxymethyl group, isocyanate compounds, azide compounds, and compounds having a double bond such as an alkenyloxy group. These compounds may be used as an additive or introduced into a polymer side chain as a pendant group. In addition, a compound containing a hydroxy group can also be used as a crosslinker.

Examples of the epoxy compound include tris(2,3-epoxypropyl) isocyanurate, trimethylolmethane triglycidyl ether, trimethylolpropane triglycidyl ether, and triethylolethane triglycidyl ether.

Examples of the melamine compound include hexamethylol melamine, hexamethoxymethyl melamine, hexamethylol melamine compounds having 1 to 6 methylol groups methoxymethylated and mixtures thereof, hexamethoxyethyl melamine, hexaacyloxymethyl melamine, and hexamethylol melamine compounds having 1 to 6 methylol groups acyloxymethylated and mixtures thereof.

Examples of the guanamine compound include tetramethylol guanamine, tetramethoxymethyl guanamine, tetramethylol guanamine compounds having 1 to 4 methylol groups methoxymethylated and mixtures thereof, tetramethoxyethyl guanamine, tetraacyloxyguanamine, and tetramethylol guanamine compounds having 1 to 4 methylol groups acyloxymethylated and mixtures thereof.

Examples of the glycoluril compound include tetramethylol glycoluril, tetramethoxy glycoluril, tetramethoxymethyl glycoluril, tetramethylol glycoluril compounds having 1 to 4 methylol groups methoxymethylated and mixtures thereof, and tetramethylol glycoluril compounds having 1 to 4 methylol groups acyloxymethylated and mixtures thereof.

Examples of the urea compound include tetramethylol urea, tetramethoxymethyl urea, tetramethylol urea compounds having 1 to 4 methylol groups methoxymethylated and mixtures thereof, and tetramethoxyethyl urea.

Examples of the isocyanate compound include tolylene diisocyanate, diphenylmethane diisocyanate, hexamethylene diisocyanate, and cyclohexane diisocyanate.

Examples of the azide compound include 1,1'-biphenyl-4,4'-bisazide, 4,4'-methylidenebisazide, and 4,4'-oxybisazide.

Examples of the alkenyloxy group-containing compound include ethylene glycol divinyl ether, triethylene glycol divinyl ether, 1,2-propanediol divinyl ether, 1,4-butanediol divinyl ether, tetramethylene glycol divinyl ether, neopentyl glycol divinyl ether, trimethylol propane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylol propane trivinyl ether.

The content of the crosslinker (B) in the chemically amplified negative resist composition of the present invention is preferably 0.1 to 50 parts by weight, and more preferably 1 to 30 parts by weight per 80 parts by weight of the base polymer (A). As long as the amount of the crosslinker is within the above range, there is little possibility that resolution is reduced by bridge formation between pattern features. The crosslinker (B) may be used singly or in combination of two or more kinds thereof.

### (C) Fluorinated Polymer

The chemically amplified negative resist composition of the present invention may further contain, as the component (C), a fluorinated polymer for the purposes of enhancing contrast, preventing chemical flare of an acid upon exposure to high-energy radiation, preventing mixing of an acid from an anti-charging film in the step of applying an anti-charging film-forming material onto a resist film, and reducing unexpected unnecessary pattern deterioration. The fluorinated polymer contains at least one moiety selected from a repeat unit having formula (C1) (hereinafter, the repeat unit is also referred to as a repeat unit C1), a repeat unit having formula (C2) (hereinafter, the repeat unit is also referred to as a repeat unit C2), a repeat unit having formula (C3) (hereinafter, the repeat unit is also referred to as a repeat unit C3), and a repeat unit having formula (C4) (hereinafter, the repeat unit is also referred to as a repeat unit C4), and may further contain at least one moiety selected from a repeat unit having formula (C5) (hereinafter, the repeat unit is also referred to as a repeat unit C5) and a repeat unit having formula (C6) (hereinafter, the repeat unit is also referred to as a repeat unit C6). Since the fluorinated polymer also functions as a surfactant, the fluorinated polymer can prevent the insoluble matter that may be generated during the development process from being reattached to the substrate, so that the fluorinated polymer also exhibits an effect on development defects.

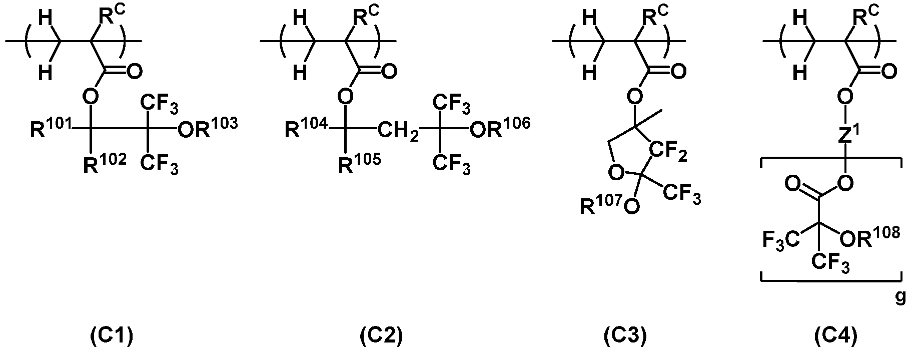

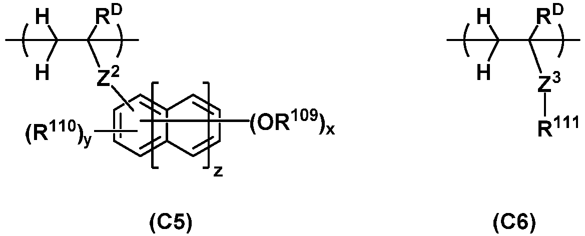

In formulae (C1) to (C6), x is 1, 2, or 3. y is an integer satisfying 0 ≤ y ≤ 5 + 2z - x. z is 0 or 1. g is 1, 2, or 3. Groups R^{C} are each independently a hydrogen atom, a fluorine atom, a methyl group, or a trifluoromethyl group. Groups R^{D} are each independently a hydrogen atom or a methyl group. R¹⁰¹, R¹⁰², R¹⁰⁴, and R¹⁰⁵ are each independently a hydrogen atom or a C₁-C₁₀ saturated hydrocarbyl group. R¹⁰³, R¹⁰⁶, R¹⁰⁷, and R¹⁰⁸ are each independently a hydrogen atom, a C₁-C₁₅ hydrocarbyl group, a C₁-C₁₅ fluorinated hydrocarbyl group, or an acid labile group, and when R¹⁰³, R¹⁰⁶, R¹⁰⁷, and R¹⁰⁸ are each a hydrocarbyl group or a fluorinated hydrocarbyl group, an ether bond or a carbonyl group may intervene in a carbon-carbon bond. R¹⁰⁹ is a hydrogen atom or a C₁-C₅ linear or branched hydrocarbyl group in which a heteroatom-containing moiety may intervene in a carbon-carbon bond. When x is 2 or more, groups R¹⁰⁹ may be identical or different from each other. R¹¹⁰ is a C₁-C₅ linear or branched hydrocarbyl group in which a heteroatom-containing moiety may intervene in a carbon-carbon bond. When y is 2 or more, groups R¹¹⁰ may be identical or different from each other. R¹¹¹ is a C₁-C₂₀ saturated hydrocarbyl group in which at least one hydrogen atom is substituted with a fluorine atom, and some -CH₂- in the saturated hydrocarbyl group may be replaced by an ester bond or an ether bond. Z¹ is a C₁-C₂₀ (g+1)-valent hydrocarbon group or a C₁-C₂₀ (g+1)-valent fluorinated hydrocarbon group. Z² is a single bond, *-C(=O)-O-, or *-C(=O)-NH-, wherein the asterisk (*) designates a point of attachment to a carbon atom in a backbone. Z³ is a single bond, -O-, *-C(=O)-O-Z³¹-Z³²-, or *-C(=O)-NH-Z³¹-Z³²-. Z³¹ is a single bond or a C₁-C₁₀ saturated hydrocarbylene group, and Z³² is a single bond, an ester bond, an ether bond, or a sulfonamide bond, wherein the asterisk (*) designates a point of attachment to a carbon atom in a backbone.

In formulae (C1) and (C2), the C₁-C₁₀ saturated hydrocarbyl group represented by R¹⁰¹, R¹⁰², R¹⁰⁴, and R¹⁰⁵ may be linear, branched or cyclic, and specific examples thereof include C₁-C₁₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-heptyl group, a n-octyl group, a n-nonyl group, and a n-decyl group; and C₃-C₁₀ cyclic saturated hydrocarbyl groups such as a cyclopropyl group, a cyclobutyl group, a cyclopentyl group, a cyclohexyl group, an adamantyl group, and a norbornyl group. Among them, C₁-C₆ saturated hydrocarbyl groups are preferable.

In formulae (C1) to (C4), the C₁-C₁₅ hydrocarbyl group represented by R¹⁰³, R¹⁰⁶, R¹⁰⁷, and R¹⁰⁸ may be linear, branched, or cyclic, and specific examples thereof include C₁-C₁₅ alkyl groups, C₂-C₁₅ alkenyl groups, and C₂-C₁₅ alkynyl groups. C₁-C₁₅ alkyl groups are preferable. Examples of the alkyl group include, in addition to those described above, a methyl group, an ethyl group, a n-propyl group, an isopropyl group, a n-butyl group, an isobutyl group, a sec-butyl group, a n-pentyl group, a n-hexyl group, a n-heptyl group, a n-octyl group, a n-nonyl group, a n-decyl group, a n-undecyl group, a n-dodecyl group, a n-tridecyl group, a n-tetradecyl group, and a n-pentadecyl group. Examples of the fluorinated hydrocarbyl group include groups in which some or all of hydrogen atoms bonded to the carbon atoms of the hydrocarbyl group are substituted with a fluorine atom.

In formula (C4), examples of the C₁-C₂₀ (g+1)-valent hydrocarbon group represented by Z¹ include a group obtained by further removing g hydrogen atoms from a C₁-C₂₀ alkyl group or a C₃-C₂₀ cyclic saturated hydrocarbyl group. Examples of the C₁-C₂₀ (g+1)-valent fluorinated hydrocarbon group represented by Z¹ include groups in which at least one hydrogen atom of the (g+1)-valent hydrocarbon group is substituted with a fluorine atom.

Specific examples of the repeat units C1 to C4 include those shown below, but are not limited thereto. In the following formulae, R^{C} is as defined above.

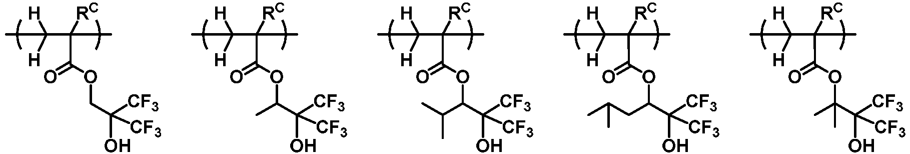

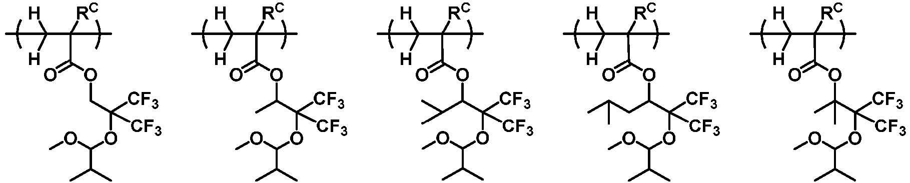

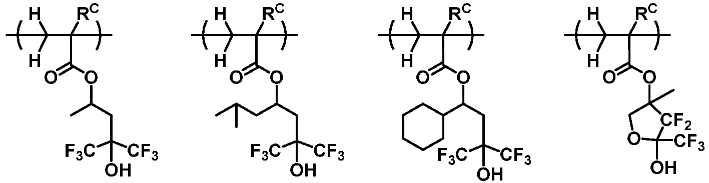

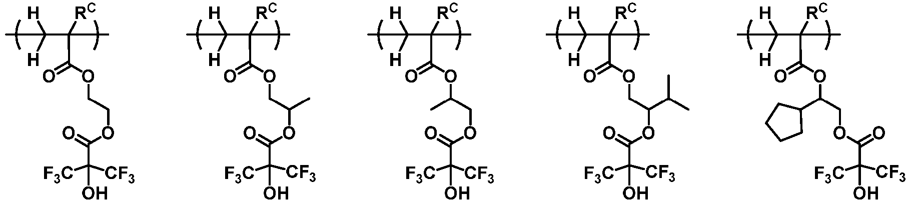

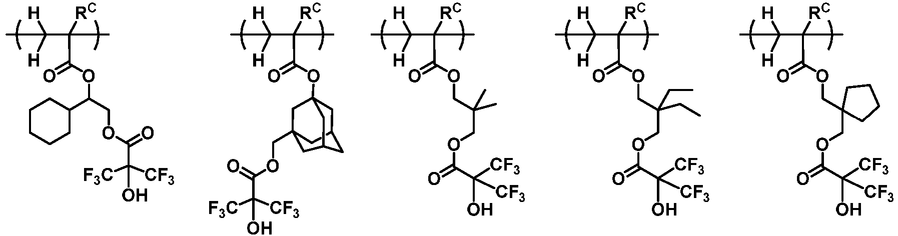

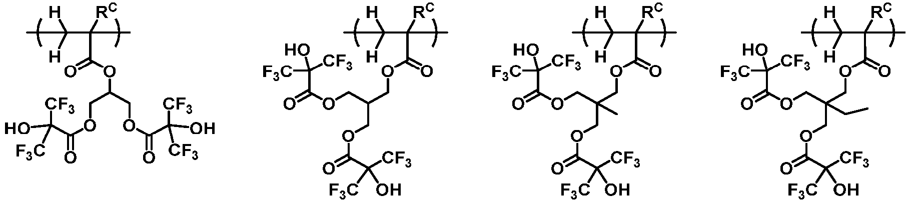

In formula (C5), examples of the C₁-C₅ hydrocarbyl group represented by R¹⁰⁹ and R¹¹⁰ include an alkyl group, an alkenyl group, and an alkynyl group, and an alkyl group is preferable. Examples of the alkyl group include a methyl group, an ethyl group, a n-propyl group, an isopropyl group, a n-butyl group, an isobutyl group, a sec-butyl group, and a n-pentyl group. In addition, a heteroatom-containing moiety such as an oxygen atom, a sulfur atom, or a nitrogen atom may intervene in a carbon-carbon bond of the hydrocarbyl group.

In formula (C5), -OR¹⁰⁹ is preferably a hydrophilic group. In this case, R¹⁰⁹ is preferably a hydrogen atom, a C₁-C₅ alkyl group in which an oxygen atom intervenes in a carbon-carbon bond, or the like.

In formula (C5), Z² is preferably *-C(=O)-O- or *-C(=O)-NH-. Further, R^{D} is preferably a methyl group. The presence of a carbonyl group in Z² enhances the ability to trap the acid originating from the anti-charging film. A polymer in which R^{D} is a methyl group is a robust polymer having a high glass transition temperature (Tg), which is effective for reducing acid diffusion. As a result, the resist film has improved temporal stability, and neither the resolution nor the pattern profile is deteriorated.

Examples of the repeat unit C5 include those shown below, but are not limited thereto. In the following formulae, R^{D} is as defined above.

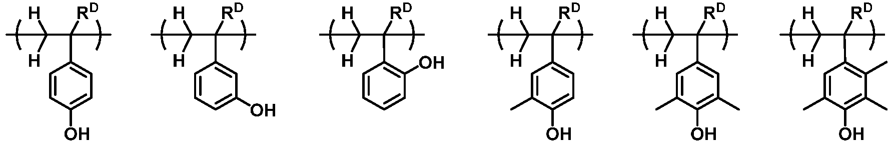

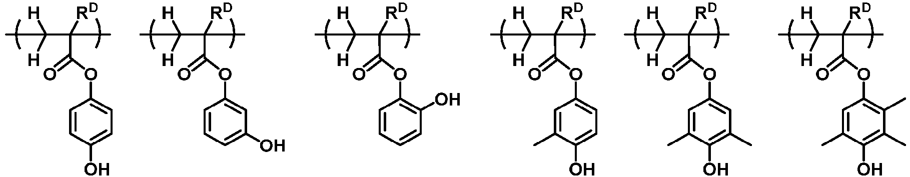

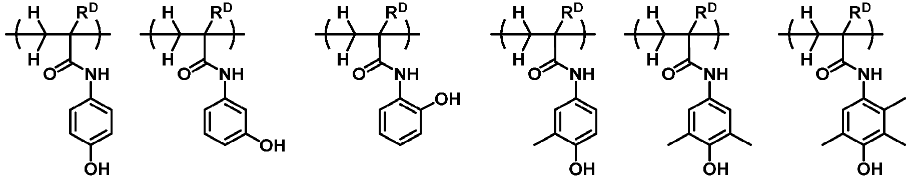

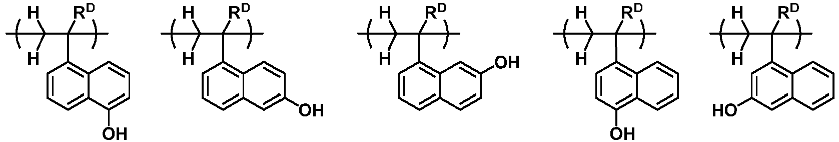

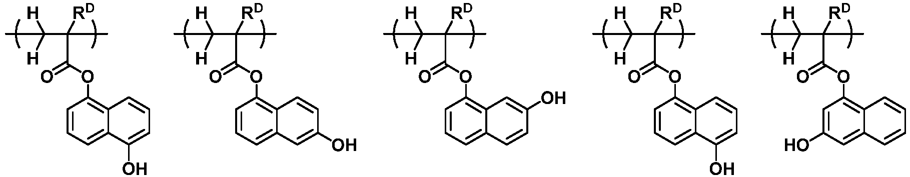

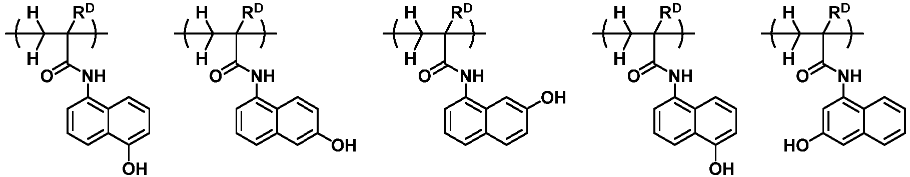

In formula (C6), the C₁-C₁₀ saturated hydrocarbylene group represented by Z³ may be linear, branched, or cyclic, and examples thereof include a methanediyl group, an ethane-1,1-diyl group, an ethane-1,2-diyl group, a propane-1,1-diyl group, a propane-1,2-diyl group, a propane-1,3-diyl group, a propane-2,2-diyl group, a butane-1,1-diyl group, a butane-1,2-diyl group, a butane-1,3-diyl group, a butane-2,3-diyl group, a butane-1,4-diyl group, and a 1,1-dimethylethane-1,2-diyl group.

In formula (C6), the C₁-C₂₀ saturated hydrocarbyl group in which at least one hydrogen atom is substituted with a fluorine atom represented by R¹¹¹ may be linear, branched, or cyclic, and specific examples thereof include groups in which at least one hydrogen atom of a C₁-C₂₀ alkyl group or a C₃-C₂₀ cyclic saturated hydrocarbyl group is substituted with a fluorine atom.

Examples of the repeat unit C6 include those shown below, but are not limited thereto. In the following formulae, R^{D} is as defined above.

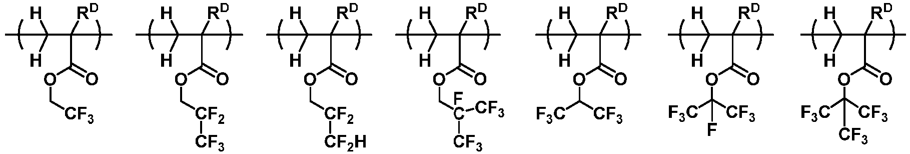

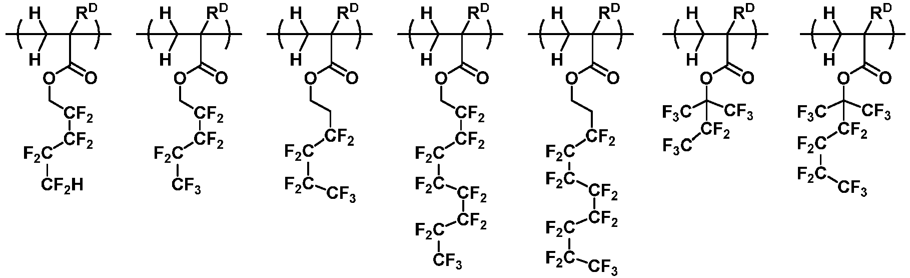

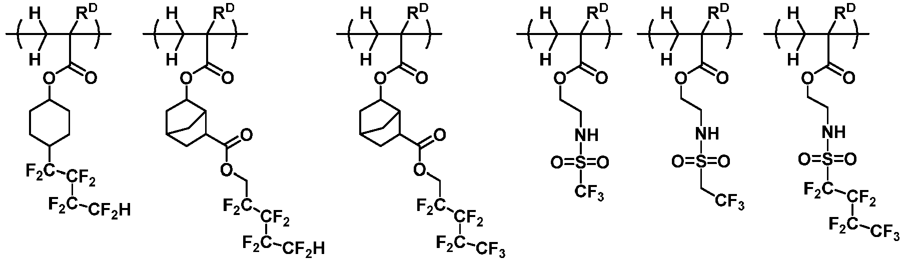

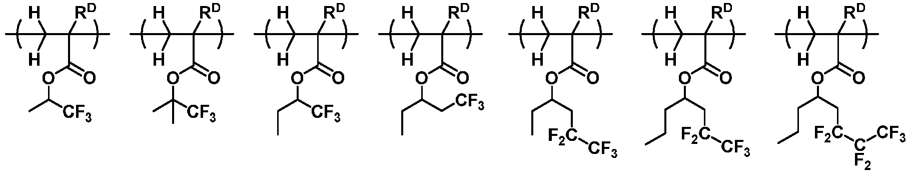

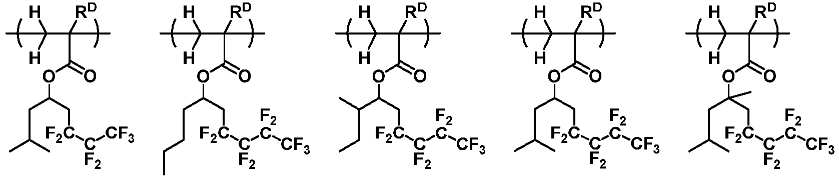

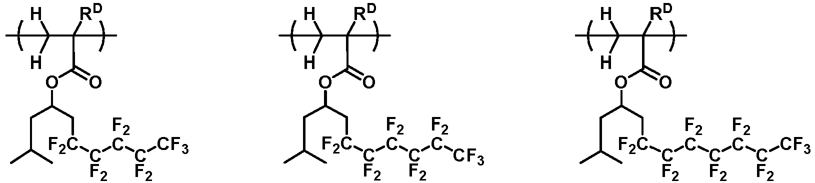

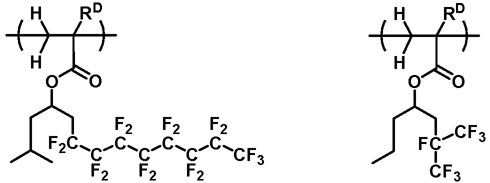

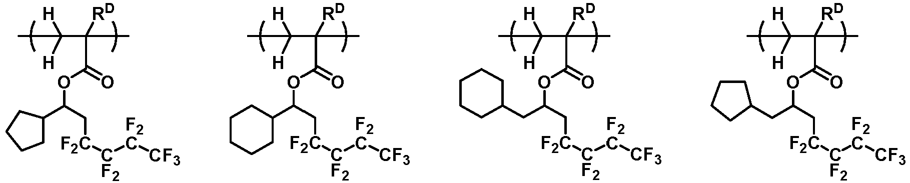

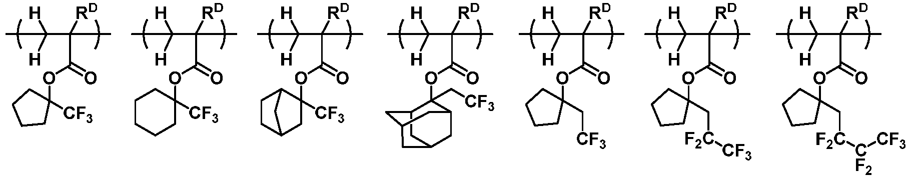

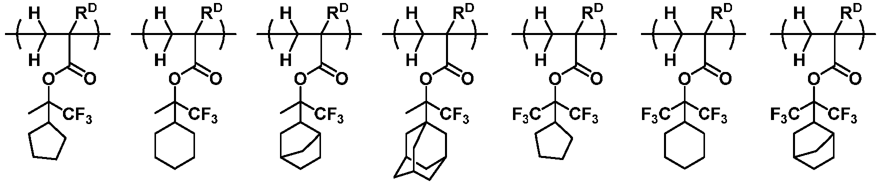

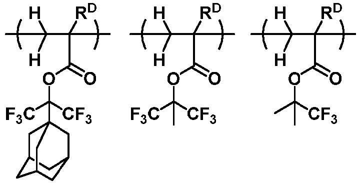

Each of the contents of the repeat units C1 to C4 in all the repeat units of the fluorinated polymer is preferably 15 to 95 mol%, and more preferably 20 to 85 mol%. Each of the contents of the repeat units C5 and/or C6 is preferably 5 to 85 mol%, and more preferably 15 to 80 mol% in all the repeat units of the fluorinated polymer. Each of the repeat units C1 to C6 may be used singly or in combination of two or more kinds thereof.

The fluorinated polymer may contain other repeat units other than the repeat units described above. Examples of such repeat units include those described in paragraphs [0046] to [0078] of JP-A 2014-177407. When the fluorinated polymer contains other repeat units, the content thereof is preferably 50 mol% or less in all the repeat units of the fluorinated polymer.

The fluorinated polymer can be synthesized by copolymerizing monomers optionally protected with a protecting group by a known method, and then performing a deprotection reaction as necessary. The copolymerization reaction is not particularly limited, and is preferably radical polymerization or anionic polymerization. As for the copolymerization method, JP-A 2004-115630 can be used as a reference.

The fluorinated polymer preferably has a Mw of 2,000 to 50,000, and more preferably 3,000 to 20,000. If the Mw is less than 2,000, the acid diffusion is promoted, and the resolution may be deteriorated or the temporal stability may be impaired. If the Mw is too large, the solubility in a solvent decreases, and coating defects may occur. The fluorinated polymer preferably has a Mw/Mn of 1.0 to 2.2, and more preferably 1.0 to 1.7.

When the chemically amplified negative resist composition of the present invention contains the fluorinated polymer (C), the content thereof is preferably 0.01 to 30 parts by weight, more preferably 0.1 to 20 parts by weight, and still more preferably 0.5 to 10 parts by weight per 80 parts by weight of the base polymer (A). The fluorinated polymer (C) may be used singly or in combination of two or more kinds thereof.

### (D) Quencher

The chemically amplified negative resist composition of the present invention preferably contains a quencher as the component (D). In the present invention, the quencher is a material which traps an acid generated from the photoacid generator in the chemically amplified resist composition to prevent diffusion to an unexposed area, thereby forming a desired pattern.

Examples of the quencher include conventional basic compounds. Examples of the conventional basic compounds include primary, secondary, and tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, imide derivatives, and carbamate derivatives. In particular, primary, secondary, and tertiary amine compounds described in paragraphs [0146] to [0164] of JP-A 2008-111103, particularly amine compounds having a hydroxy group, an ether bond, an ester bond, a lactone ring, a cyano group, or a sulfonic ester bond, and compounds having a carbamate group described in JP 3790649 are preferable. Preferable examples include tris[2-(methoxymethoxy)ethyl]amine, tris[2-(methoxymethoxy)ethyl]amine-N-oxide, dibutylaminobenzoic acid, morpholine derivatives, and imidazole derivatives. Addition of a basic compound may be effective for further reducing the diffusion rate of the acid in the resist film or correcting the pattern profile.

Examples of the quencher also include onium salts such as sulfonium salts, iodonium salts, and ammonium salts of α-non-fluorinated carboxylic acids as described in JP-A 2008-158339. While an α-fluorinated sulfonic acid, imide acid, or methide acid is necessary for deprotecting the acid labile group, an α-non-fluorinated carboxylic acid is released by salt exchange with an α-non-fluorinated onium salt. The α-non-fluorinated carboxylic acid functions as a quencher because it hardly induces a deprotection reaction.

Examples of the onium salt of the α-non-fluorinated carboxylic acid include those having formula (D1).

**R²⁰¹-CO₂⁻ Mq_{A}⁺** **(D1)**

In formula (D1), R²⁰¹ is a hydrogen atom or a C₁-C₄₀ hydrocarbyl group which may contain a heteroatom, exclusive of a hydrocarbyl group in which a hydrogen atom bonded to the carbon atom at the α-position of the carboxy group is substituted with a fluorine atom or a fluoroalkyl group.

The hydrocarbyl group represented by R²⁰¹ may be saturated or unsaturated, and may be linear, branched, or cyclic. Specific examples thereof include C₁-C₄₀ alkyl groups such as a methyl group, an ethyl group, a n-propyl group, an isopropyl group, a n-butyl group, a sec-butyl group, a tert-butyl group, a n-pentyl group, a tert-pentyl group, a n-hexyl group, a n-octyl group, a 2-ethylhexyl group, a n-nonyl group, and a n-decyl group; C₃-C₄₀ cyclic saturated hydrocarbyl groups such as a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a norbornyl group, a tricyclo[5.2.1.0^{2,6}]decyl group, an adamantyl group, and an adamantylmethyl group; C₂-C₄₀ alkenyl groups such as a vinyl group, an allyl group, a propenyl group, a butenyl group, and a hexenyl group; C₃-C₄₀ cyclic unsaturated aliphatic hydrocarbyl groups such as a cyclohexenyl group; C₆-C₄₀ aryl groups such as a phenyl group, a naphthyl group, alkylphenyl groups (e.g., a 2-methylphenyl group, a 3-methylphenyl group, a 4-methylphenyl group, a 4-ethylphenyl group, a 4-tert-butylphenyl group, and a 4-n-butylphenyl group), dialkylphenyl groups (e.g., a 2,4-dimethylphenyl group and a 2,4,6-triisopropylphenyl group), alkylnaphthyl groups (e.g., a methylnaphthyl group and an ethylnaphthyl group), and dialkylnaphthyl groups (e.g., a dimethylnaphthyl group and a diethylnaphthyl group); and C₇-C₄₀ aralkyl groups such as a benzyl group, a 1-phenylethyl group, and a 2-phenylethyl group.

Some or all of hydrogen atoms of the hydrocarbyl group may be substituted with a heteroatom-containing moiety such as an oxygen atom, a sulfur atom, a nitrogen atom, or a halogen atom, and some -CH₂- in the hydrocarbyl group may be substituted with a heteroatom-containing moiety such as an oxygen atom, a sulfur atom, or a nitrogen atom, so that the group may contain a hydroxy group, a cyano group, a carbonyl group, an ether bond, a thioether bond, an ester bond, a sulfonic ester bond, a carbonate bond, a lactone ring, a sultone ring, a carboxylic anhydride (-C(=O)-O-C(=O)-), or a haloalkyl group. Examples of the heteroatom-containing hydrocarbyl group include heteroaryl groups such as a thienyl group; alkoxyphenyl groups such as a 4-hydroxyphenyl group, a 4-methoxyphenyl group, a 3-methoxyphenyl group, a 2-methoxyphenyl group, a 4-ethoxyphenyl group, a 4-tert-butoxyphenyl group, and a 3-tert-butoxyphenyl group; alkoxynaphthyl groups such as a methoxynaphthyl group, an ethoxynaphthyl group, a n-propoxynaphthyl group, and a n-butoxynaphthyl group; dialkoxynaphthyl groups such as a dimethoxynaphthyl group and a diethoxynaphthyl group; and aryloxoalkyl groups, typically 2-aryl-2-oxoethyl groups such as a 2-phenyl-2-oxoethyl group, a 2-(1-naphthyl)-2-oxoethyl group, and a 2-(2-naphthyl)-2-oxoethyl group.

In formula (D1), Mq_{A}⁺ is an onium cation. The onium cation is preferably a sulfonium cation, an iodonium cation, or an ammonium cation, and more preferably a sulfonium cation or an iodonium cation. Specific examples of the sulfonium cation include those cations mentioned as the sulfonium cation having formula (cation-1). Specific examples of the iodonium cation include those cations mentioned as the iodonium cation having formula (cation-2).

Examples of an anion of the onium salt having formula (D1) include those shown below, but are not limited thereto.

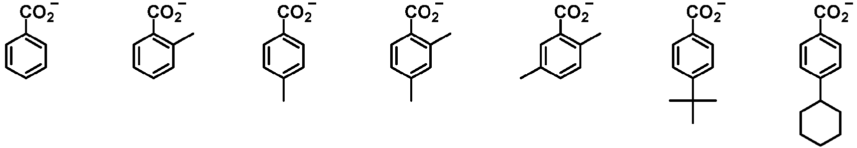

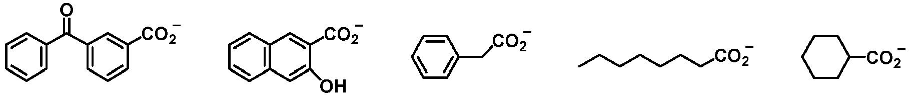

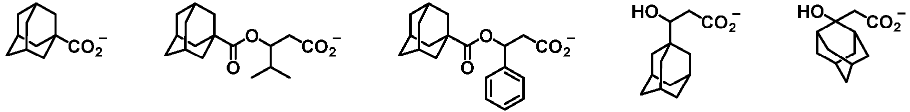

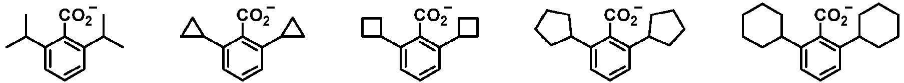

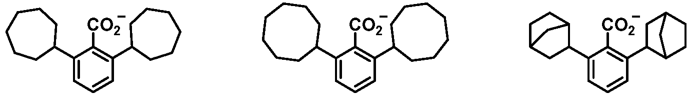

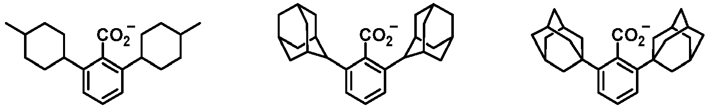

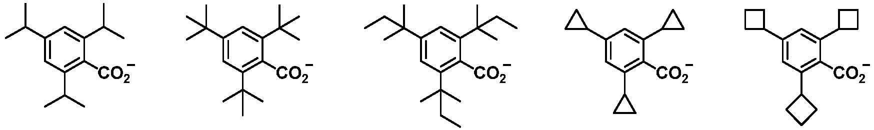

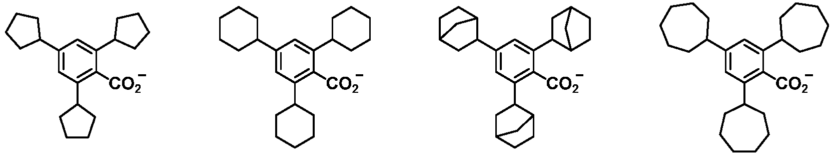

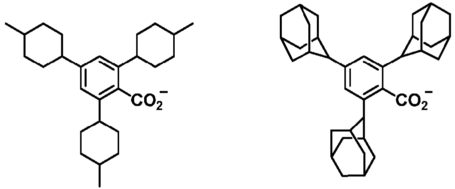

A sulfonium salt of iodized benzene ring-containing carboxylic acid having formula (D2) is also suitable for the quencher.

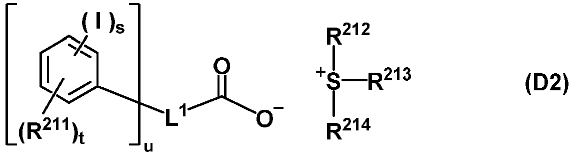

In formula (D2), s is 1, 2, 3, 4, or 5, t is 0, 1, 2, or 3, provided that 1 ≤ s + t ≤ 5. u is 1, 2, or 3.

In formula (D2), R²¹¹ is a hydroxy group, a fluorine atom, a chlorine atom, a bromine atom, an amino group, a nitro group, a cyano group, a C₁-C₆ saturated hydrocarbyl group, a C₁-C₆ saturated hydrocarbyloxy group, a C₂-C₆ saturated hydrocarbylcarbonyloxy group, a C₁-C₄ saturated hydrocarbylsulfonyloxy group, -N(R^{211A})-C(=O)-R^{211B}, or -N(R^{211A})-C(=O)-O-R^{211B}, and some or all of hydrogen atoms of the saturated hydrocarbyl group, the saturated hydrocarbyloxy group, the saturated hydrocarbylcarbonyloxy group, or the saturated hydrocarbylsulfonyloxy group may be substituted with a halogen atom. R^{211A} is a hydrogen atom or a C₁-C₆ saturated hydrocarbyl group. R^{211B} is a C₁-C₆ saturated hydrocarbyl group or a C₂-C₈ unsaturated aliphatic hydrocarbyl group. When t and/or u is 2 or more, groups R²¹¹ may be identical or different from each other.

In formula (D2), L¹ is a single bond or a C₁-C₂₀ (u+1)-valent linking group which may contain at least one moiety selected from an ether bond, a carbonyl group, an ester bond, an amide bond, a sultone ring, a lactam ring, a carbonate bond, a halogen atom, a hydroxy group, and a carboxy group. The saturated hydrocarbyl group, the saturated hydrocarbyloxy group, the saturated hydrocarbylcarbonyloxy group, and the saturated hydrocarbylsulfonyloxy group may be linear, branched, or cyclic.

In formula (D2), R²¹², R²¹³, and R²¹⁴ are each independently a halogen atom or a C₁-C₂₀ hydrocarbyl group which may contain a heteroatom. The hydrocarbyl group may be saturated or unsaturated, and may be linear, branched, or cyclic. Specific examples thereof include C₁-C₂₀ alkyl groups, C₂-C₂₀ alkenyl groups, C₆-C₂₀ aryl groups, and C₇-C₂₀ aralkyl groups. Some or all of hydrogen atoms of the hydrocarbyl group may be substituted with a hydroxy group, a carboxy group, a halogen atom, an oxo group, a cyano group, a nitro group, a sultone ring, a sulfo group, or a sulfonium salt-containing group, and some -CH₂- in the hydrocarbyl group may be replaced by an ether bond, an ester bond, a carbonyl group, an amide bond, a carbonate bond, or a sulfonic ester bond. R²¹² and R²¹³ may bond together to form a ring with a sulfur atom to which they are bonded.

Specific examples of the compound having formula (D2) include compounds described in JP-A 2017-219836. The compound having formula (D2) is highly absorbable and has a high sensitizing effect and a high acid diffusion-controlling effect.

As the quencher, a nitrogen atom-containing carboxylic acid salt compound having formula (D3) can also be used.

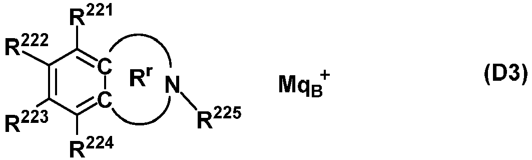

In formula (D3), R²²¹ to R²²⁴ are each independently a hydrogen atom, -L²-CO₂⁻, or a C₁-C₂₀ hydrocarbyl group which may contain a heteroatom. R²²¹ and R²²², R²²² and R²²³, or R²²³ and R²²⁴ may bond together to form a ring with a carbon atom to which they are bonded. L² is a single bond or a C₁-C₂₀ hydrocarbylene group which may contain a heteroatom. R²²⁵ is a hydrogen atom or a C₁-C₂₀ hydrocarbyl group which may contain a heteroatom.

In formula (D3), the ring R^{r} is a C₂-C₆ ring containing a carbon atom and a nitrogen atom in the formula, and some or all of hydrogen atoms bonded to the carbon atoms of the ring may be substituted with a C₁-C₂₀ hydrocarbyl group or -L²-CO₂⁻, and some -CH₂- in the ring may be substituted with a sulfur atom, an oxygen atom, or a nitrogen atom. The ring may be an alicyclic ring or an aromatic ring, and is preferably a 5- or 6-membered ring, and specific examples thereof include a pyridine ring, a pyrrole ring, a pyrrolidine ring, a piperidine ring, a pyrazole ring, an imidazoline ring, a pyridazine ring, a pyrimidine ring, a pyrazine ring, an imidazoline ring, an oxazole ring, a thiazole ring, a morpholine ring, a thiazine ring, and a triazole ring.

The carboxylic onium salt having formula (D3) has at least one -L²-CO₂⁻ group. That is, at least one of R²²¹ to R²²⁴ is -L²-CO₂⁻ and/or at least one of hydrogen atoms bonded to the carbon atoms of the ring R^{r} is substituted with -L²-CO₂⁻.

In formula (D3), Mq_{B}⁺ is a sulfonium cation, an iodonium cation, or an ammonium cation, and is preferably a sulfonium cation. Specific examples of the sulfonium cation include those cations mentioned as the sulfonium cation having formula (cation-1).

Examples of an anion of the compound having formula (D3) include those shown below, but are not limited thereto.

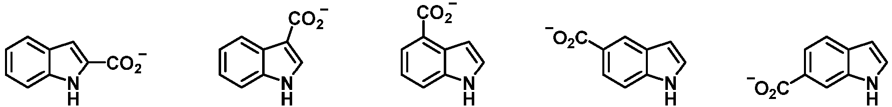

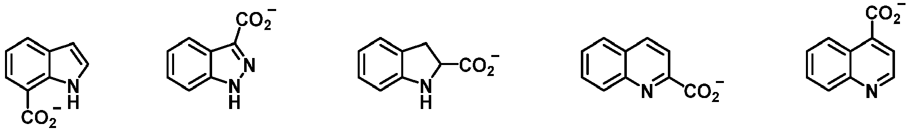

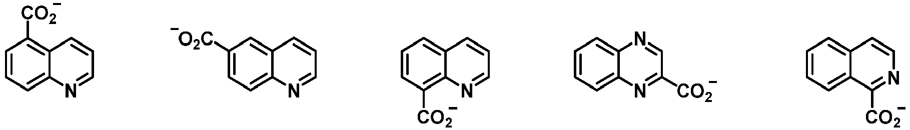

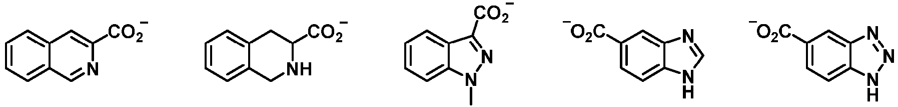

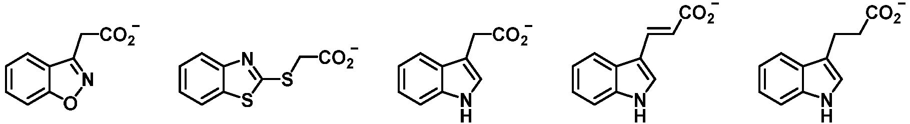

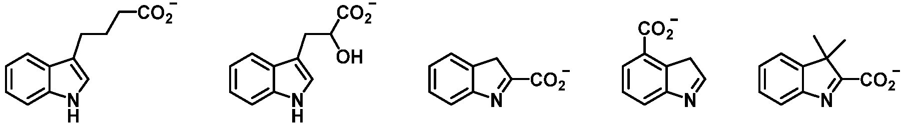

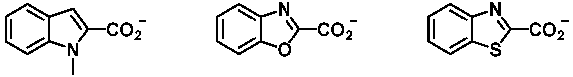

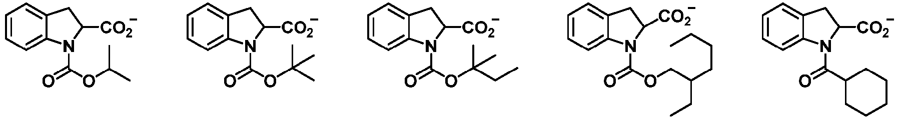

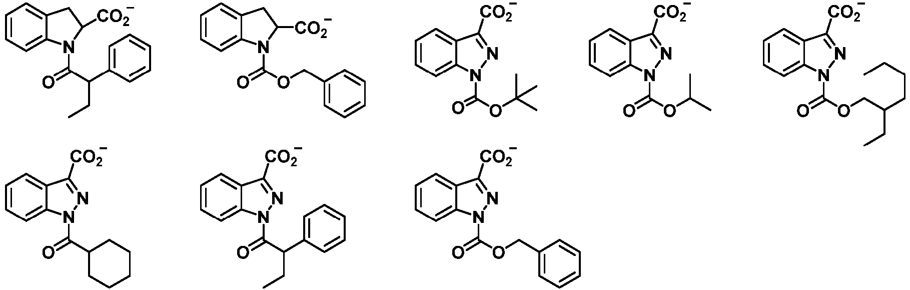

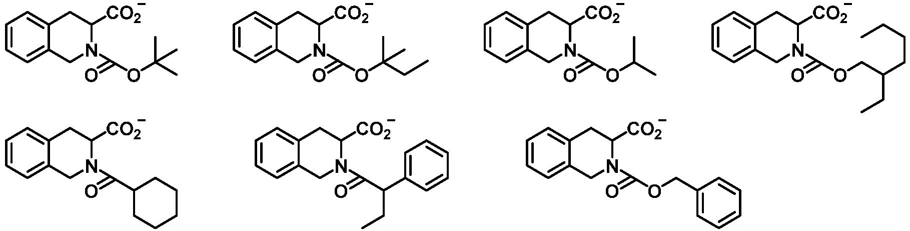

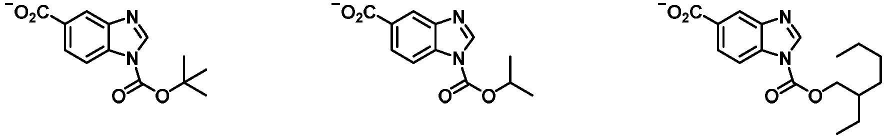

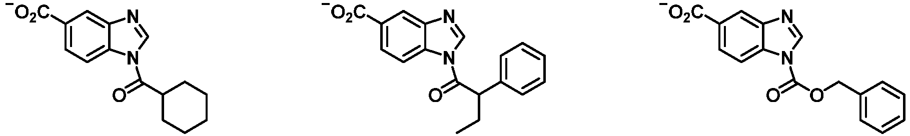

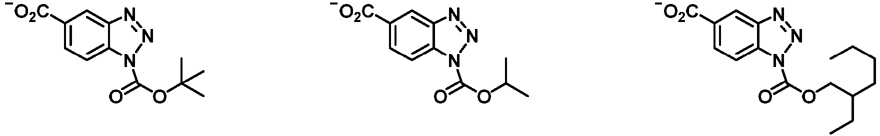

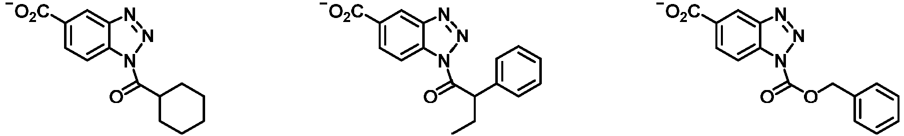

As the quencher, a weak acid betaine compound can also be used. Specific examples thereof include those shown below, but are not limited thereto.

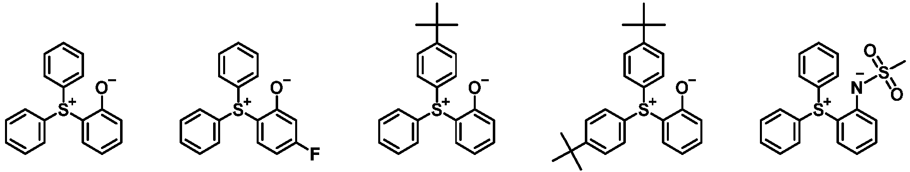

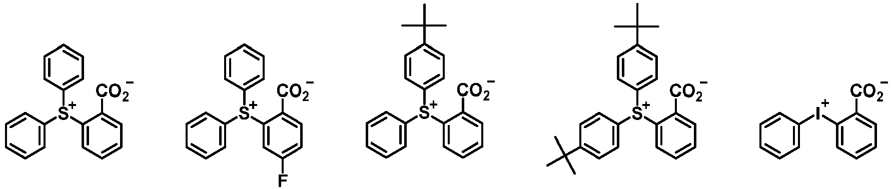

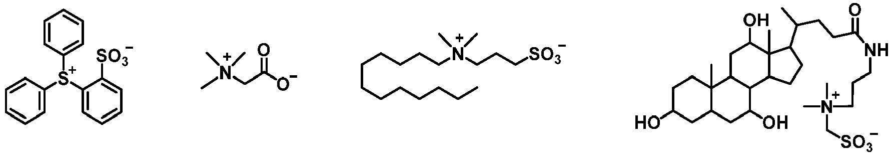

Examples of the quencher further include a polymeric quencher described in JP-A 2008-239918. The polymeric quencher segregates at the resist film surface and thus enhances the rectangularity of the resist pattern. When a protective film is applied as is often the case in immersion lithography, the polymeric quencher is also effective for preventing a film thickness loss of the resist pattern or rounding of the pattern top.

When the chemically amplified negative resist composition of the present invention contains the quencher (D), the content thereof is preferably 0 to 50 parts by weight, and more preferably 0.1 to 40 parts by weight per 80 parts by weight of the base polymer (A). The quencher (D) may be used singly or in combination of two or more kinds thereof.

When the chemically amplified negative resist composition of the present invention contains the photoacid generator as the component (F) described later and the quencher as the component (D), these components are contained so that the content ratio of the photoacid generator to the quencher (that is, (F)/(D)) is preferably less than 6, more preferably less than 5, and still more preferably less than 4 in terms of mass ratio. When the content ratio of the photoacid generator to the quencher in the chemically amplified negative resist composition is within the above range, acid diffusion can be sufficiently reduced, and excellent resolution and dimensional uniformity can be achieved.

### (E) Organic Solvent

The chemically amplified negative resist composition of the present invention may contain an organic solvent as the component (E). The organic solvent is not particularly limited as long as it can dissolve each of the components. Examples of the organic solvent include those described in paragraphs [0144] to [0145] of JP-A 2008-111103, including ketones such as cyclohexanone, cyclopentanone, methyl-2-n-pentyl ketone, and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, tert-butyl acetate, tert-butyl propionate, and propylene glycol mono-tert-butyl ether acetate; lactones such as γ-butyrolactone; and mixed solvents thereof.

Among these organic solvents, 1-ethoxy-2-propanol, PGMEA, PGME, cyclohexanone, EL, γ-butyrolactone, and mixed solvents thereof are preferable.

When the chemically amplified negative resist composition of the present invention contains the organic solvent (E), the content thereof is preferably 200 to 10000 parts by weight, and more preferably 400 to 6000 parts by weight per 80 parts by weight of the base polymer (A). The organic solvent (E) may be used singly or as a mixture of two or more kinds thereof.

### (F) Photoacid Generator

The chemically amplified negative resist composition of the present invention may contain a photoacid generator as the component (F). The photoacid generator is not particularly limited as long as it is a compound which generates an acid by irradiation with high-energy radiation. Suitable photoacid generators include sulfonium salts, iodonium salts, sulfonyldiazomethane, N-sulfonyloxyimide, and oxime-O-sulfonate acid generators.

Specific examples of the photoacid generator include nonafluorobutane sulfonate, the partially fluorinated sulfonate described in paragraphs [0247] to [0251] of JP-A 2012-189977, the partially fluorinated sulfonate described in paragraphs [0261] to [0265] of JP-A 2013-101271, and those described in paragraphs [0122] to [0142] of JP-A 2008-111103 and paragraphs [0080] to [0081] of JP-A 2010-215608. Among the above specific examples, arenesulfonate and alkanesulfonate type photoacid generators are preferable because they generate an acid having an appropriate strength for deprotecting the acid labile group of the repeat unit A3.

As the photoacid generator, the following salt compounds containing an anion are preferable.

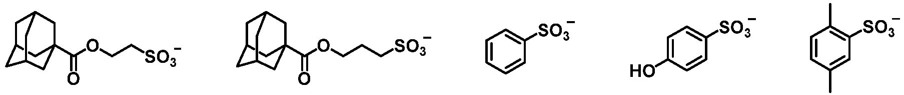

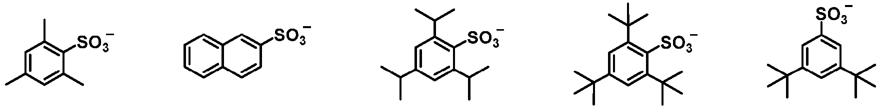

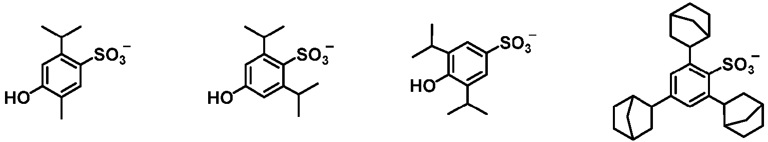

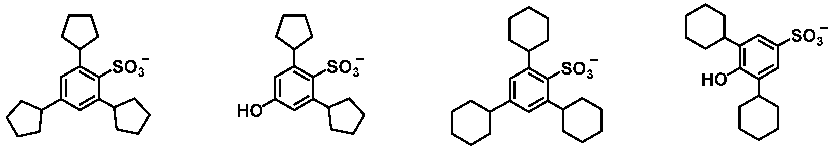

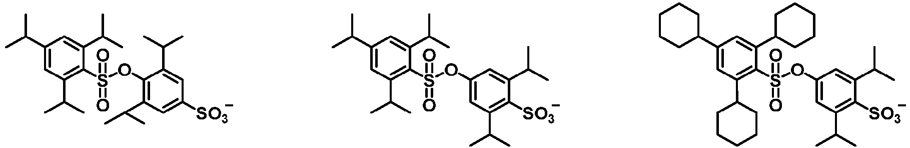

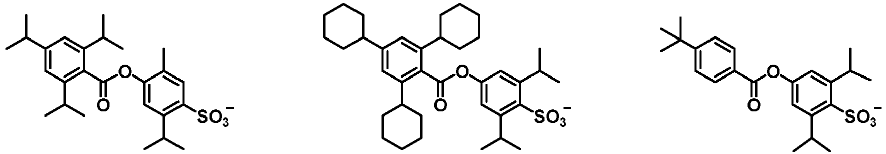

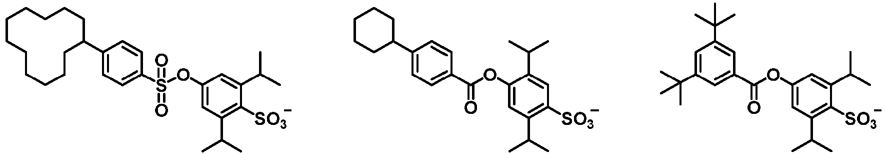

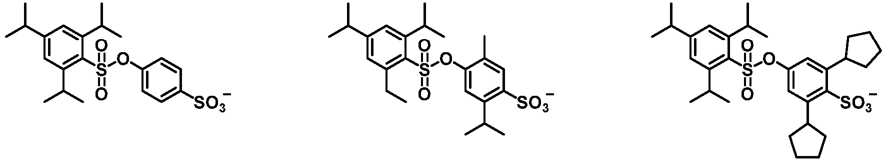

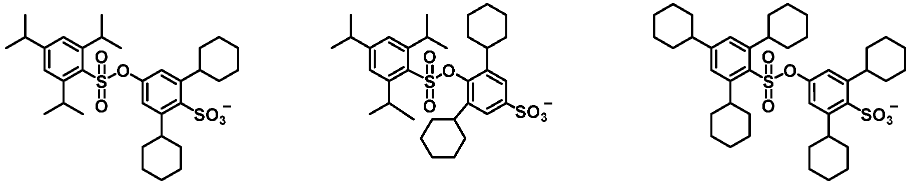

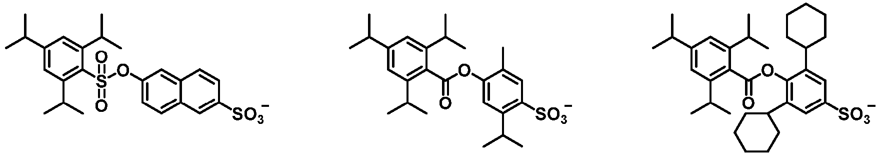

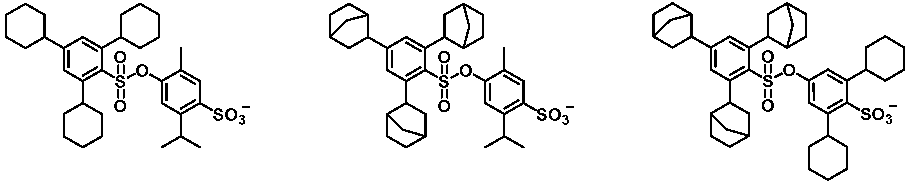

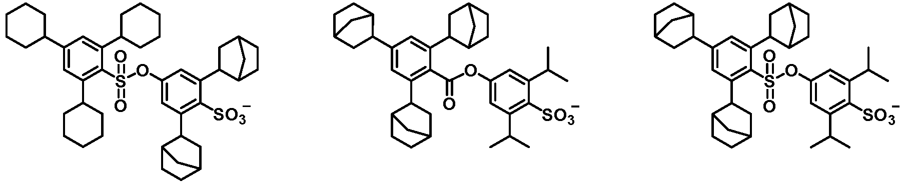

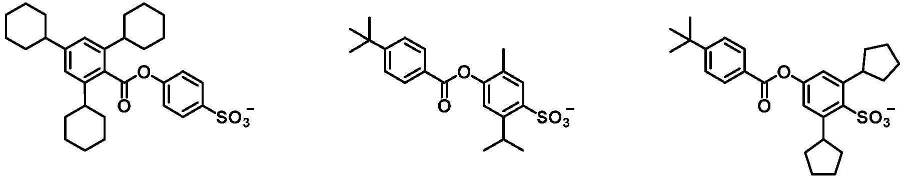

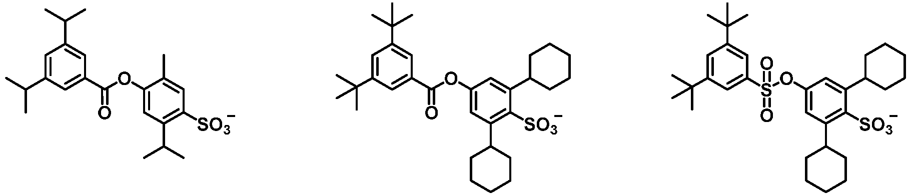

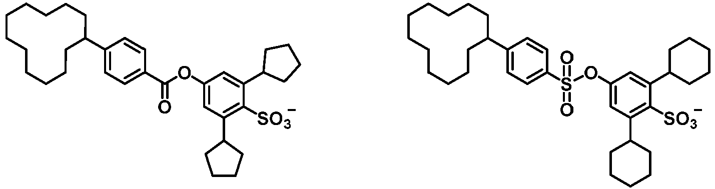

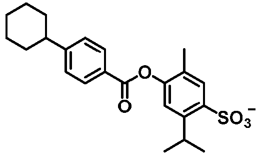

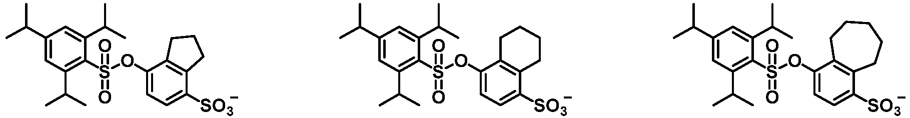

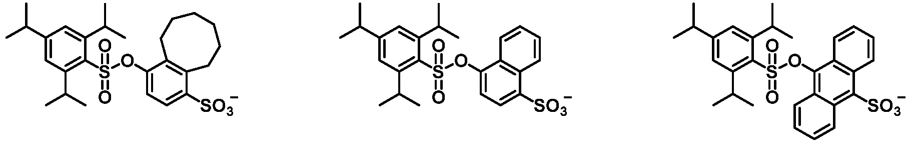

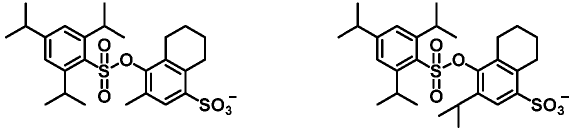

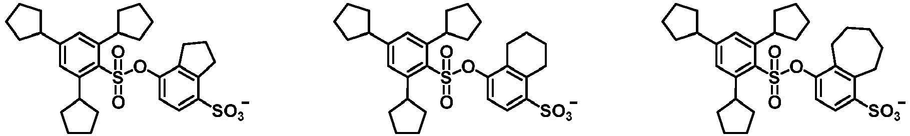

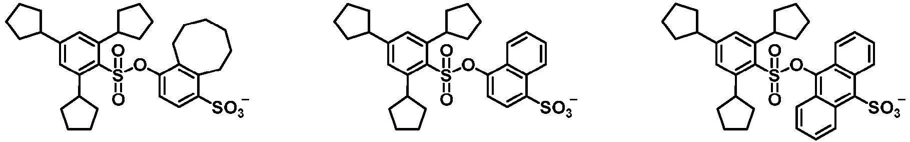

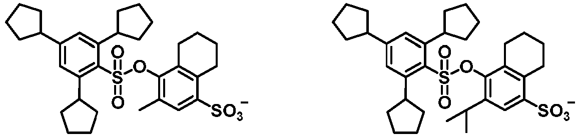

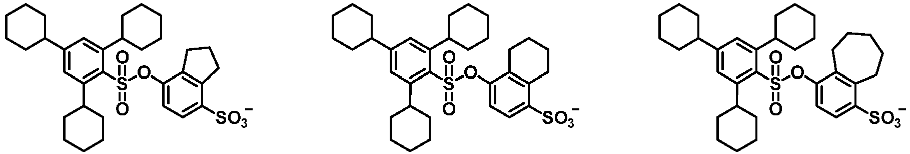

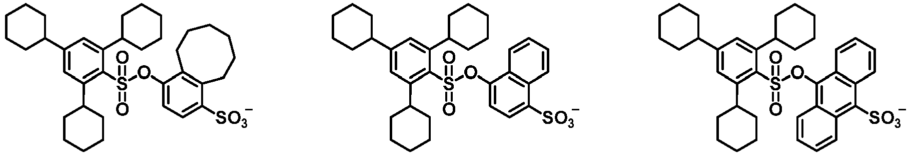

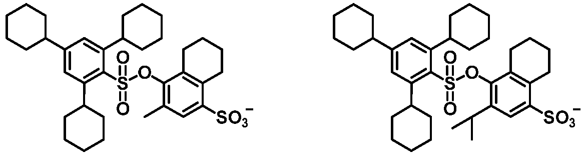

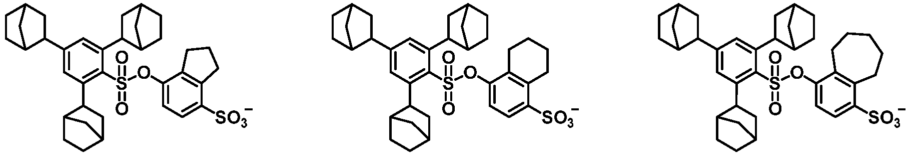

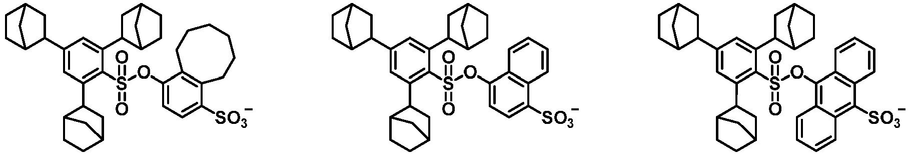

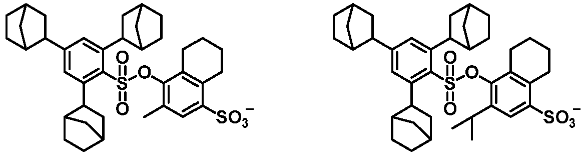

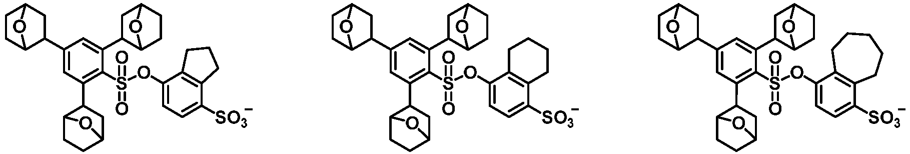

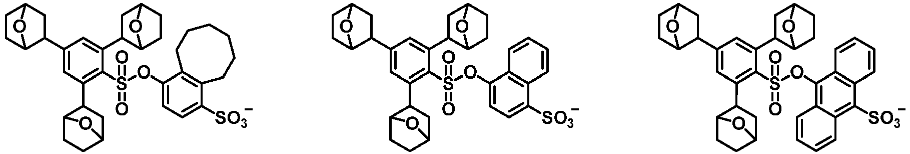

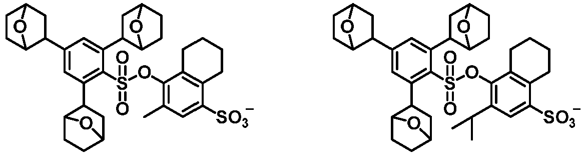

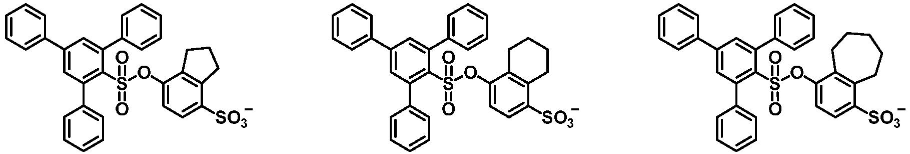

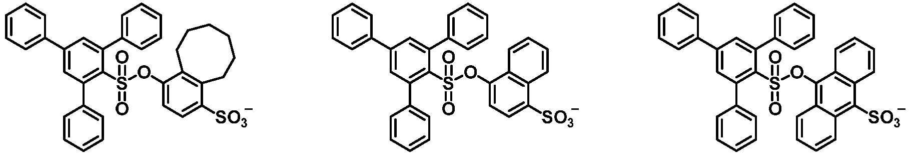

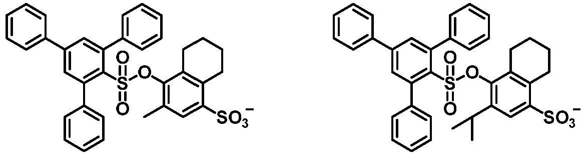

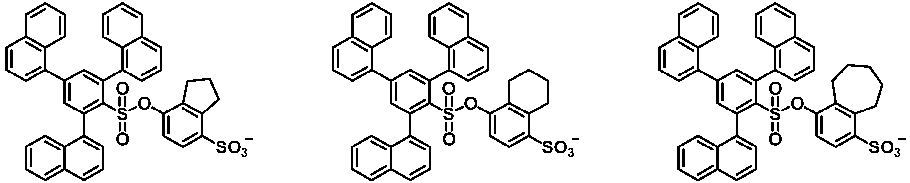

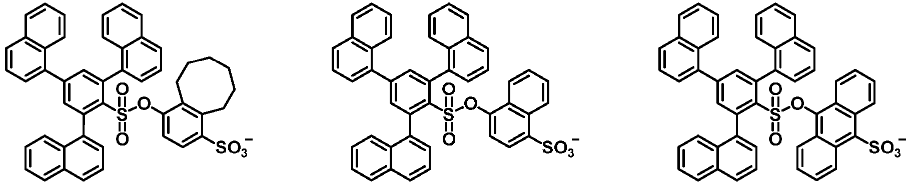

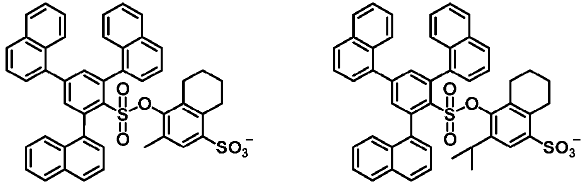

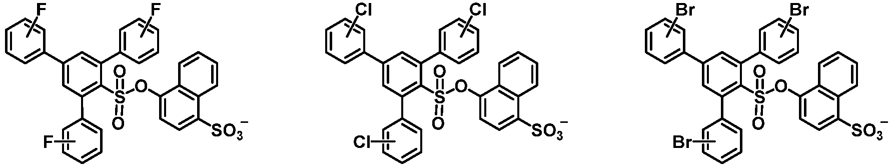

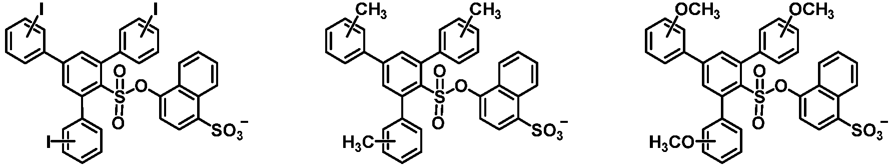

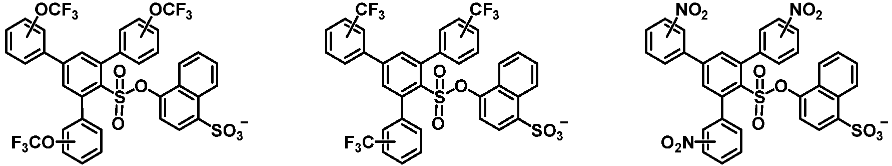

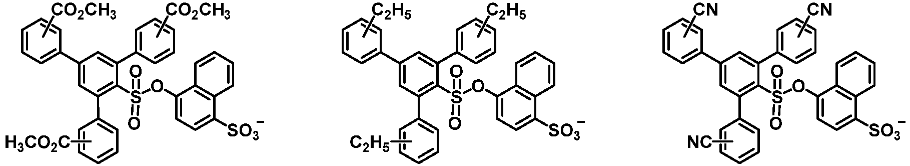

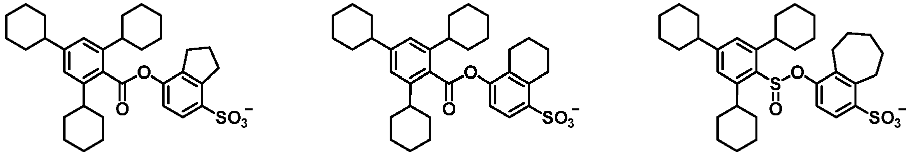

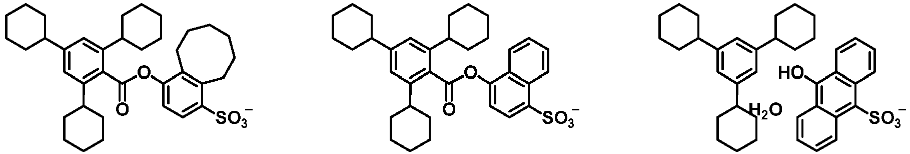

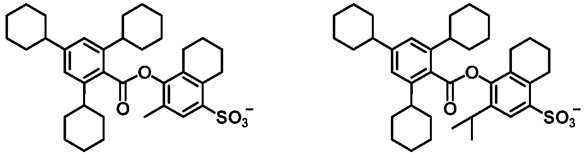

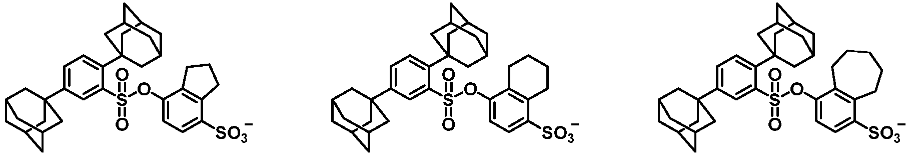

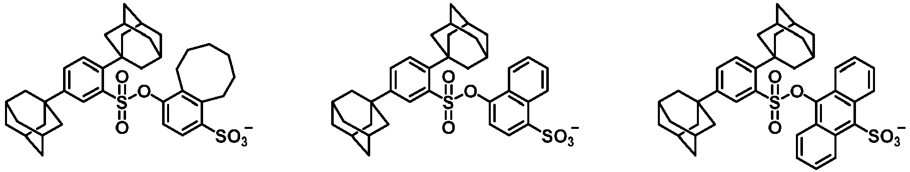

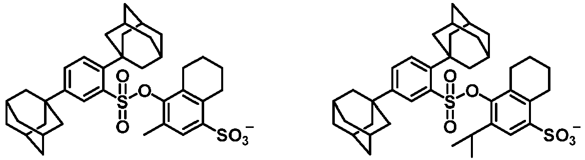

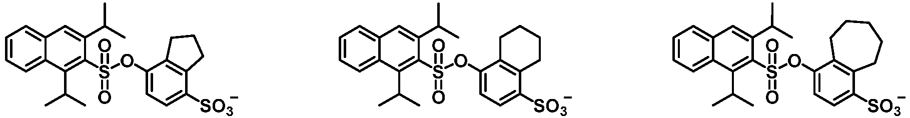

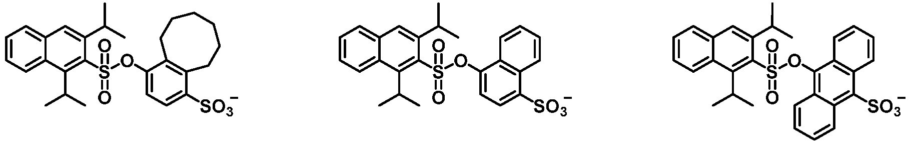

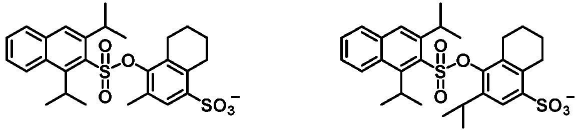

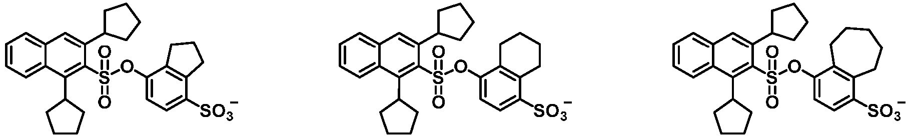

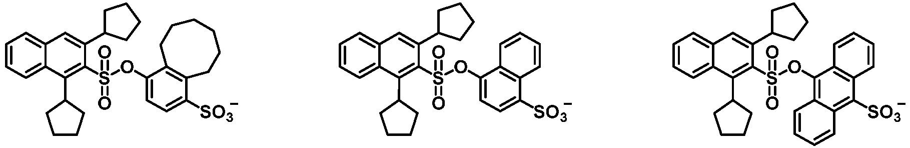

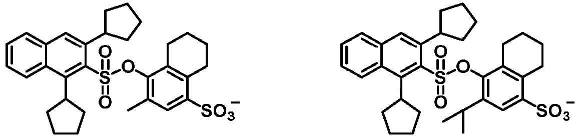

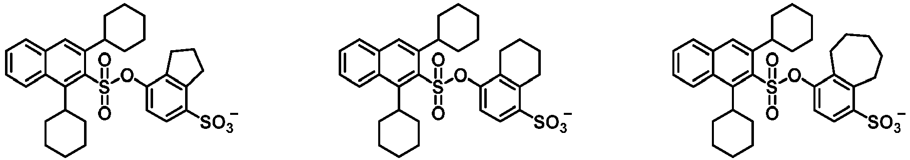

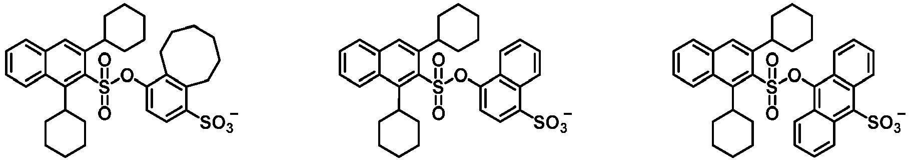

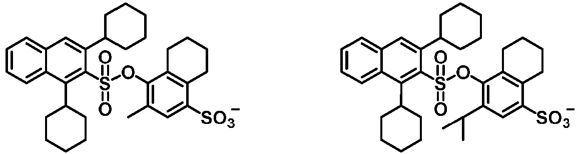

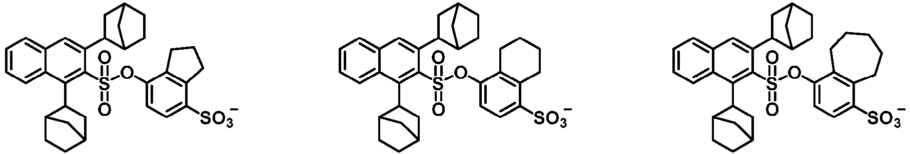

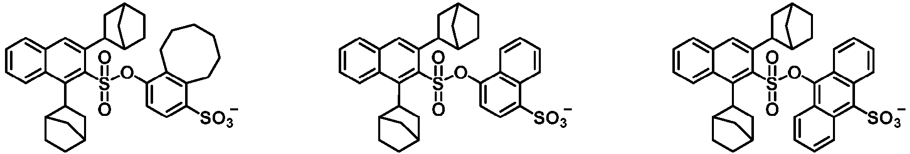

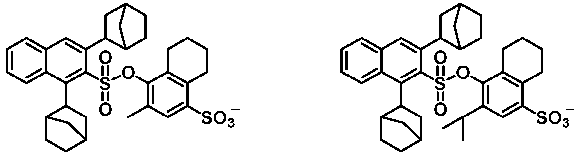

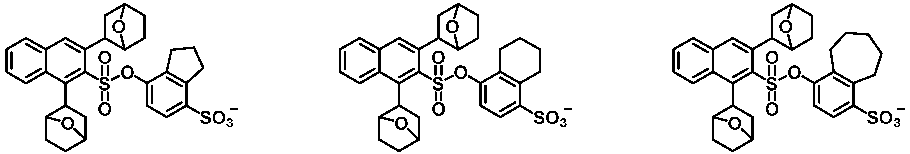

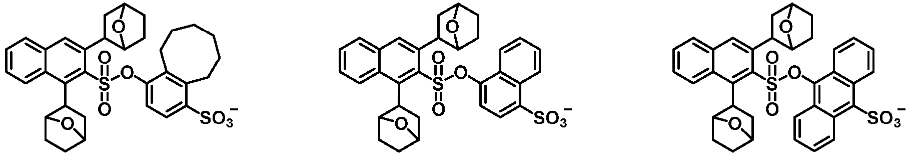

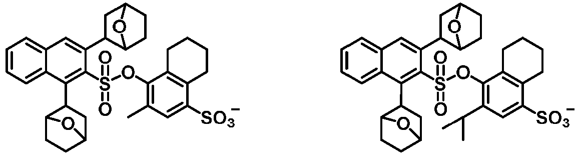

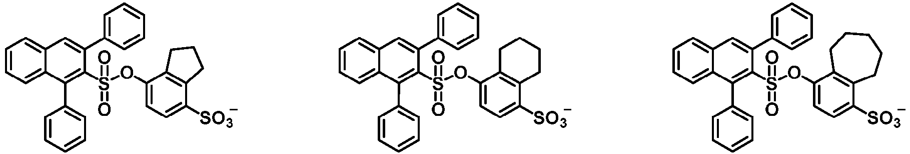

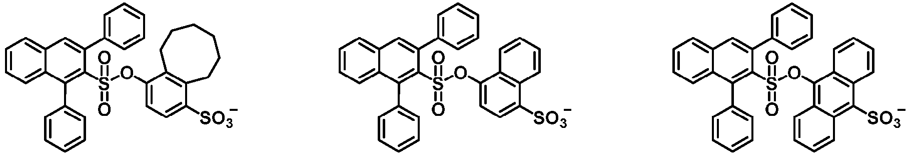

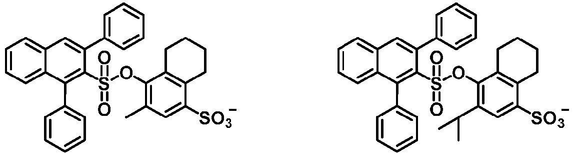

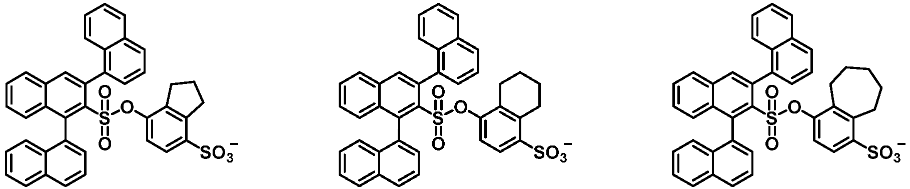

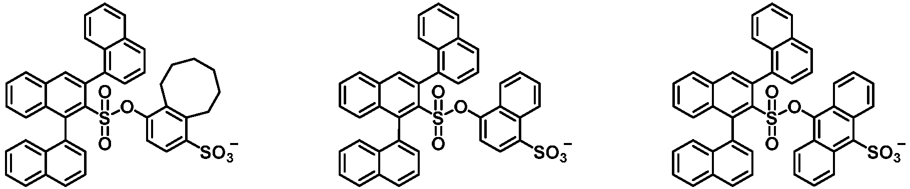

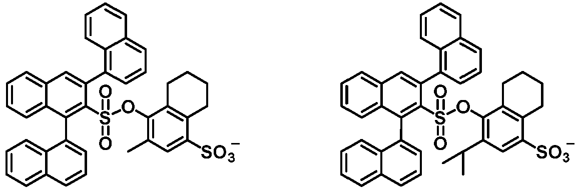

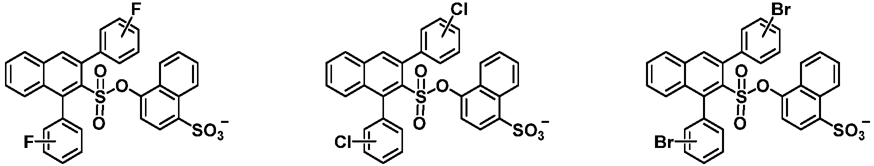

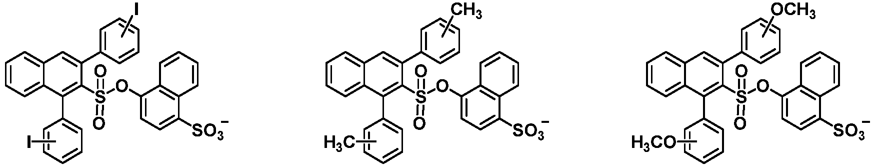

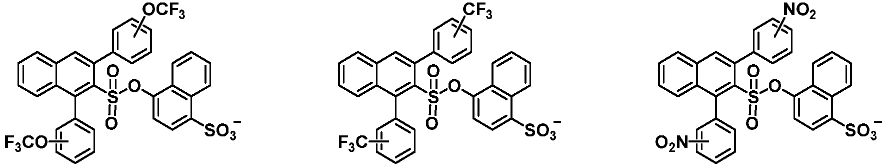

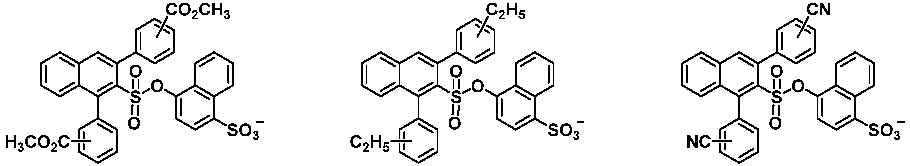

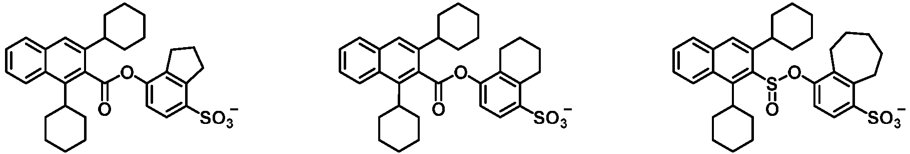

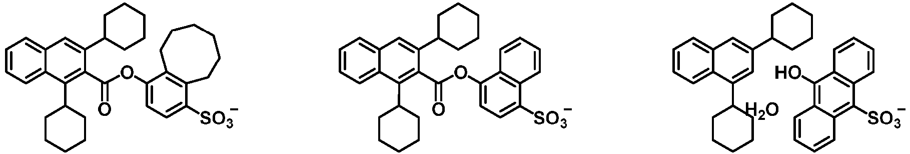

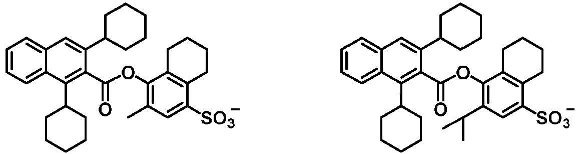

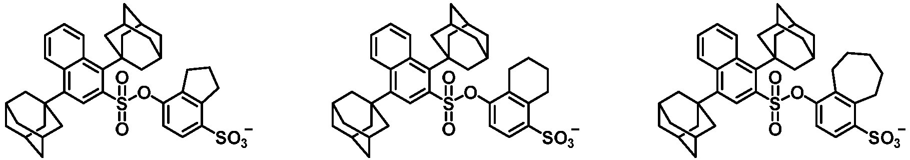

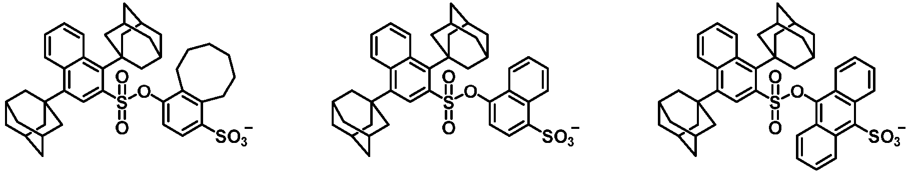

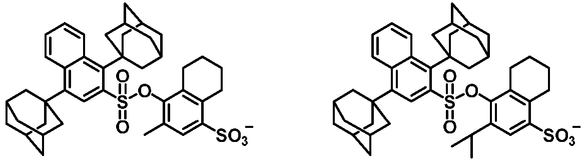

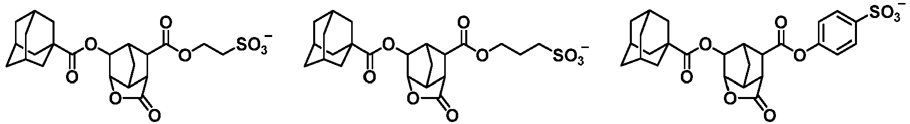

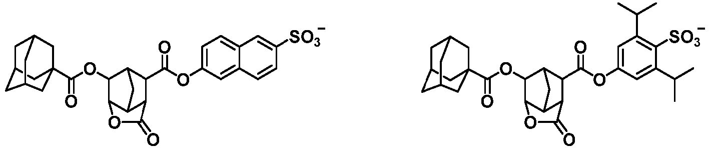

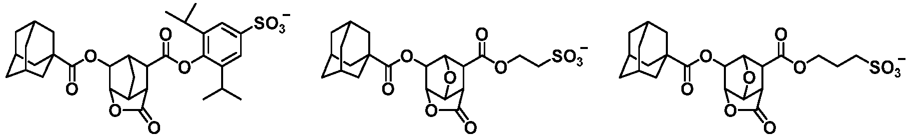

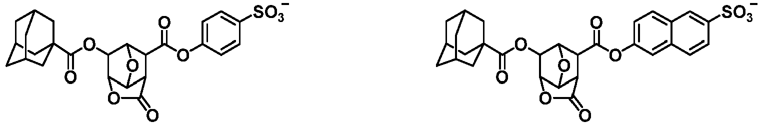

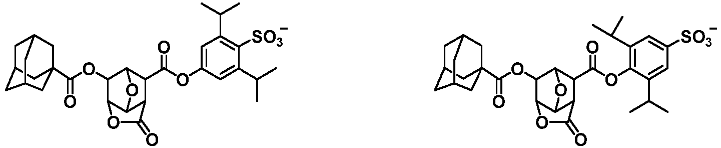

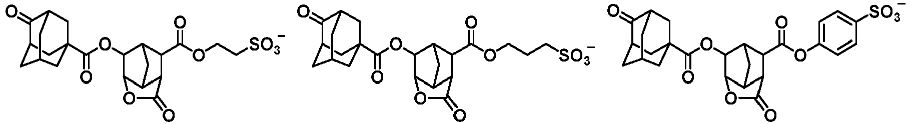

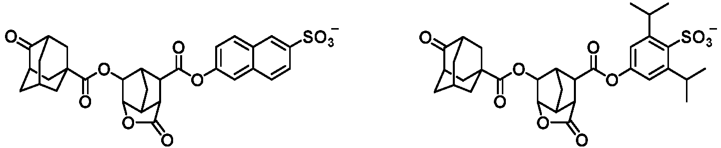

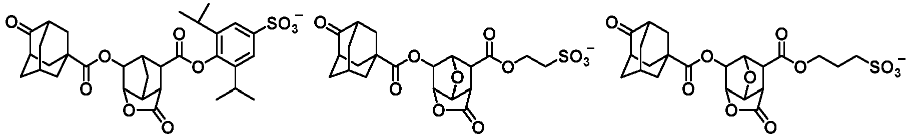

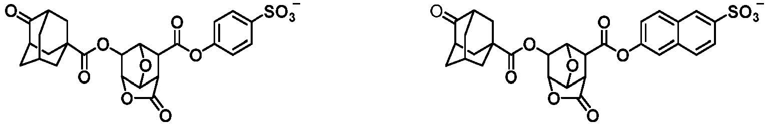

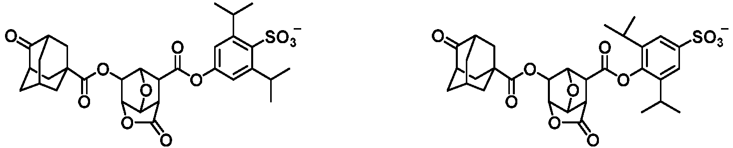

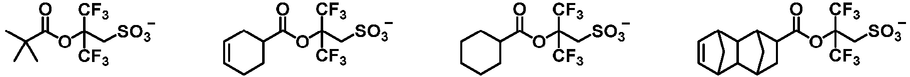

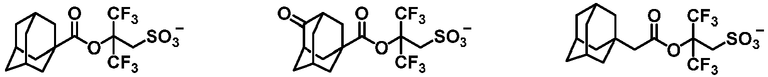

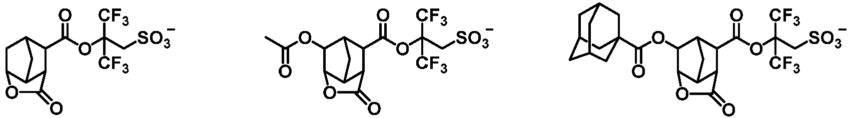

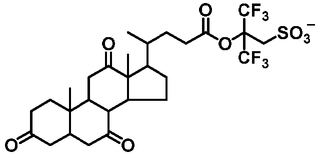

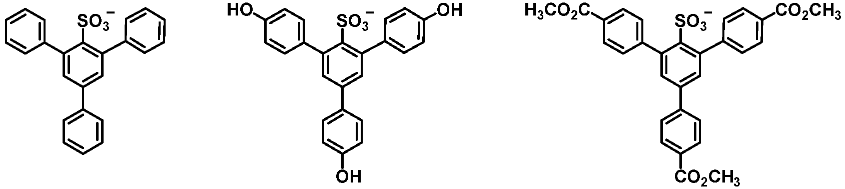

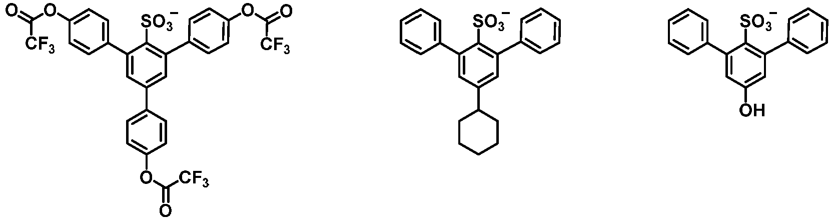

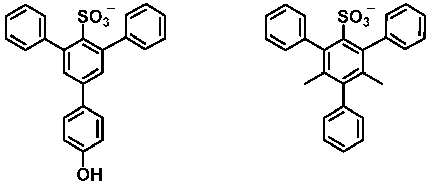

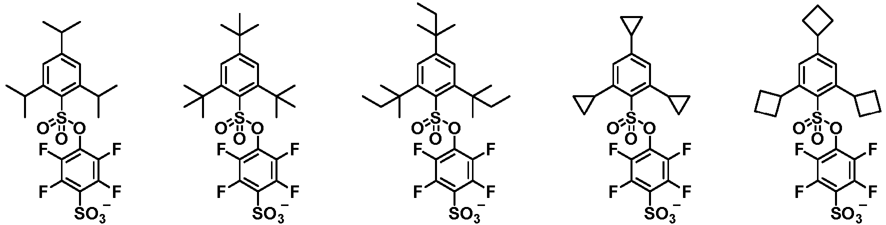

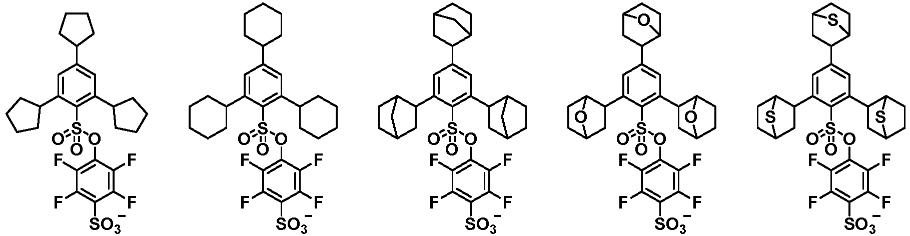

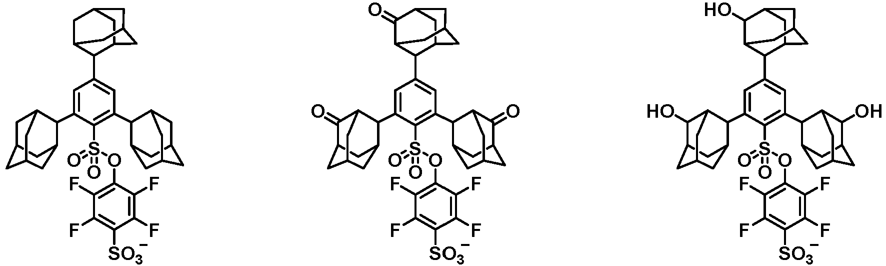

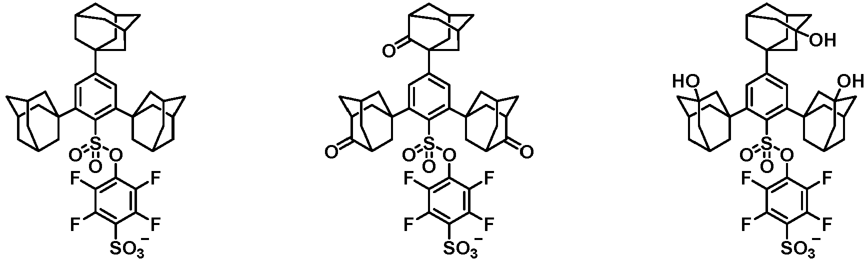

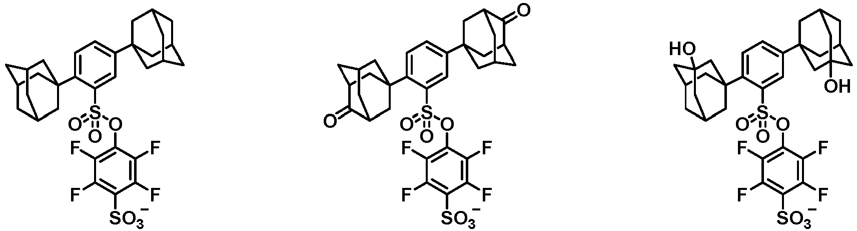

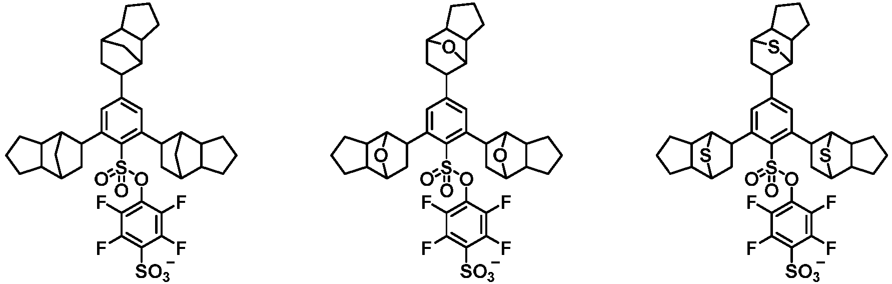

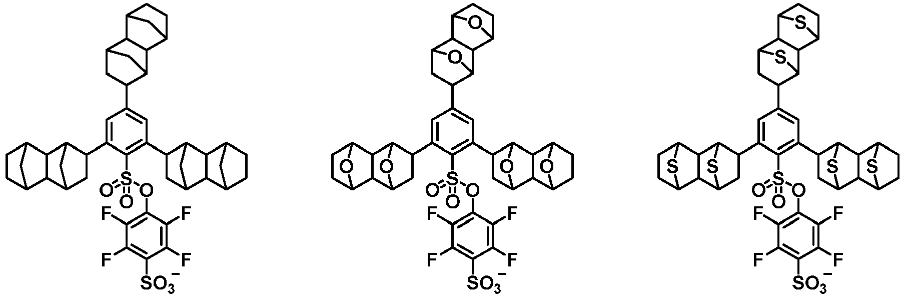

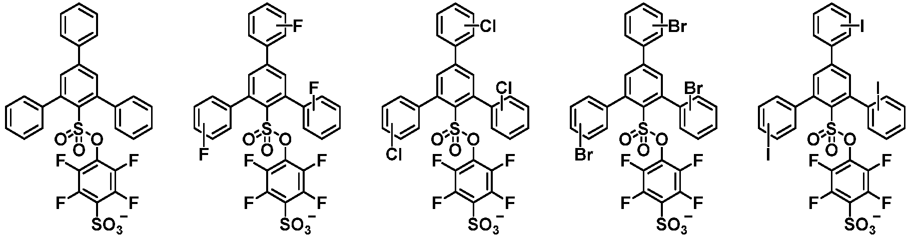

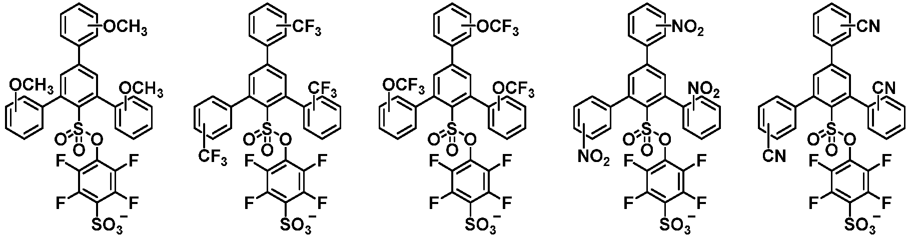

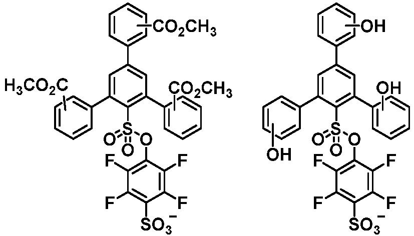

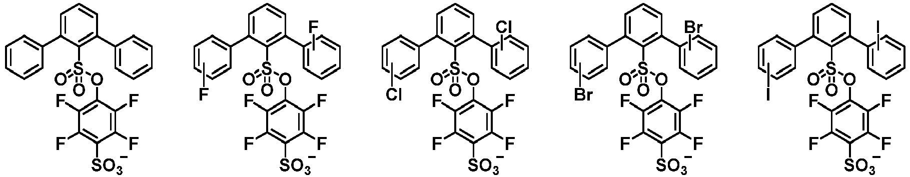

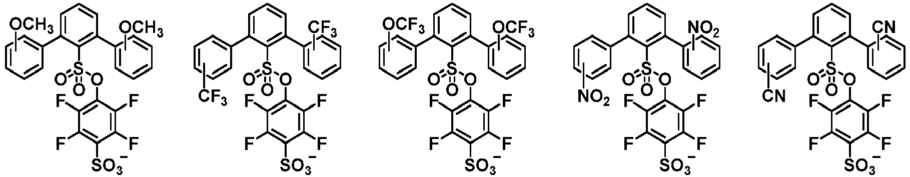

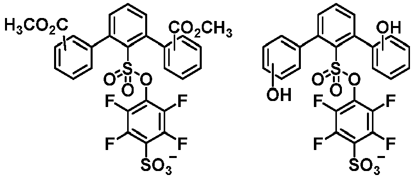

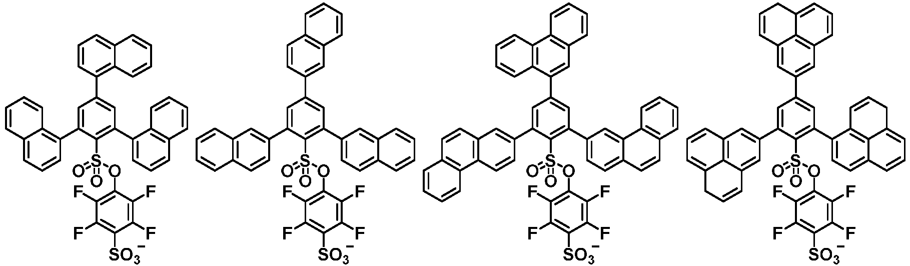

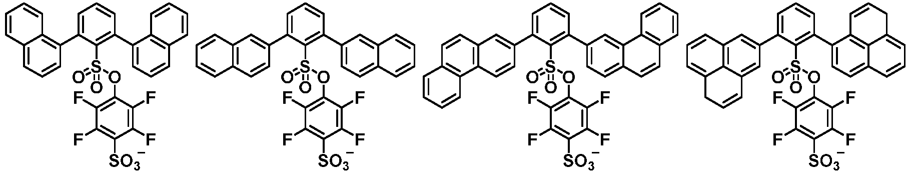

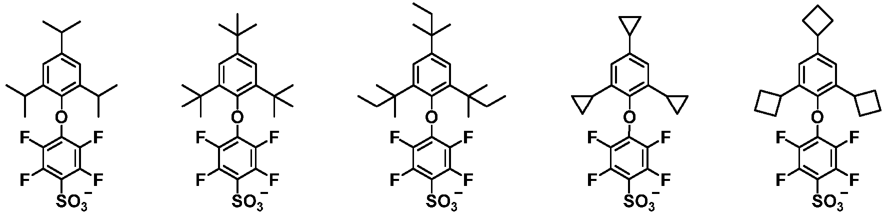

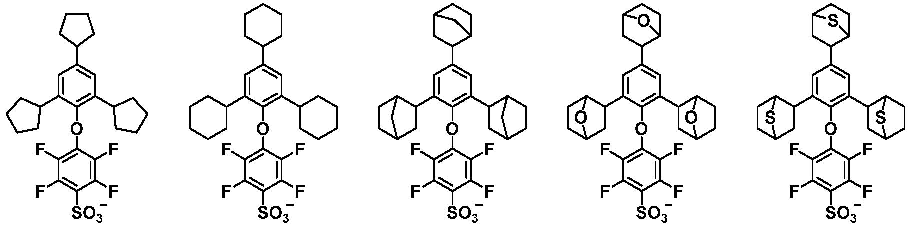

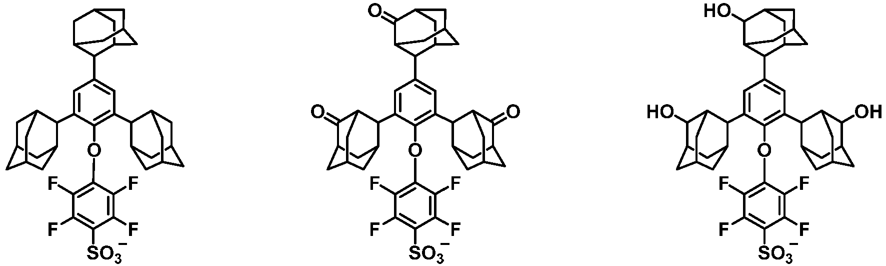

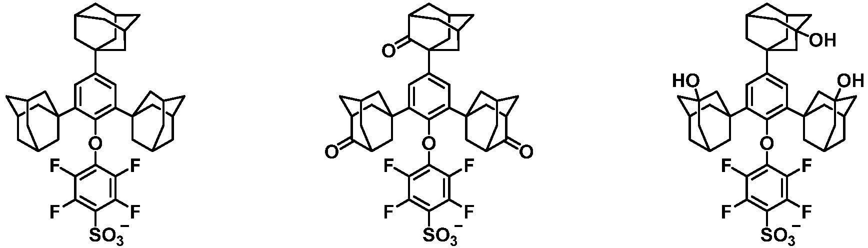

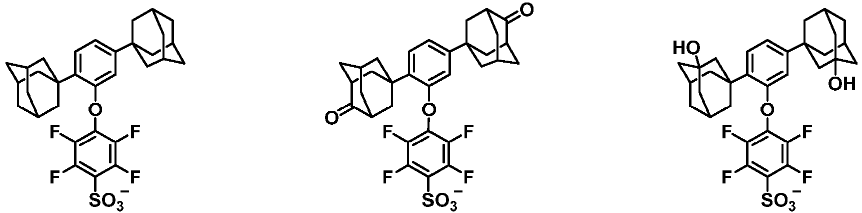

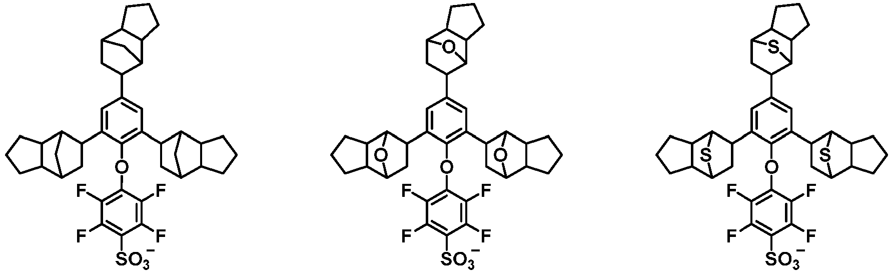

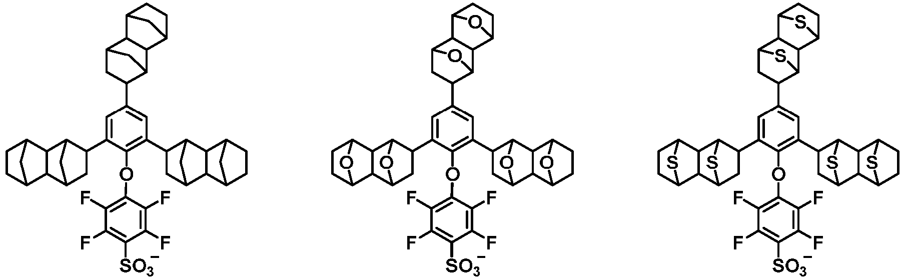

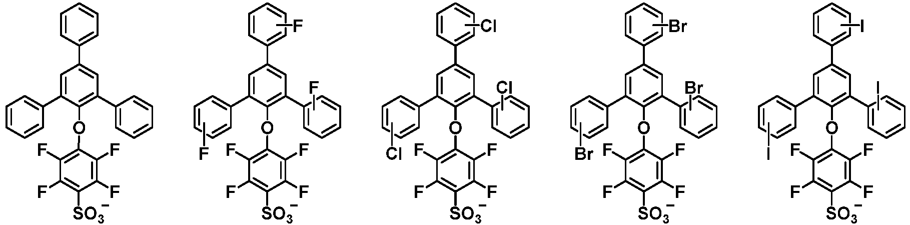

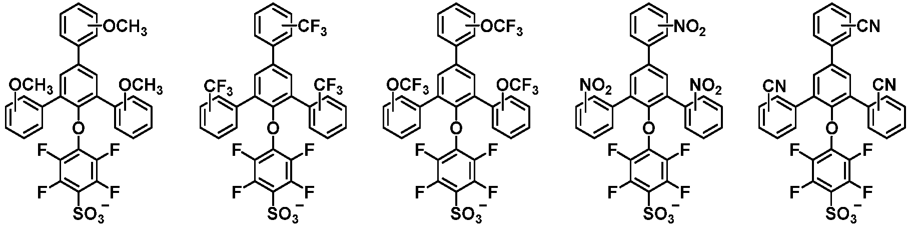

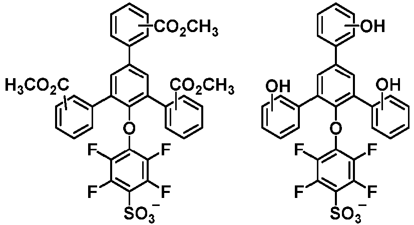

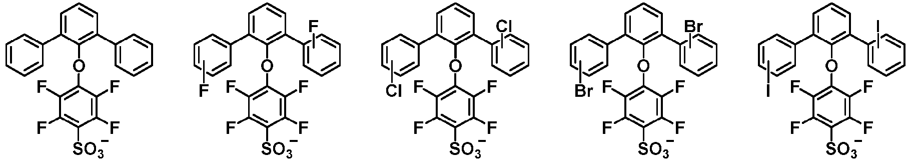

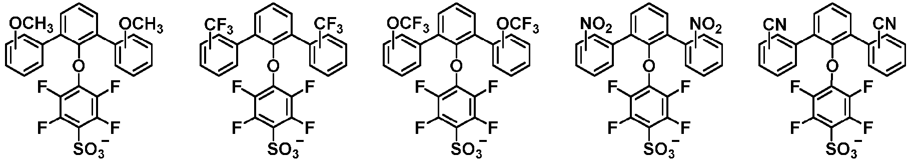

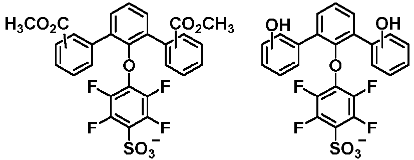

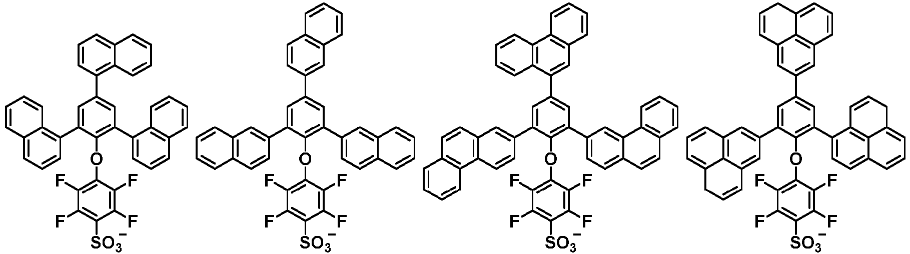

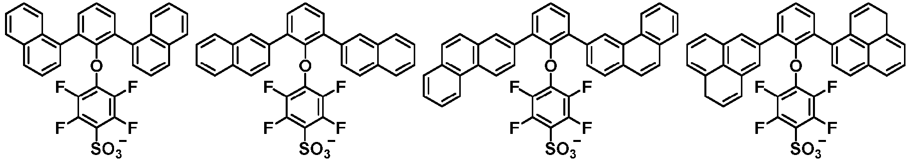

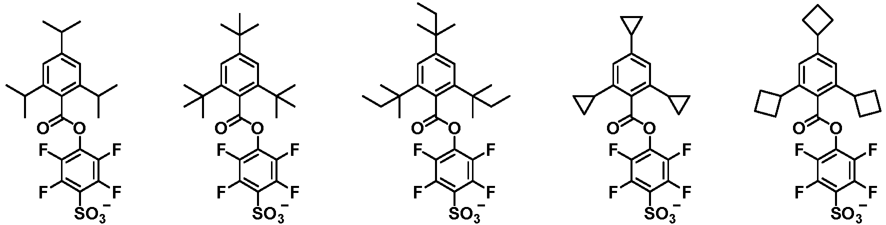

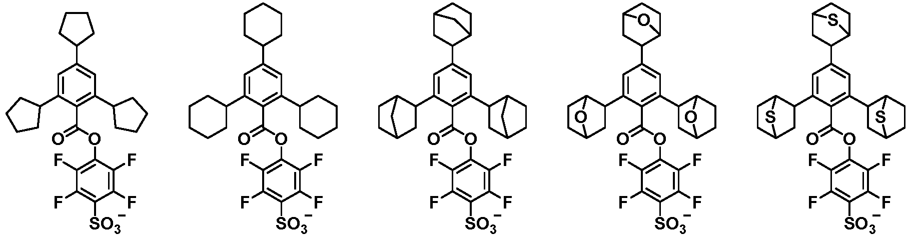

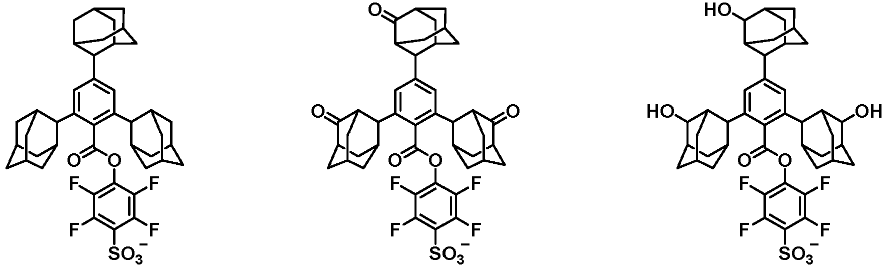

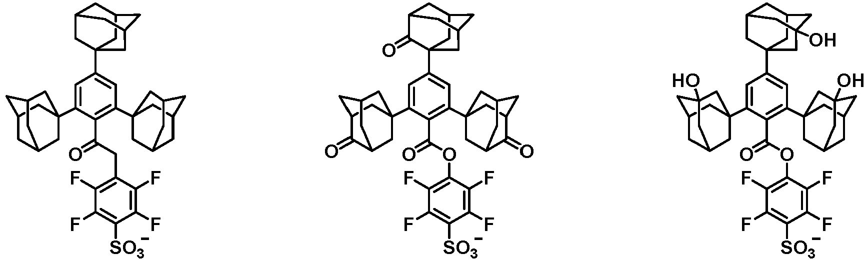

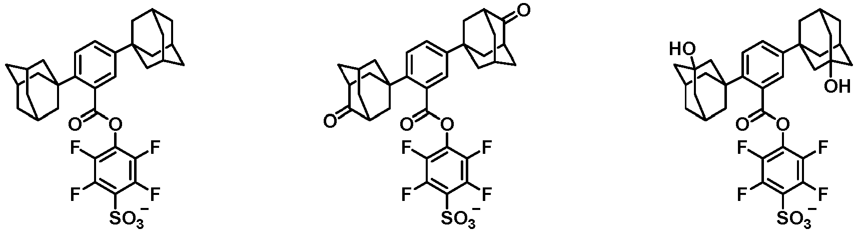

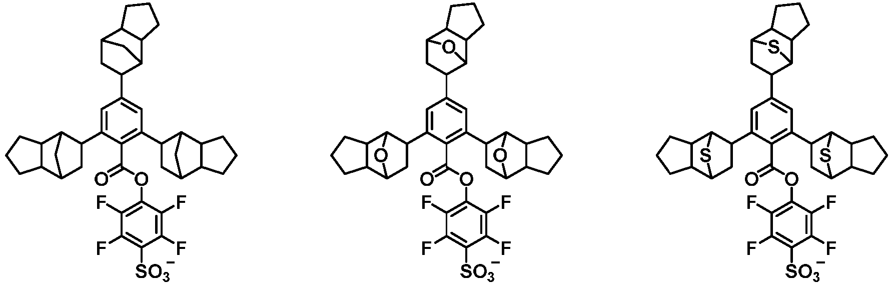

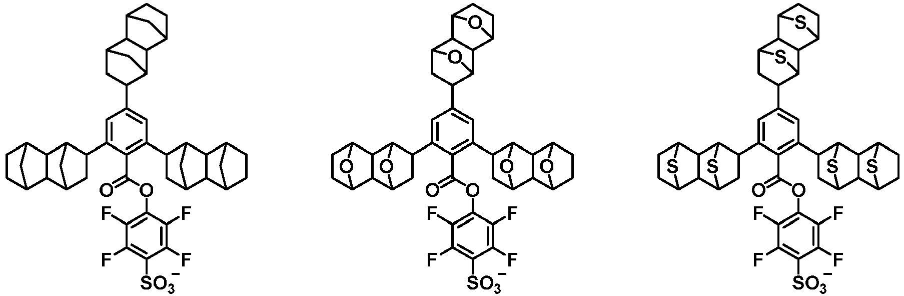

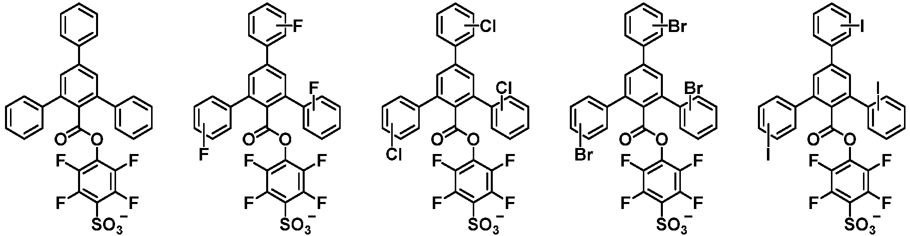

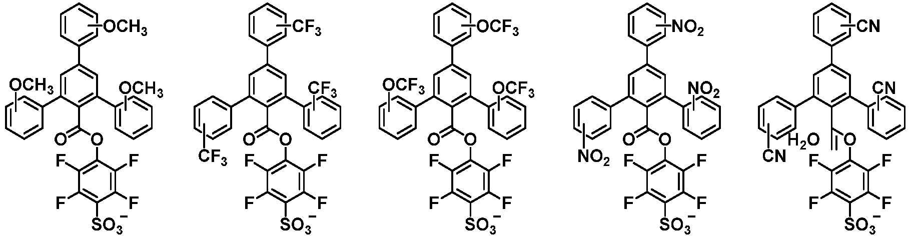

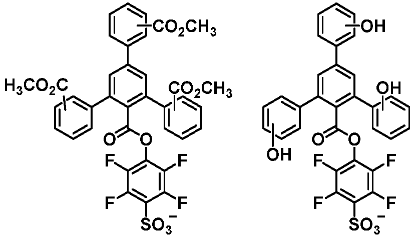

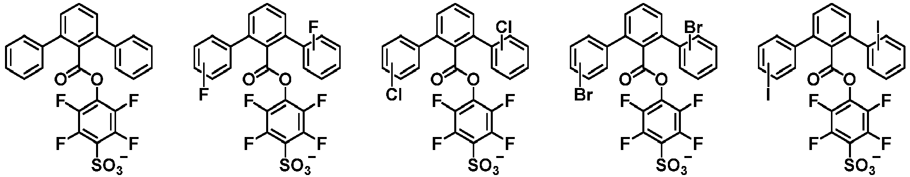

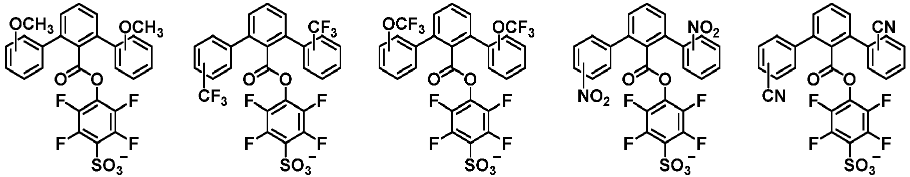

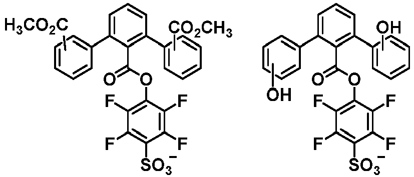

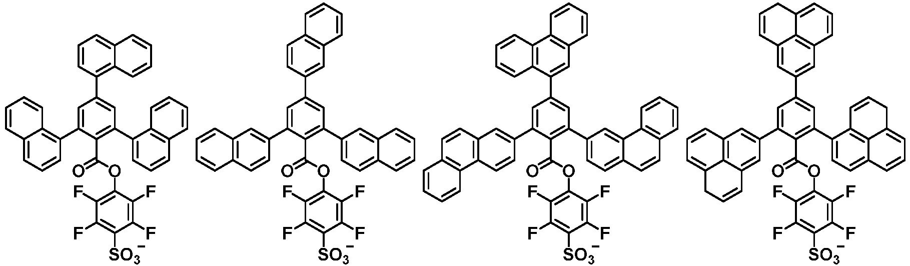

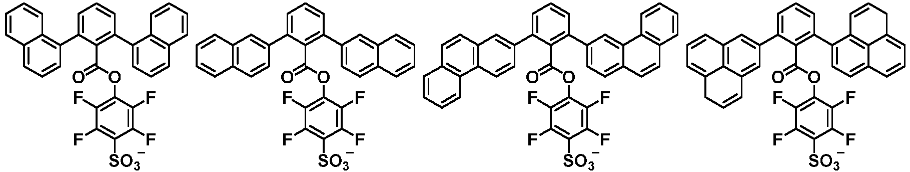

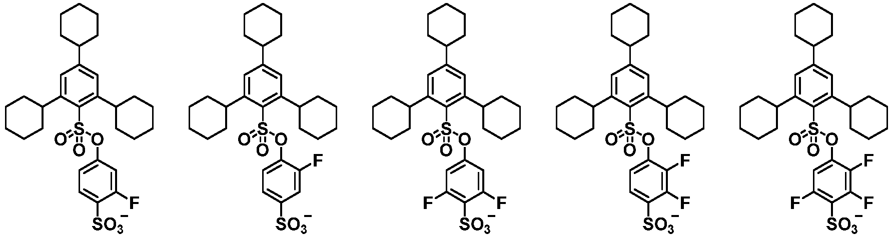

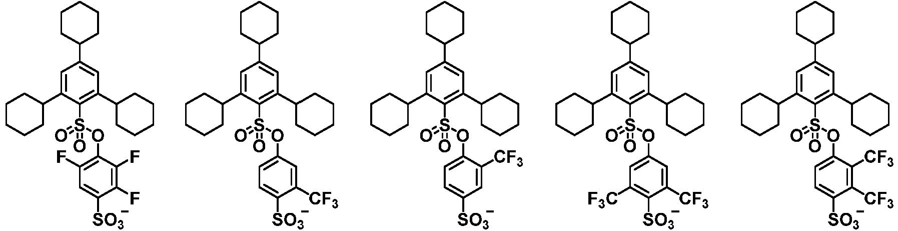

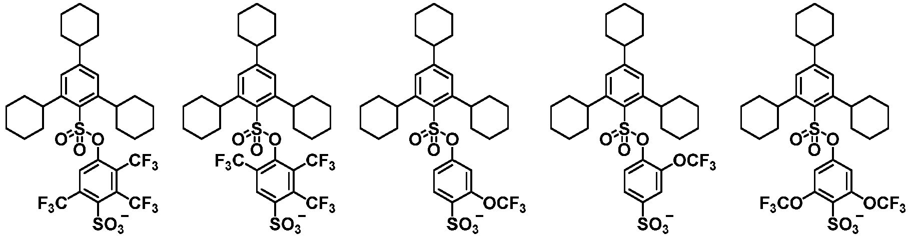

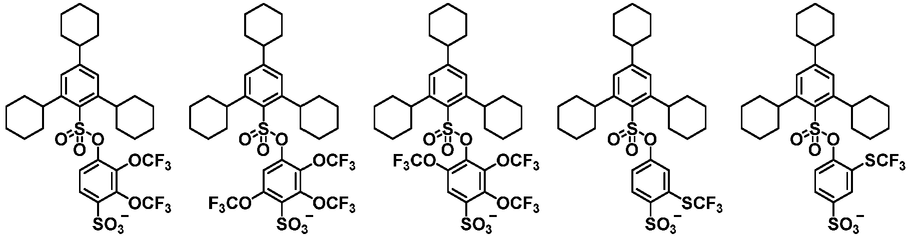

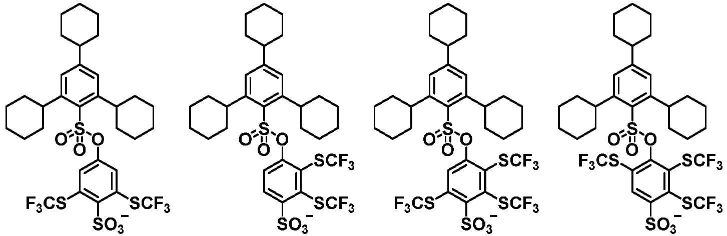

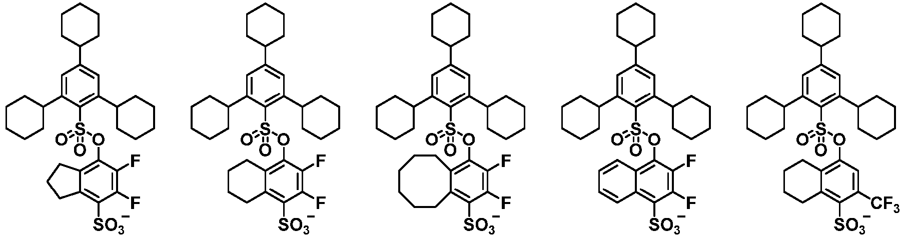

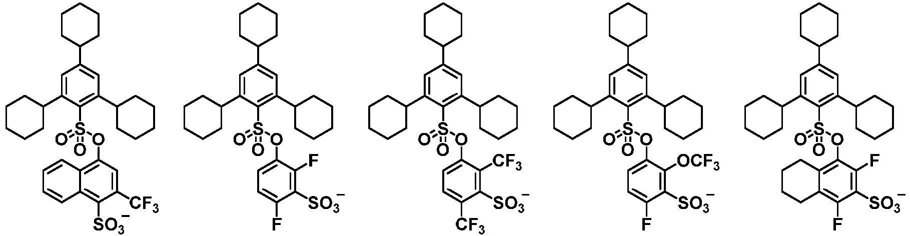

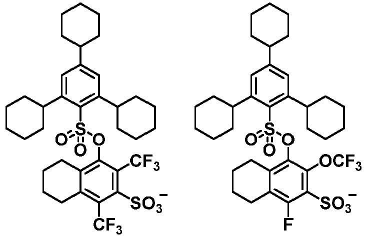

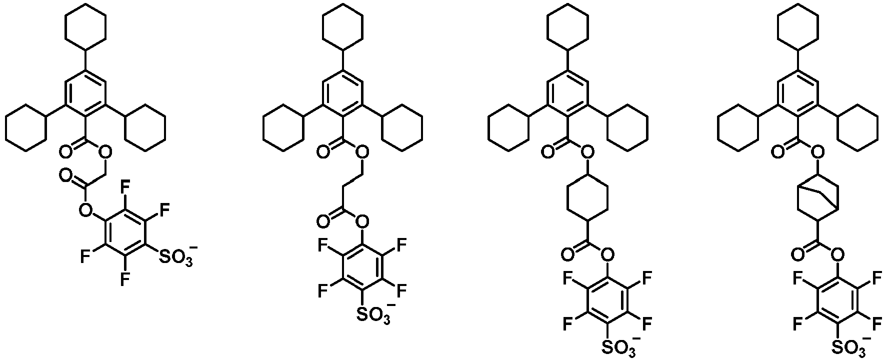

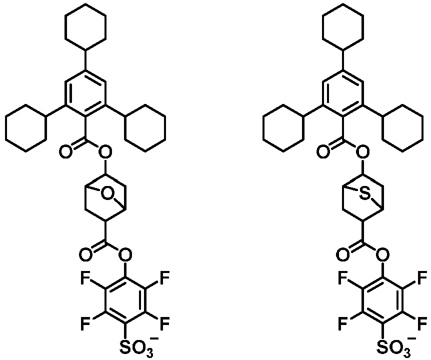

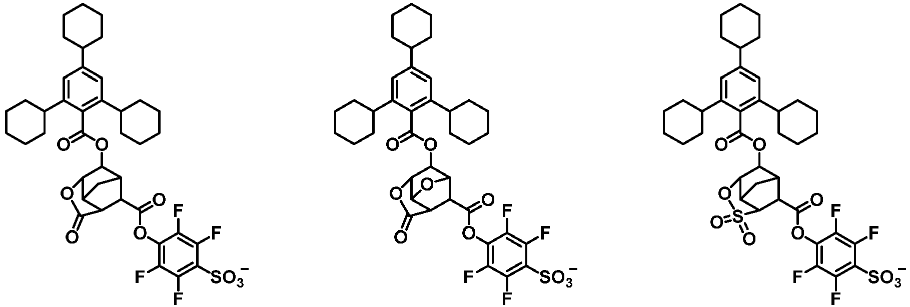

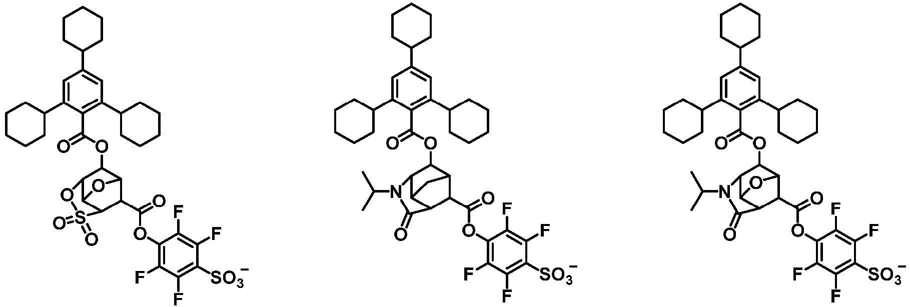

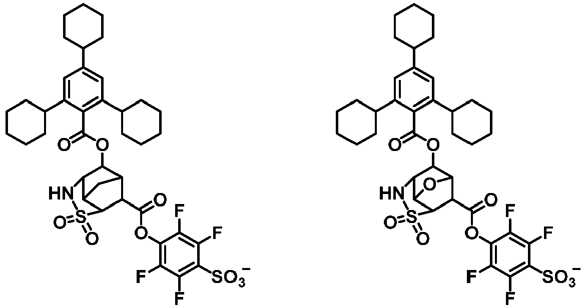

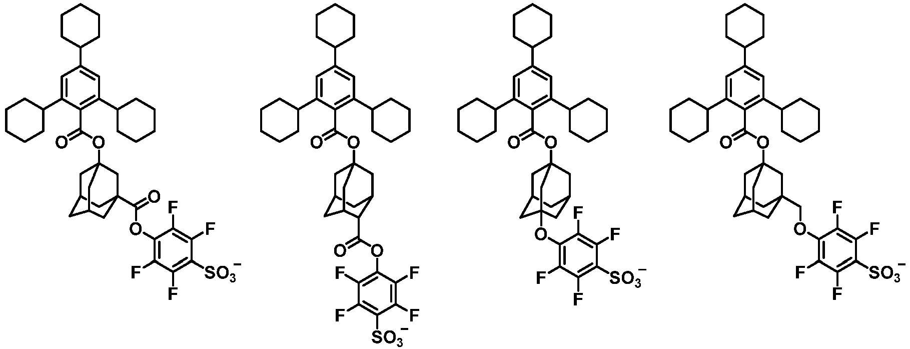

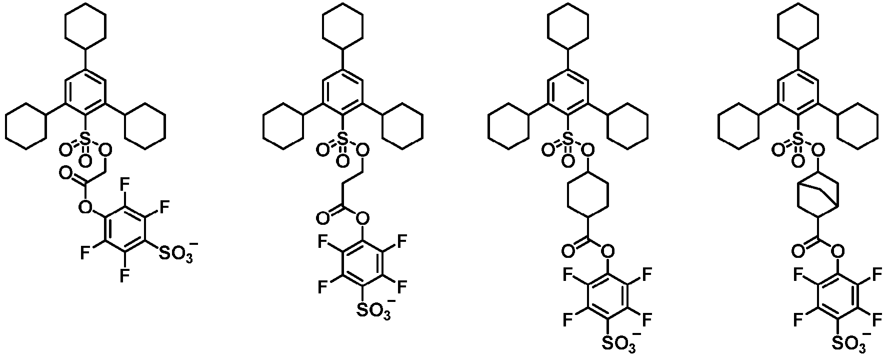

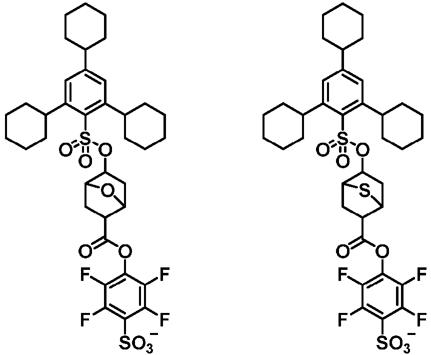

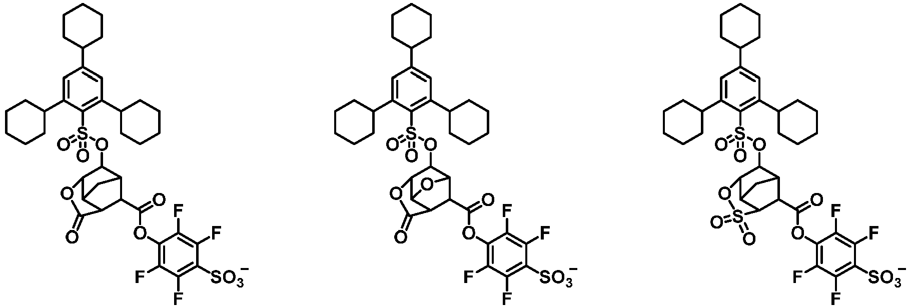

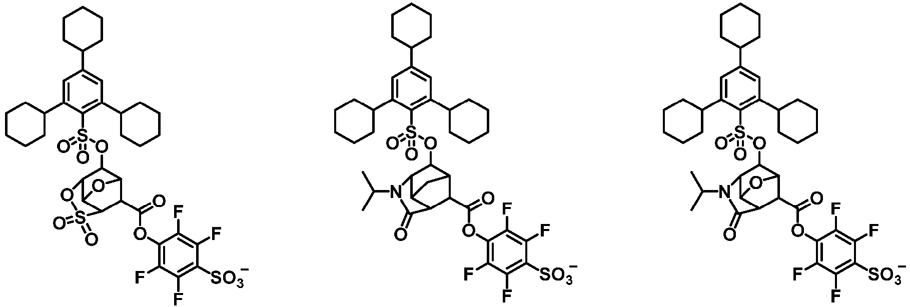

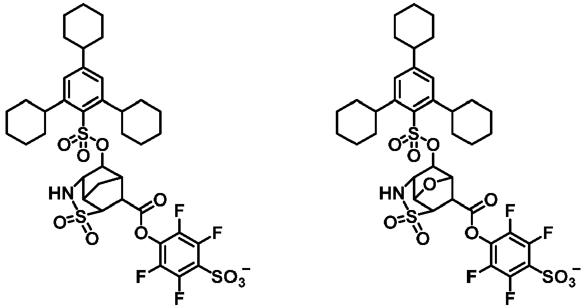

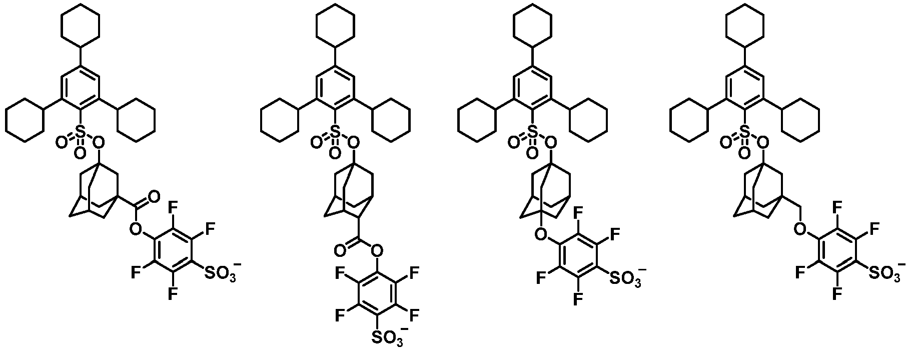

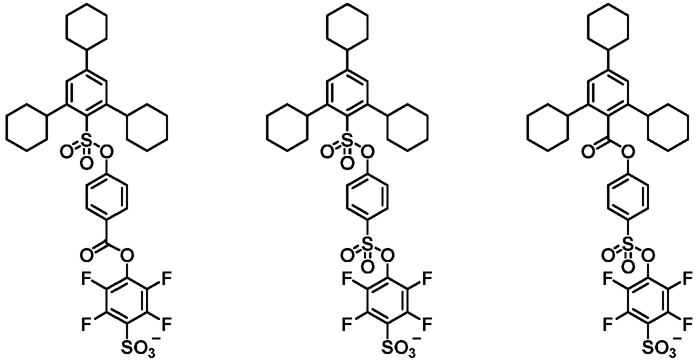

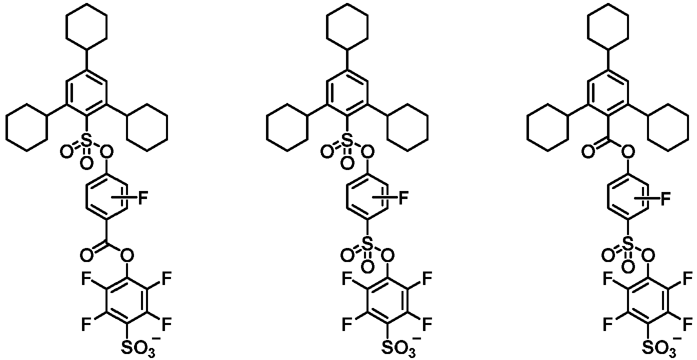

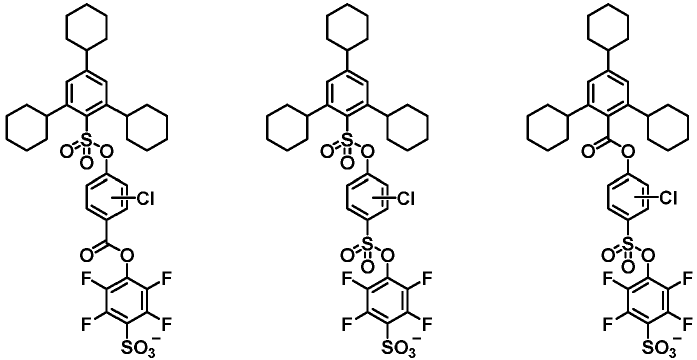

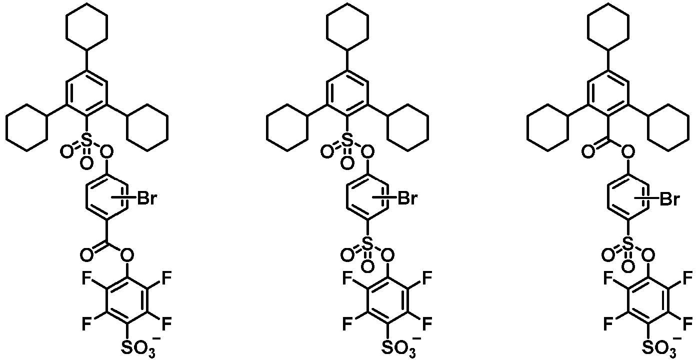

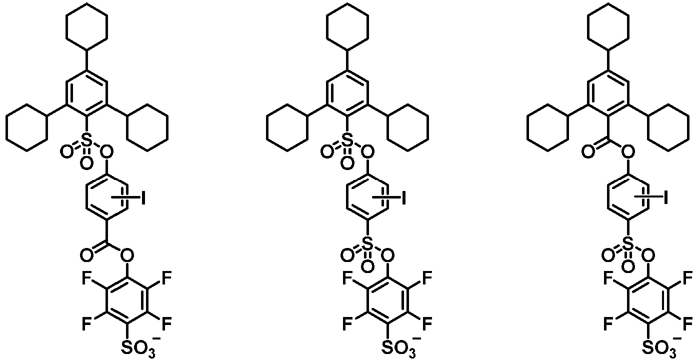

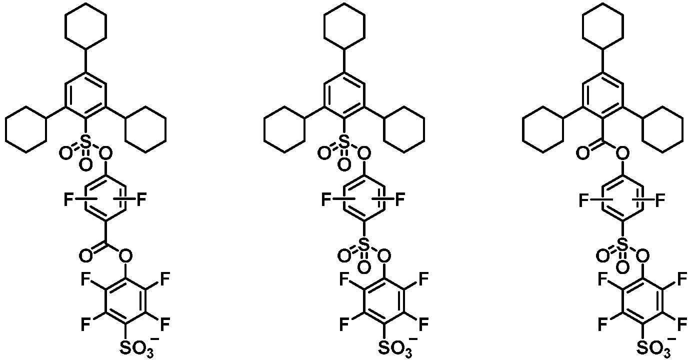

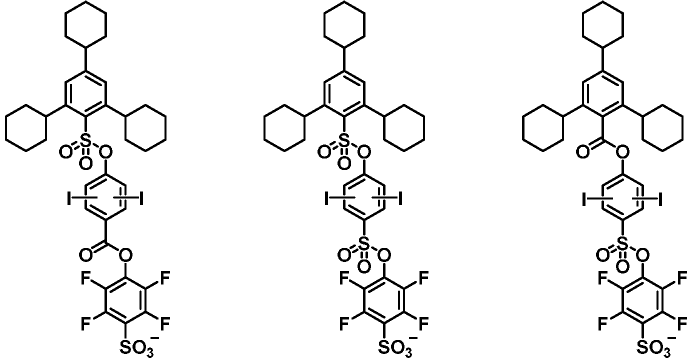

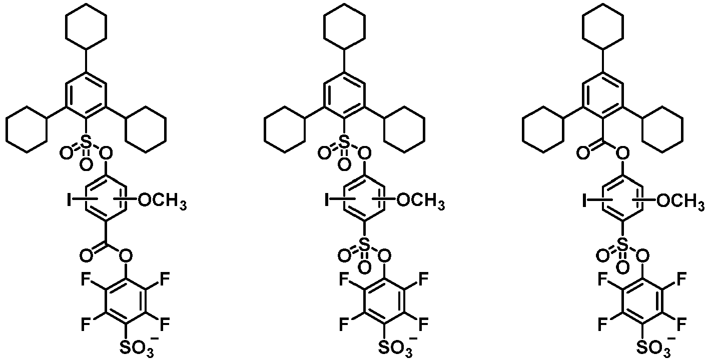

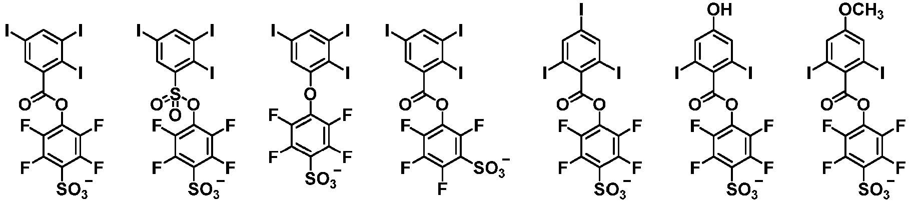

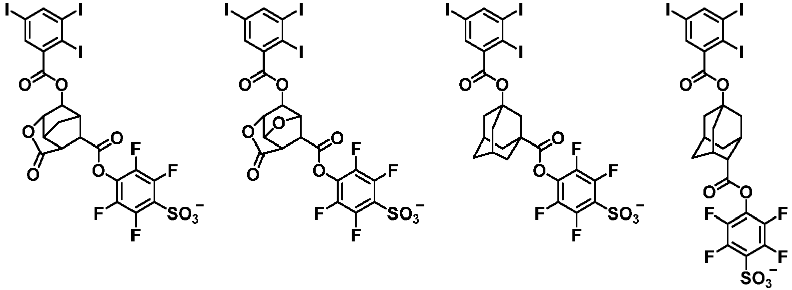

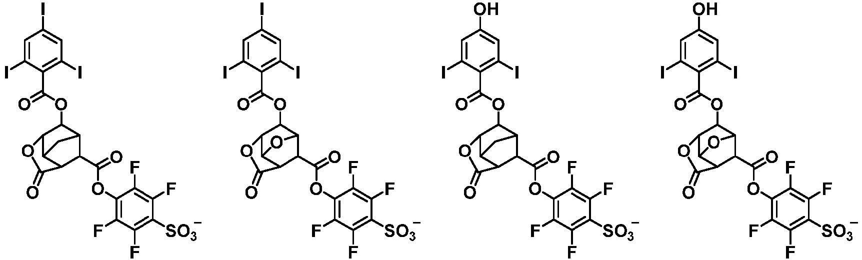

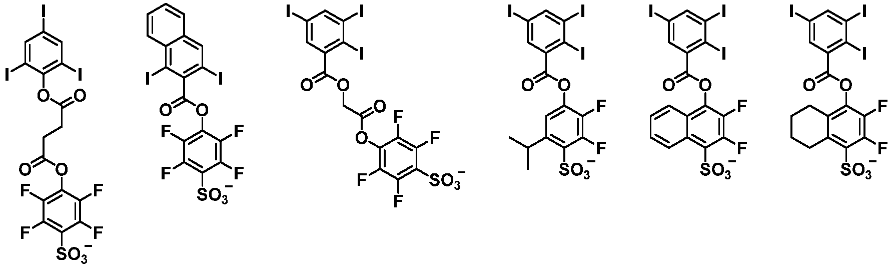

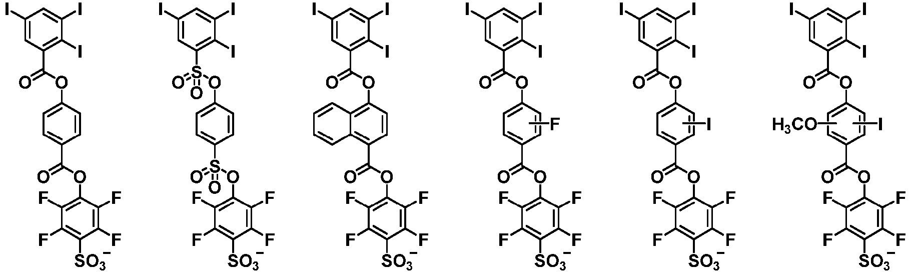

In addition, as the photoacid generator, a salt compound containing an anion having formula (F1) is also preferable.

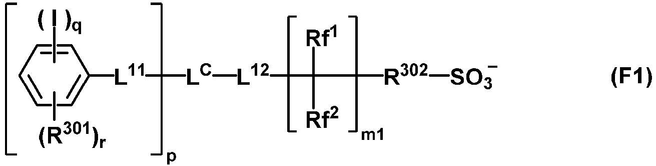

In formula (F1), m1 is 0 or 1. p is 1, 2, or 3. q is 1, 2, 3, 4, or 5, and r is 0, 1, 2, or 3, provided that 1 ≤ q + r ≤ 5.

In formula (F1), L¹¹ is a single bond, an ether bond, an ester bond, a sulfonic ester bond, a carbonate bond, or a carbamate bond.

In formula (F1), L¹² is an ether bond, an ester bond, a sulfonic ester bond, a carbonate bond, or a carbamate bond.

In formula (F1), L^{C} is a single bond or a C₁-C₂₀ hydrocarbylene group when p is 1, and is a C₁-C₂₀ (p+1)-valent hydrocarbon group when p is 2 or 3, and the hydrocarbylene group and the (p+1)-valent hydrocarbon group may contain at least one moiety selected from an ether bond, a carbonyl group, an ester bond, an amide bond, a sultone ring, a lactam ring, a carbonate bond, a halogen atom, a hydroxy group, and a carboxy group.

The C₁-C₂₀ hydrocarbylene group represented by L^{C} may be saturated or unsaturated, and may be linear, branched, or cyclic. Specific examples thereof include C₁-C₂₀ alkanediyl groups such as a methanediyl group, an ethane-1,1-diyl group, an ethane-1,2-diyl group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, and a dodecane-1,12-diyl group; C₃-C₂₀ cyclic saturated hydrocarbylene groups such as a cyclopentanediyl group, a cyclohexanediyl group, a norbornanediyl group, and an adamantanediyl group; C₂-C₂₀ unsaturated aliphatic hydrocarbylene groups such as a vinylene group and a propene-1,3-diyl group; C₆-C₂₀ arylene groups such as a phenylene group and a naphthylene group; and groups obtained by combining the foregoing. The C₁-C₂₀ (p+1)-valent hydrocarbon group represented by L^{C} may be saturated or unsaturated, and may be linear, branched, or cyclic. Specific examples thereof include groups obtained by further removing one or two hydrogen atoms from the above-described specific examples of the C₁-C₂₀ hydrocarbylene group.

In formula (F1), Rf¹ and Rf² are each independently a hydrogen atom, a fluorine atom, or a trifluoromethyl group, and at least one of Rf¹ and Rf² is a fluorine atom or a trifluoromethyl group.

In formula (F1), R³⁰¹ is a hydroxy group, a carboxy group, a C₁-C₆ saturated hydrocarbyl group, a C₁-C₆ saturated hydrocarbyloxy group, a C₂-C₆ saturated hydrocarbylcarbonyloxy group, a fluorine atom, a chlorine atom, a bromine atom, -N(R^{301A})(R^{301B}), -N(R^{301C})-C(=O)-R^{301D}, or -N(R^{301C})-C(=O)-O-R^{301D}. R^{301A} and R^{301B} are each independently a hydrogen atom or a C₁-C₆ saturated hydrocarbyl group. R^{301C} is a hydrogen atom or a C₁-C₆ saturated hydrocarbyl group. R^{301D} is a C₁-C₆ saturated hydrocarbyl group or a C₂-C₈ unsaturated aliphatic hydrocarbyl group.

The C₁-C₆ saturated hydrocarbyl group represented by R³⁰¹, R^{301A}, R^{301B}, and R^{301C} may be linear, branched or cyclic, and specific examples thereof include C₁-C₆ alkyl groups such as a methyl group, an ethyl group, a n-propyl group, an isopropyl group, a n-butyl group, an isobutyl group, a sec-butyl group, a tert-butyl group, a n-pentyl group, and a n-hexyl group; and C₃-C₆ cyclic saturated hydrocarbyl groups such as a cyclopropyl group, a cyclobutyl group, a cyclopentyl group, and a cyclohexyl group. Examples of the saturated hydrocarbyl moiety in the C₁-C₆ saturated hydrocarbyloxy group represented by R³⁰¹ include those groups mentioned as the specific examples of the saturated hydrocarbyl group, and examples of the saturated hydrocarbyl moiety in the C₂-C₆ saturated hydrocarbylcarbonyloxy group represented by R³⁰¹ include C₁-C₅ saturated hydrocarbyl groups among the specific examples of the C₁-C₆ saturated hydrocarbyl groups.

The C₂-C₈ unsaturated aliphatic hydrocarbyl group represented by R^{301D} may be linear, branched, or cyclic, and specific examples thereof include C₂-C₈ alkenyl groups such as a vinyl group, a propenyl group, a butenyl group, and a hexenyl group; C₂-C₈ alkynyl groups such as an ethynyl group, a propynyl group, and a butynyl group; and C₃-C₈ cyclic unsaturated aliphatic hydrocarbyl groups such as a cyclohexenyl group and a norbornenyl group.

In formula (F1), R³⁰² is a C₁-C₂₀ saturated hydrocarbylene group or a C₆-C₂₀ arylene group, some or all of hydrogen atoms of the saturated hydrocarbylene group may be substituted with a halogen atom other than a fluorine atom, and some or all of hydrogen atoms of the arylene group may be substituted with a substituent selected from a C₁-C₂₀ saturated hydrocarbyl group, a C₁-C₂₀ saturated hydrocarbyloxy group, a C₆-C₂₀ aryl group, a halogen atom, and a hydroxy group.

The C₁-C₂₀ hydrocarbylene group represented by R³⁰² may be saturated or unsaturated, and may be linear, branched, or cyclic. Specific examples thereof include those groups mentioned as the C₁-C₂₀ hydrocarbylene group represented by L^{C}.

Specific examples of the C₆-C₂₀ arylene group represented by R³⁰² include a phenylene group, a naphthylene group, a phenanthrenediyl group, and an anthracenediyl group. The hydrocarbyl moiety in the C₁-C₂₀ saturated hydrocarbyl group and the C₁-C₂₀ hydrocarbyloxy group which are substituents for the arylene group may be linear, branched, or cyclic, and specific examples thereof include C₁-C₂₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-octyl group, a n-nonyl group, a n-decyl group, an undecyl group, a dodecyl group, a tridecyl group, a tetradecyl group, a pentadecyl group, a heptadecyl group, an octadecyl group, a nonadecyl group, and an icosyl group; and C₃-C₂₀ cyclic saturated hydrocarbyl groups such as a cyclopropyl group, a cyclopentyl group, a cyclohexyl group, a cyclopropylmethyl group, a 4-methylcyclohexyl group, a cyclohexylmethyl group, a norbornyl group, and an adamantyl group. Specific examples of the C₆-C₁₄ arylene group which is a substituent for the arylene group include a phenylene group, a naphthylene group, a phenanthrenediyl group, and an anthracenediyl group.

The anion having formula (F1) is preferably an anion having formula (F2).

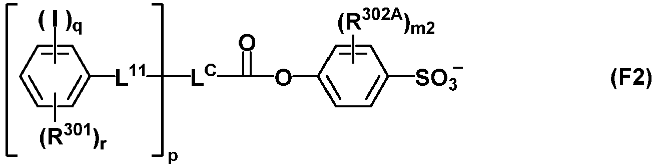

In formula (F2), p, q, r, L¹¹, L^{C}, and R³⁰¹ are as defined above. m2 is 1, 2, 3, or 4. R^{302A} is a C₁-C₂₀ saturated hydrocarbyl group, a C₁-C₂₀ saturated hydrocarbyloxy group, a C₆-C₁₄ aryl group, a halogen atom, or a hydroxy group. When m2 is 2, 3, or 4, groups R^{302A} may be identical or different from each other.

Specific examples of the anion having formula (F1) include those shown below, but are not limited thereto.

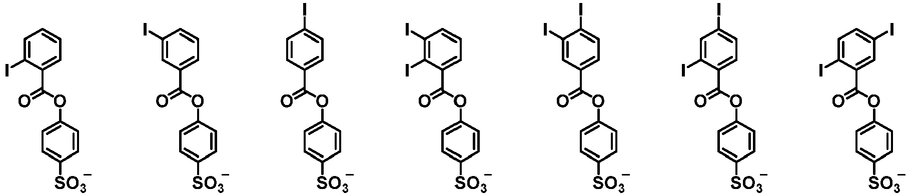

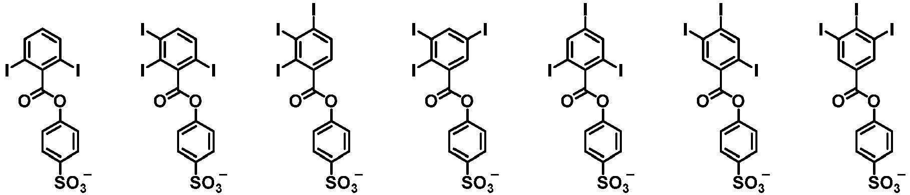

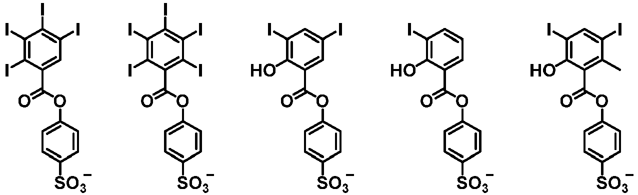

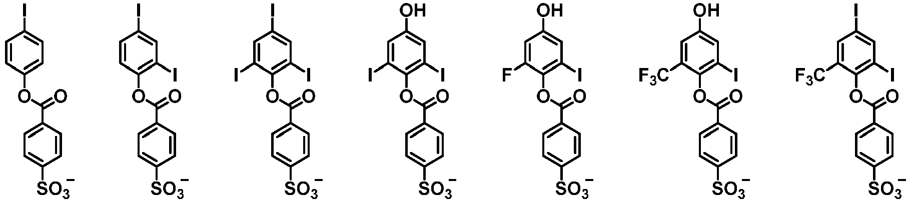

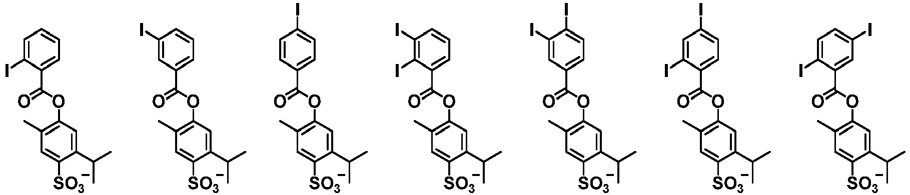

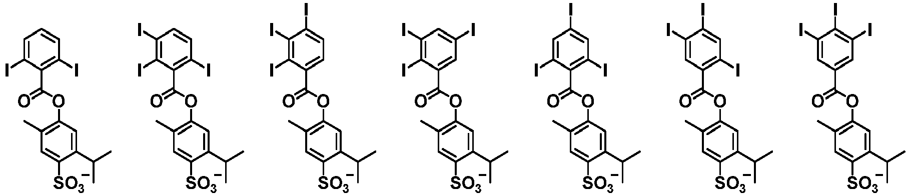

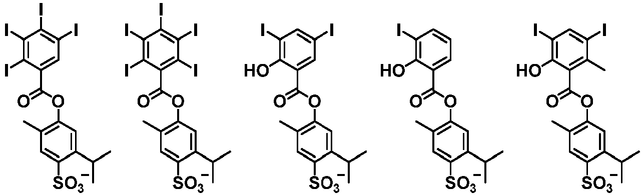

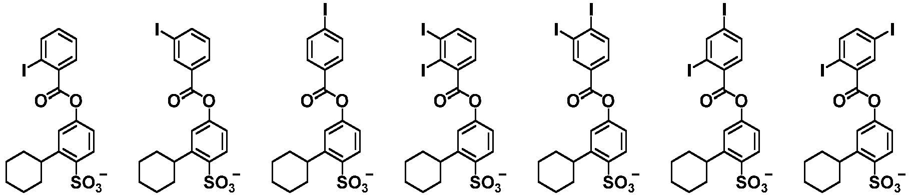

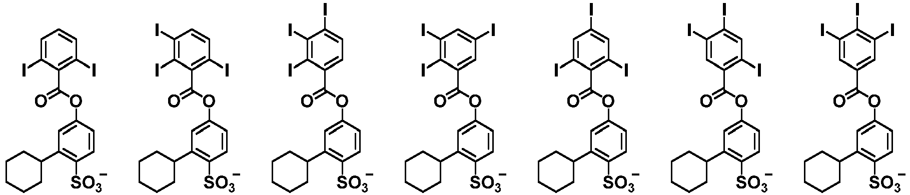

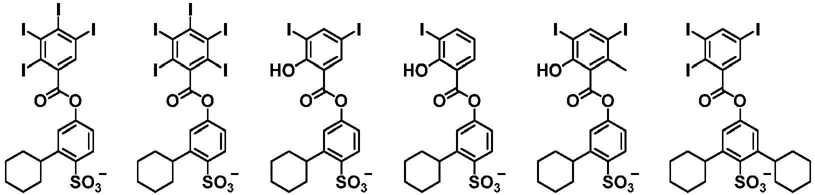

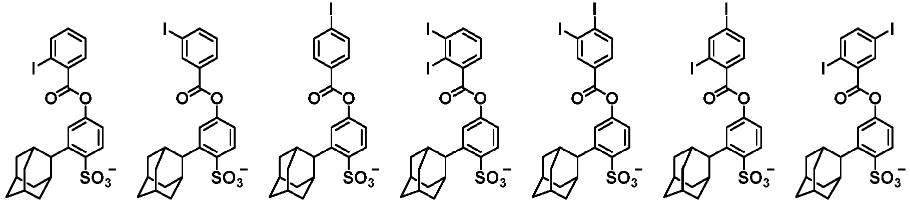

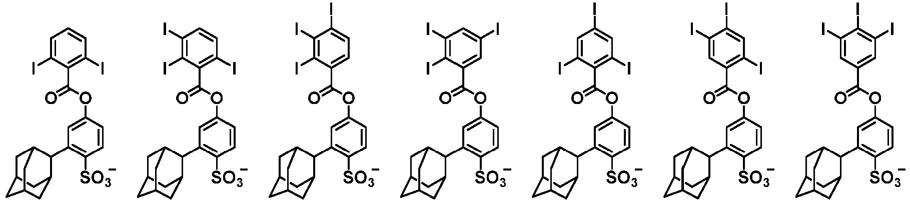

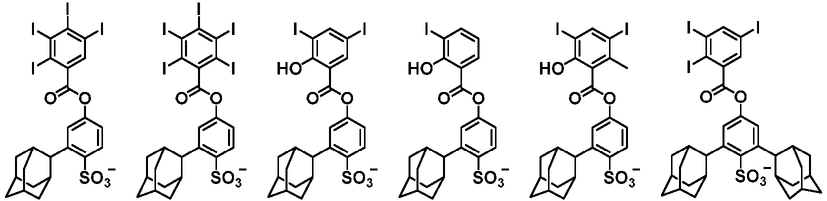

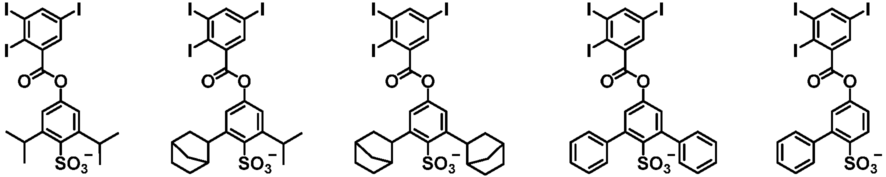

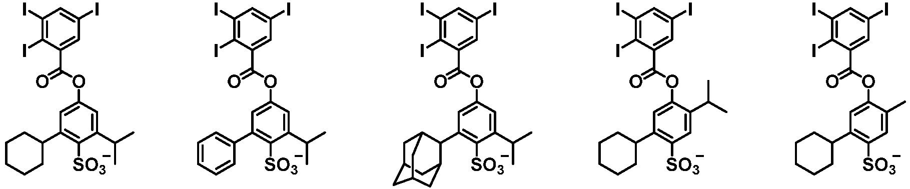

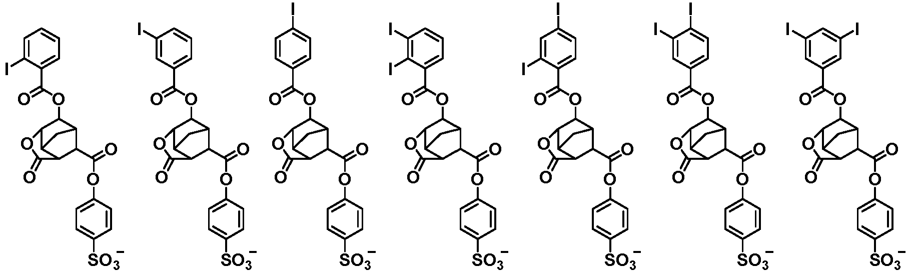

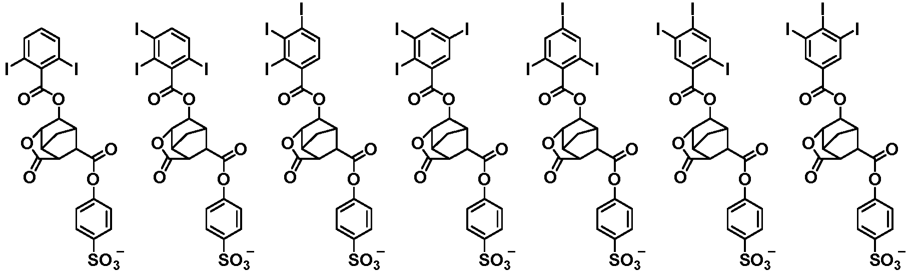

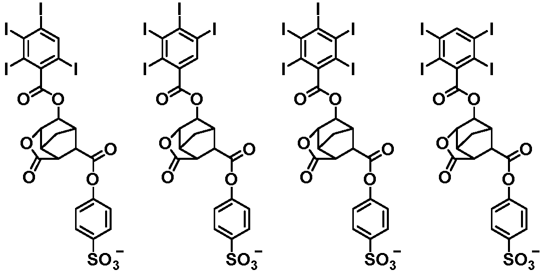

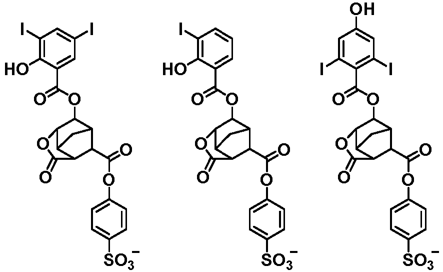

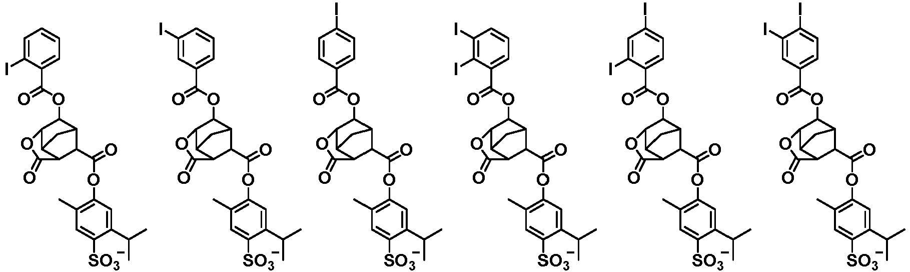

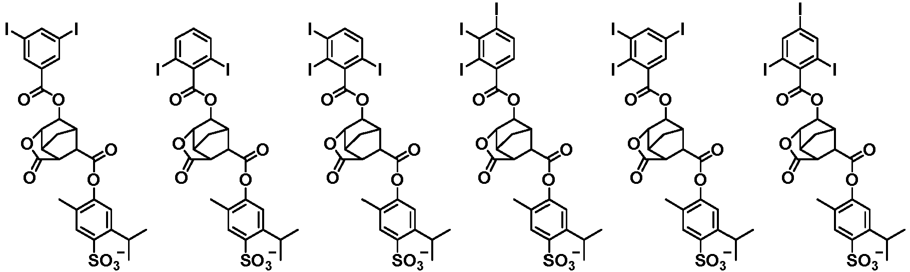

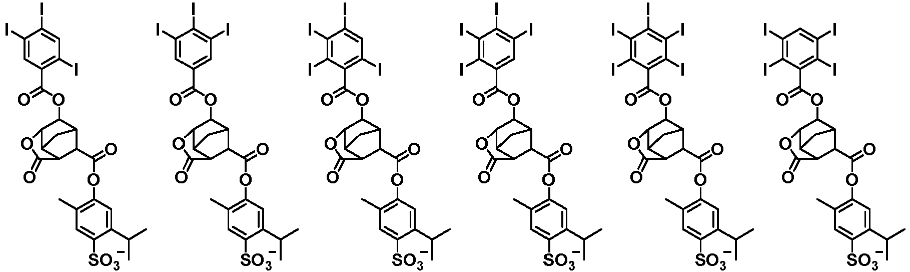

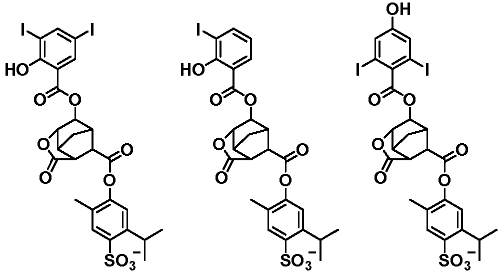

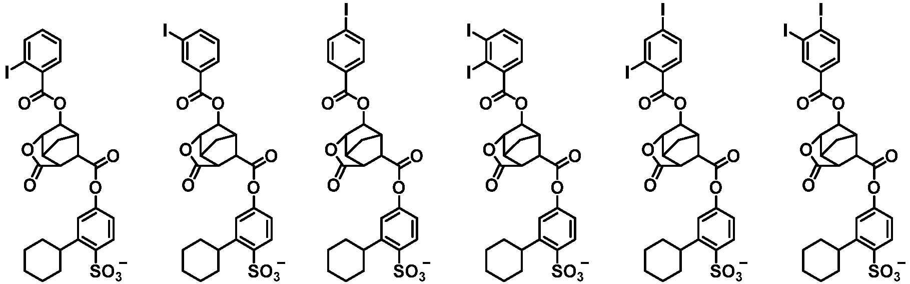

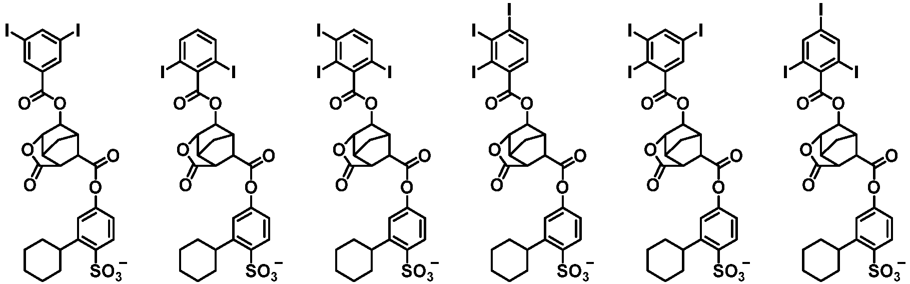

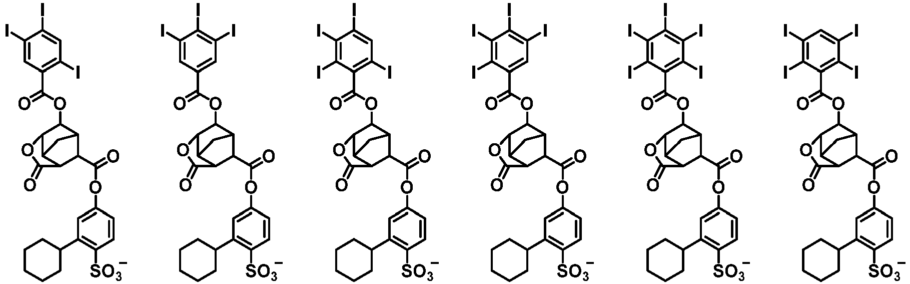

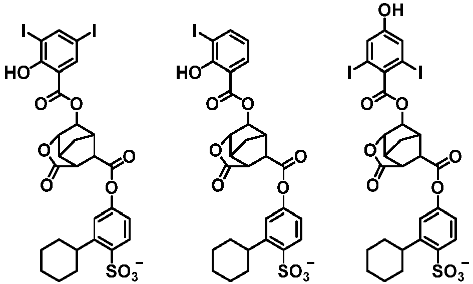

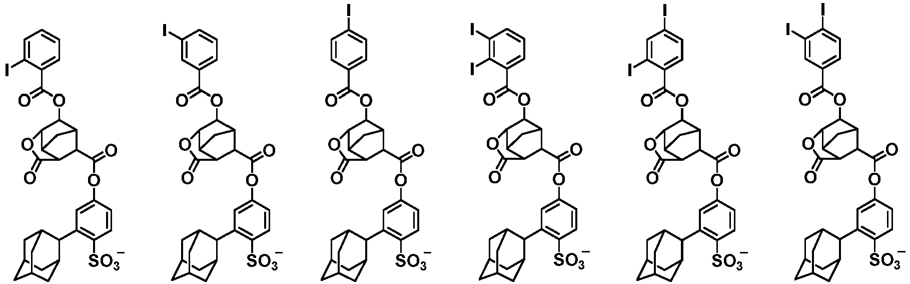

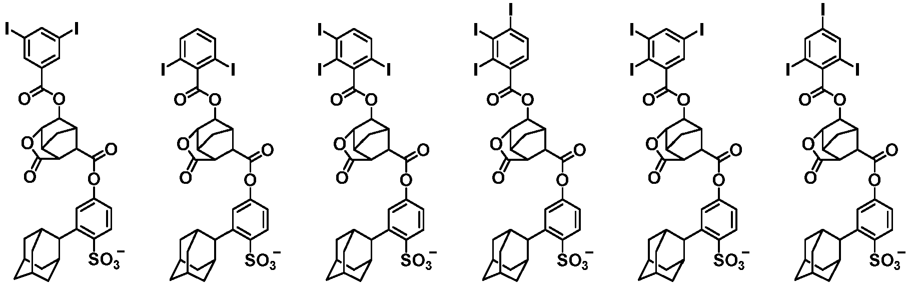

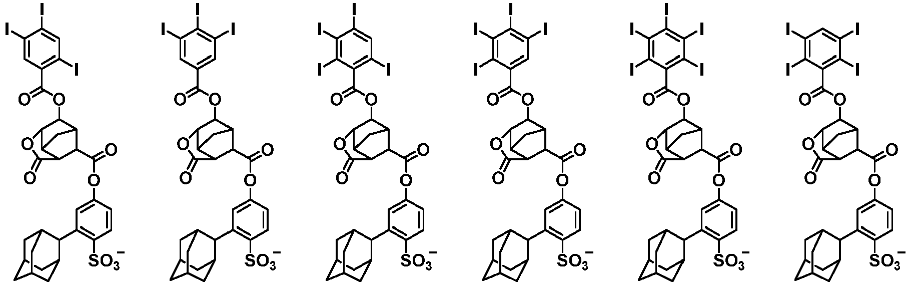

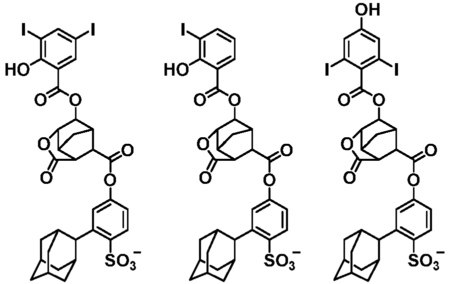

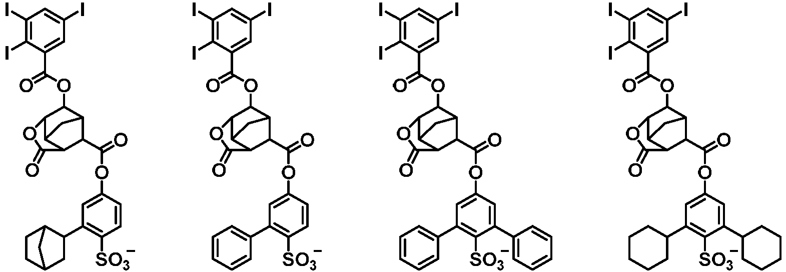

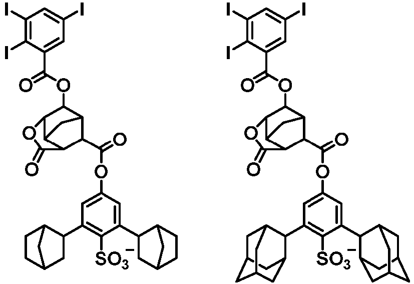

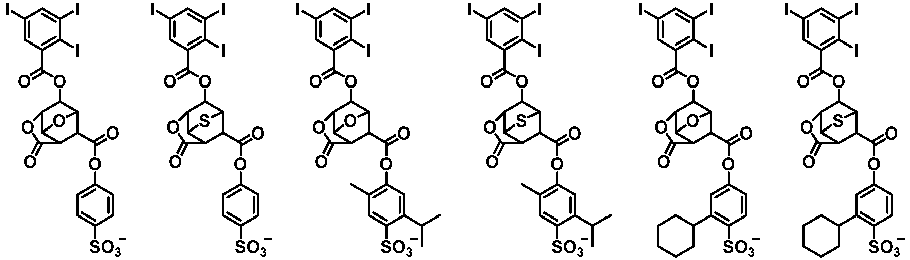

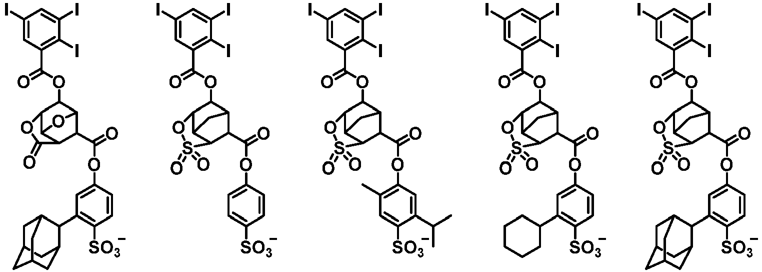

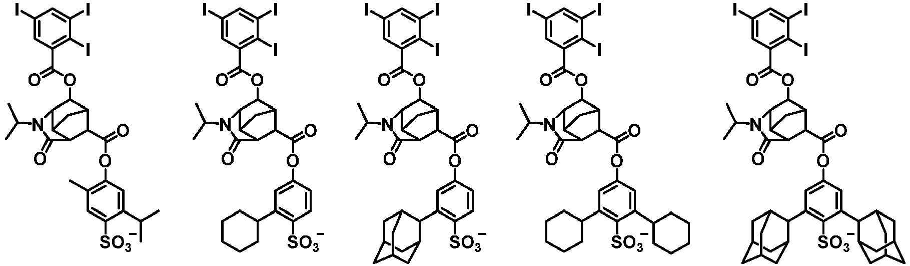

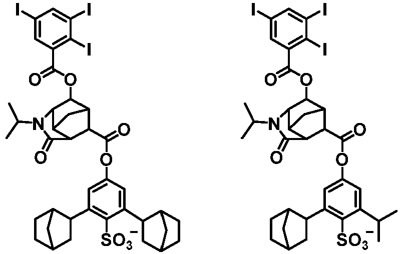

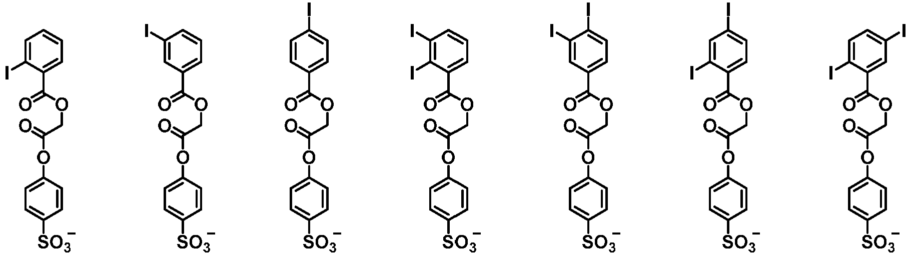

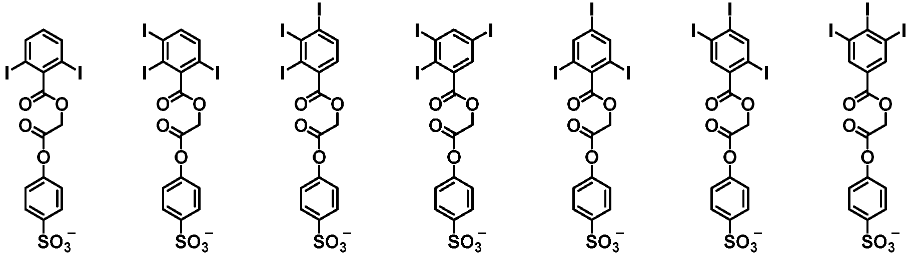

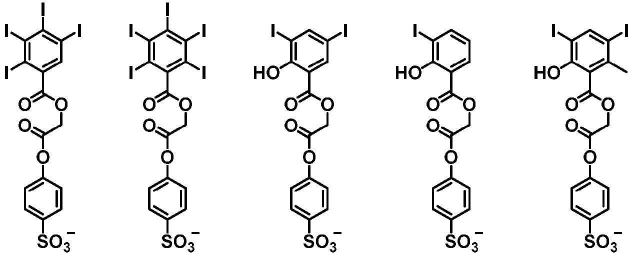

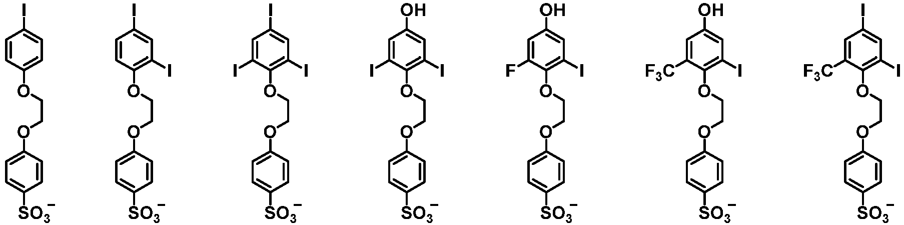

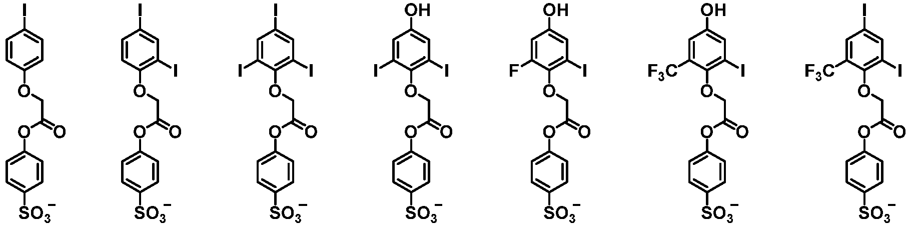

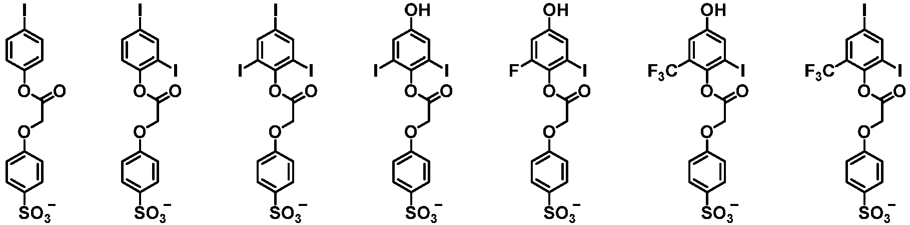

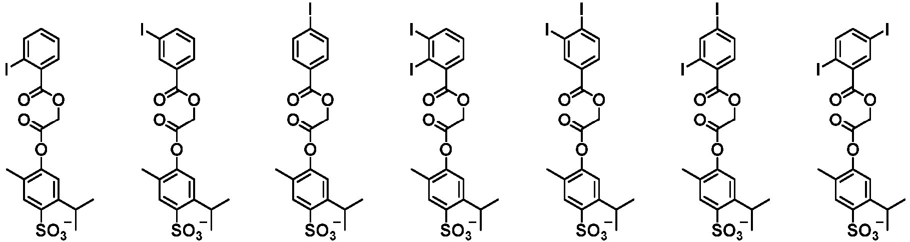

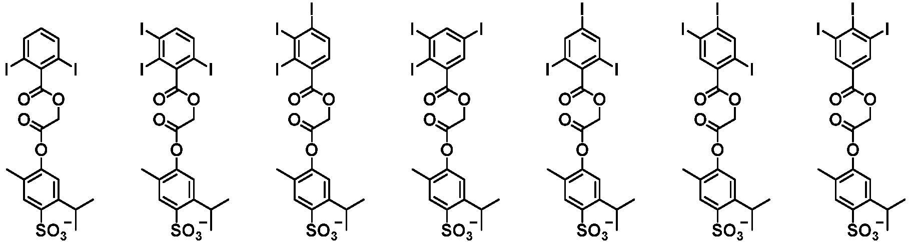

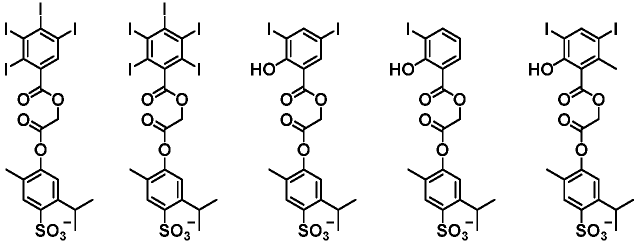

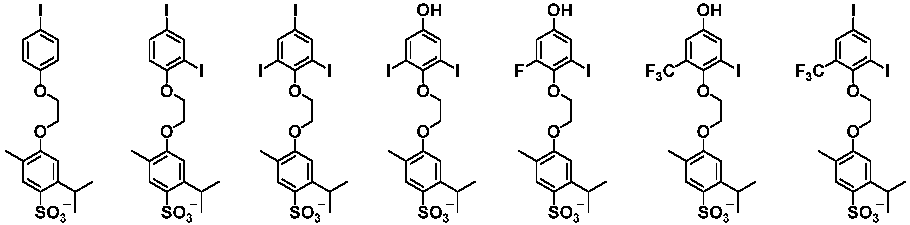

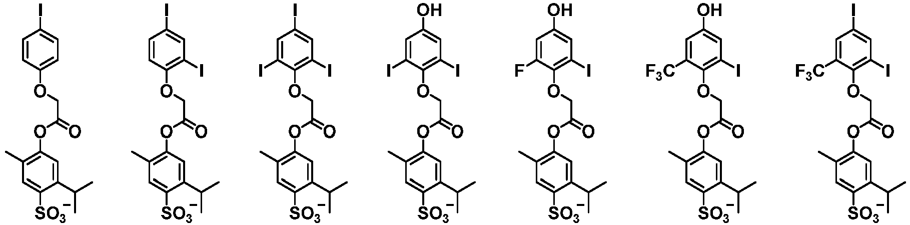

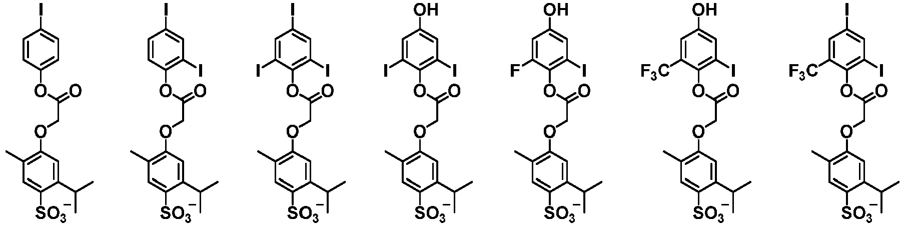

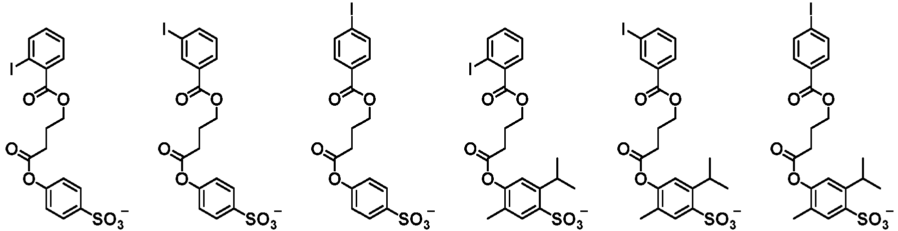

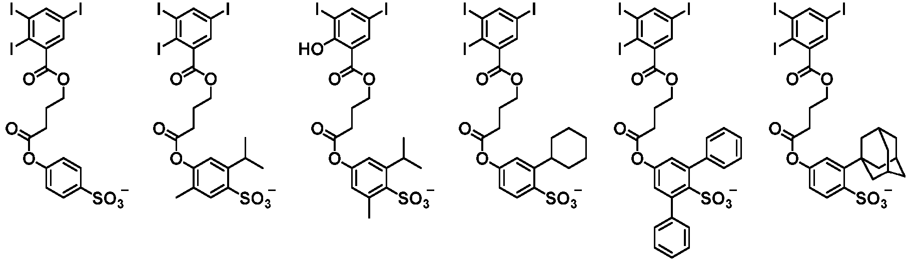

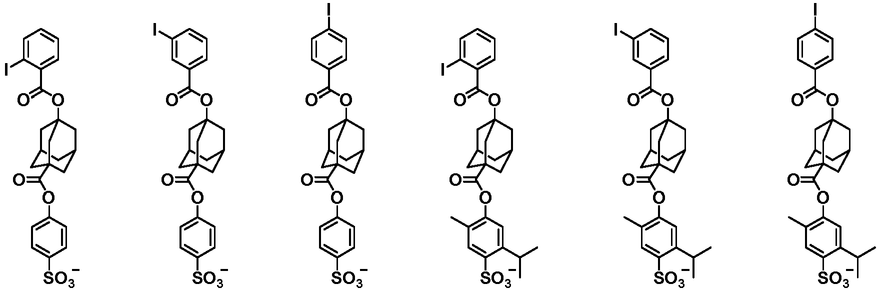

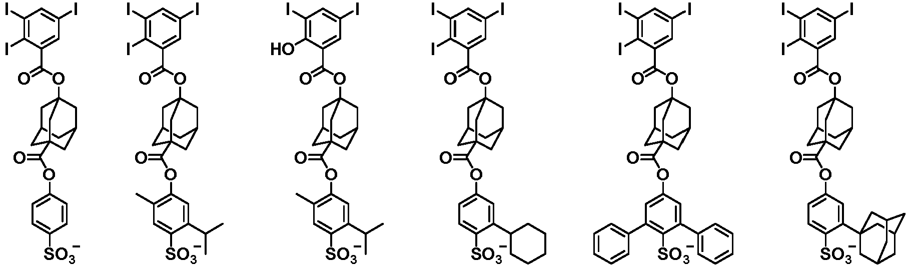

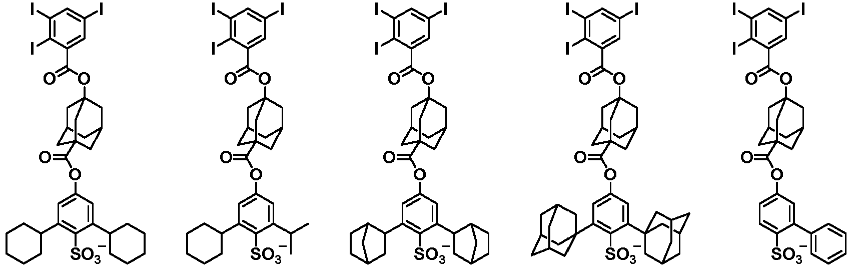

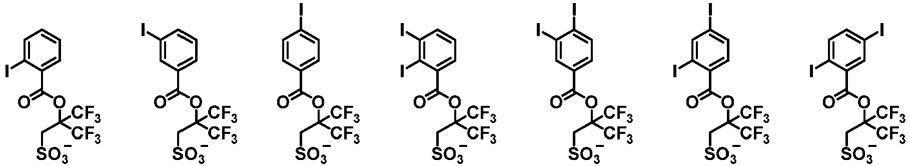

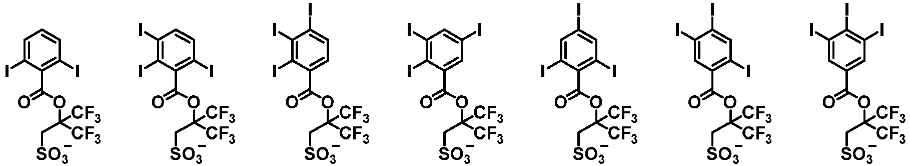

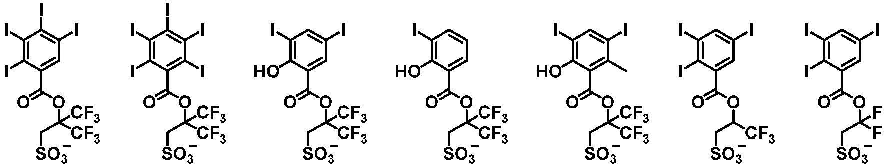

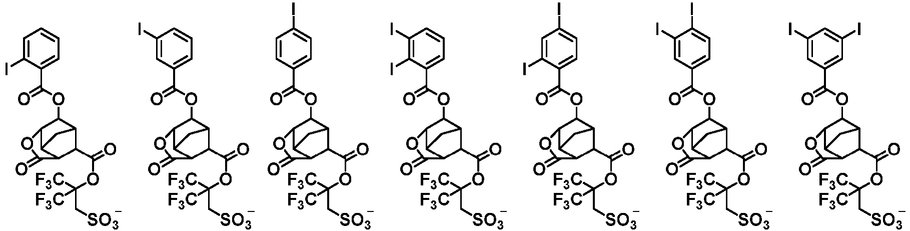

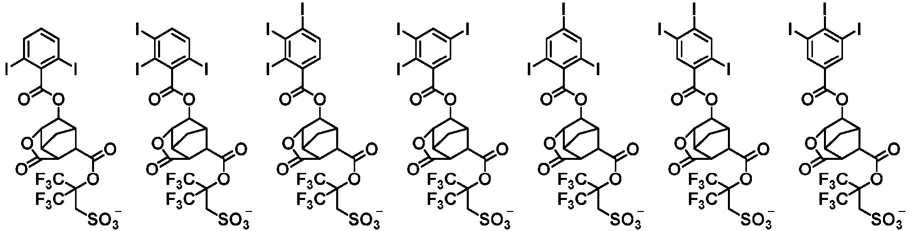

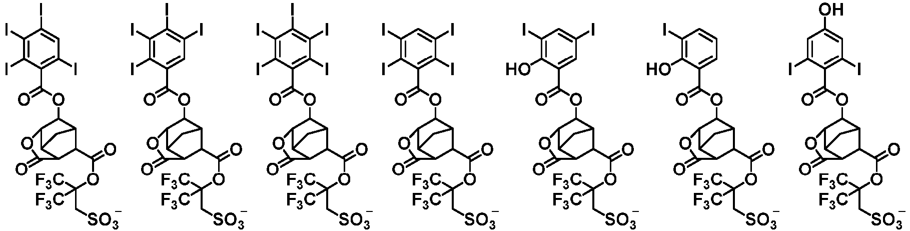

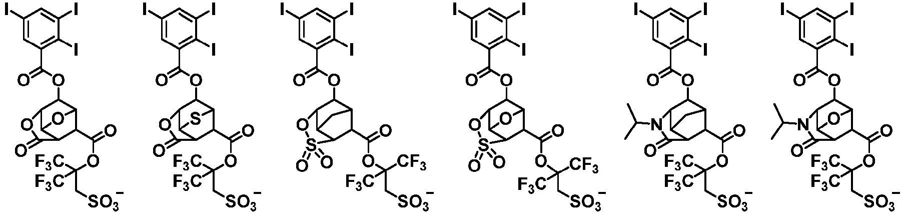

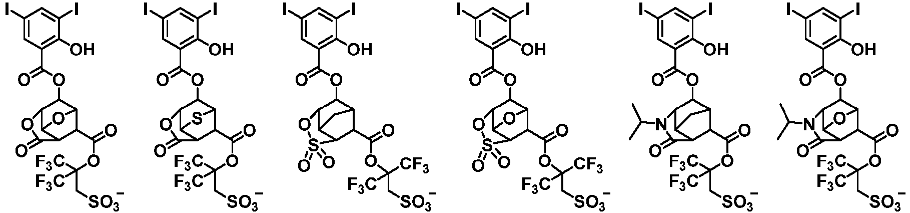

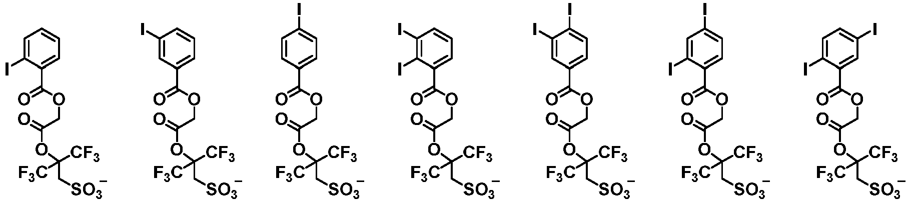

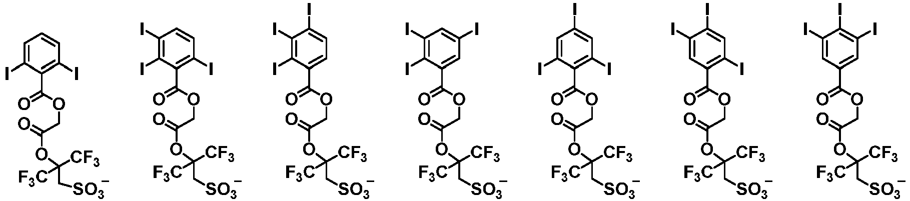

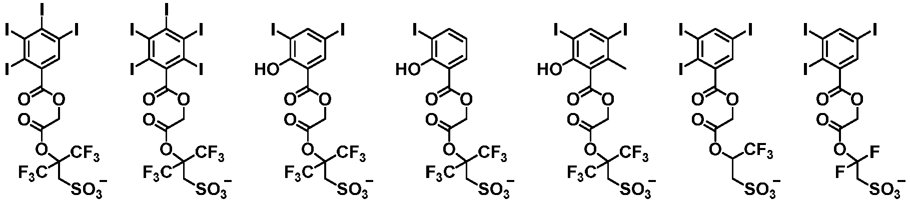

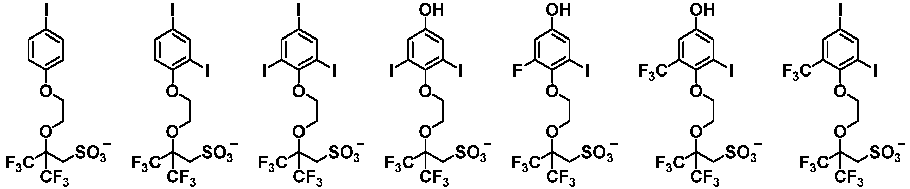

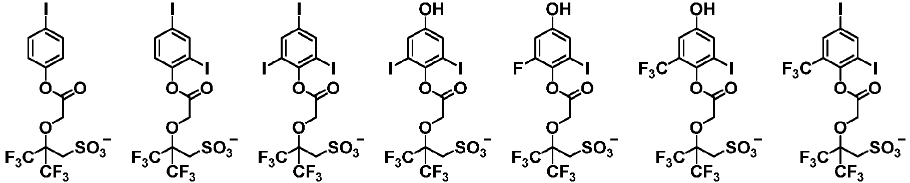

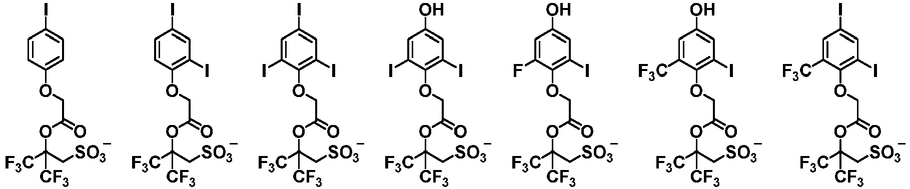

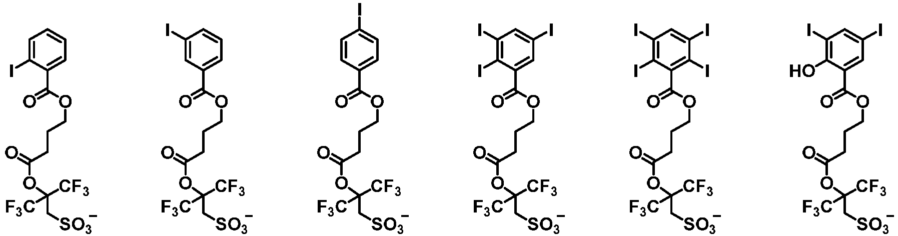

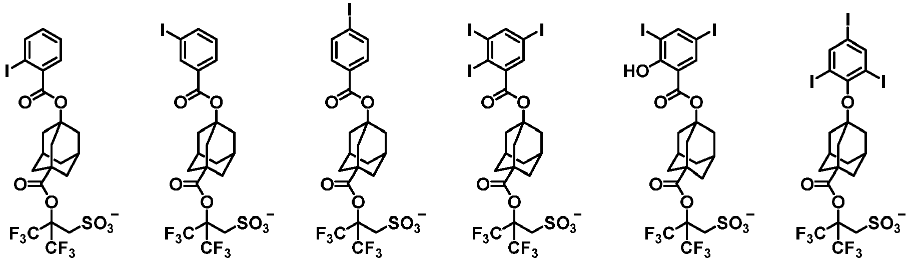

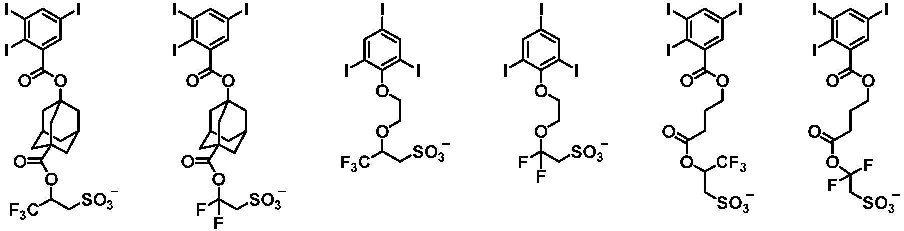

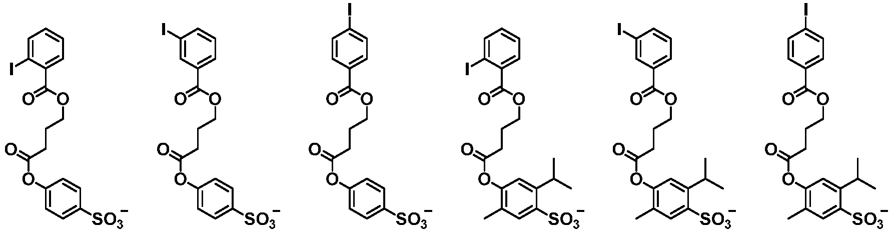

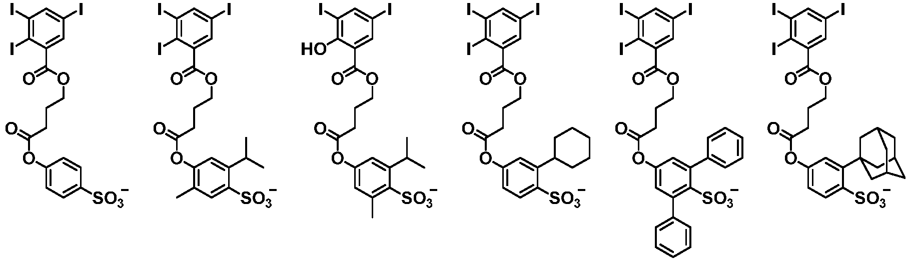

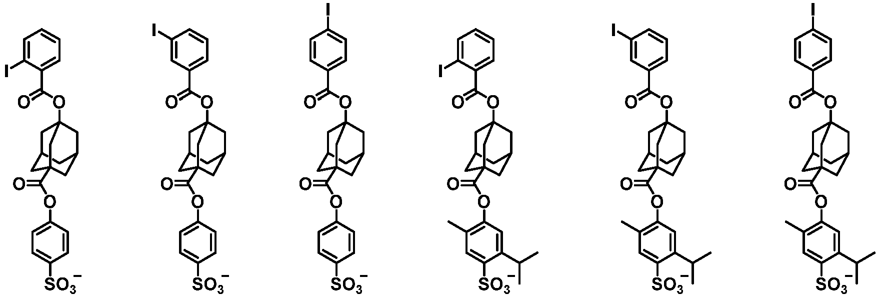

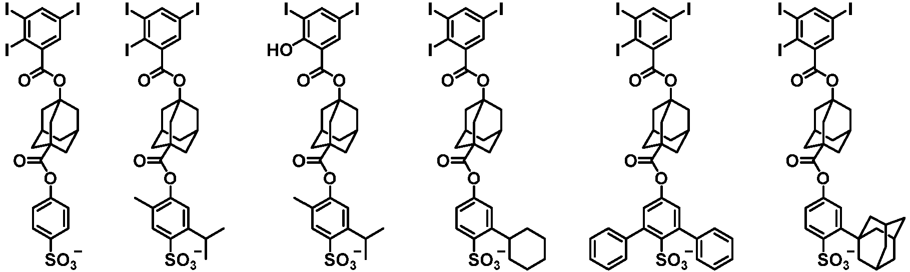

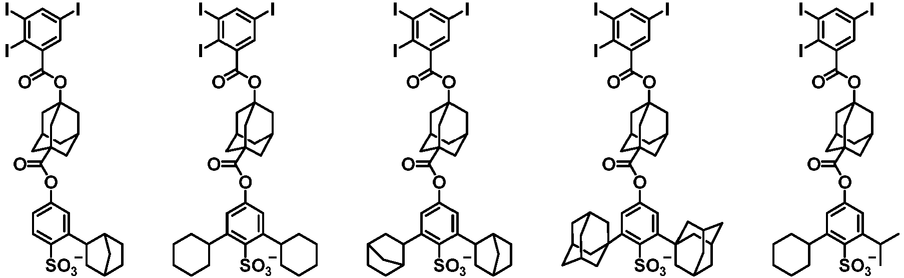

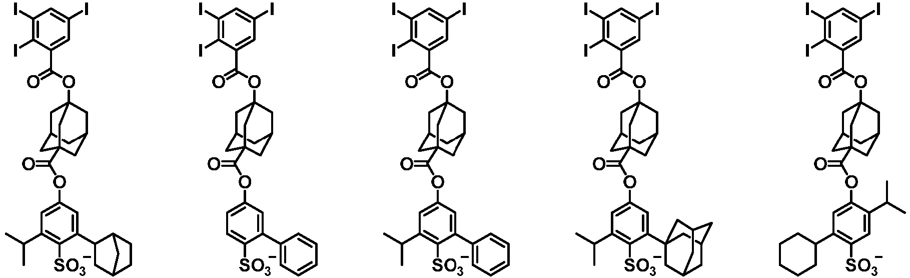

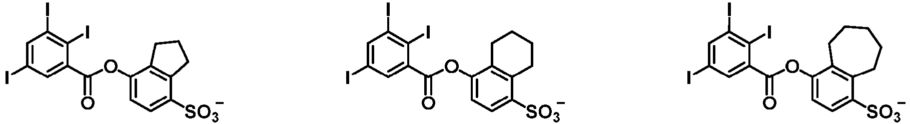

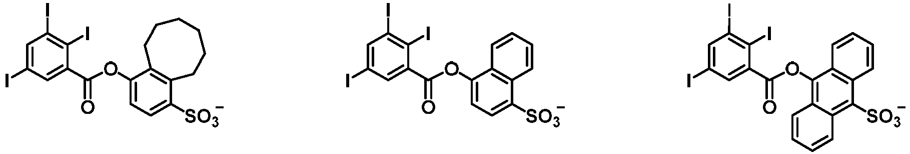

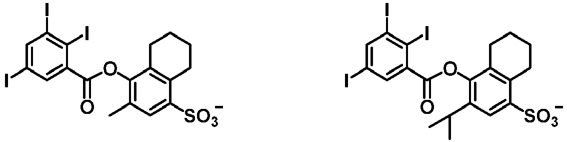

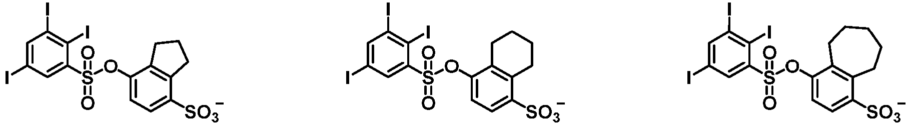

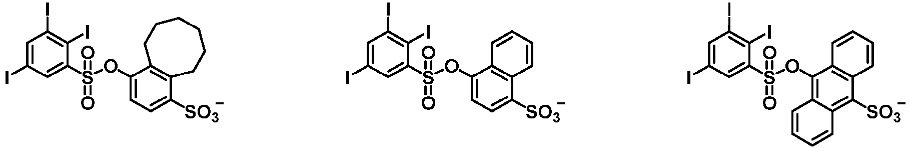

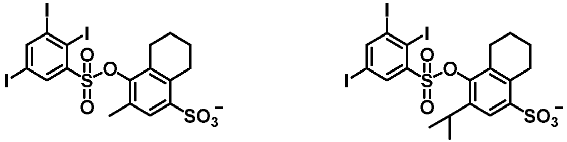

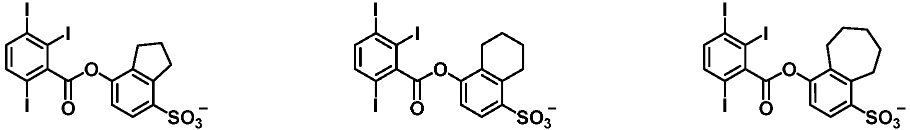

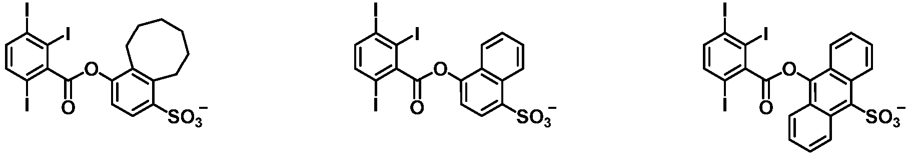

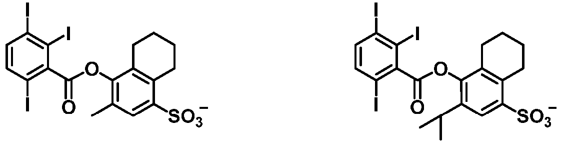

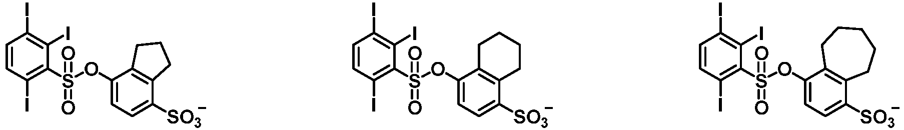

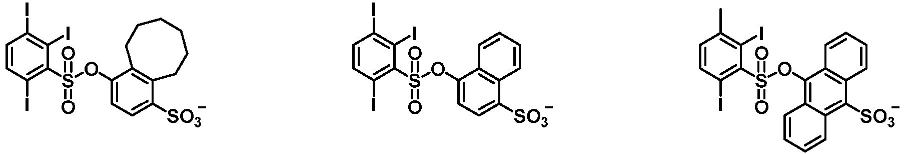

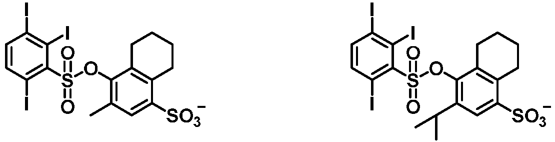

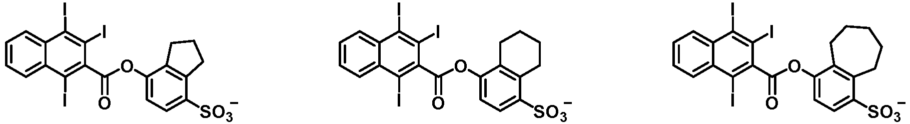

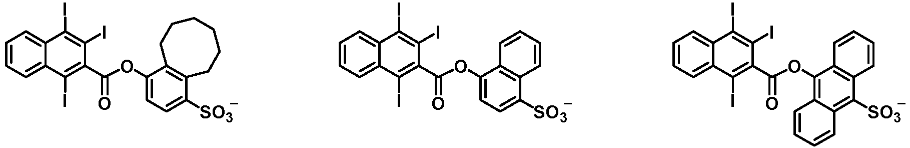

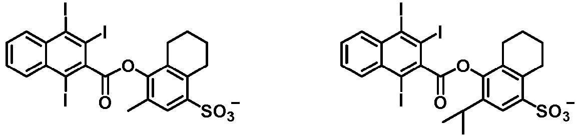

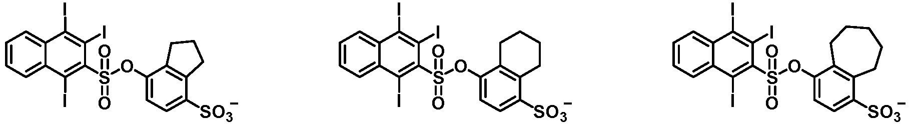

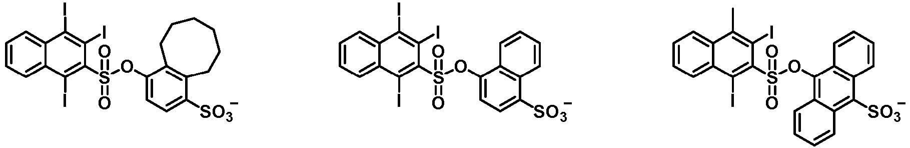

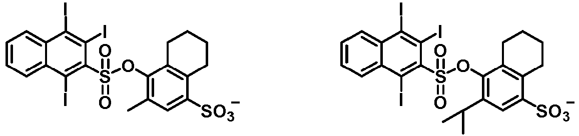

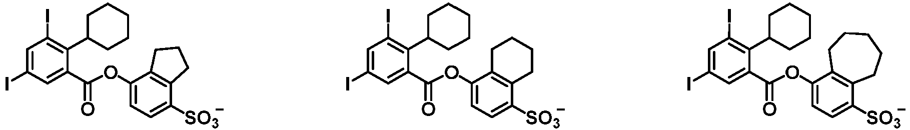

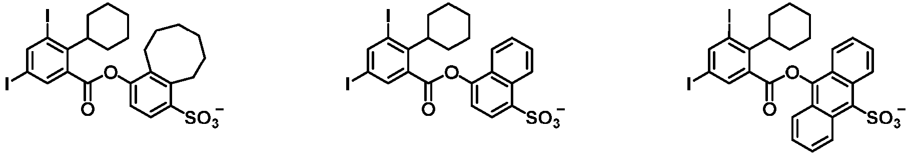

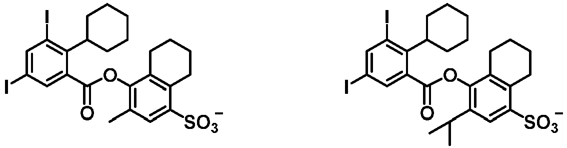

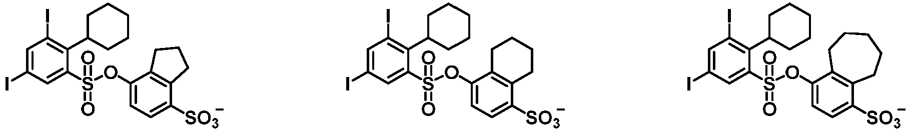

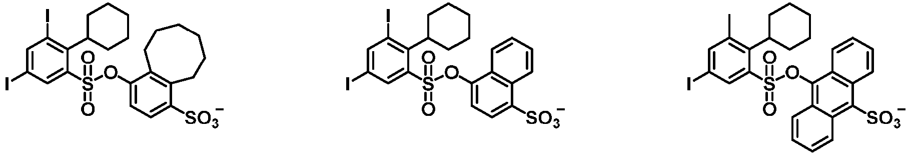

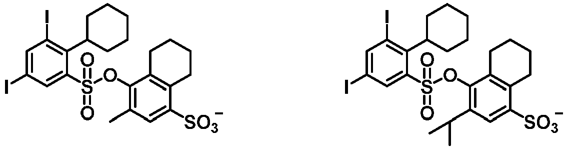

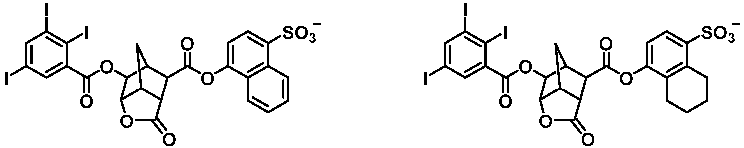

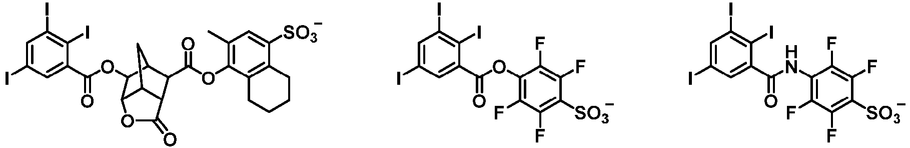

In the photoacid generator (F), as a cation that pairs with the anion described above, a sulfonium cation or an iodonium cation is preferable. Specific examples of the sulfonium cation include those cations mentioned as the sulfonium cation having formula (cation-1), but are not limited thereto. Specific examples of the iodonium cation include those cations mentioned as the iodonium cation having formula (cation-2), but are not limited thereto.

The acid generated by the photoacid generator preferably has a pKa value of -2.0 or more, and more preferably -1.0 or more. The upper limit of the pKa value is preferably 2.0. The pKa value is calculated using pKa DB in software ACD/Chemsketch ver: 9.04 manufactured by Advanced Chemistry Development, Inc.

When the chemically amplified negative resist composition of the present invention contains the photoacid generator (F), the content thereof is preferably 1 to 10 parts by weight, and more preferably 1 to 5 parts by weight per 80 parts by weight of the base polymer. Since the chemically amplified negative resist composition contains the photoacid generator (F), it is possible to appropriately adjust the amount of acid generated in the exposed area and the ability to inhibit dissolution of the unexposed area. The photoacid generator (F) may be used singly or in combination of two or more kinds thereof.

### (G) Surfactant

The chemically amplified negative resist composition of the present invention may contain a commonly used surfactant in order to improve the coating property on the substrate. Examples of the surfactant include PF-636 (manufactured by OMNOVA SOLUTIONS) and FC-4430 (manufactured by 3M). Many surfactants are known as many examples are described in JP-A 2004-115630, and the surfactant can be selected with reference to such examples. When the chemically amplified negative resist composition of the present invention contains the surfactant (G), the content thereof is preferably 0 to 5 parts by weight per 80 parts by weight of the base polymer (B). The surfactant (G) may be used singly or in combination of two or more kinds thereof.

### Resist Pattern Forming Process

The resist pattern forming process of the present invention includes the steps of: applying the chemically amplified negative resist composition onto a substrate to form a resist film thereon, exposing the resist film patternwise to high-energy radiation (that is, a step of exposing the resist film to high-energy radiation), and developing the exposed resist film in an alkaline developer.

As the substrate, for example, a substrate for manufacturing an integrated circuit (such as Si, SiO, SiO₂, SiN, SiON, TiN, WSi, BPSG, SOG, and an organic antireflective film), or a substrate for manufacturing a mask circuit of transmission or reflection type (such as Cr, CrO, CrON, MoSi₂, Si, SiO, SiO₂, SiON, SiONC, CoTa, NiTa, TaBN, and SnO₂) can be used. The chemically amplified negative resist composition is applied onto the substrate by a method such as spin coating so as to have a film thickness of 0.03 to 2 µm, and prebaked on a hotplate preferably at 60 to 150°C for 1 to 20 minutes, more preferably at 80 to 140°C for 1 to 10 minutes to form a resist film.

The resist film is then exposed patternwise to high-energy radiation. Examples of the high-energy radiation include UV, deep-UV, excimer laser (such as KrF and ArF), EUV having a wavelength of 3 to 15 nm, X-rays, γ-rays, synchrotron radiation, and EB. In the present invention, it is preferable to perform exposure using EUV or EB.

When UV, deep-UV, excimer laser, EUV, X-rays, γ-rays, or synchrotron radiation is used as the high-energy radiation, the resist film is exposed thereto through a mask having a desired pattern preferably at a dose of about 1 to 500 mJ/cm², and more preferably about 10 to 400 mJ/cm². When EB is used, the resist film is exposed directly thereto preferably at a dose of about 1 to 500 µC/cm², and more preferably about 10 to 400 µC/cm² in order to form a desired pattern.

The exposure may be performed by conventional lithography, or immersion lithography of holding a liquid between the resist film and the mask may be employed if desired. In the case of immersion lithography, a protective film which is insoluble in water may be formed on the resist film.

The resist film is subjected to post exposure baking (PEB) on a hotplate preferably at a temperature of 60 to 150°C for 1 to 20 minutes, and more preferably at 80 to 140°C for 1 to 10 minutes.

Thereafter, the resist film is developed using a developer of an aqueous alkaline solution of TMAH or the like at a concentration of 0.1 to 5 wt%, preferably 2 to 3 wt% for preferably 0.1 to 3 minutes, more preferably 0.5 to 2 minutes by a conventional technique such as a dip, puddle, or spray technique, whereby a desired pattern is formed on the substrate.

The chemically amplified negative resist composition of the present invention is useful particularly because it can form a pattern having good resolution and small LER. In addition, the chemically amplified negative resist composition of the present invention is particularly useful for pattern formation of a substrate, specifically a substrate having a surface layer of a material to which a resist film is less adherent and which is likely to invite pattern stripping or pattern collapse. Examples of such a substrate include a substrate in which metallic chromium or a chromium compound containing one or more light elements selected from oxygen, nitrogen, and carbon is deposited as the outermost surface by sputtering, and a substrate containing SiO, SiOₓ, a tantalum compound, a molybdenum compound, a cobalt compound, a nickel compound, a tungsten compound, or a tin compound in the outermost layer. The chemically amplified negative resist composition of the present invention is particularly useful for pattern formation using a photomask blank as a substrate. In this case, the photomask blank may be of transmission or reflection type.

As for the mask blank of transmission type, the photomask blank having a light-shielding film made of a chromium-based material may be a photomask blank for a binary mask or a photomask blank for a phase shift mask. In the case of the photomask blank for a binary mask, the light-shielding film may have an antireflection layer made of a chromium-based material and a light-shielding layer, and the entire antireflective film on the surface layer side, or only the surface layer portion of the antireflective film on the surface layer side may be made of a chromium-based material, and the remaining portion may be made of, for example, a silicon-based compound material which may contain a transition metal. Further, in the case of a photomask blank for a phase shift mask, the photomask blank for a phase shift mask may have a chromium-based light-shielding film on a phase shift film.

The photomask blank containing the chromium-based material in the outermost layer described above is very well known as disclosed in JP-A 2008-26500, JP-A 2007-302873, and the references cited therein, and the detailed description thereof is omitted. For example, when a light-shielding film having an antireflection layer and a light-shielding layer is formed using a chromium-based material, the following film configuration can be used.

When the light-shielding film having the antireflection layer and the light-shielding layer is formed using a chromium-based material, as a layer configuration, the antireflection layer and the light-shielding layer may be stacked in this order from the surface layer side, or the antireflection layer, the light-shielding layer, and the antireflection layer may be stacked in this order. In addition, each of the antireflection layer and the light-shielding layer may be composed of multiple sub-layers. When the sub-layers have different compositions, the composition may be graded discontinuously or continuously from sub-layer to sub-layer. As the chromium-based material to be used, metallic chromium, or a material containing light elements such as oxygen, nitrogen, and/or carbon in metallic chromium is used. Specifically, metallic chromium, chromium oxide, chromium nitride, chromium carbide, chromium oxynitride, chromium oxycarbide, chromium nitride carbide, chromium oxide nitride carbide, and the like can be used.

In addition, the reflection type mask blank includes a substrate, a multilayer reflective film formed on one main surface (front surface) of the substrate, specifically, a multilayer reflective film which reflects exposure radiation such as EUV radiation, and an absorber film formed on the multilayer reflective film, specifically, an absorber film which absorbs exposure radiation such as EUV radiation and reduces reflectivity. A reflection type mask (reflection type mask for EUV lithography) having an absorber pattern (pattern of the absorber film) formed by patterning the absorber film is manufactured from the reflection type mask blank (reflection type mask blank for EUV lithography). The EUV radiation used for EUV lithography has a wavelength of 13 to 14 nm, and is usually radiation having a wavelength of about 13.5 nm.

Usually, the multilayer reflective film is preferably provided in contact with one main surface of the substrate, but it is also possible to provide an underlay film between the substrate and the multilayer reflective film as long as the effect of the present invention is not impaired. The absorber film may be formed in contact with the multilayer reflective film, but a protective film (protective film for the multilayer reflective film) may be provided between the multilayer reflective film and the absorber film, preferably in contact with the multilayer reflective film, and more preferably in contact with the multilayer reflective film and the absorber film. The protective film is used to protect the multilayer reflective film in processing such as cleaning and tailoring. In addition, the protective film preferably has a function of protecting the multilayer reflective film when the absorber film is patterned by etching and preventing oxidation of the multilayer reflective film. Meanwhile, an electroconductive film used for electrostatically chucking the reflection type mask to an exposure apparatus may be provided under another main surface (back side surface), which is a surface opposite to the one main surface of the substrate, preferably in contact with the other main surface. Here, one main surface of the substrate is the front surface and the upper side, and the other main surface is the back surface and the lower side. However, the terms "front and back" surfaces or "upper and lower" sides are used for the sake of convenience. The one main surface and the other main surface are either of two main surfaces (film-bearing surfaces) of the substrate, and front and back or upper and lower are exchangeable. More specifically, the multilayer reflective film can be formed by a method disclosed in JP-A 2021-139970 or the references cited therein.

According to the resist pattern forming process of the present invention, even with use of a substrate (for example, a mask blank of transmission or reflection type) whose outermost surface is made of a material which easily affects the profile of the resist pattern, such as a material containing chromium, silicon, or tantalum, a pattern having very high resolution, small LER, excellent rectangularity, and excellent pattern fidelity can be obtained.

### EXAMPLES

Hereinafter, the present invention is specifically described with reference to Synthesis Examples, Examples, and Comparative Examples, but the present invention is not limited to the following Examples.

### [1] Synthesis of Base Polymer

### Synthesis Example 1-1

### Synthesis of Base Polymer P-1

In a nitrogen atmosphere, 69.4 g of 3-hydroxystyrene, 10.4 g of 4-chlorostyrene, 20.2 g of PM-1, 12.7 g of V-601 (manufactured by FUJIFILM Wako Pure Chemical Corporation), and 120 g of PGME were placed in a flask to prepare a monomer-polymerization initiator solution. In another flask under a nitrogen atmosphere, 60 g of PGME was placed, heated to 80°C with stirring, and then the monomer-polymerization initiator solution was added dropwise over 4 hours. After completion of the dropwise addition, stirring was continued for 18 hours while maintaining the temperature of the polymerization liquid at 80°C, and then the polymerization liquid was cooled to room temperature. The obtained polymerization liquid was added dropwise to 5000 g of a stirred mixed solvent of methanol and water (methanol : water = 1 : 9), and the precipitated polymer was separated by filtration. The obtained polymer was washed twice with 1000 g of a mixed solvent of methanol and water (methanol : water = 1 : 9), and then vacuum-dried at 40°C for 20 hours to give 85.4 g of Polymer P-1 as a white powder. Polymer P-1 was analyzed by ¹³C-NMR, ¹H-NMR, and GPC, and the following analysis results were obtained. The Mw is determined by GPC versus polystyrene standards using a DMF solvent.

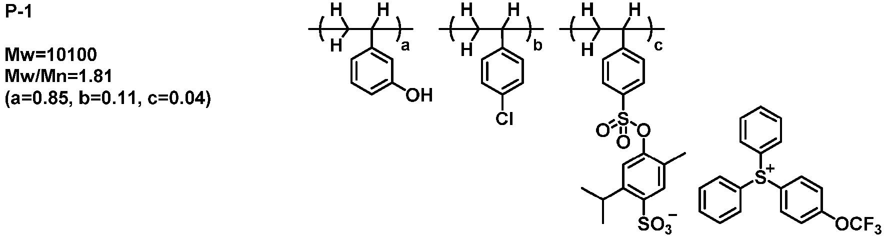

### Synthesis Examples 1-2 to 1-40 and Synthesis Examples 2-1 to 2-7

### Synthesis of Base Polymers P-2 to P-40 and Base Polymers AP-1 to AP-7

Base Polymers P-2 to P-40 and AP-1 to AP-7 shown in the following Tables 1 to 3 were synthesized in the same manner as in Synthesis Example 1-1 except that the type and compounding ratio of the monomers were changed. In Tables 1 to 3 below, the introduction rate indicates the molar rate.

**Table 1**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| P-1 | PP-1 | 4.0 | A-1 | 85.0 | B-3 | 11.0 | - | - | 10,000 | 1.82 |
| P-2 | PP-1 | 5.0 | A-1 | 75.0 | B-1 | 10.0 | B-3 | 10.0 | 14,500 | 1.85 |
| P-3 | PP-1 | 5.0 | A-1 | 75.0 | B-2 | 10.0 | B-3 | 10.0 | 15,200 | 1.81 |
| P-4 | PP-1 | 5.0 | A-1 | 75.0 | B-2 | 10.0 | B-4 | 10.0 | 14,400 | 1.83 |
| P-5 | PP-1 | 5.0 | A-1 | 75.0 | B-2 | 10.0 | B-5 | 10.0 | 14,300 | 1.88 |
| P-6 | PP-1 | 5.0 | A-2 | 75.0 | B-2 | 10.0 | B-3 | 10.0 | 14,200 | 1.85 |
| P-7 | PP-1 | 15.0 | A-3 | 60.0 | B-2 | 15.0 | B-3 | 10.0 | 14,600 | 1.81 |
| P-8 | PP-1 | 5.0 | A-1 | 70.0 | B-6 | 5.0 | C-1 | 20.0 | 15,800 | 1.83 |
| P-9 | PP-2 | 5.0 | A-1 | 70.0 | B-6 | 5.0 | C-1 | 20.0 | 18,500 | 1.87 |
| P-10 | PP-3 | 5.0 | A-1 | 70.0 | B-6 | 5.0 | C-1 | 20.0 | 17,200 | 1.70 |
| P-11 | PP-4 | 5.0 | A-1 | 70.0 | B-6 | 5.0 | C-1 | 20.0 | 16,200 | 1.86 |
| P-12 | PP-5 | 3.0 | A-1 | 72.0 | B-6 | 5.0 | C-1 | 20.0 | 29,600 | 1.91 |
| P-13 | PP-6 | 5.0 | A-1 | 70.0 | B-6 | 5.0 | C-1 | 20.0 | 16,200 | 1.82 |
| P-14 | PP-7 | 5.0 | A-1 | 70.0 | B-6 | 5.0 | C-1 | 20.0 | 16,400 | 1.85 |
| P-15 | PP-8 | 5.0 | A-1 | 70.0 | B-6 | 5.0 | C-1 | 20.0 | 16,600 | 1.83 |
| P-16 | PP-9 | 5.0 | A-1 | 70.0 | B-6 | 5.0 | C-1 | 20.0 | 16,200 | 1.81 |
| P-17 | PP-10 | 5.0 | A-1 | 70.0 | B-6 | 5.0 | C-1 | 20.0 | 16,300 | 1.86 |
| P-18 | PP-11 | 2.5 | A-1 | 70.0 | B-6 | 5.0 | C-1 | 22.5 | 19,000 | 1.84 |
| P-19 | PP-12 | 5.0 | A-1 | 70.0 | B-6 | 5.0 | C-1 | 20.0 | 15,900 | 1.83 |
| P-20 | PP-13 | 5.0 | A-1 | 70.0 | B-6 | 5.0 | C-1 | 20.0 | 16,300 | 2.00 |
| P-21 | PP-14 | 5.0 | A-1 | 70.0 | B-6 | 5.0 | C-1 | 20.0 | 16,600 | 1.83 |
| P-22 | PP-15 | 5.0 | A-1 | 70.0 | B-6 | 5.0 | C-1 | 20.0 | 16,100 | 1.82 |
| P-23 | PP-16 | 5.0 | A-1 | 70.0 | B-6 | 5.0 | C-1 | 20.0 | 16,200 | 1.60 |
| P-24 | PP-1 | 5.0 | A-2 | 70.0 | B-2 | 5.0 | C-1 | 20.0 | 17,100 | 1.84 |
| P-25 | PP-1 | 10.0 | A-2 | 65.0 | B-2 | 5.0 | C-1 | 20.0 | 16,500 | 1.84 |
| P-26 | PP-1 | 5.0 | A-2 | 70.0 | B-2 | 5.0 | C-2 | 20.0 | 16,100 | 1.85 |
| P-27 | PP-1 | 5.0 | A-2 | 75.0 | B-2 | 5.0 | C-3 | 15.0 | 16,200 | 1.81 |
| P-28 | PP-1 | 5.0 | A-2 | 50.0 | B-2 | 5.0 | C-4 | 40.0 | 16,300 | 1.85 |
| P-29 | PP-1 | 5.0 | A-2 | 70.0 | B-2 | 5.0 | C-5 | 20.0 | 16,700 | 1.83 |
| P-30 | PP-1 | 5.0 | A-2 | 45.0 | B-2 | 5.0 | C-6 | 45.0 | 16,800 | 1.81 |
| P-31 | PP-1 | 5.0 | A-2 | 70.0 | B-2 | 5.0 | C-7 | 20.0 | 17,200 | 1.84 |
| P-32 | PP-1 | 5.0 | A-2 | 65.0 | C-1 | 30.0 | - | - | 20,000 | 1.50 |

**Table 2**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| P-33 | PP-1 | 1.0 | A-2 | 66.0 | B-2 | 8.0 | C-1 | 25.0 | 12,000 | 1.72 |
| P-34 | PP-1 | 2.0 | A-2 | 55.0 | B-2 | 8.0 | C-4 | 35.0 | 9,200 | 1.90 |
| P-35 | PP-1 | 0.5 | A-2 | 66.0 | B-2 | 8.0 | C-5 | 25.0 | 4,000 | 1.81 |
| P-36 | PP-1 | 3.0 | A-1 | 77.0 | C-1 | 20.0 | - | - | 13,000 | 1.85 |
| P-37 | PP-1 | 3.0 | A-1 | 67.0 | C-4 | 30.0 | - | - | 25,000 | 1.86 |
| P-38 | PP-1 | 3.0 | A-1 | 77.0 | C-5 | 20.0 | - | - | 15,000 | 1.94 |
| P-39 | PP-1 | 3.0 | A-2 | 67.0 | C-4 | 30.0 | - | - | 10,000 | 1.89 |
| P-40 | PP-1 | 3.0 | A-2 | 77.0 | C-5 | 20.0 | - | - | 23,000 | 1.93 |

**Table 3**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| AP-1 | A-1 | 80.0 | B-1 | 10.0 | B-3 | 10.0 | - | - | 4,400 | 1.66 |
| AP-2 | A-2 | 80.0 | B-1 | 10.0 | B-3 | 10.0 | - | - | 4,300 | 1.65 |
| AP-3 | A-2 | 60.0 | B-2 | 10.0 | C-1 | 30.0 | - | - | 4,500 | 1.62 |
| AP-4 | A-2 | 45.0 | B-2 | 10.0 | C-4 | 45.0 | - | - | 4,400 | 1.61 |
| AP-5 | A-2 | 55.0 | B-2 | 10.0 | C-5 | 35.0 | - | - | 3,500 | 1.63 |
| AP-6 | A-2 | 50.0 | B-2 | 10.0 | C-6 | 40.0 | - | - | 4,500 | 1.64 |
| AP-7 | A-2 | 65.0 | B-2 | 10.0 | C-7 | 35.0 | - | - | 4,600 | 1.62 |

The structures of the repeat units introduced into the polymers are shown below.

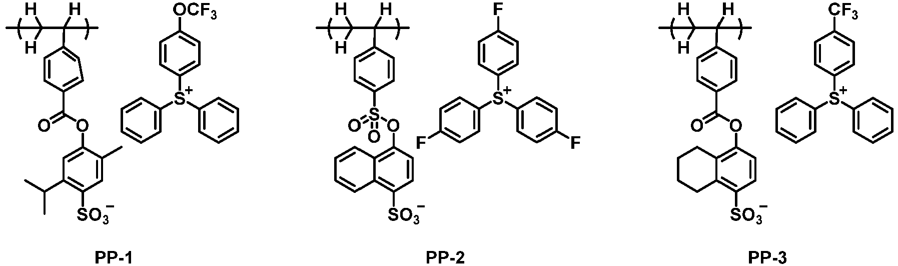

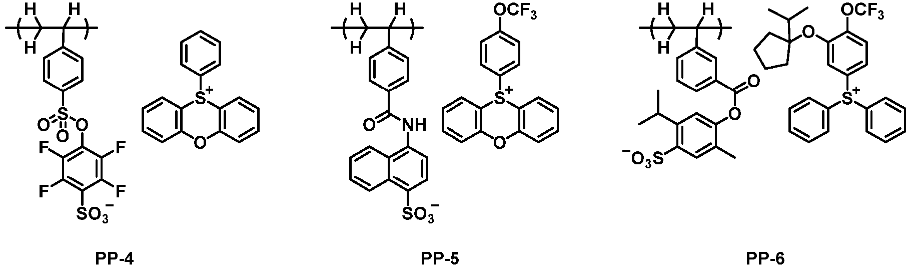

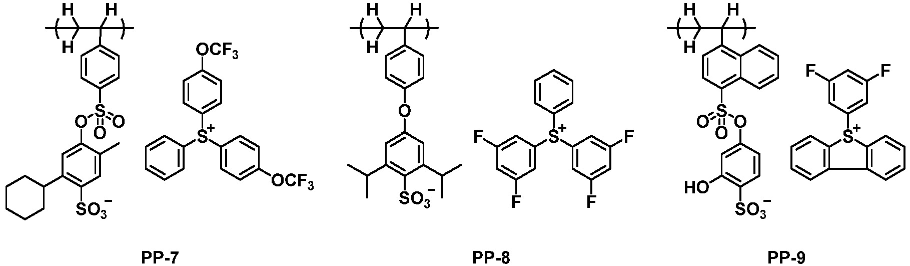

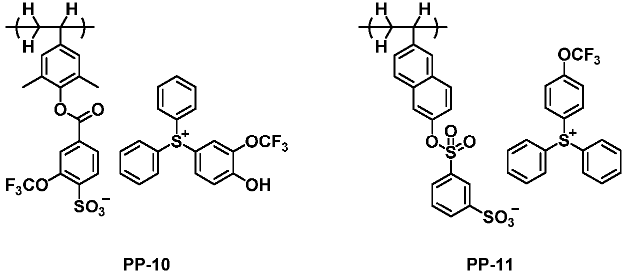

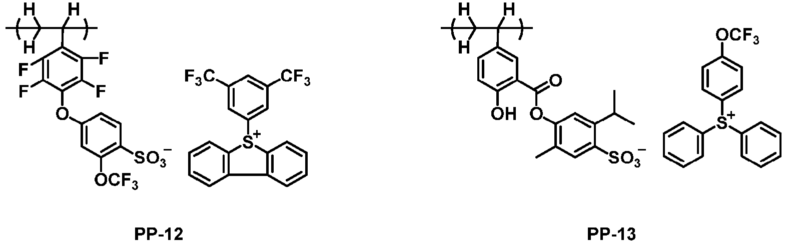

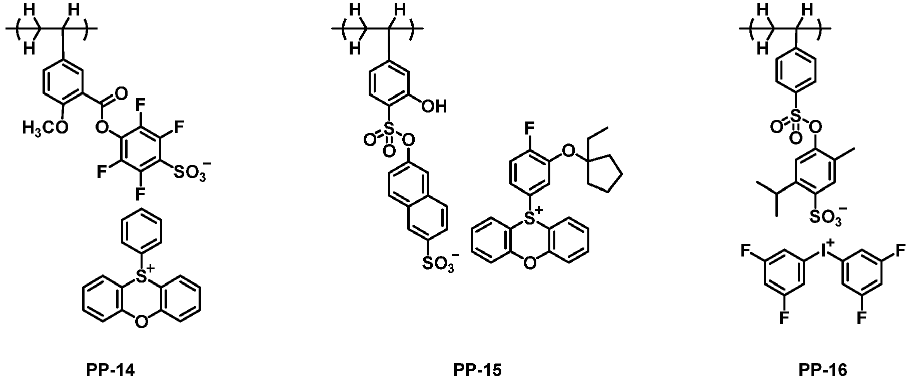

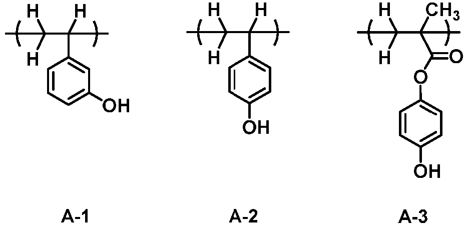

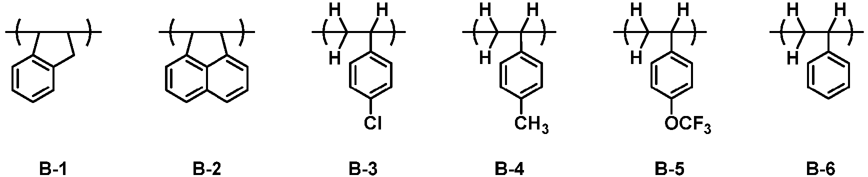

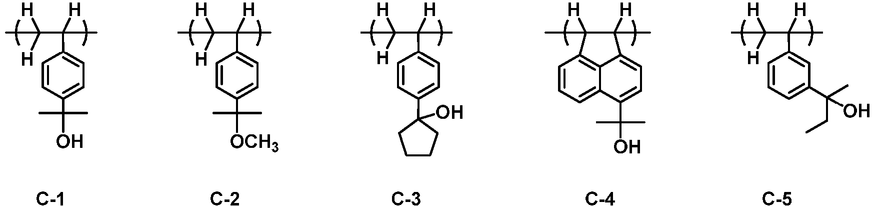

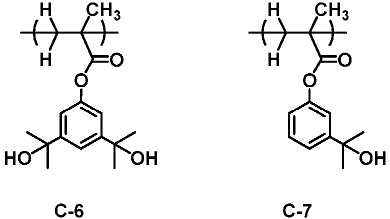

The dissolution rate of each of the polymers in an alkaline developer was calculated by applying a polymer solution (polymer concentration: 12.0 wt%, solvent: PGME) onto an 8-inch silicon wafer by spin coating, baking the solution at 150°C for 90 seconds to form a film having a thickness of 2000 nm, then performing development with a 2.38 wt% aqueous TMAH solution at 23°C for 10 seconds, and measuring the film thickness loss. As a result, the dissolution rates of Polymers P-1 to P-40 and AP-1 to AP-7 were 20 nm/sec or less.

### Comparative Synthesis Examples 1-1 to 1-4

### Synthesis of Polymers cP-1 to cP-4

The following polymers cP-1 to cP-4 were synthesized in the same manner as in Synthesis Example 1-1 except that the raw material compounds used were changed.

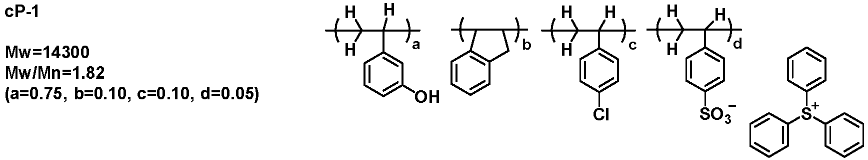

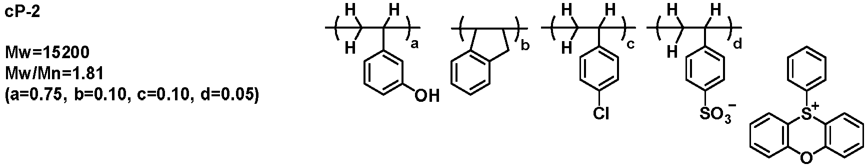

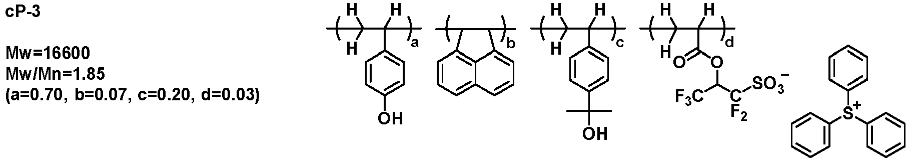

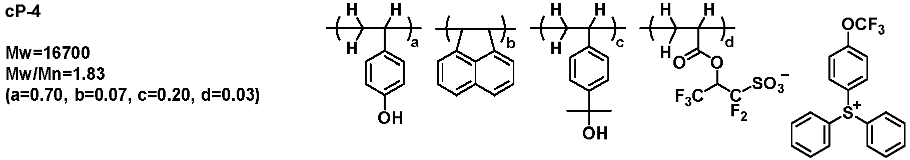

The dissolution rates of Comparative Polymers cP-1 to cP-4 were 20 nm/sec or less.

### [2] Preparation of Chemically Amplified Negative Resist Composition

### Examples 1-1 to 1-76 and Comparative Examples 1-1 to 1-7

Each of the compositions containing the components shown in the following Tables 4 to 7 was dissolved in an organic solvent, and the obtained solution was filtered through a nylon filter having a size of 5 nm and a UPE filter having a size of sub-1 nm to prepare a chemically amplified negative resist composition. The organic solvent is a mixed solvent of 920 parts by weight of PGMEA, 1850 parts by weight of EL, and 1850 parts by weight of PGME. In Tables 4 to 7, the crosslinker TMGU is tetramethoxymethyl glycoluril, and PF-636 is a surfactant PolyFox PF-636 manufactured by OMNOVA SOLUTIONS.

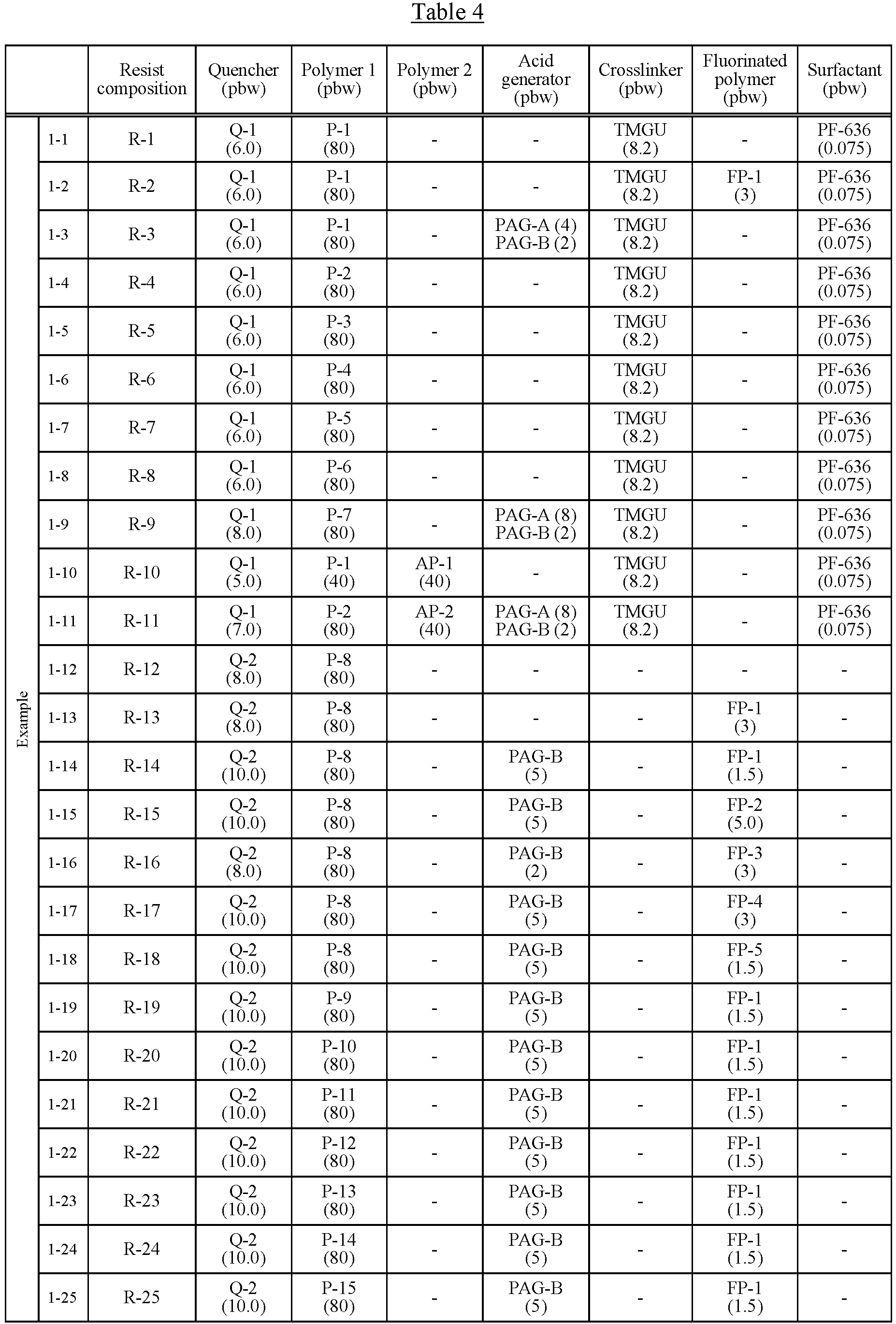

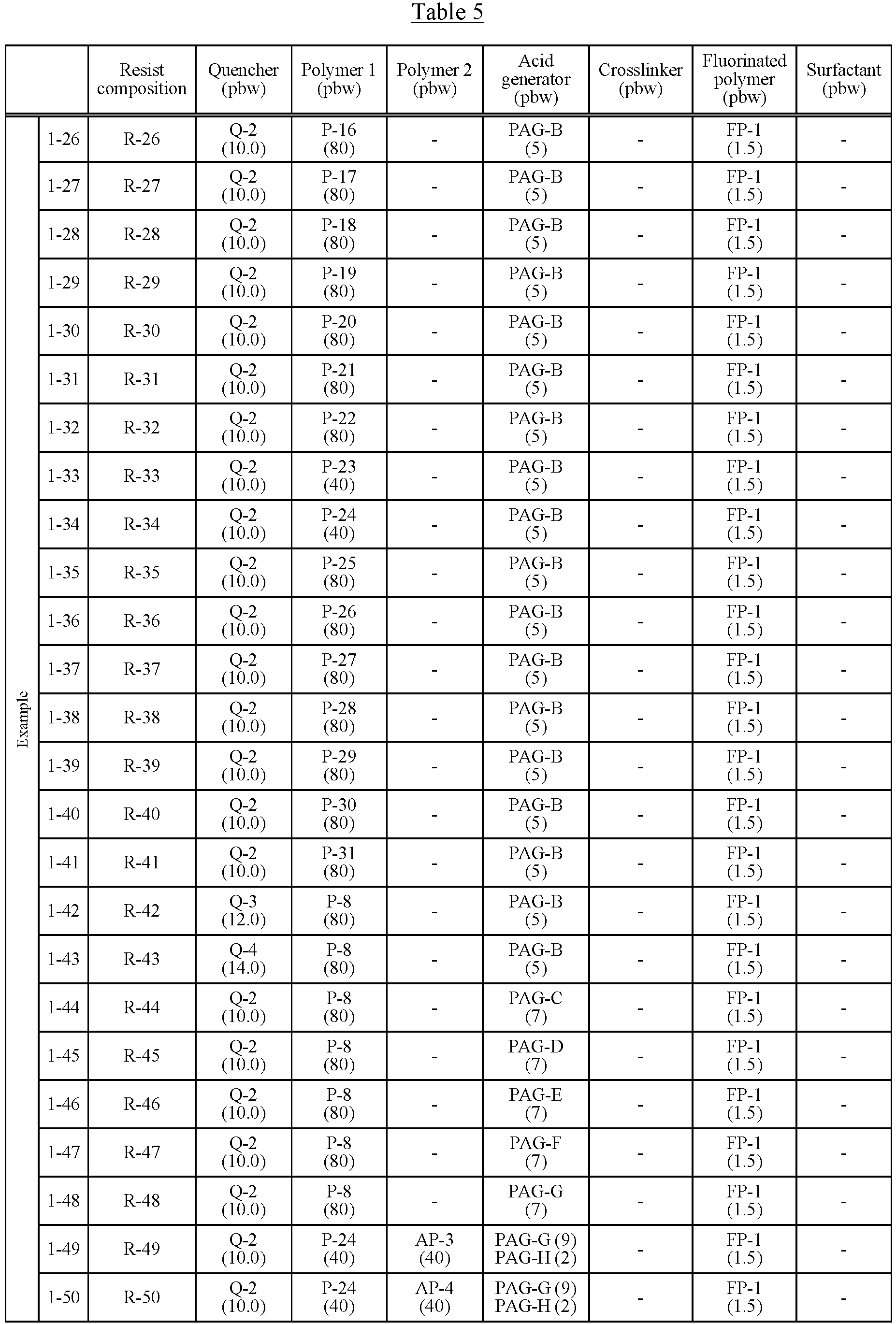

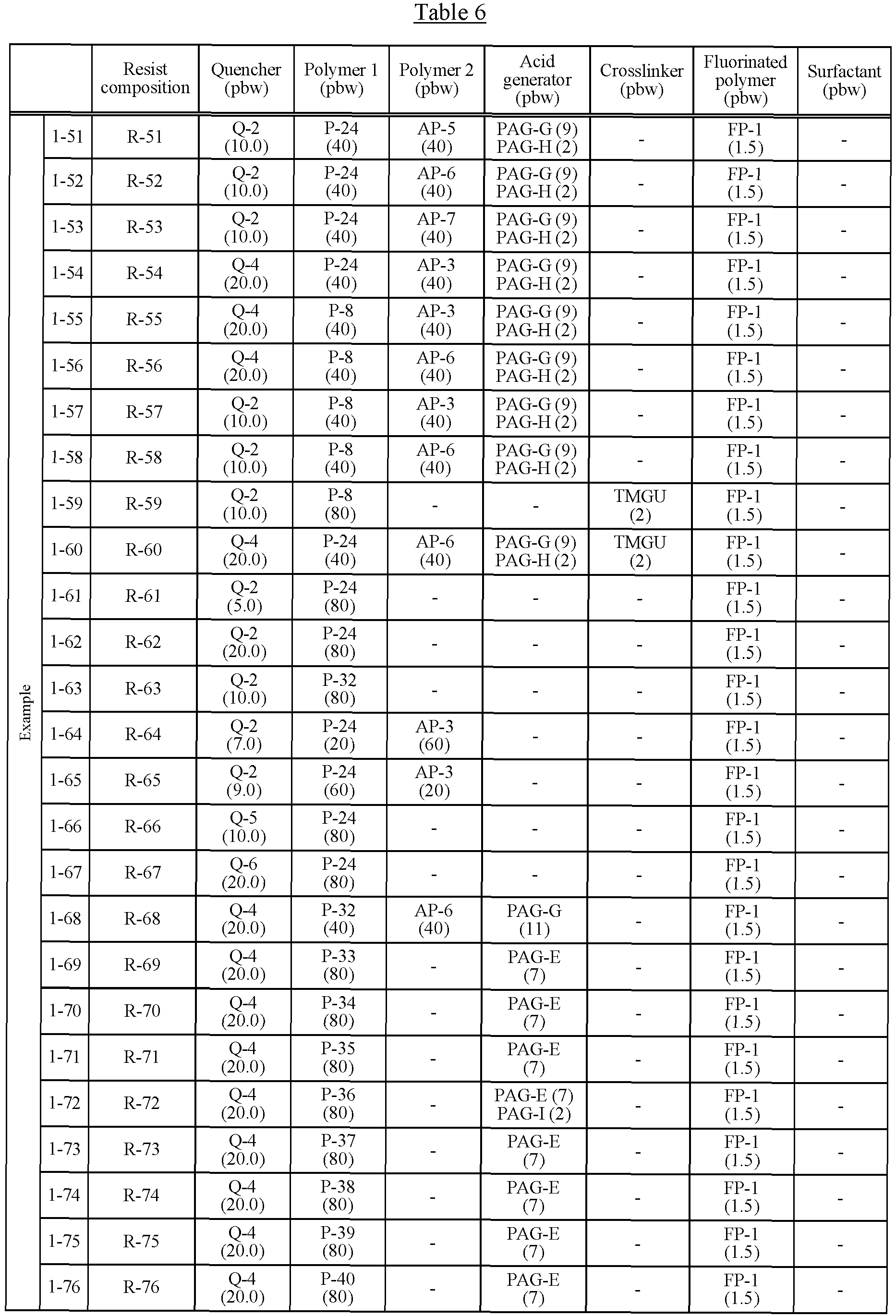

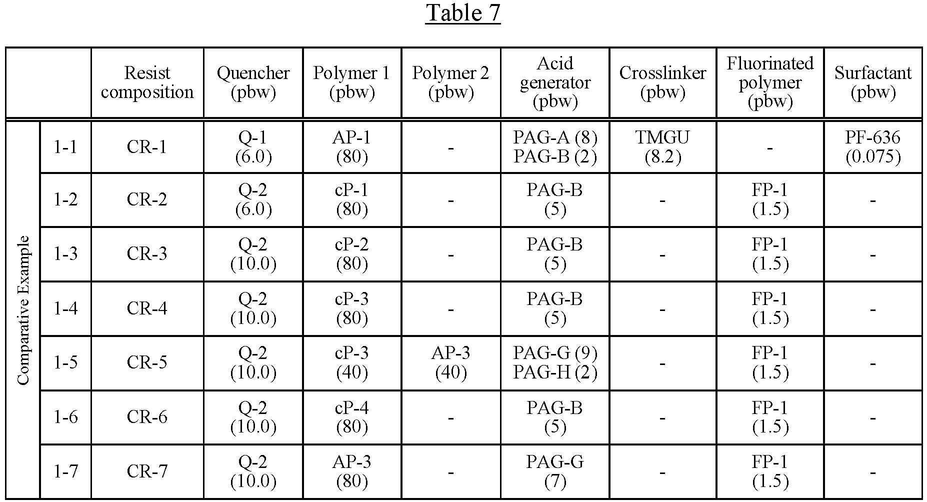

Structures of Quenchers Q-1 to Q-6, Photoacid generators PAG-A to PAG-I, and Polymers FP-1 to FP-5 in Tables 4 to 7 are as follows.

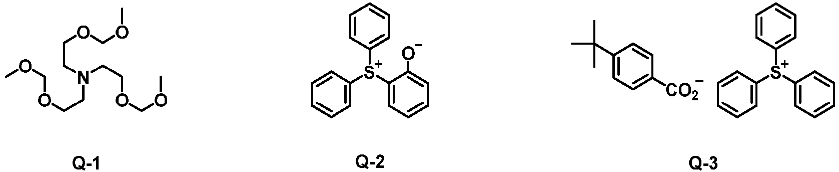

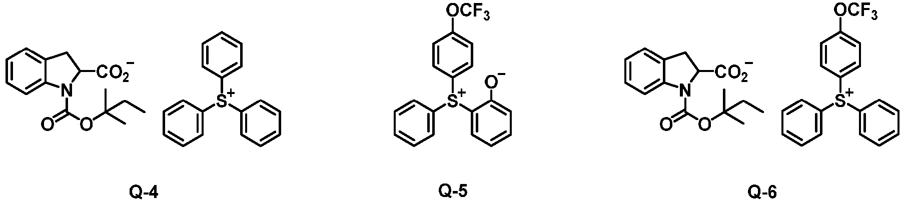

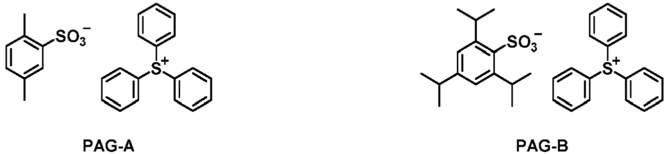

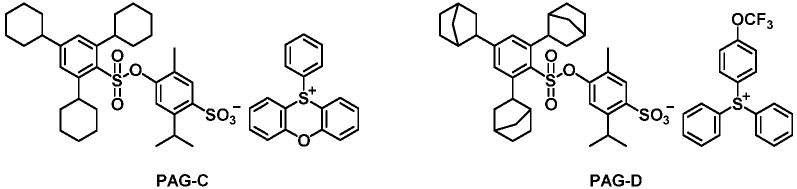

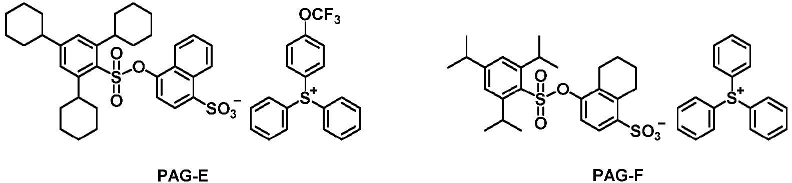

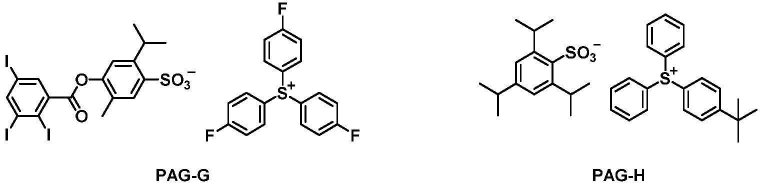

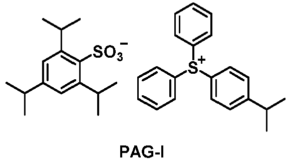

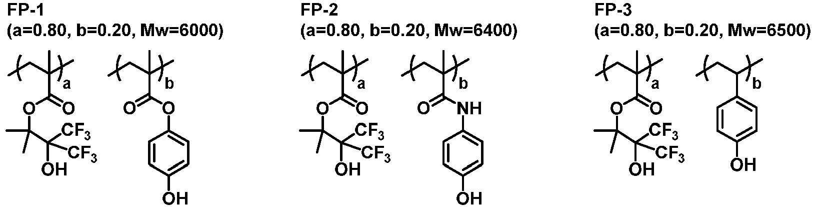

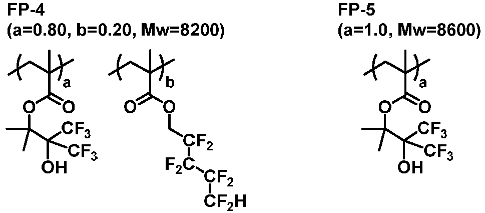

### [3] EB Lithography Evaluation

### Examples 2-1 to 2-76 and Comparative Examples 2-1 to 2-7

Each of the chemically amplified negative resist compositions (R-1 to R-76 and CR-1 to CR-7) was applied by spin coating using ACT-M (manufactured by Tokyo Electron Limited) onto a reflection type mask blank for an EUV lithography mask containing a chromium compound in a 152 mm square outermost surface, and prebaked on a hotplate at 110°C for 600 seconds to form a resist film having a thickness of 80 nm. The film thickness of the obtained resist film was measured using an optical measuring instrument NanoSpec (manufactured by Nanometrics, Inc.). Measurement was made at 81 points in the plane of the blank substrate excluding an outer rim portion extending 10 mm inward from the periphery of the blank, and the average film thickness and the film thickness range were calculated therefrom.

Further, the resist film was exposed using an electron beam exposure apparatus (EBM-5000plus manufactured by NuFlare Technology, Inc., acceleration voltage: 50 kV), PEB was performed at 110°C for 600 seconds, and the resist film was developed with a 2.38 wt% aqueous TMAH solution to give a negative pattern.

The obtained resist pattern was evaluated as follows. The patterned mask blank was observed under a top-down SEM (scanning electron microscope). The optimum dose (Eop) was defined as the exposure dose (µC/cm²) which provided a 1 : 1 resolution at the top and bottom of a 200-nm 1 : 1 line-and-space (LS) pattern. The LS resolution (or maximum resolution) was defined as the minimum size at the dose which provided a 1 : 1 resolution for an LS of 200 nm. The dot resolution (or maximum resolution) was defined as the minimum size at the dose which provided a square resolution for a line width of a 200 nm square. The edge roughness (LER) of a 200-nm LS pattern was measured under SEM. The pattern was visually observed to judge whether or not the profile was rectangular. The evaluation results of the resist compositions are shown in Tables 8 to 11.

**Table 8**

| | | Optimum dose (µC/cm²) | Maximum resolution (LS) (nm) | Maximum resolution (dot) (nm) | LER (nm) | Pattern profile |
|---|---|---|---|---|---|---|
| Example | 2-1 | 150 | 40 | 80 | 4.1 | rectangular |
| | 2-2 | 160 | 40 | 80 | 4.1 | rectangular |
| | 2-3 | 160 | 40 | 80 | 4.0 | rectangular |
| | 2-4 | 160 | 40 | 80 | 4.2 | rectangular |
| | 2-5 | 160 | 40 | 80 | 4.3 | rectangular |
| | 2-6 | 160 | 40 | 80 | 4.2 | rectangular |
| | 2-7 | 160 | 40 | 80 | 4.1 | rectangular |
| | 2-8 | 160 | 40 | 80 | 4.2 | rectangular |
| | 2-9 | 170 | 40 | 80 | 4.2 | rectangular |
| | 2-10 | 160 | 40 | 80 | 4.3 | rectangular |
| | 2-11 | 160 | 40 | 80 | 4.1 | rectangular |
| | 2-12 | 160 | 35 | 70 | 3.7 | rectangular |
| | 2-13 | 160 | 35 | 70 | 3.6 | rectangular |
| | 2-14 | 160 | 35 | 70 | 3.5 | rectangular |
| | 2-15 | 160 | 35 | 70 | 3.5 | rectangular |
| | 2-16 | 160 | 35 | 70 | 3.5 | rectangular |
| | 2-17 | 160 | 35 | 70 | 3.5 | rectangular |
| | 2-18 | 170 | 35 | 70 | 3.7 | rectangular |
| | 2-19 | 160 | 35 | 70 | 3.5 | rectangular |
| | 2-20 | 160 | 35 | 70 | 3.6 | rectangular |
| | 2-21 | 160 | 35 | 70 | 3.5 | rectangular |
| | 2-22 | 160 | 35 | 70 | 3.6 | rectangular |
| | 2-23 | 160 | 35 | 70 | 3.5 | rectangular |
| | 2-24 | 160 | 35 | 70 | 3.6 | rectangular |
| | 2-25 | 160 | 35 | 70 | 3.5 | rectangular |
| | 2-26 | 160 | 35 | 70 | 3.6 | rectangular |
| | 2-27 | 160 | 35 | 70 | 3.7 | rectangular |
| | 2-28 | 170 | 35 | 70 | 3.5 | rectangular |
| | 2-29 | 160 | 35 | 70 | 3.7 | rectangular |
| | 2-30 | 160 | 35 | 70 | 3.6 | rectangular |
| | 2-31 | 160 | 35 | 70 | 3.5 | rectangular |
| | 2-32 | 160 | 35 | 70 | 3.6 | rectangular |
| | 2-33 | 160 | 35 | 70 | 3.6 | rectangular |
| | 2-34 | 160 | 35 | 70 | 3.6 | rectangular |
| | 2-35 | 160 | 35 | 70 | 3.7 | rectangular |

**Table 9**

| | | Optimum dose (µC/cm²) | Maximum resolution (LS) (nm) | Maximum resolution (dot) (nm) | LER (nm) | Pattern profile |
|---|---|---|---|---|---|---|
| Example | 2-36 | 170 | 35 | 70 | 3.5 | rectangular |
| | 2-37 | 180 | 35 | 70 | 3.7 | rectangular |
| | 2-38 | 160 | 35 | 70 | 3.6 | rectangular |
| | 2-39 | 160 | 35 | 70 | 3.5 | rectangular |
| | 2-40 | 160 | 35 | 70 | 3.5 | rectangular |
| | 2-41 | 160 | 35 | 70 | 3.6 | rectangular |
| | 2-42 | 160 | 35 | 70 | 3.8 | rectangular |
| | 2-43 | 160 | 35 | 70 | 3.6 | rectangular |
| | 2-44 | 160 | 35 | 70 | 3.7 | rectangular |
| | 2-45 | 160 | 35 | 70 | 3.7 | rectangular |
| | 2-46 | 160 | 35 | 70 | 3.6 | rectangular |
| | 2-47 | 160 | 35 | 70 | 3.5 | rectangular |
| | 2-48 | 160 | 35 | 70 | 3.7 | rectangular |
| | 2-49 | 160 | 35 | 70 | 3.5 | rectangular |
| | 2-50 | 160 | 35 | 70 | 3.6 | rectangular |
| | 2-51 | 160 | 35 | 70 | 3.5 | rectangular |
| | 2-52 | 160 | 35 | 70 | 3.8 | rectangular |
| | 2-53 | 160 | 35 | 70 | 3.7 | rectangular |
| | 2-54 | 160 | 35 | 70 | 3.5 | rectangular |
| | 2-55 | 160 | 35 | 70 | 3.7 | rectangular |
| | 2-56 | 160 | 35 | 70 | 3.5 | rectangular |
| | 2-57 | 160 | 35 | 70 | 3.8 | rectangular |
| | 2-58 | 160 | 35 | 70 | 3.5 | rectangular |
| | 2-59 | 160 | 35 | 70 | 3.6 | rectangular |
| | 2-60 | 160 | 35 | 70 | 3.5 | rectangular |
| | 2-61 | 100 | 35 | 70 | 3.7 | rectangular |
| | 2-62 | 300 | 35 | 70 | 3.4 | rectangular |
| | 2-63 | 160 | 35 | 70 | 3.4 | rectangular |
| | 2-64 | 160 | 35 | 70 | 3.5 | rectangular |
| | 2-65 | 160 | 35 | 70 | 3.7 | rectangular |
| | 2-66 | 160 | 35 | 70 | 3.6 | rectangular |
| | 2-67 | 160 | 35 | 70 | 3.5 | rectangular |

**Table 10**

| | | Optimum dose (µC/cm²) | Maximum resolution (LS) (nm) | Maximum resolution (dot) (nm) | LER (nm) | Pattern profile |
|---|---|---|---|---|---|---|
| Example | 2-68 | 160 | 35 | 70 | 3.5 | rectangular |
| | 2-69 | 160 | 35 | 70 | 3.4 | rectangular |
| | 2-70 | 160 | 35 | 70 | 3.6 | rectangular |
| | 2-71 | 160 | 35 | 70 | 3.5 | rectangular |
| | 2-72 | 150 | 35 | 70 | 3.6 | rectangular |
| | 2-73 | 160 | 35 | 70 | 3.6 | rectangular |
| | 2-74 | 160 | 35 | 70 | 3.7 | rectangular |
| | 2-75 | 160 | 35 | 70 | 3.5 | rectangular |
| | 2-76 | 160 | 35 | 70 | 3.6 | rectangular |

**Table 11**

| | | Optimum dose (µC/cm²) | Maximum resolution (LS) (nm) | Maximum resolution (dot) (nm) | LER (nm) | Pattern profile |
|---|---|---|---|---|---|---|
| Comparative Example | 2-1 | 150 | 60 | 100 | 5.6 | undercut |
| | 2-2 | It was impossible to prepare a resist composition because the components did not dissolve in the solvent. | | | | |
| | 2-3 | It was impossible to prepare a resist composition because the components did not dissolve in the solvent. | | | | |
| | 2-4 | 160 | 50 | 90 | 5.1 | round head |
| | 2-5 | 160 | 50 | 90 | 5.0 | round head |
| | 2-6 | 160 | 50 | 90 | 5.1 | round head |
| | 2-7 | 160 | 50 | 90 | 5.1 | round head |

### [4] Evaluation of Etching Resistance

### Examples 3-1 to 3-2 and Comparative Examples 3-1 to 3-3

Each of the chemically amplified negative resist compositions (R-34, R-49, CR-4, CR-5, and CR-6) was applied by spin coating using ACT-M (manufactured by Tokyo Electron Limited) onto a photomask blank containing chromium in a 152 mm square outermost surface, and prebaked on a hotplate at 110°C for 600 seconds to form a resist film having a thickness of 120 nm. The film thickness of the obtained resist film was measured using an optical measuring instrument NanoSpec (manufactured by Nanometrics, Inc.). Measurement was made at 81 points in the plane of the blank substrate excluding an outer rim portion extending 10 mm inward from the periphery, and the average film thickness and the film thickness range were calculated therefrom. The obtained coated substrate was dry-etched with a dry etching apparatus (UNAXIS G4) under the following conditions, and the film thickness loss rate (A/sec) derived from the residual film after etching was calculated. The results are shown in Table 12.

| | |
|---|---|
| RF1 (RIE): | pulse 700 V |
| RF2 (ICP): | CW 400 W |
| Pressure: | 6 mTorr |
| Cl₂: | 185 sccm |
| O₂: | 55 sccm |
| He: | 9.25 sccm |
| Etching time: | 75 sec |

**Table 12**

| | | Resist composition | Rate [A/sec] |
|---|---|---|---|
| Example | 3-1 | R-34 | 5.4 |
| | 3-2 | R-49 | 5.5 |
| Comparative Example | 3-1 | CR-4 | 7.5 |
| | 3-2 | CR-5 | 7.3 |
| | 3-3 | CR-6 | 7.5 |

All of the chemically amplified negative resist compositions (R-1 to R-76) of the present invention exhibited good resolution, LER, and pattern rectangularity. On the other hand, of the resist compositions (CR-1 to CR-6) of Comparative Examples, CR-2 and CR-3 had low solubility in the resist solvent, and it was impossible even to prepare a resist composition. In CR-1, CR-4, and CR-5, the optimization of acid diffusion was insufficient, and deterioration of resolution, LER, and pattern rectangularity was observed. In addition, also in the dry etching evaluation using R-34 and R-49, R-34 and R-49 had good etching resistance as compared with CR-4, CR-5, and CR-6, and it was suggested that the incorporation of the repeat unit A1 into the polymer is effective for mask processing.

### [5] Evaluation of Development Residue

### Examples 4-1 to 4-20 and Comparative Examples 4-1 to 4-4

Each of the chemically amplified negative resist compositions (R-4, R-9, R-14, R-19 to R-33, R-49, R-71, CR-1, CR-4, CR-5, and CR-7) was applied by spin coating using ACT-M (manufactured by Tokyo Electron Limited) onto a reflection type mask blank for an EUV lithography mask containing a chromium compound in a 152 mm square outermost surface, and prebaked on a hotplate at 110°C for 600 seconds to form a resist film having a thickness of 80 nm. The film thickness of the obtained resist film was measured using an optical measuring instrument NanoSpec (manufactured by Nanometrics, Inc.). Measurement was made at 81 points in the plane of the blank substrate excluding an outer rim portion extending 10 mm inward from the periphery of the blank, and the average film thickness and the film thickness range were calculated therefrom.

Each of the resist films was baked as it was at 120°C for 600 seconds without writing, and developed with a 2.38 wt% aqueous tetramethylammonium hydroxide solution, and then the development residue was evaluated with a mask defect inspection apparatus (M9650 manufactured by Lasertec Co., Ltd.). The total number of defects after development is shown in Table 13.

**Table 13**

| | | Resist composition | Total number of defects after development |
|---|---|---|---|
| Example | 4-1 | R-4 | 440 |
| | 4-2 | R-9 | 420 |
| | 4-3 | R-14 | 340 |
| | 4-4 | R-19 | 350 |
| | 4-5 | R-20 | 370 |
| | 4-6 | R-21 | 400 |
| | 4-7 | R-22 | 90 |
| | 4-8 | R-23 | 370 |
| | 4-9 | R-24 | 350 |
| | 4-10 | R-25 | 340 |
| | 4-11 | R-26 | 360 |
| | 4-12 | R-27 | 340 |
| | 4-13 | R-28 | 350 |
| | 4-14 | R-29 | 350 |
| | 4-15 | R-30 | 340 |
| | 4-16 | R-31 | 330 |
| | 4-17 | R-32 | 340 |
| | 4-18 | R-33 | 330 |
| | 4-19 | R-49 | 320 |
| | 4-20 | R-71 | 330 |
| Comparative Example | 4-1 | CR-1 | 1,200 |
| | 4-2 | CR-4 | 1,000 |
| | 4-3 | CR-5 | 1,000 |
| | 4-4 | CR-7 | 1,200 |

As is apparent from the results shown in Table 13, the number of defects due to the development residue can be greatly reduced by the polymer containing the repeat unit A1 as compared with the conventional negative resist composition.

The resist pattern forming process using the chemically amplified negative resist composition of the present invention is useful for photolithography in semiconductor element manufacturing, particularly in processing of photomask blanks of transmission or reflection type.

## Claims

1. A chemically amplified negative resist composition comprising (A) a base polymer containing a polymer which contains a repeat unit having formula (A1) and a repeat unit having formula (A2), the polymer being adapted to decrease its solubility in an aqueous alkaline solution under an action of an acid: 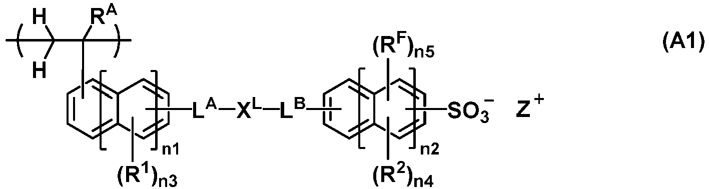
wherein n1 is 0 or 1, n2 is 0 or 1, n3 is 0, 1, 2, 3, or 4, n4 is 0, 1, 2, 3, or 4, n5 is 0, 1, 2, 3, or 4, provided that when n2 is 0, 0 ≤ n4 + n5 ≤ 4, and when n2 is 1, 0 ≤ n4 + n5 ≤ 6, and
a case where n1 to n5 are all 0 is excluded,
R^{A} is a hydrogen atom, a fluorine atom, a methyl group, or a trifluoromethyl group,
R¹ is a halogen atom, a nitro group, a cyano group, or a C₁-C₂₀ hydrocarbyl group which may contain a heteroatom, and when n3 is 2 or more, groups R¹ may be identical or different from each other, and a plurality of groups R¹ may bond together to form a ring with a carbon atom to which they are bonded,
R² is a C₁-C₂₀ hydrocarbyl group which may contain a heteroatom, and when n4 is 2 or more, groups R² may be identical or different from each other, and a plurality of groups R² may bond together to form a ring with a carbon atom to which they are bonded,
R^{F} is a fluorine atom, a C₁-C₆ fluorinated alkyl group, a C₁-C₆ fluorinated alkoxy group, or a C₁-C₆ fluorinated alkylthio group, and when n5 is 2 or more, groups R^{F} may be identical or different from each other,
L^{A} and L^{B} are each independently a single bond, an ether bond, an ester bond, a sulfonic ester bond, a sulfonic amide bond, a carbonate bond, or a carbamate bond,
X^{L} is a C₁-C₄₀ hydrocarbylene group which may contain a heteroatom, and
Z⁺ is an onium cation, 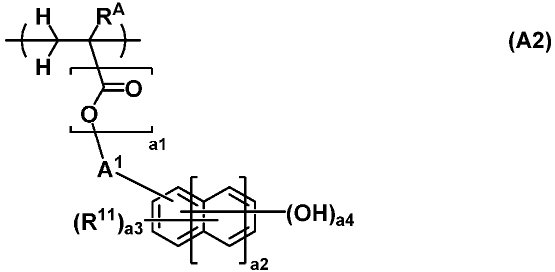
wherein a1 is 0 or 1, a2 is 0, 1, or 2, a3 is an integer satisfying 0 ≤ a3 ≤ 5 + 2(a2) - a4, and
a4 is 1, 2, or 3,
R^{A} is a hydrogen atom, a fluorine atom, a methyl group, or a trifluoromethyl group,
R¹¹ is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom, and when a3 is 2 or more, groups R¹¹ may be identical or different from each other, and
A¹ is a single bond or a C₁-C₁₀ saturated hydrocarbylene group in which some constituent -CH₂- may be replaced by -O-.

2. The chemically amplified negative resist composition according to claim 1,
wherein Z⁺ is a sulfonium cation having formula (cation-1) or an iodonium cation having formula (cation-2): 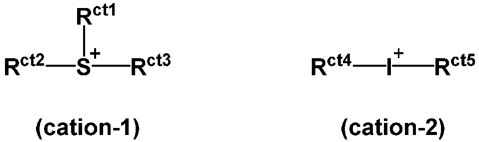 wherein R^{ct1} to R^{ct5} are each independently a halogen atom or a C₁-C₃₀ hydrocarbyl group which may contain a heteroatom, and R^{ct1} and R^{ct2} may bond together to form a ring with a sulfur atom to which they are bonded.

3. The chemically amplified negative resist composition according to claim 1 or 2,
wherein the polymer further contains at least one moiety selected from a repeat unit having formula (A3) and a repeat unit having formula (A4): 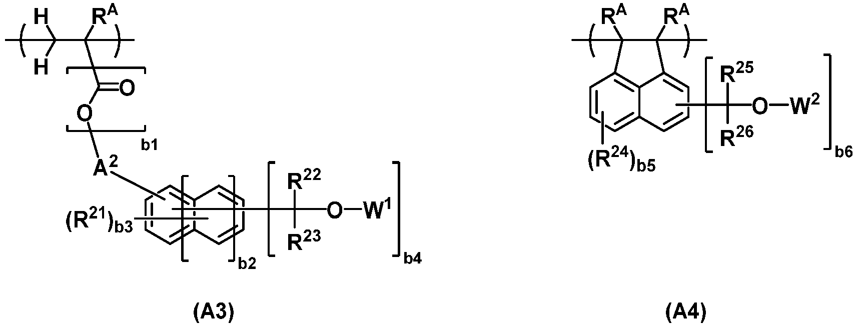 wherein b1 is 0 or 1, b2 is 0, 1, or 2, b3 is an integer satisfying 0 ≤ b3 ≤ 5 + 2(b2) - b4, b4 is 1, 2, or 3, b5 is 0, 1, or 2, and b6 is 1 or 2,
groups R^{A} are each independently a hydrogen atom, a fluorine atom, a methyl group, or a trifluoromethyl group,
R²¹ is a halogen atom or a C₁-C₂₀ hydrocarbyl group which may contain a heteroatom, and when b3 is 2 or more, groups R²¹ may be identical or different from each other,
R²² and R²³ are each independently a hydrogen atom, a C₁-C₁₅ saturated hydrocarbyl group which may be substituted with a hydroxy moiety or a C₁-C₆ saturated hydrocarbyloxy moiety, or a C₆-C₁₅ aryl group which may have a substituent, a case where R²² and R²³ are both hydrogen atoms simultaneously is excluded, R²² and R²³ may bond together to form a ring with a carbon atom to which they are bonded, and some -CH₂- in the ring may be replaced by -O- or -S-,
R²⁴ is a halogen atom or a C₁-C₂₀ hydrocarbyl group which may contain a heteroatom, and when b5 is 2 or more, groups R²⁴ may be identical or different from each other,
R²⁵ and R²⁶ are each independently a hydrogen atom, a C₁-C₁₅ saturated hydrocarbyl group which may be substituted with a hydroxy moiety or a C₁-C₆ saturated hydrocarbyloxy moiety, or a C₆-C₁₅ aryl group which may have a substituent, a case where R²⁵ and R²⁶ are both hydrogen atoms simultaneously is excluded, R²⁵ and R²⁶ may bond together to form a ring with a carbon atom to which they are bonded, and some -CH₂- in the ring may be replaced by -O- or -S-,
A² is a single bond or a C₁-C₁₀ saturated hydrocarbylene group in which some constituent -CH₂- may be replaced by -O-, and
W¹ and W² are each independently a hydrogen atom, a C₁-C₁₀ aliphatic hydrocarbyl group, a C₂-C₁₀ aliphatic hydrocarbylcarbonyl group, or a C₆-C₁₅ aryl group which may have a substituent.

4. The chemically amplified negative resist composition according to any one of claims 1 to 3, wherein the polymer further contains at least one moiety selected from a repeat unit having formula (A5), a repeat unit having formula (A6), and a repeat unit having formula (A7): 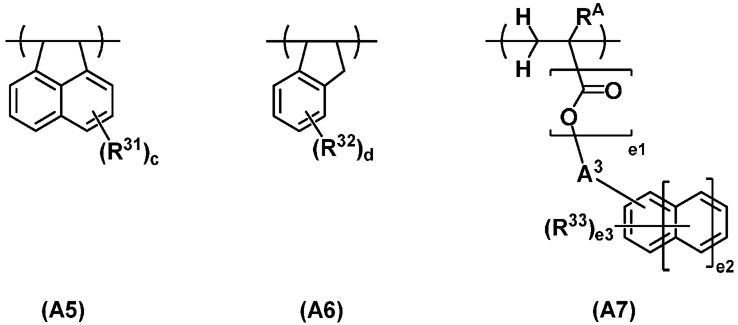
wherein c and d are each independently 0, 1, 2, 3, or 4, e1 is 0 or 1, e2 is 0, 1, or 2, and
e3 is 0, 1, 2, 3, 4, or 5,
R^{A} is a hydrogen atom, a fluorine atom, a methyl group, or a trifluoromethyl group,
R³¹ and R³² are each independently a hydroxy group, a halogen atom, a C₁-C₈ saturated hydrocarbyl group which may be substituted with a halogen atom, a C₁-C₈ saturated hydrocarbyloxy group which may be substituted with a halogen atom, or a C₂-C₈ saturated hydrocarbylcarbonyloxy group which may be substituted with a halogen atom, when c is 2 or more, groups R³¹ may be identical or different from each other, and when d is 2 or more, groups R³² may be identical or different from each other,
R³³ is a C₁-C₂₀ saturated hydrocarbyl group, a C₁-C₂₀ saturated hydrocarbyloxy group, a C₂-C₂₀ saturated hydrocarbylcarbonyloxy group, a C₂-C₂₀ saturated hydrocarbyloxyhydrocarbyl group, a C₂-C₂₀ saturated hydrocarbylthiohydrocarbyl group, a halogen atom, a nitro group, a cyano group, a C₁-C₂₀ saturated hydrocarbylsulfinyl group, or a C₁-C₂₀ saturated hydrocarbylsulfonyl group, and when e3 is 2 or more, groups R³³ may be identical or different from each other, and
A³ is a single bond or a C₁-C₁₀ saturated hydrocarbylene group in which some constituent -CH₂- may be replaced by -O-.

5. The chemically amplified negative resist composition according to claim 1,
wherein a content of a repeat unit having an aromatic ring structure in all repeat units of the polymer contained in the base polymer is 60 mol% or more.

6. The chemically amplified negative resist composition according to any one of claims 1 to 5, further comprising (B) a crosslinker.

7. The chemically amplified negative resist composition according to claim 3, which is free of a crosslinker.

8. The chemically amplified negative resist composition according to any one of claims 1 to 7, further comprising (C) a fluorinated polymer which contains at least one moiety selected from a repeat unit having formula (C1), a repeat unit having formula (C2), a repeat unit having formula (C3), and a repeat unit having formula (C4), and may further contain at least one moiety selected from a repeat unit having formula (C5) and a repeat unit having formula (C6): 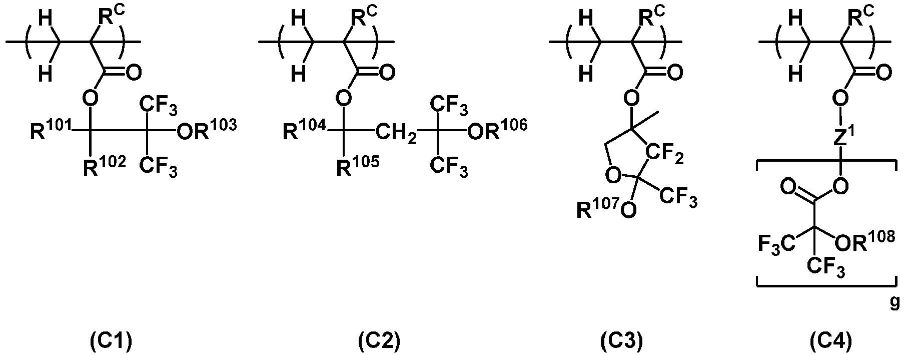 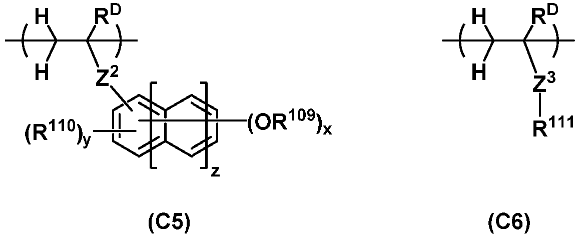 wherein x is 1, 2, or 3, y is an integer satisfying 0 ≤ y ≤ 5 + 2z - x, z is 0 or 1, and g is 1, 2, or 3,
groups R^{C} are each independently a hydrogen atom, a fluorine atom, a methyl group, or a trifluoromethyl group,
groups R^{D} are each independently a hydrogen atom or a methyl group,
R¹⁰¹, R¹⁰², R¹⁰⁴, and R¹⁰⁵ are each independently a hydrogen atom or a C₁-C₁₀ saturated hydrocarbyl group,
R¹⁰³, R¹⁰⁶, R¹⁰⁷, and R¹⁰⁸ are each independently a hydrogen atom, a C₁-C₁₅ hydrocarbyl group, a C₁-C₁₅ fluorinated hydrocarbyl group, or an acid labile group, and when R¹⁰³, R¹⁰⁶, R¹⁰⁷, and R¹⁰⁸ are each a hydrocarbyl group or a fluorinated hydrocarbyl group, an ether bond or a carbonyl group may intervene in a carbon-carbon bond,
R¹⁰⁹ is a hydrogen atom or a C₁-C₅ linear or branched hydrocarbyl group in which a heteroatom-containing moiety may intervene in a carbon-carbon bond, and when x is 2 or more, groups R¹⁰⁹ may be identical or different from each other,
R¹¹⁰ is a C₁-C₅ linear or branched hydrocarbyl group in which a heteroatom-containing moiety may intervene in a carbon-carbon bond, and when y is 2 or more, groups R¹¹⁰ may be identical or different from each other,
R¹¹¹ is a C₁-C₂₀ saturated hydrocarbyl group in which at least one hydrogen atom is substituted with a fluorine atom, and some -CH₂- in the saturated hydrocarbyl group may be replaced by an ester bond or an ether bond,
Z¹ is a C₁-C₂₀ (g+1)-valent hydrocarbon group or a C₁-C₂₀ (g+1)-valent fluorinated hydrocarbon group,
Z² is a single bond, *-C(=O)-O-, or *-C(=O)-NH-, wherein the asterisk (*) designates a point of attachment to a carbon atom in a backbone,
Z³ is a single bond, -O-, *-C(=O)-O-Z³¹-Z³²-, or *-C(=O)-NH-Z³¹-Z³²-, Z³¹ is a single bond or a C₁-C₁₀ saturated hydrocarbylene group, and Z³² is a single bond, an ester bond, an ether bond, or a sulfonamide bond, wherein the asterisk (*) designates a point of attachment to a carbon atom in a backbone.

9. The chemically amplified negative resist composition according to any one of claims 1 to 8, further comprising (D) a quencher.

10. The chemically amplified negative resist composition according to any one of claims 1 to 9, further comprising (E) an organic solvent.

11. The chemically amplified negative resist composition according to any one of claims 1 to 10, further comprising (F) a photoacid generator.

12. A resist pattern forming process comprising the steps of:
applying the chemically amplified negative resist composition of any one of claims 1 to 11 onto a substrate to form a resist film thereon,
exposing the resist film patternwise to high-energy radiation, and
developing the exposed resist film in an alkaline developer.

13. The resist pattern forming process according to claim 12, wherein the high-energy radiation is an extreme ultraviolet ray having a wavelength of 3 to 15 nm or an electron beam.

14. The resist pattern forming process according to claim 12 or 13, wherein the substrate is a mask blank of transmission or reflection type.

15. A mask blank of transmission or reflection type which is coated with the chemically amplified negative resist composition according to any one of claims 1 to 11.
